(19) Europäisches Patentamt / European Patent Office / Office européen des brevets

(11) EP 4 240 745 B1

(12) **EUROPEAN PATENT SPECIFICATION**

(45) Date of publication and mention of the grant of the patent:
**28.08.2024 Bulletin 2024/35**

(21) Application number: **21815112.4**

(22) Date of filing: **03.11.2021**

(51) International Patent Classification (IPC):
***C07F 5/02*** *(2006.01)* ***C09K 11/06*** *(2006.01)*
***H10K 85/30*** *(2023.01)* ***H10K 85/60*** *(2023.01)*
***H10K 101/20*** *(2023.01)*

(52) Cooperative Patent Classification (CPC):
**C07F 5/027; C09K 11/06; H10K 85/636; H10K 85/657; H10K 85/658;** H10K 50/11; H10K 2101/20; Y02E 10/549

(86) International application number:
**PCT/EP2021/080488**

(87) International publication number:
**WO 2022/096495 (12.05.2022 Gazette 2022/19)**

# (54) ORGANIC MOLECULES FOR OPTOELECTRONIC DEVICES

ORGANISCHE MOLEKÜLE FÜR OPTOELEKTRONISCHE VORRICHTUNGEN

MOLÉCULES ORGANIQUES POUR DISPOSITIFS OPTOÉLECTRONIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.11.2020 EP 20205724**

(43) Date of publication of application:
**13.09.2023 Bulletin 2023/37**

(73) Proprietor: **Samsung Display Co., Ltd.**
**Yongin-si, Gyeonggi-do 17113 (KR)**

(72) Inventor: **DÜCK, Sebastian**
**69115 Heidelberg (DE)**

(74) Representative: **Gulde & Partner**
**Patent- und Rechtsanwaltskanzlei mbB**
**Wallstraße 58/59**
**10179 Berlin (DE)**

(56) References cited:
**CA-A1- 3 017 010** **US-A1- 2020 203 651**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The invention relates to light-emitting organic molecules and their use in organic light-emitting diodes (OLEDs) and in other optoelectronic devices.

## Description

The object of the present invention is to provide molecules which are suitable for use in optoelectronic devices.

This object is achieved by the invention which provides a new class of organic molecules.

Optoelectronic devices containing one or more light-emitting layers based on organics such as, e.g., organic light emitting diodes (OLEDs), light emitting electrochemical cells (LECs) and light-emitting transistors gain increasing importance. In particular, OLEDs are promising devices for electronic products such as screens, displays and illumination devices. In contrast to most electroluminescent devices essentially based on inorganics, organic optoelectronic devices based on organics are often rather flexible and producible in particularly thin layers. The OLED-based screens and displays already available today bear either good efficiencies and long lifetimes or good color purity and long lifetimes, but do not combine all three properties, i.e. good efficiency, long lifetime, and good color purity. CA 3017010 and US 2020/203651 disclose organic light emitting devices with compounds having a heterocyclic skeleton comprising nitrogen and boron.

Thus, there is still an unmet technical need for optoelectronic devices which have a high quantum yield, a long lifetime, and good color purity.

The color purity or color point of an OLED is typically provided by CIEx and CIEy coordinates, whereas the color gamut for the next display generation is provided by so-called BT-2020 and DCPI3 values. Generally, in order to achieve these color coordinates, top emitting devices are needed to adjust the color coordinates by changing the cavity. In order to achieve high efficiency in top emitting devices while targeting this color gamut, a narrow emission spectrum in bottom emitting devices is required.

The organic molecules according to the invention exhibit emission maxima in the deep blue, sky blue, or green spectral range, preferably in the deep blue, and sky blue spectral range, and most preferably in the deep blue spectral range. The organic molecules exhibit in particular emission maxima between 420 nm and 520 nm, preferably between 440 nm and 495 nm, more preferably between 450 nm and 470 nm. The excited state lifetime is not more than 5 μs.

Additionally, the molecules of the invention exhibit in particular a narrow - expressed by a small full width at half maximum (FWHM) - emission. The emission spectra of the organic molecules preferably show a full width at half maximum (FWHM) of less than or equal to 0.15 eV (≤ 0.15 eV), unless stated otherwise, measured with 1% by weight of emitter in poly(methyl methacrylate) PMMA at room temperature (i.e. approximately 25 °C). The excited state lifetime of the organic molecules according to the invention are, in particular, 5 μs or less.

The use of the molecules according to the invention in an optoelectronic device, for example, an organic light-emitting diode (OLED), leads to a narrow emission and high efficiency of the device. Corresponding OLEDs have a higher stability than OLEDs with known emitter materials and comparable color and/or by employing the molecules according to the invention in an OLED display, a more accurate reproduction of visible colors in nature, i.e. a higher resolution in the displayed image, is achieved. In particular, the molecules can be used in combination with an energy pump to achieve hyper-fluorescence or hyper-phosphorescence. In these cases, another species comprised in an organic electroluminescent device transfers energy to the organic molecules of the invention which then emit light.

The organic molecules according to the invention comprise or consist of:

- a first chemical moiety comprising a structure of formula I:

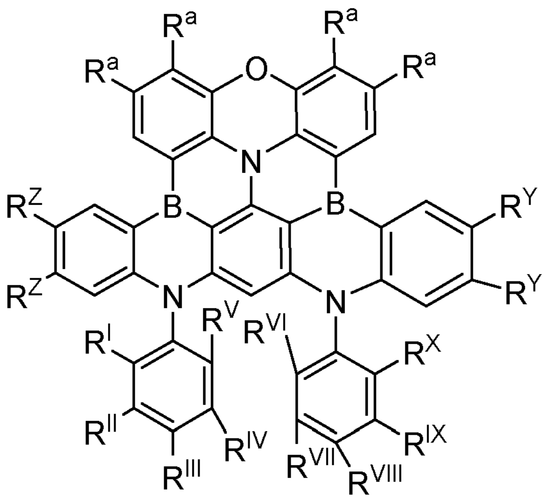

Formula I

- exactly one or exactly two second chemical moieties comprising a structure of formula II:

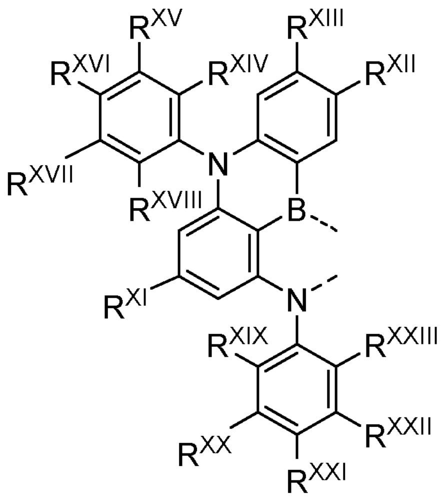

Formula II

wherein $R^Z$ is at each occurrence the binding site of a single bond linking the first chemical moiety to the second moiety;

$R^Y$ is at each occurrence the binding site of a single bond linking the first chemical moiety to the second moiety or $R^a$;

the dashed lines "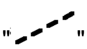" in formula II represent the binding sites of the first chemical moiety to the second chemical moiety (at both $R^Z$ and/or at both $R^Y$). In an embodiment of the organic molecule with only one second chemical moiety, it is bound at the positions $R^Z$ and $R^Y$ is $R^a$.

$R^a$ is at each occurrence independently selected from the group consisting of:

hydrogen,

deuterium,

$N(R^5)_2$,

$OR^5$,

$SR^5$,

$CF_3$,

CN,

halogen (F, Cl, Br, I),

$C_1$-$C_{40}$-alkyl,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^S)_2$, C=O, C=S, C=Se, $C=NR^5$, $P(=O)(R^5)$, SO, $SO_2$, $NR^5$, O, S or $CONR^5$;

$C_1$-$C_{40}$-alkoxy,

which is optionally substituted with one or more substituents $R^5$ and

wherein one or more non-adjacent $CH_2$-groups are optionally substituted by $R^5C=CR^5$, C=C, $Si(R^5)_2$, $Ge(R^5)_2$, $Sn(R^S)_2$, C=O, C=S, C=Se, $C=NR^5$, $P(=O)(R^5)$, SO, $SO_2$, $NR^5$, O, S or $CONR^5$;

$C_1$-$C_{40}$-thioalkoxy,

which is optionally substituted with one or more substituents $R^4$ and

wherein one or more non-adjacent $CH_2$-groups are optionally substituted by $R^5C=CR^5$, C=C, $Si(R^5)_2$, $Ge(R^5)_2$, $Sn(R^S)_2$, C=O, C=S, C=Se, $C=NR^5$, $P(=O)(R^5)$, SO, $SO_2$, $NR^5$, O, S or $CONR^5$;

$C_6$-$C_{60}$-aryl,

which is optionally substituted with one or more substituents $R^5$; and $C_3$-$C_{57}$-heteroaryl,

which is optionally substituted with one or more substituents $R^5$;

$R^5$ is at each occurrence independently selected from the group consisting of:

hydrogen, deuterium, halogen,

$C_1$-$C_{12}$-alkyl,
wherein optionally one or more hydrogen atoms are independently substituted by $R^6$;

$C_6$-$C_{18}$-aryl,
wherein optionally one or more hydrogen atoms are independently substituted by $R^6$; and

$C_3$-$C_{15}$-heteroaryl,
wherein optionally one or more hydrogen atoms are independently substituted by $R^6$;

$R^6$ is at each occurrence independently selected from the group consisting of:

hydrogen, deuterium, halogen,

$C_1$-$C_{12}$-alkyl,

$C_6$-$C_{18}$-aryl,
wherein optionally one or more hydrogen atoms are independently substituted by $C_1$-Cs-alkyl substituents; and

$C_3$-$C_{15}$-heteroaryl,

wherein optionally one or more hydrogen atoms are independently substituted by $C_1$-Cs-alkyl substituents;

$R^I$, $R^{II}$, $R^{III}$, $R^{IV}$, $R^V$, $R^{VI}$, $R^{VII}$, $R^{VIII}$, $R^{IX}$, $R^X$, $R^{XI}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen,

deuterium,

$N(R^4)_2$,

$OR^4$,

$SR^4$,

$Si(R^4)_3$,

$B(OR^4)_2$,

$OSO_2R^4$,

$CF_3$,

CN,

halogen,

$C_1$-$C_{40}$-alkyl,

which is optionally substituted with one or more substituents $R^4$ and
wherein one or more non-adjacent $CH_2$-groups are optionally substituted by $R^4C$=$CR^4$, C≡C, $Si(R^4)_2$, $Ge(R^4)_2$, $Sn(R^4)_2$, C=O, C=S, C=Se, C=$NR^4$, P(=O)($R^4$), SO, $SO_2$, $NR^4$, O, S or $CONR^4$;

$C_1$-$C_{40}$-alkoxy,

which is optionally substituted with one or more substituents $R^4$ and

wherein one or more non-adjacent $CH_2$-groups are optionally substituted by $R^4C$=$CR^4$, C≡C, $Si(R^4)_2$, $Ge(R^4)_2$, $Sn(R^4)_2$, C=O, C=S, C=Se, C=$NR^4$, P(=O)($R^4$), SO, $SO_2$, $NR^4$, O, S or $CONR^4$;

$C_1$-$C_{40}$-thioalkoxy,

which is optionally substituted with one or more substituents $R^4$ and

wherein one or more non-adjacent $CH_2$-groups are optionally substituted by $R^4C$=$CR^4$, C≡C, $Si(R^4)_2$, $Ge(R^4)_2$, $Sn(R^4)_2$, C=O, C=S, C=Se, C=$NR^4$, P(=O)($R^4$), SO, $SO_2$, $NR^4$, O, S or $CONR^4$;

$C_2$-$C_{40}$-alkenyl,

which is optionally substituted with one or more substituents $R^4$ and

wherein one or more non-adjacent $CH_2$-groups are optionally substituted by $R^4C$=$CR^4$, C≡C, $Si(R^4)_2$, $Ge(R^4)_2$, $Sn(R^4)_2$, C=O, C=S, C=Se, C=$NR^4$, P(=O)($R^4$), SO, $SO_2$, $NR^4$, O, S or $CONR^4$;

$C_2$-$C_{40}$-alkynyl,

which is optionally substituted with one or more substituents $R^4$ and

wherein one or more non-adjacent $CH_2$-groups are optionally substituted by $R^4C=CR^4$, $C\equiv C$, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;

$C_6$-$C_{60}$-aryl,

which is optionally substituted with one or more substituents $R^4$; and $C_3$-$C_{57}$-heteroaryl,

which is optionally substituted with one or more substituents $R^4$;

$R^4$ is at each occurrence independently from another selected from the group consisting of: hydrogen, deuterium, halogen, OPh (Ph = phenyl), SPh, $CF_3$, CN, $Si(C_1$-$C_5$-alkyl$)_3$, $Si(Ph)_3$,

$C_1$-$C_5$-alkyl,
wherein optionally one or more hydrogen atoms are independently substituted by deuterium, halogen, CN, or $CF_3$;

$C_1$-$C_5$-alkoxy,
wherein optionally one or more hydrogen atoms are independently substituted by deuterium, halogen, CN, or $CF_3$;

$C_1$-$C_5$-thioalkoxy,
wherein optionally one or more hydrogen atoms are independently substituted by deuterium, halogen, CN, or $CF_3$;

$C_2$-$C_5$-alkenyl,
wherein optionally one or more hydrogen atoms are independently substituted by deuterium, halogen, CN, or $CF_3$;

$C_2$-$C_5$-alkynyl,
wherein optionally one or more hydrogen atoms are independently substituted by deuterium, halogen, CN, or $CF_3$;

$C_6$-$C_{18}$-aryl,
which is optionally substituted with one or more substituents $R^5$;

$C_3$-$C_{17}$-heteroaryl,
which is optionally substituted with one or more substituents $R^5$;

$N(C_6$-$C_{18}$-aryl$)_2$,

$N(C_3$-$C_{17}$-heteroaryl$)_2$; and

$N(C_3$-$C_{17}$-heteroaryl$)(C_6$-$C_{18}$-aryl$)$,

wherein subsituents $R^a$ positioned adjacent to each other are optionally bonded to each other and form an aryl ring, which is optionally substituted with one or more $C_1$-$C_5$-alkyl substituents, deuterium, halogen, CN or $CF_3$.

In one embodiment of the invention, the organic molecules according to the invention comprise or consist of:

- a first chemical moiety comprising a structure of formula I and

- two second chemical moieties comprising a structure of formula II.

In one embodiment of the invention, $R^{I}$, $R^{II}$, $R^{III}$, $R^{IV}$, $R^{V}$, $R^{VI}$, $R^{VII}$, $R^{VIII}$, $R^{IX}$, $R^{X}$, $R^{XI}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen,

Me, $^{i}$Pr, $^{t}$Bu, CN, $CF_3$, F,

Ph, which is optionally substituted with one or more substituents independently from each other selected from the group consisting of Me, $^{i}$Pr, $^{t}$Bu, CN, $CF_3$, F and Ph,

pyridinyl, which is optionally substituted with one or more substituents independently from each other selected from the group consisting of Me, $^{i}$Pr, $^{t}$Bu, CN, $CF_3$, F and Ph,

carbazolyl, which is optionally substituted with one or more substituents independently from each other selected from the group consisting of Me, $^{i}$Pr, $^{t}$Bu, CN, $CF_3$, F and Ph,

triazinyl, which is optionally substituted with one or more substituents independently from each other selected from the group consisting of Me, $^{i}$Pr, $^{t}$Bu, CN, $CF_3$, F and Ph,

and $N(Ph)_2$, which is optionally substituted with one or more substituents independently from each other selected from the group consisting of Me, $^{i}$Pr, $^{t}$Bu, F and Ph.

In one embodiment of the invention $R^{I}$, $R^{II}$, $R^{III}$, $R^{IV}$, $R^{V}$, $R^{VI}$, $R^{VII}$, $R^{VIII}$, $R^{IX}$, $R^{X}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen,

Me, $^{i}$Pr, $^{t}$Bu, CN, $CF_3$, F,

Ph, which is optionally substituted with one or more substituents independently from each other selected from the group consisting of Me, $^{i}$Pr, $^{t}$Bu, CN, $CF_3$, F and Ph,

pyridinyl, which is optionally substituted with one or more substituents independently from each other selected from the group consisting of Me, $^{i}$Pr, $^{t}$Bu, CN, $CF_3$, F and Ph,

carbazolyl, which is optionally substituted with one or more substituents independently from each other selected from the group consisting of Me, $^{i}$Pr, $^{t}$Bu, CN, $CF_3$, F and Ph,

triazinyl, which is optionally substituted with one or more substituents independently from each other selected from the group consisting of Me, $^{i}$Pr, $^{t}$Bu, CN, $CF_3$, F and Ph.

In one embodiment of the invention, $R^{I}$, $R^{II}$, $R^{III}$, $R^{IV}$, $R^{V}$, $R^{VI}$, $R^{VII}$, $R^{VIII}$, $R^{IX}$, $R^{X}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen, Me, $^{i}$Pr, $^{t}$Bu, CN, $CF_3$, F, and

Ph, which is optionally substituted with one or more substituents independently from each other selected from the group consisting of Me, $^{i}$Pr, $^{t}$Bu, CN, $CF_3$, F and Ph.

In one embodiment of the invention, $R^{I}$, $R^{II}$, $R^{III}$, $R^{IV}$, $R^{V}$, $R^{VI}$, $R^{VII}$, $R^{VIII}$, $R^{IX}$, $R^{X}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen, Me, $^{i}$Pr, $^{t}$Bu, F, and

Ph, which is optionally substituted with one or more substituents independently from each other selected from the group consisting of Me, $^{i}$Pr, $^{t}$Bu, CN, $CF_3$, F and Ph.

In one embodiment of the invention, $R^{I}$, $R^{II}$, $R^{III}$, $R^{IV}$, $R^{V}$, $R^{VI}$, $R^{VII}$, $R^{VIII}$, $R^{IX}$, $R^{X}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen, Me, $^{i}$Pr, $^{t}$Bu, F, and

Ph, which is optionally substituted with one or more substituents independently from each other selected from the group consisting of Me, $^{i}$Pr, $^{t}$Bu, and Ph.

In one embodiment of the invention, $R^{I}$, $R^{II}$, $R^{III}$, $R^{IV}$, $R^{V}$, $R^{VI}$, $R^{VII}$, $R^{VIII}$, $R^{IX}$, $R^{X}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen, Me, $^{i}$Pr, $^{t}$Bu, and
Ph, which is optionally substituted with one or more substituents independently from each other selected from the group consisting of Me, $^{i}$Pr, $^{t}$Bu, and Ph.

In a preferred embodiment of the invention, $R^{XIII}$ and $R^{XII}$ are hydrogen.
In a preferred embodiment of the invention, $R^{XV}$ and $R^{XIX}$ are hydrogen.
In a preferred embodiment of the invention, $R^{I}$ and $R^{X}$ are hydrogen.
In a certain embodiment of the invention, $R^{I}$, $R^{V}$, $R^{XV}$ and $R^{XIX}$ are hydrogen.
In a certain embodiment of the invention, $R^{I}$, $R^{V}$, $R^{VI}$ and $R^{X}$ are hydrogen.
In a certain embodiment of the invention, $R^{I}$, $R^{V}$, $R^{VI}$, $R^{X}$, $R^{XV}$ and $R^{XIX}$ are hydrogen.
In one embodiment of the invention, $R^{XI}$ is independently selected from the group consisting of:

hydrogen, Me, $^{i}$Pr, $^{t}$Bu, CN, $CF_3$,

Ph, which is optionally substituted with one or more substituents independently from each other selected from the group consisting of Me, $^{i}$Pr, $^{t}$Bu, CN, $CF_3$, F and Ph,

and $N(Ph)_2$, which is optionally substituted with one or more substituents independently from each other selected from the group consisting of Me, $^{i}$Pr, $^{t}$Bu, F and Ph.

In a preferred embodiment of the invention, $R^{XI}$ is independently selected from the group consisting of:

hydrogen, Me, $^{i}$Pr, $^{t}$Bu,

Ph, which is optionally substituted with one or more substituents independently from each other selected from the group consisting of Me, $^{i}$Pr, $^{t}$Bu, and Ph,

and $N(Ph)_2$, which is optionally substituted with one or more substituents independently from each other selected from the group consisting of Me, $^{i}$Pr, $^{t}$Bu, and Ph.

In a more preferred embodiment of the invention, $R^{XI}$ is independently selected from the group consisting of:

Me, $^{i}$Pr, $^{t}$Bu,

Ph, which is optionally substituted with one or more substituents independently from each other selected from the group consisting of Me, $^{i}$Pr, $^{t}$Bu, and Ph,

and $N(Ph)_2$, which is optionally substituted with one or more substituents independently from each other selected from the group consisting of Me, $^{i}$Pr, $^{t}$Bu, and Ph.

In one embodiment of the invention, $R^{XI}$ is independently selected from the group consisting of:

Ph, which is optionally substituted with one or more substituents independently from each other selected from the group consisting of Me, $^{i}$Pr, $^{t}$Bu, and Ph,

and $N(Ph)_2$, which is optionally substituted with one or more substituents independently from each other selected from the group consisting of Me, $^{i}$Pr, $^{t}$Bu, and Ph.

In a certain embodiment of the invention, $R^{XI}$ is $N(Ph)_2$, which is optionally substituted with one or more substituents independently from each other selected from the group consisting of Me, $^{i}Pr$, $^{t}Bu$, and Ph.

In one embodiment of the invention, $R^{XI}$ is $N(Ph)_2$.

In one embodiment of the invention, $R^Y$ is the binding site of a single bond linking the first chemical moiety to the second moiety.

In one embodiment of the invention, $R^a$ is at each occurrence independently selected from the group consisting of:

hydrogen,

Me, $^{i}Pr$, $^{t}Bu$, CN, $CF_3$, F,

aryl, which is optionally substituted with one or more substituents independently from each other selected from the group consisting of Me, $^{i}Pr$, $^{t}Bu$, CN, $CF_3$, F and Ph,

pyridinyl, which is optionally substituted with one or more substituents independently from each other selected from the group consisting of Me, $^{i}Pr$, $^{t}Bu$, CN, $CF_3$, F and Ph,

carbazolyl, which is optionally substituted with one or more substituents independently from each other selected from the group consisting of Me, $^{i}Pr$, $^{t}Bu$, CN, $CF_3$, F and Ph,

triazinyl, which is optionally substituted with one or more substituents independently from each other selected from the group consisting of Me, $^{i}Pr$, $^{t}Bu$, CN, $CF_3$, F and Ph,

and $N(Ph)_2$, which is optionally substituted with one or more substituents independently from each other selected from the group consisting of Me, $^{i}Pr$, $^{t}Bu$, F and Ph.

In a further embodiment of the invention, $R^a$ is at each occurrence independently selected from the group consisting of:

hydrogen,

Me, $^{i}Pr$, $^{t}Bu$, F,

Ph, which is optionally substituted with one or more substituents independently from each other selected from the group consisting of Me, $^{i}Pr$, $^{t}Bu$, CN, $CF_3$, F and Ph,

carbazolyl, which is optionally substituted with one or more substituents independently from each other selected from the group consisting of Me, $^{i}Pr$, $^{t}Bu$, CN, $CF_3$, F and Ph,

and $N(Ph)_2$, which is optionally substituted with one or more substituents independently from each other selected from the group consisting of Me, $^{i}Pr$, $^{t}Bu$, F and Ph.

In a further embodiment of the invention, $R^a$ is at each occurrence independently selected from the group consisting of:

hydrogen,

Me, $^{i}Pr$, $^{t}Bu$, F

Ph, which is optionally substituted with one or more substituents independently from each other selected from the group consisting of Me, $^{i}Pr$, $^{t}Bu$, F and Ph,

carbazolyl, which is optionally substituted with one or more substituents independently from each other selected from the group consisting of Me, $^{i}Pr$, $^{t}Bu$, F and Ph,

and $N(Ph)_2$, which is optionally substituted with one or more substituents independently from each other selected from the group consisting of Me, $^{i}Pr$, $^{t}Bu$, F and Ph.

In a further embodiment of the invention, $R^a$ is at each occurrence independently selected from the group consisting of:

hydrogen,

Me, $^i$Pr, $^t$Bu,

Ph, which is optionally substituted with one or more substituents independently from each other selected from the group consisting of Me, $^i$Pr, $^t$Bu, and Ph,

carbazolyl, which is optionally substituted with one or more substituents independently from each other selected from the group consisting of Me, $^i$Pr, $^t$Bu, and Ph,

and $N(Ph)_2$, which is optionally substituted with one or more substituents independently from each other selected from the group consisting of Me, $^i$Pr, $^t$Bu, and Ph.

In a further embodiment of the invention, $R^a$ is at each occurrence independently selected from the group consisting of:

hydrogen,

Me, $^i$Pr, $^t$Bu,

Ph, which is optionally substituted with one or more substituents independently from each other selected from the group consisting of Me, $^i$Pr, $^t$Bu, and Ph,

and $N(Ph)_2$, which is optionally substituted with one or more substituents independently from each other selected from the group consisting of Me, $^i$Pr, $^t$Bu, and Ph.

In a further embodiment of the invention, $R^a$ is at each occurrence independently selected from the group consisting of:

hydrogen,

Me, $^i$Pr, $^t$Bu,
and

Ph, which is optionally substituted with one or more substituents independently from each other selected from the group consisting of Me, $^i$Pr, $^t$Bu, and Ph.

In one embodiment of the invention, $R^a$ is at each occurrence independently selected from the group consisting of:
hydrogen, and Ph.

In one embodiment of the invention, $R^a$ is at each occurrence hydrogen.

In a preferred embodiment of the invention, $R^V = R^X$ and $R^I = R^{VI}$.

In one embodiment of the invention, $R^5$ is at each occurrence independently selected from the group consisting of:

hydrogen,

Me, $^i$Pr, $^t$Bu,

Ph, which is optionally substituted with one or more substituents independently from each other selected from the group consisting of Me, $^i$Pr, $^t$Bu, and Ph.

In one embodiment of the invention, $R^5$ is at each occurrence independently selected from the group consisting of:
hydrogen, and Ph.

In one embodiment of the invention, $R^5$ is at each occurrence hydrogen.

In one embodiment of the invention, the organic molecules comprise or consist of a structure of formula II-a, and formula II-b:

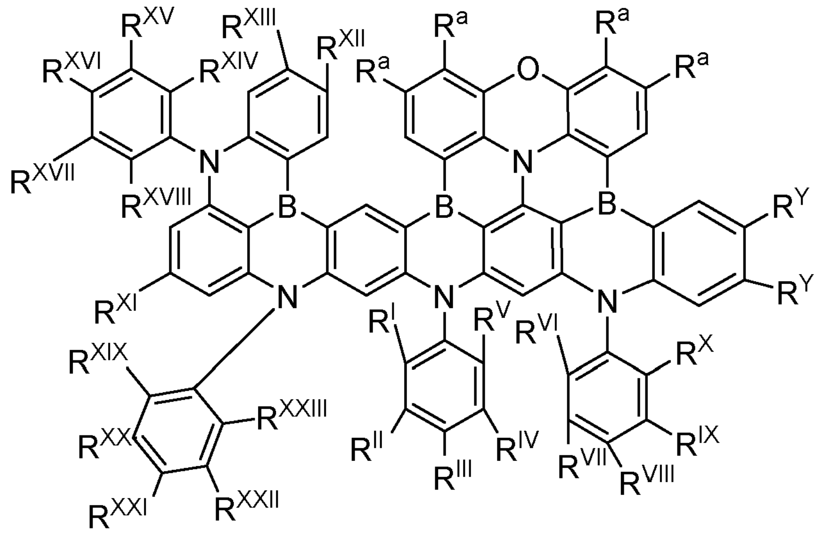

Formula II-a

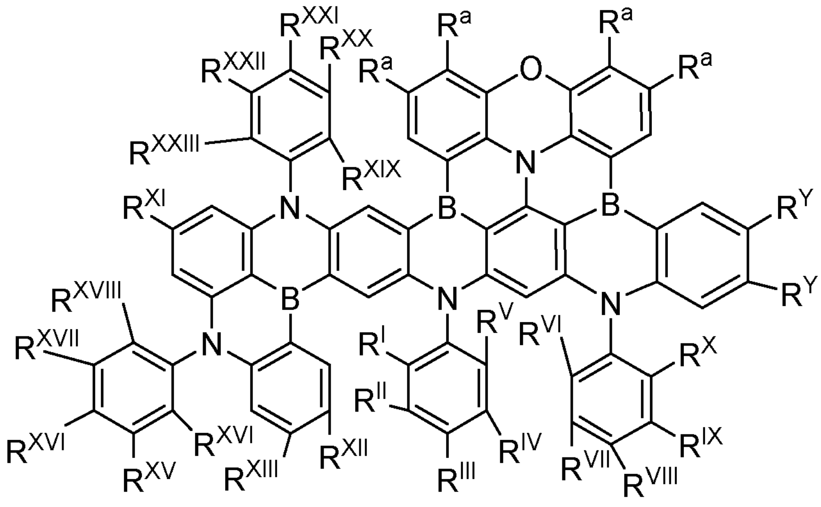

Formula II-b.

In one embodiment of the invention, the organic molecules comprise or consists of a structure according to any of formulas II-a, II-b, wherein $R^I$, $R^{II}$, $R^{III}$, $R^{IV}$, $R^V$, $R^{VI}$, $R^{VII}$, $R^{VIII}$, $R^{IX}$, $R^X$, $R^{XI}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen,

Me, $^i$Pr, $^t$Bu, CN, $CF_3$, F,

Ph, which is optionally substituted with one or more substituents independently from each other selected from the group consisting of Me, $^i$Pr, $^t$Bu, CN, $CF_3$, F and Ph,

pyridinyl, which is optionally substituted with one or more substituents independently from each other selected from the group consisting of Me, $^i$Pr, $^t$Bu, CN, $CF_3$, F and Ph,

carbazolyl, which is optionally substituted with one or more substituents independently from each other selected from the group consisting of Me, $^{i}$Pr, $^{t}$Bu, CN, $CF_3$, F and Ph,

triazinyl, which is optionally substituted with one or more substituents independently from each other selected from the group consisting of Me, $^{i}$Pr, $^{t}$Bu, CN, $CF_3$, F and Ph,

and $N(Ph)_2$, which is optionally substituted with one or more substituents independently from each other selected from the group consisting of Me, $^{i}$Pr, $^{t}$Bu, F and Ph.

In one embodiment of the invention, the organic molecules comprise or consists of a structure according to any of formulas II-a, II-b, wherein $R^{I}$, $R^{II}$, $R^{III}$, $R^{IV}$, $R^{V}$, $R^{VI}$, $R^{VII}$, $R^{VIII}$, $R^{IX}$, $R^{X}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen,

Me, $^{i}$Pr, $^{t}$Bu, CN, $CF_3$, F,

Ph, which is optionally substituted with one or more substituents independently from each other selected from the group consisting of Me, $^{i}$Pr, $^{t}$Bu, CN, $CF_3$, F and Ph,

pyridinyl, which is optionally substituted with one or more substituents independently from each other selected from the group consisting of Me, $^{i}$Pr, $^{t}$Bu, CN, $CF_3$, F and Ph,

carbazolyl, which is optionally substituted with one or more substituents independently from each other selected from the group consisting of Me, $^{i}$Pr, $^{t}$Bu, CN, $CF_3$, F and Ph,

triazinyl, which is optionally substituted with one or more substituents independently from each other selected from the group consisting of Me, $^{i}$Pr, $^{t}$Bu, CN, $CF_3$, F and Ph.

In one embodiment of the invention, the organic molecules comprise or consists of a structure according to any of formulas II-a, II-b, wherein $R^{I}$, $R^{II}$, $R^{III}$, $R^{IV}$, $R^{V}$, $R^{VI}$, $R^{VII}$, $R^{VIII}$, $R^{IX}$, $R^{X}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen, Me, $^{i}$Pr, $^{t}$Bu, CN, $CF_3$, F, and

Ph, which is optionally substituted with one or more substituents independently from each other selected from the group consisting of Me, $^{i}$Pr, $^{t}$Bu, CN, $CF_3$, F and Ph.

In one embodiment of the invention, the organic molecules comprise or consists of a structure according to any of formulas II-a, II-b, wherein $R^{I}$, $R^{II}$, $R^{III}$, $R^{IV}$, $R^{V}$, $R^{VI}$, $R^{VII}$, $R^{VIII}$, $R^{IX}$, $R^{X}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen, Me, $^{i}$Pr, $^{t}$Bu, F, and

Ph, which is optionally substituted with one or more substituents independently from each other selected from the group consisting of Me, $^{i}$Pr, $^{t}$Bu, CN, $CF_3$, F and Ph.

In one embodiment of the invention, the organic molecules comprise or consists of a structure according to any of formulas II-a, II-b, wherein $R^{I}$, $R^{II}$, $R^{III}$, $R^{IV}$, $R^{V}$, $R^{VI}$, $R^{VII}$, $R^{VIII}$, $R^{IX}$, $R^{X}$, $R^{XII}$, $R^{XIII}$, $R^{XIV}$, $R^{XV}$, $R^{XVI}$, $R^{XVII}$, $R^{XVII}$, $R^{XIX}$, $R^{XX}$, $R^{XXI}$, $R^{XXII}$, and $R^{XXIII}$ are at each occurrence independently selected from the group consisting of:

hydrogen, Me, $^{i}$Pr, $^{t}$Bu, F, and

Ph, which is optionally substituted with one or more substituents independently from each other selected from the group consisting of Me, $^{i}$Pr, $^{t}$Bu, and Ph.

In one embodiment of the invention, the organic molecules comprise or consists of a structure according to any of formulas II-a, II-b, wherein $R^{I}$, $R^{II}$, $R^{III}$, $R^{IV}$, $R^{V}$, $R^{VI}$, $R^{VII}$, $R^{VIII}$, $R^{IX}$, $R^{X}$, $R^{XII}$, $R^{XIII}$, $R^{XIV}$, $R^{XV}$, $R^{XVI}$, $R^{XVII}$, $R^{XVIII}$,

$R^{XIX}$, $R^{XX}$, $R^{XXI}$, $R^{XXII}$, and $R^{XXIII}$ are at each occurrence independently selected from the group consisting of:

hydrogen, Me, $^{i}$Pr, $^{t}$Bu, and

Ph, which is optionally substituted with one or more substituents independently from each other selected from the group consisting of Me, $^{i}$Pr, $^{t}$Bu, and Ph.

In a preferred embodiment of the invention, the organic molecules comprise or consists of a structure according to any of formulas II-a, II-b, wherein $R^{I}$ and $R^{X}$ are hydrogen.

In a certain embodiment of the invention, the organic molecules comprise or consists of a structure according to any of formulas II-a, II-b, wherein $R^{I}$, $R^{V}$, $R^{VI}$ and $R^{X}$ are hydrogen.

In a preferred embodiment of the invention, the organic molecules comprise or consists of a structure according to any of formulas II-a, II-b, wherein $R^{XIII}$ and $R^{XII}$ are hydrogen.

In a preferred embodiment of the invention, the organic molecules comprise or consists of a structure according to any of formulas II-a, II-b, wherein $R^{XV}$ and $R^{XIX}$ are hydrogen.

In a preferred embodiment of the invention, the organic molecules comprise or consists of a structure according to any of formulas II-a, II-b, wherein $R^{I}$ and $R^{X}$ are hydrogen.

In a preferred embodiment of the invention, the organic molecules comprise or consists of a structure according to any of formulas II-a, II-b, wherein $R^{I}$, $R^{V}$, $R^{XV}$ and $R^{XIX}$ are hydrogen.

In a preferred embodiment of the invention, the organic molecules comprise or consists of a structure according to any of formulas II-a, II-b, wherein $R^{I}$, $R^{V}$, $R^{VI}$ and $R^{X}$ are hydrogen.

In a preferred embodiment of the invention, the organic molecules comprise or consists of a structure according to any of formulas II-a, II-b, wherein $R^{I}$, $R^{V}$, $R^{VI}$, $R^{X}$, $R^{XV}$ and $R^{XIX}$ are hydrogen.

In one embodiment of the invention, the organic molecules comprise or consists of a structure according to any of formulas II-a, II-b, wherein $R^{XI}$ is at each occurrence independently selected from the group consisting of:

hydrogen, Me, $^{i}$Pr, $^{t}$Bu, CN, $CF_3$,

Ph, which is optionally substituted with one or more substituents independently from each other selected from the group consisting of Me, $^{i}$Pr, $^{t}$Bu, CN, $CF_3$, F and Ph,

and $N(Ph)_2$, which is optionally substituted with one or more substituents independently from each other selected from the group consisting of Me, $^{i}$Pr, $^{t}$Bu, F and Ph.

In a preferred embodiment of the invention, the organic molecules comprise or consists of a structure according to any of formulas II-a, II-b, wherein $R^{XI}$ is at each occurrence independently selected from the group consisting of:

hydrogen, Me, $^{i}$Pr, $^{t}$Bu,

Ph, which is optionally substituted with one or more substituents independently from each other selected from the group consisting of Me, $^{i}$Pr, $^{t}$Bu, and Ph,

and $N(Ph)_2$, which is optionally substituted with one or more substituents independently from each other selected from the group consisting of Me, $^{i}$Pr, $^{t}$Bu, and Ph.

In another preferred embodiment of the invention, the organic molecules comprise or consists of a structure according to any of formulas wherein II-a, II-b, wherein $R^{XI}$ is at each occurrence independently selected from the group consisting of:

Me, $^{i}$Pr, $^{t}$Bu,

Ph, which is optionally substituted with one or more substituents independently from each other selected from the group consisting of Me, $^{i}$Pr, $^{t}$Bu, and Ph,

and $N(Ph)_2$, which is optionally substituted with one or more substituents independently from each other selected from the group consisting of Me, $^{i}$Pr, $^{t}$Bu, and Ph.

In one embodiment of the invention, the organic molecules comprise or consists of a structure according to

any of formulas II-a, II-b, wherein $R^{XI}$ is at each occurrence independently selected from the group consisting of:

Ph, which is optionally substituted with one or more substituents independently from each other selected from the group consisting of Me, $^{i}Pr$, $^{t}Bu$, and Ph,

and $N(Ph)_2$, which is optionally substituted with one or more substituents independently from each other selected from the group consisting of Me, $^{i}Pr$, $^{t}Bu$, and Ph.

In a certain embodiment of the invention, the organic molecules comprise or consists of a structure according to any of formulas II-a, II-b, wherein $R^{XI}$ is at each occurrence independently $N(Ph)_2$, which is optionally substituted with one or more substituents independently from each other selected from the group consisting of Me, $^{i}Pr$, $^{t}Bu$, and Ph.

In one embodiment of the invention, the organic molecules comprise or consists of a structure according to any of formulas II-a, II-b, wherein $R^{XI}$ is at each occurrence independently $N(Ph)_2$.

In one embodiment of the invention, the organic molecules comprise or consists of a structure according to any of formulas II-a, II-b, wherein $R^a$ is at each occurrence independently selected from the group consisting of:

hydrogen,

Me, $^{i}Pr$, $^{t}Bu$, CN, $CF_3$, F,

aryl, which is optionally substituted with one or more substituents independently from each other selected from the group consisting of Me, $^{i}Pr$, $^{t}Bu$, CN, $CF_3$, F and Ph,

pyridinyl, which is optionally substituted with one or more substituents independently from each other selected from the group consisting of Me, $^{i}Pr$, $^{t}Bu$, CN, $CF_3$, F and Ph,

carbazolyl, which is optionally substituted with one or more substituents independently from each other selected from the group consisting of Me, $^{i}Pr$, $^{t}Bu$, CN, $CF_3$, F and Ph,

triazinyl, which is optionally substituted with one or more substituents independently from each other selected from the group consisting of Me, $^{i}Pr$, $^{t}Bu$, CN, $CF_3$, F and Ph,

and $N(Ph)_2$, which is optionally substituted with one or more substituents independently from each other selected from the group consisting of Me, $^{i}Pr$, $^{t}Bu$, F and Ph.

In a further embodiment of the invention, the organic molecules comprise or consists of a structure according to any of formulas II-a, II-b, wherein $R^a$ is at each occurrence independently selected from the group consisting of:

hydrogen, Me, $^{i}Pr$, $^{t}Bu$, F,

Ph, which is optionally substituted with one or more substituents independently from each other selected from the group consisting of Me, $^{i}Pr$, $^{t}Bu$, CN, $CF_3$, F and Ph,

carbazolyl, which is optionally substituted with one or more substituents independently from each other selected from the group consisting of Me, $^{i}Pr$, $^{t}Bu$, CN, $CF_3$, F and Ph,

and $N(Ph)_2$, which is optionally substituted with one or more substituents independently from each other selected from the group consisting of Me, $^{i}Pr$, $^{t}Bu$, F and Ph.

In a further embodiment of the invention, the organic molecules comprise or consists of a structure according to any of formulas II-a, II-b, wherein $R^a$ is at each occurrence independently selected from the group consisting of:

hydrogen, Me, $^{i}Pr$, $^{t}Bu$, F

Ph, which is optionally substituted with one or more substituents independently from each other selected from the group consisting of Me, $^{i}Pr$, $^{t}Bu$, F and Ph,

carbazolyl, which is optionally substituted with one or more substituents independently from each other selected from the group consisting of Me, $^{i}Pr$, $^{t}Bu$, F and Ph,

and $N(Ph)_2$, which is optionally substituted with one or more substituents independently from each other selected from the group consisting of Me, $^{i}Pr$, $^{t}Bu$, F and Ph.

In a further embodiment of the invention, the organic molecules comprise or consists of a structure according to any of formulas II-a, II-b, wherein $R^a$ is at each occurrence independently selected from the group consisting of:

hydrogen, Me, $^{i}Pr$, $^{t}Bu$,

Ph, which is optionally substituted with one or more substituents independently from each other selected from the group consisting of Me, $^{i}Pr$, $^{t}Bu$, and Ph,

carbazolyl, which is optionally substituted with one or more substituents independently from each other selected from the group consisting of Me, $^{i}Pr$, $^{t}Bu$, and Ph,

and $N(Ph)_2$, which is optionally substituted with one or more substituents independently from each other selected from the group consisting of Me, $^{i}Pr$, $^{t}Bu$, and Ph.

In a further embodiment of the invention, the organic molecules comprise or consists of a structure according to any of formulas II-a, II-b, wherein $R^a$ is at each occurrence independently selected from the group consisting of:

hydrogen, Me, $^{i}Pr$, $^{t}Bu$,

Ph, which is optionally substituted with one or more substituents independently from each other selected from the group consisting of Me, $^{i}Pr$, $^{t}Bu$, and Ph,

and $N(Ph)_2$, which is optionally substituted with one or more substituents independently from each other selected from the group consisting of Me, $^{i}Pr$, $^{t}Bu$, and Ph.

In a further embodiment of the invention, the organic molecules comprise or consists of a structure according to any of formulas II-a, II-b, wherein $R^a$ is at each occurrence independently selected from the group consisting of:

hydrogen, Me, $^{i}Pr$, $^{t}Bu$, and

Ph, which is optionally substituted with one or more substituents independently from each other selected from the group consisting of Me, $^{i}Pr$, $^{t}Bu$, and Ph.

In a preferred embodiment of the invention, the organic molecules comprise or consists of a structure according to any of formulas II-a, II-b, wherein $R^V = R^X$ and $R^I = R^{VI}$.

In a preferred embodiment of the invention, the organic molecules comprise or consist of a structure of formula IIa:

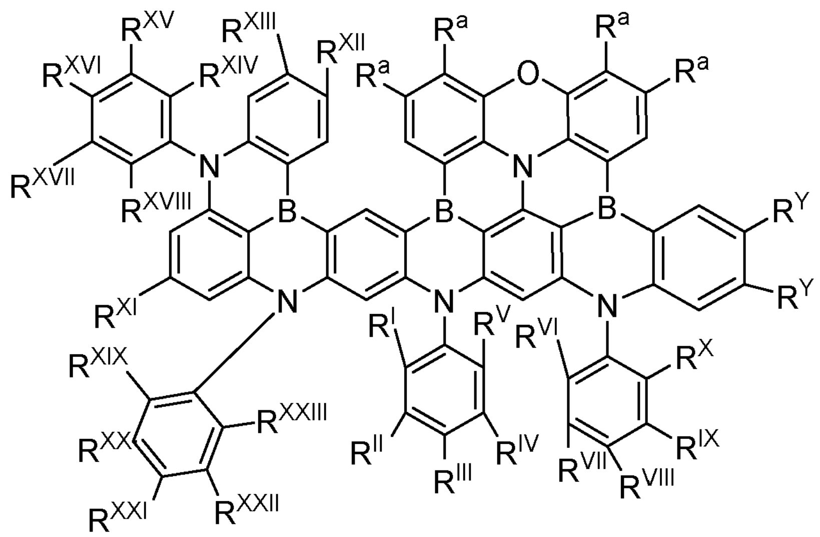

Formula II-a,

In a more preferred embodiment of the invention, the organic molecules comprise or consists of a structure of formula II-a, wherein $R^{XI}$ is at each occurrence independently selected from the group consisting of:

Me, $^{i}$Pr, $^{t}$Bu,

Ph, which is optionally substituted with one or more substituents independently from each other selected from the group consisting of Me, $^{i}$Pr, $^{t}$Bu, and Ph,

and $N(Ph)_2$, which is optionally substituted with one or more substituents independently from each other selected from the group consisting of Me, $^{i}$Pr, $^{t}$Bu, F, and Ph.

In one embodiment of the invention, the organic molecules comprise or consists of a structure of formula II-a, wherein $R^{XI}$ is at each occurrence independently selected from the group consisting of:

Ph, which is optionally substituted with one or more substituents independently from each other selected from the group consisting of Me, $^{i}$Pr, $^{t}$Bu, and Ph,

and $N(Ph)_2$, which is optionally substituted with one or more substituents independently from each other selected from the group consisting of Me, $^{i}$Pr, $^{t}$Bu, and Ph.

In a certain embodiment of the invention, the organic molecules comprise or consists of a structure of formula II-a, wherein $R^{XI}$ is at each occurrence independently
$N(Ph)_2$, which is optionally substituted with one or more substituents independently from each other selected from the group consisting of Me, $^{i}$Pr, $^{t}$Bu, and Ph.
In one embodiment of the invention, the organic molecules comprise or consists of a structure of formula II-a, wherein $R^{XI}$ is at each occurrence independently $N(Ph)_2$.
In another embodiment of the invention, the organic molecules comprise or consist of a structure of formula III-a and III-b:

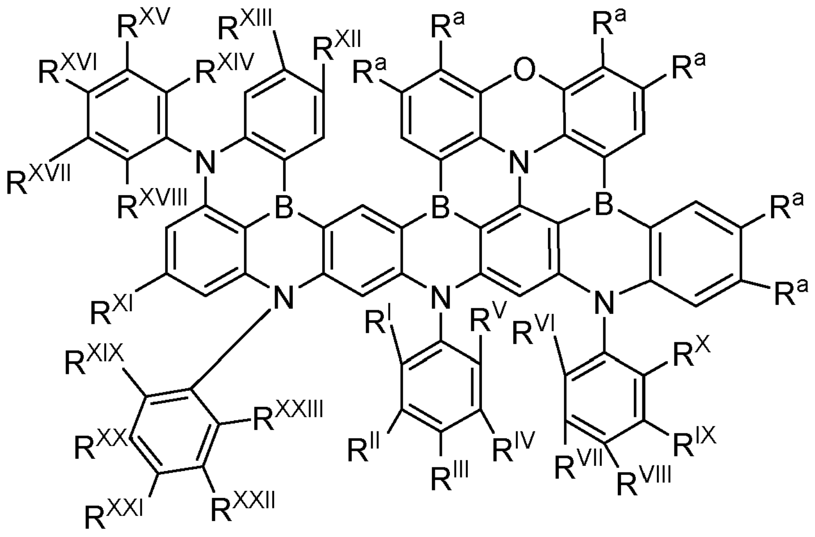

Formula III-a

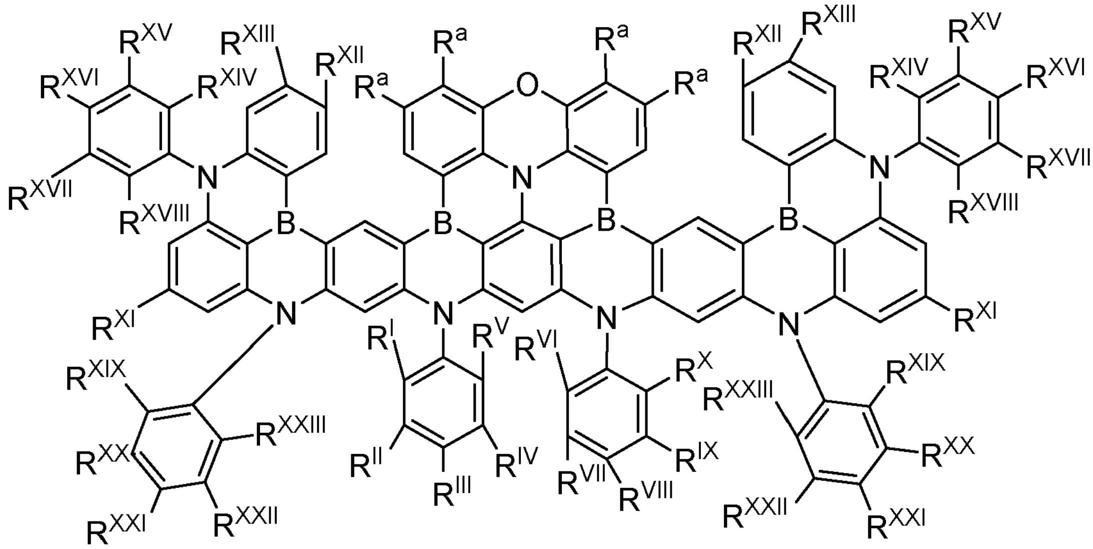

Formula III-b

In one embodiment of the invention, the organic molecules comprise or consists of a structure according to any of formulas III-a, and III-b, wherein $R^I$, $R^{II}$, $R^{III}$, $R^{IV}$, $R^V$, $R^{VI}$, $R^{VII}$, $R^{VIII}$, $R^{IX}$, $R^X$, $R^{XI}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen,

Me, $^i$Pr, $^t$Bu, CN, $CF_3$, F,

Ph, which is optionally substituted with one or more substituents independently from each other selected from the group consisting of Me, $^i$Pr, $^t$Bu, CN, $CF_3$, F and Ph,

pyridinyl, which is optionally substituted with one or more substituents independently from each other selected from the group consisting of Me, $^i$Pr, $^t$Bu, CN, $CF_3$, F and Ph,

carbazolyl, which is optionally substituted with one or more substituents independently from each other selected from the group consisting of Me, $^i$Pr, $^t$Bu, CN, $CF_3$, F and Ph,

triazinyl, which is optionally substituted with one or more substituents independently from each other selected from the group consisting of Me, $^i$Pr, $^t$Bu, CN, $CF_3$, F and Ph,

and $N(Ph)_2$, which is optionally substituted with one or more substituents independently from each other selected from the group consisting of Me, $^i$Pr, $^t$Bu, F and Ph.

In one embodiment of the invention, the organic molecules comprise or consists of a structure according to any of formulas III-a, and III-b, wherein $R^I$, $R^{II}$, $R^{III}$, $R^{IV}$, $R^V$, $R^{VI}$, $R^{VII}$, $R^{VIII}$, $R^{IX}$, $R^X$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen,

Me, $^i$Pr, $^t$Bu, CN, $CF_3$, F,

Ph, which is optionally substituted with one or more substituents independently from each other selected from the group consisting of Me, $^i$Pr, $^t$Bu, CN, $CF_3$, F and Ph,

pyridinyl, which is optionally substituted with one or more substituents independently from each other selected from the group consisting of Me, $^i$Pr, $^t$Bu, CN, $CF_3$, F and Ph,

carbazolyl, which is optionally substituted with one or more substituents independently from each other selected from the group consisting of Me, $^i$Pr, $^t$Bu, CN, $CF_3$, F and Ph,

triazinyl, which is optionally substituted with one or more substituents independently from each other selected from the group consisting of Me, $^i$Pr, $^t$Bu, CN, $CF_3$, F and Ph.

In one embodiment of the invention, the organic molecules comprise or consists of a structure according to any of formulas III-a, and III-b, wherein R’, R", $R^{III}$, $R^{IV}$, $R^V$, $R^{VI}$, $R^{VII}$, $R^{VIII}$, $R^{IX}$, $R^X$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen,

Me, $^i$Pr, $^t$Bu, CN, $CF_3$, F,

Ph, which is optionally substituted with one or more substituents independently from each other selected from the group consisting of Me, $^i$Pr, $^t$Bu, CN, $CF_3$, F and Ph.

In one embodiment of the invention, the organic molecules comprise or consists of a structure according to any of formulas III-a, and III-b, wherein $R^I$, R", $R^{III}$, $R^{IV}$, $R^V$, $R^{VI}$, $R^{VII}$, $R^{VIII}$, $R^{IX}$, $R^X$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen,

Me, $^i$Pr, $^t$Bu, F,

Ph, which is optionally substituted with one or more substituents independently from each other selected from the group consisting of Me, $^i$Pr, $^t$Bu, CN, $CF_3$, F and Ph.

In one embodiment of the invention, the organic molecules comprise or consists of a structure according to any of formulas III-a, and III-b, wherein $R^I$, R", $R^{III}$, $R^{IV}$, $R^V$, $R^{VI}$, $R^{VII}$, $R^{VIII}$, $R^{IX}$, $R^X$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen,

Me, $^i$Pr, $^t$Bu, F,

Ph, which is optionally substituted with one or more substituents independently from each other selected from the group consisting of Me, $^i$Pr, $^t$Bu, and Ph.

In one embodiment of the invention, the organic molecules comprise or consists of a structure according to any of formulas III-a, and III-b, wherein $R^{I}$, R", $R^{III}$, $R^{IV}$, $R^{V}$, $R^{VI}$, $R^{VII}$, $R^{VIII}$, $R^{IX}$, $R^{X}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen,

Me, $^{i}Pr$, $^{t}Bu$,

Ph, which is optionally substituted with one or more substituents independently from each other selected from the group consisting of Me, $^{i}Pr$, $^{t}Bu$, and Ph.

In a preferred embodiment of the invention, the organic molecules comprise or consists of a structure according to any of formulas III-a, and III-b, wherein $R^{I}$ and $R^{X}$ are hydrogen.

In a certain embodiment of the invention, the organic molecules comprise or consists of a structure according to any of formulas III-a, and III-b, wherein $R^{I}$, $R^{V}$, $R^{VI}$ and $R^{X}$ are hydrogen.

In a preferred embodiment of the invention, the organic molecules comprise or consists of a structure according to any of formulas III-a, and III-b, wherein $R^{XIII}$ and $R^{XII}$ are hydrogen.

In a preferred embodiment of the invention, the organic molecules comprise or consists of a structure according to any of formulas III-a, and III-b, wherein $R^{XV}$ and $R^{XIX}$ are hydrogen.

In a preferred embodiment of the invention, the organic molecules comprise or consists of a structure according to any of formulas III-a, and III-b, wherein $R^{I}$ and $R^{X}$ are hydrogen.

In a preferred embodiment of the invention, the organic molecules comprise or consists of a structure according to any of formulas III-a, and III-b, wherein $R^{I}$, $R^{V}$, $R^{XV}$ and $R^{XIX}$ are hydrogen.

In a preferred embodiment of the invention, the organic molecules comprise or consists of a structure according to any of formulas III-a, and III-b, wherein $R^{I}$, $R^{V}$, $R^{VI}$ and $R^{X}$ are hydrogen.

In a preferred embodiment of the invention, the organic molecules comprise or consists of a structure according to any of formulas III-a, and III-b, wherein $R^{I}$, $R^{V}$, $R^{VI}$, $R^{X}$, $R^{XV}$ and $R^{XIX}$ are hydrogen.

In one embodiment of the invention, the organic molecules comprise or consists of a structure according to any of formulas III-a, and III-b, wherein $R^{XI}$ is at each occurrence independently selected from the group consisting of:

hydrogen, Me, $^{i}Pr$, $^{t}Bu$, CN, $CF_3$,

Ph, which is optionally substituted with one or more substituents independently from each other selected from the group consisting of Me, $^{i}Pr$, $^{t}Bu$, CN, $CF_3$, F and Ph,

and $N(Ph)_2$, which is optionally substituted with one or more substituents independently from each other selected from the group consisting of Me, $^{i}Pr$, $^{t}Bu$, F and Ph.

In a preferred embodiment of the invention, the organic molecules comprise or consists of a structure according to any of formulas III-a, and III-b, wherein $R^{XI}$ is at each occurrence independently selected from the group consisting of:

hydrogen, Me, $^{i}Pr$, $^{t}Bu$,

Ph, which is optionally substituted with one or more substituents independently from each other selected from the group consisting of Me, $^{i}Pr$, $^{t}Bu$, and Ph,

and $N(Ph)_2$, which is optionally substituted with one or more substituents independently from each other selected from the group consisting of Me, $^{i}Pr$, $^{t}Bu$, and Ph.

In a more preferred embodiment of the invention, the organic molecules comprise or consists of a structure according to any of formulas wherein III-a, and III-b, wherein $R^{XI}$ is at each occurrence independently selected from the group consisting of:

Me, $^{i}Pr$, $^{t}Bu$,

Ph, which is optionally substituted with one or more substituents independently from each other selected from the group consisting of Me, $^{i}Pr$, $^{t}Bu$, and Ph,

and $N(Ph)_2$, which is optionally substituted with one or more substituents independently from each other selected from the group consisting of Me, $^{i}Pr$, $^{t}Bu$, and Ph.

In one embodiment of the invention, the organic molecules comprise or consists of a structure according to any of formulas III-a, and III-b, wherein $R^{XI}$ is at each occurrence independently selected from the group consisting of:

Ph, which is optionally substituted with one or more substituents independently from each other selected from the group consisting of Me, $^{i}Pr$, $^{t}Bu$, and Ph,

and $N(Ph)_2$, which is optionally substituted with one or more substituents independently from each other selected from the group consisting of Me, $^{i}Pr$, $^{t}Bu$, and Ph.

In a certain embodiment of the invention, the organic molecules comprise or consists of a structure according to any of formulas III-a, and III-b, wherein $R^{XI}$ is at each occurrence independently
$N(Ph)_2$, which is optionally substituted with one or more substituents independently from each other selected from the group consisting of Me, $^{i}Pr$, $^{t}Bu$, and Ph.
In one embodiment of the invention, the organic molecules comprise or consists of a structure according to any of formulas III-a, and III-b, wherein $R^{XI}$ is at each occurrence independently $N(Ph)_2$.
In one embodiment of the invention, the organic molecules comprise or consists of a structure according to any of formulas III-a, and III-b, wherein $R^a$ is at each occurrence independently selected from the group consisting of:

hydrogen, Me, $^{i}Pr$, $^{t}Bu$, CN, $CF_3$, F,

aryl, which is optionally substituted with one or more substituents independently from each other selected from the group consisting of Me, $^{i}Pr$, $^{t}Bu$, CN, $CF_3$, F and Ph,

pyridinyl, which is optionally substituted with one or more substituents independently from each other selected from the group consisting of Me, $^{i}Pr$, $^{t}Bu$, CN, $CF_3$, F and Ph,

carbazolyl, which is optionally substituted with one or more substituents independently from each other selected from the group consisting of Me, $^{i}Pr$, $^{t}Bu$, CN, $CF_3$, F and Ph,

triazinyl, which is optionally substituted with one or more substituents independently from each other selected from the group consisting of Me, $^{i}Pr$, $^{t}Bu$, CN, $CF_3$, F and Ph,

and $N(Ph)_2$, which is optionally substituted with one or more substituents independently from each other selected from the group consisting of Me, $^{i}Pr$, $^{t}Bu$, F and Ph.

In a further embodiment of the invention, the organic molecules comprise or consists of a structure according to any of formulas III-a, and III-b, wherein $R^a$ is at each occurrence independently selected from the group consisting of:

hydrogen, Me, $^{i}Pr$, $^{t}Bu$, F,

Ph, which is optionally substituted with one or more substituents independently from each other selected from the group consisting of Me, $^{i}Pr$, $^{t}Bu$, CN, $CF_3$, F and Ph,

carbazolyl, which is optionally substituted with one or more substituents independently from each other selected from the group consisting of Me, $^{i}Pr$, $^{t}Bu$, CN, $CF_3$, F and Ph,

and $N(Ph)_2$, which is optionally substituted with one or more substituents independently from each other selected from the group consisting of Me, $^{i}Pr$, $^{t}Bu$, F and Ph.

In a further embodiment of the invention, the organic molecules comprise or consists of a structure according to any of formulas III-a, and III-b, wherein $R^a$ is at each occurrence independently selected from the group consisting of:

hydrogen, Me, $^{i}Pr$, $^{t}Bu$, F

Ph, which is optionally substituted with one or more substituents independently from each other selected from the

group consisting of Me, $^{i}$Pr, $^{t}$Bu, F and Ph,

carbazolyl, which is optionally substituted with one or more substituents independently from each other selected from the group consisting of Me, $^{i}$Pr, $^{t}$Bu, F and Ph,

and $N(Ph)_2$, which is optionally substituted with one or more substituents independently from each other selected from the group consisting of Me, $^{i}$Pr, $^{t}$Bu, F and Ph.

In a further embodiment of the invention, the organic molecules comprise or consists of a structure according to any of formulas III-a, and III-b, wherein $R^a$ is at each occurrence independently selected from the group consisting of:

hydrogen, Me, $^{i}$Pr, $^{t}$Bu,

Ph, which is optionally substituted with one or more substituents independently from each other selected from the group consisting of Me, $^{i}$Pr, $^{t}$Bu, and Ph,

carbazolyl, which is optionally substituted with one or more substituents independently from each other selected from the group consisting of Me, $^{i}$Pr, $^{t}$Bu, and Ph,

and $N(Ph)_2$, which is optionally substituted with one or more substituents independently from each other selected from the group consisting of Me, $^{i}$Pr, $^{t}$Bu, and Ph.

In a further embodiment of the invention, the organic molecules comprise or consists of a structure according to any of formulas III-a, and III-b, wherein $R^a$ is at each occurrence independently selected from the group consisting of:

hydrogen, Me, $^{i}$Pr, $^{t}$Bu,

Ph, which is optionally substituted with one or more substituents independently from each other selected from the group consisting of Me, $^{i}$Pr, $^{t}$Bu, and Ph, and $N(Ph)_2$, which is optionally substituted with one or more substituents independently from each other selected from the group consisting of Me, $^{i}$Pr, $^{t}$Bu, and Ph.

In a further embodiment of the invention, the organic molecules comprise or consists of a structure according to any of formulas III-a, and III-b, wherein $R^a$ is at each occurrence independently selected from the group consisting of:

hydrogen, Me, $^{i}$Pr, $^{t}$Bu,
and

Ph, which is optionally substituted with one or more substituents independently from each other selected from the group consisting of Me, $^{i}$Pr, $^{t}$Bu, and Ph.

In a preferred embodiment of the invention, the organic molecules comprise or consists of a structure according to any of formulas III-a, and III-b, wherein $R^V = R^X$ and $R^I = R^{VI}$.

In another embodiment of the invention, the organic molecules comprise or consist of a structure of formula III-b:

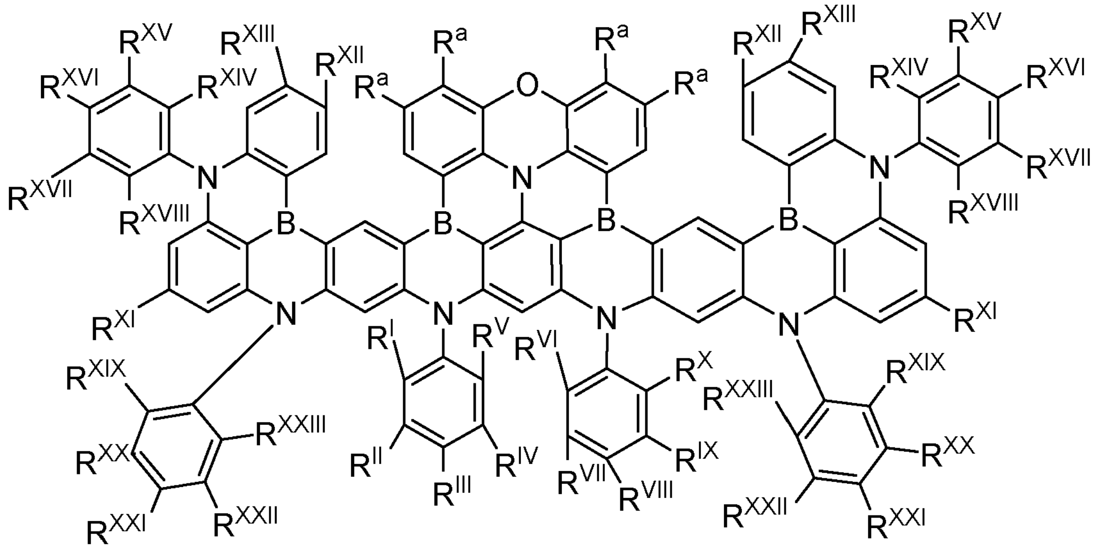

Formula III-b.

In a preferred embodiment of the invention, the second chemical moiety consists of a structure of formula II-0a, formula !!-0b or formula II-0c:

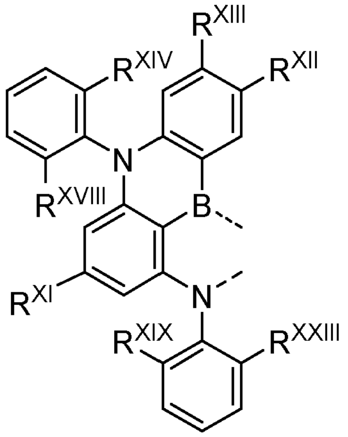

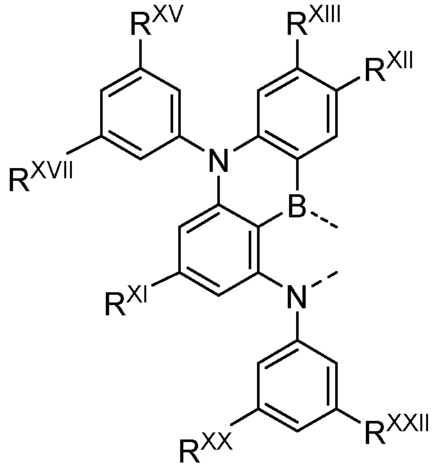

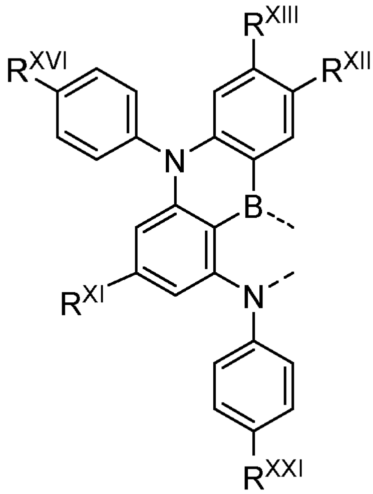

Formula II-0a Formula II-0b Formula II-0c.

In a more preferred embodiment of the invention, the organic molecules comprise or consists of a structure of formula II-0a, formula II-0b and formula II-0c, wherein $R^{XI}$ is at each occurrence independently selected from the group consisting of:

Me, $^{i}$Pr, $^{t}$Bu,

Ph, which is optionally substituted with one or more substituents independently from each other selected from the group consisting of Me, $^{i}$Pr, $^{t}$Bu, and Ph,

and $N(Ph)_2$, which is optionally substituted with one or more substituents independently from each other selected from the group consisting of Me, $^{i}$Pr, $^{t}$Bu, F, and Ph.

In one embodiment of the invention, the organic molecules comprise or consists of a structure of formula II-0a, formula II-0b and formula II-0c, wherein $R^{XI}$ is at each occurrence independently selected from the group consisting of:

Ph, which is optionally substituted with one or more substituents independently from each other selected from the group consisting of Me, $^{i}$Pr, $^{t}$Bu, and Ph,

and $N(Ph)_2$, which is optionally substituted with one or more substituents independently from each other selected from the group consisting of Me, $^{i}$Pr, $^{t}$Bu, and Ph.

In a certain embodiment of the invention, the organic molecules comprise or consists of a structure of formula II-0a, formula II-0b and formula II-0c, wherein $R^{XI}$ is at each occurrence independently
$N(Ph)_2$, which is optionally substituted with one or more substituents independently from each other selected from the group consisting of Me, $^{i}$Pr, $^{t}$Bu, and Ph.

In one embodiment of the invention, the organic molecules comprise or consists of a structure of formula II-0a, formula II-0b and formula II-0c, wherein $R^{XI}$ is $N(Ph)_2$.

In one embodiment of the invention, the organic molecules comprise or consists of a structure of formula II-0a, formula II-0b and formula II-0c, wherein $R^{XIII}$ is at each occurrence hydrogen.

In one embodiment of the invention, the organic molecules comprise or consists of a structure of formula II-0a, formula II-0b and formula II-0c, wherein $R^{XII}$ is at each occurrence hydrogen.

In one embodiment of the invention, the organic molecules comprise or consists of a structure of formula II-0a, formula II-0b and formula II-0c, wherein $R^{XIII}$ and $R^{XII}$ are at each occurrence hydrogen.

In a preferred embodiment of the invention, the second chemical moiety consists of a structure of formula II-I:

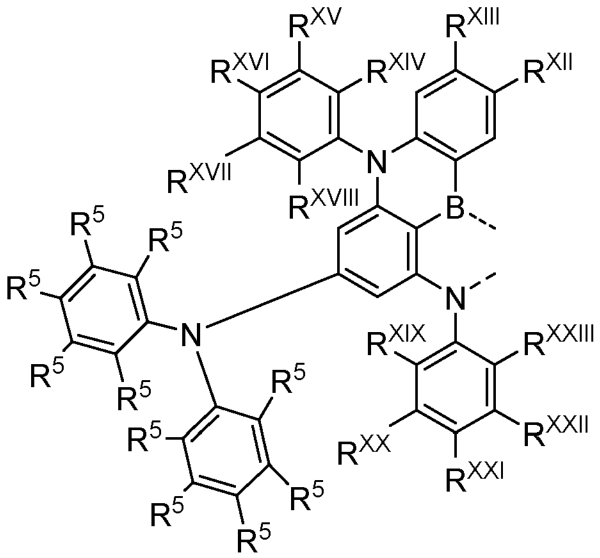

Formula II-I.

In a preferred embodiment of the invention, the second chemical moiety consists of a structure of formula II-II:

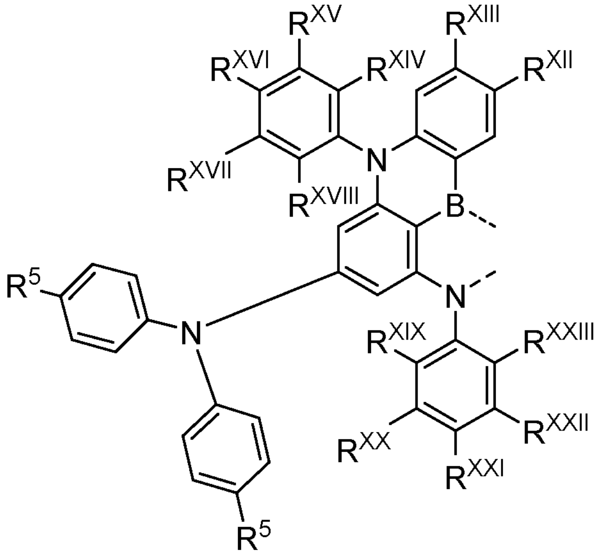

Formula II-II.

As used throughout the present application, the term "cyclic group" may be understood in the broadest sense as any mono-, bi- or polycyclic moieties.

As used throughout the present application, the terms "ring" and "ring system" may be understood in the broadest sense as any mono-, bi- or polycyclic moieties.

As used throughout the present application, the term "carbocycle" may be understood in the broadest sense as any cyclic group in which the cyclic core structure comprises only carbon atoms that may of course be substituted with hydrogen or any other substituents defined in the specific embodiments of the invention. It is understood that the term "carbocyclic" as adjective refers to cyclic groups in which the cyclic core structure comprises only carbon atoms that may of course be substituted with hydrogen or any other substituents defined in the specific embodiments of the invention.

As used throughout the present application, the term "heterocycle" may be understood in the broadest sense as any cyclic group in which the cyclic core structure comprises not just carbon atoms, but also at least one heteroatom. It is understood that the term "heterocyclic" as adjective refers to cyclic groups in which the cyclic core structure comprises not just carbon atoms, but also at least one heteroatom. The heteroatoms may, unless stated otherwise in specific embodiments, at each occurrence be the same or different and be individually selected from the group consisting of N, O, S, and Se. All carbon atoms or heteroatoms comprised in a heterocycle in the context of the invention may of course be substituted with hydrogen or any other substituents defined in the specific embodiments of the invention.

As used throughout the present application, the term "aromatic ring system" may be understood in the broadest sense as any bi- or polycyclic aromatic moiety.

As used throughout the present application, the term "heteroaromatic ring system" may be understood in the broadest sense as any bi- or polycyclic heteroaromatic moiety.

As used throughout the present application, the term "fused" when referring to aromatic or heteroaromatic ring systems means that the aromatic or hetroaromatic rings that are "fused" share at least one bond that is part of both ring systems. For example naphthalene (or naphthyl when referred to as substituent) or benzothiophene (or benzothiphenyl when referred to as substituent) are considered fused aromatic ring systems in the context of the present invention, in which two benzene rings (for naphthalene) or a thiophene and a benzene (for benzothiophene) share one bond. It is also understood that sharing a bond in this context includes sharing the two atoms that build up the respective bond and that fused aromatic or heteroaromatic ring systems can be understood as one aromatic or heteroaromatic system. Additionally, it is understood, that more than one bond may be shared by the aromatic or heteroaromatic rings building up a fused aromatic or heteroaromatic ring system (e.g. in pyrene). Furthermore, it will be understood that aliphatic ring systems may also be fused and that this has the same meaning as for aromatic or heteroaromatic ring systems, with the exception of course, that fused aliphatic ring systems are not aromatic.

As used throughout the present application, the terms "aryl" and "aromatic" may be understood in the broadest sense as any mono-, bi- or polycyclic aromatic moieties. Accordingly, an aryl group contains 6 to 60 aromatic ring atoms, and a heteroaryl group contains 5 to 60 aromatic ring atoms, of which at least one is a heteroatom. Notwithstanding, throughout the application the number of aromatic ring atoms may be given as subscripted number in the definition of certain substituents. In particular, the heteroaromatic ring includes one to three heteroatoms. Again, the terms "heteroaryl"

and "heteroaromatic" may be understood in the broadest sense as any mono-, bi- or polycyclic hetero-aromatic moieties that include at least one heteroatom. The heteroatoms may, unless stated otherwise in specific embodiments, at each occurrence be the same or different and be individually selected from the group consisting of N, O, S, and Se. Accordingly, the term "arylene" refers to a divalent substituent that bears two binding sites to other molecular structures and thereby serving as a linker structure. In case, a group in the exemplary embodiments is defined differently from the definitions given here, for example, the number of aromatic ring atoms or number of heteroatoms differs from the given definition, the definition in the exemplary embodiments is to be applied. According to the invention, a condensed (annulated) aromatic or heteroaromatic polycycle is built of two or more single aromatic or heteroaromatic cycles, which formed the polycycle via a condensation reaction.

In particular, as used throughout the present application the term "aryl group" or "heteroaryl group" comprises groups which can be bound via any position of the aromatic or heteroaromatic group, derived from benzene, naphthaline, anthracene, phenanthrene, pyrene, dihydropyrene, chrysene, perylene, fluoranthene, benzanthracene, benzphenanthrene, tetracene, pentacene, benzpyrene, furan, benzofuran, isobenzofuran, dibenzofuran, thiophene, benzothiophene, isobenzothiophene, dibenzothiophene, selenophene, benzoselenophene, isobenzoselenophene, dibenzoselenophene; pyrrole, indole, isoindole, carbazole, indolocarbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthoimidazole, phenanthroimidazole, pyridoimidazole, pyrazinoimidazole, quinoxalinoimidazole, oxazole, benzoxazole, napthooxazole, anthroxazol, phenanthroxazol, isoxazole, 1,2-thiazole, 1,3-thiazole, benzothiazole, pyridazine, benzopyridazine, pyrimidine, benzopyrimidine, 1,3,5-triazine, quinoxaline, pyrazine, phenazine, naphthyridine, carboline, benzocarboline, phenanthroline, 1,2,3-triazole, 1,2,4-triazole, benzotriazole, 1,2,3-oxadiazole, 1,2,4-oxadiazole, 1,2,5-oxadiazole, 1,2,3,4-tetrazine, purine, pteridine, indolizine and benzothiadiazole or combinations of the abovementioned groups.

As used throughout the present application, the term "aliphatic" when referring to ring systems may be understood in the broadest sense and means that none of the rings that build up the ring system is an aromatic or heteroaromatic ring. It is understood that such an aliphatic ring system may be fused to one or more aromatic rings so that some (but not all) carbon- or heteroatoms comprised in the core structure of the aliphatic ring system are part of an attached aromatic ring.

As used above and herein, the term "alkyl group" may be understood in the broadest sense as any linear, branched, or cyclic alkyl substituent. In particular, the term alkyl comprises the substituents methyl (Me), ethyl (Et), n-propyl ($^nPr$), i-propyl ($^iPr$), cyclopropyl, n-butyl ($^nBu$), i-butyl ('Bu), s-butyl ($^sBu$), t-butyl ($^tBu$), cyclobutyl, 2-methylbutyl, n-pentyl, s-pentyl, t-pentyl, 2-pentyl, neo-pentyl, cyclopentyl, n-hexyl, s-hexyl, t-hexyl, 2-hexyl, 3-hexyl, neo-hexyl, cyclohexyl, 1-methylcyclopentyl, 2-methylpentyl, n-heptyl, 2-heptyl, 3-heptyl, 4-heptyl, cycloheptyl, 1-methylcyclohexyl, n-octyl, 2-ethylhexyl, cyclooctyl, 1-bicyclo[2,2,2]octyl, 2-bicyclo[2,2,2]-octyl, 2-(2,6-dimethyl)octyl, 3-(3,7-dimethyl)octyl, adamantyl, 2,2,2-trifluorethyl, 1,1-dimethyl-n-hex-1-yl, 1,1-dimethyl-n-hept-1-yl, 1,1-dimethyl-n-oct-1-yl, 1,1-dimethyl-n-dec-1-yl, 1,1-dimethyl-n-dodec-1-yl, 1,1-dimethyl-n-tetradec-1-yl, 1,1-dimethyl-n-hexadec-1-yl, 1,1-dimethyl-n-octadec-1-yl, 1,1-diethyl-n-hex-1-yl, 1,1-diethyl-n-hept-1-yl, 1,1-diethyl-n-oct-1-yl, 1,1-diethyl-n-dec-1-yl, 1,1-diethyl-n-dodec-1-yl, 1,1-diethyl-n-tetradec-1-yl, 1,1-diethyln-n-hexadec-1-yl, 1,1-diethyl-n-octadec-1-yl, 1-(n-propyl)-cyclohex-1-yl, 1-(n-butyl)-cyclohex-1-yl, 1-(n-hexyl)-cyclohex-1-yl, 1-(n-octyl)-cyclohex-1-yl and 1-(n-decyl)-cyclohex-1-yl.

As used above and herein, the term "alkenyl" comprises linear, branched, and cyclic alkenyl substituents. The term alkenyl group exemplarily comprises the substituents ethenyl, propenyl, butenyl, pentenyl, cyclopentenyl, hexenyl, cyclohexenyl, heptenyl, cycloheptenyl, octenyl, cyclooctenyl or cyclooctadienyl.

As used above and herein, the term "alkynyl" comprises linear, branched, and cyclic alkynyl substituents. The term alkynyl group exemplarily comprises ethynyl, propynyl, butynyl, pentynyl, hexynyl, heptynyl or octynyl.

As used above and herein, the term "alkoxy" comprises linear, branched, and cyclic alkoxy substituents. The term alkoxy group exemplarily comprises methoxy, ethoxy, n-propoxy, i-propoxy, n-butoxy, i-butoxy, s-butoxy, t-butoxy and 2-methylbutoxy.

As used above and herein, the term "thioalkoxy" comprises linear, branched, and cyclic thioalkoxy substituents, in which the O of the exemplarily alkoxy groups is replaced by S.

As used above and herein, the terms "halogen" and "halo" may be understood in the broadest sense as being preferably fluorine, chlorine, bromine or iodine.

It is understood that when a molecular fragment is described as being a substituent or otherwise attached to another moiety, its name may be written as if it were a fragment (e.g. naphthyl, dibenzofuryl) or as if it were the whole molecule (e.g. naphthalene, dibenzofuran). As used herein, these different ways of designating a substituent or attached fragment are considered to be equivalent.

All hydrogen atoms (H) comprised in any structure referred to herein may at each occurrence independently of each other, and without this being indicated specifically, be replaced by deuterium (D). The replacement of hydrogen by deuterium is common practice and obvious for the person skilled in the art. Thus, there are numerous known methods by which this can be achieved and several review articles describing them (see for example: A. Michelotti, M. Roche,

Synthesis 2019, 51(06), 1319-1328, DOI: 10.1055/s-0037-1610405; J. Atzrodt, V. Derdau, T. Fey, J. Zimmermann, Angew. Chem. Int. Ed. 2007, 46(15), 7744-7765, DOI: 10.1002/anie.200700039; Y. Sawama, Y. Monguchi, H. Sajiki, Synlett 2012, 23(7), 959-972, DOI: 10.1055/s-0031-1289696.).

The excited state lifetime consists of multiple components. For example, in case for TADF emitters it consists of prompt fluorescence which usually lies in the order of magnitude of nanoseconds and delayed fluorescence which usually lies in the order of magnitude of microseconds. Since the delayed fluorescence is three orders of magnitude larger, the prompt fluorescence is insignificant which implies that the excited state lifetime can be estimated by the lifetime of the delayed fluorescence.

In one embodiment, the organic molecules according to the invention have an excited state lifetime of not more than 10 μs, of not more than 8 μs, in particular of not more than 6 μs, more preferably of not more than 5 μs or not more than 4 μs, even more preferably of not more than 3 μs or not more than 2 μs in a film of poly(methyl methacrylate) (PMMA) with 1-5% by weight, in particular with 1% by weight organic molecule at room temperature (i.e. approximately 25 °C).

In one embodiment of the invention, the organic molecules according to the invention represent thermally-activated delayed fluorescence (TADF) emitters, which exhibit a $\Delta E_{ST}$ value, which corresponds to the energy difference between the first excited singlet state (S1) and the first excited triplet state (T1), of less than 5000 $cm^{-1}$, preferably less than 3000 $cm^{1}$, more preferably less than 1500 cm 1, even more preferably less than 1000 $cm^{1}$ or even less than 500 $cm^{1}$.

In a further embodiment, the organic molecules according to the invention have an excited state lifetime of not more than 10 μs, of not more than 8 μs, in particular of not more than 6 μs, more preferably of not more than 5 μs or not more than 4 μs, even more preferably of not more than 3 μs or not more than 2 μs, with a full width at half maximum of less than 0.23 eV, preferably less than 0.20 eV, more preferably less than 0.19 eV, even more preferably less than 0.15 eV or even less than 0.12 eV in a film of poly(methyl methacrylate) (PMMA) with 1-5% by weight, in particular with 1% by weight of organic molecule at room temperature (i.e. approximately 25 °C).

In one embodiment, the organic molecules according to the invention have an excited state lifetime of not more than 10 μs, of not more than 7 μs, in particular of not more than 5 μs, more preferably of not more than 2 μs or not more than 1 μs in a film of poly(methyl methacrylate) (PMMA) with 1 % by weight of organic molecule at room temperature.

If not stated otherwise, excited state lifetime in the context of the organic molecules according to the invention is equal to and/or is determined by the delayed fluorescence lifetime or delayed fluorescence decay time.

In a further embodiment of the invention, the organic molecules according to the invention have an emission peak in the visible or nearest ultraviolet range, i.e., in the range of a wavelength of from 380 nm to 800 nm, with a full width at half maximum of less than 0.23 eV, preferably less than 0.20 eV, more preferably less than 0.19 eV, even more preferably less than 0.15 eV or even less than 0.12 eV in a film of poly(methyl methacrylate) (PMMA) with 1 % by weight of organic molecule at room temperature.

Orbital and excited state energies can be determined either by means of experimental methods or by calculations employing quantum-chemical methods, in particular density functional theory calculations. The energy of the highest occupied molecular orbital $E^{HOMO}$ is determined by methods known to the person skilled in the art from cyclic voltammetry measurements with an accuracy of 0.1 eV. The energy of the lowest unoccupied molecular orbital $E^{LUMO}$ is determined as the onset of the absorption spectrum.

The onset of an absorption spectrum is determined by computing the intersection of the tangent to the absorption spectrum with the x-axis. The tangent to the absorption spectrum is set at the low-energy side of the absorption band and at the point at half maximum of the maximum intensity of the absorption spectrum.

Unless stated otherwise, the energy of the first excited triplet state T1 is determined from the onset the phosphorescence spectrum at 77K (steady-state spectrum; film of 2 % by weight of emitter in PMMA).

Unless stated otherwise, the energy of the first excited singlet state S1 is determined from the onset the fluorescence spectrum at room temperature (i.e. approx. 25 °C; steady-state spectrum; film of 2 % by weight of emitter in PMMA).

The onset of an emission spectrum is determined by computing the intersection of the tangent to the emission spectrum with the x-axis. The tangent to the emission spectrum is set at the high-energy side of the emission band and at the point at half maximum of the maximum intensity of the emission spectrum.

The $\Delta E_{ST}$ value, which corresponds to the energy difference between the first excited singlet state (S1) and the first excited triplet state (T1), is determined based on the first excited singlet state energy and the first excited triplet state energy, which were determined as stated above.

A further aspect of the invention relates to the use of an organic molecule according to the invention as a luminescent emitter or as an absorber, and/or as host material and/or as electron transport material, and/or as hole injection material, and/or as hole blocking material in an optoelectronic device.

The optoelectronic device may be understood in the broadest sense as any device based on organic materials that is suitable for emitting light in the visible or nearest ultraviolet (UV) range, i.e., in the wavelength range from 380 nm to 800 nm. More preferably, the optoelectronic device may be able to emit light in the visible range, i.e., of from 400

nm to 800 nm.

In the context of such use, the optoelectronic device is more particularly selected from the group consisting of:

- organic light-emitting diodes (OLEDs),
- light-emitting electrochemical cells,
- OLED sensors, in particular in gas and vapor sensors not hermetically shielded to the outside,
- organic diodes,
- organic solar cells,
- organic transistors,
- organic field-effect transistors,
- organic lasers, and
- down-conversion elements.

A light-emitting electrochemical cell comprises three layers, namely a cathode, an anode, and an active layer, which contains the organic molecule according to the invention.

In a preferred embodiment in the context of such use, the optoelectronic device is a device selected from the group consisting of an organic light emitting diode (OLED), a light emitting electrochemical cell (LEC), an organic laser, and a light-emitting transistor.

In one embodiment, the light-emitting layer of an organic light-emitting diode comprises the organic molecules according to the invention.

In one embodiment, the light-emitting layer of an organic light-emitting diode comprises not only the organic molecules according to the invention but also a host material whose triplet (T1) and singlet (S1) energy levels are energetically higher than the triplet (T1) and singlet (S1) energy levels of the organic molecule.

A further aspect of the invention relates to a composition comprising or consisting of:

(a) the organic molecule of the invention, in particular in the form of an emitter and/or a host, and
(b) one or more emitter and/or host materials, which differ from the organic molecule of the invention, and
(c) optionally, one or more dyes and/or one or more solvents.

In a further embodiment of the invention, the composition has a photoluminescence quantum yield (PLQY) of more than 5 %, preferably more than 10 %, preferably more than 20 %, more preferably more than 40 %, even more preferably more than 60 % or even more than 70 % at room temperature.

*Compositions with at least one further emitter*

One embodiment of the invention relates to a composition comprising or consisting of:

(i) 1-50 % by weight, preferably 5-40 % by weight, in particular 10-30 % by weight, of the organic molecule according to the invention;
(ii) 5-98 % by weight, preferably 30-93.9 % by weight, in particular 40-88% by weight, of one host compound H;
(iii) 1-30 % by weight, in particular 1-20 % by weight, preferably 1-5 % by weight, of at least one further emitter molecule F with a structure differing from the structure of the molecules according to the invention; and
(iv) optionally 0-94 % by weight, preferably 0.1-65 % by weight, in particular 1-50 % by weight, of at least one further host compound D with a structure differing from the structure of the molecules according to the invention; and
(v) optionally 0-94 % by weight, preferably 0-65 % by weight, in particular 0-50 % by weight, of a solvent.

The components or the compositions are chosen such that the sum of the weight of the components add up to 100 %.

In a further embodiment of the invention, the composition has an emission peak in the visible or nearest ultraviolet range, i.e., in the range of a wavelength of from 380 to 800 nm.

In one embodiment of the invention, the at least one further emitter molecule F is a purely organic emitter.

In one embodiment of the invention, the at least one further emitter molecule F is a purely organic TADF emitter. Purely organic TADF emitters are known from the state of the art, e.g. Wong and Zysman-Colman ("Purely Organic Thermally Activated Delayed Fluorescence Materials for Organic Light-Emitting Diodes", Adv. Mater. 2017, 29(22), 1605444-1605498, DOI: 10.1002/adma.201605444).

In one embodiment of the invention, the at least one further emitter molecule F is a fluorescence emitter, in particular a blue, a green, a yellow or a red fluorescence emitter.

In a further embodiment of the invention, the composition, containing the at least one further emitter molecule

F shows an emission peak in the visible or nearest ultraviolet range, i.e., in the range of a wavelength of from 380 to 800 nm, with a full width at half maximum of less than 0.30 eV, in particular less than 0.25 eV, preferably less than 0.22 eV, more preferably less than 0.19 eV or even less than 0.17 eV at room temperature, with a lower limit of 0.05 eV.

*Composition wherein the at least one further emitter molecule F is a green fluorescence emitter*

In a further embodiment of the invention, the at least one further emitter molecule F is a fluorescence emitter, in particular a green fluorescence emitter.

In one embodiment, the at least one further emitter molecule F is a fluorescence emitter selected from the following group:

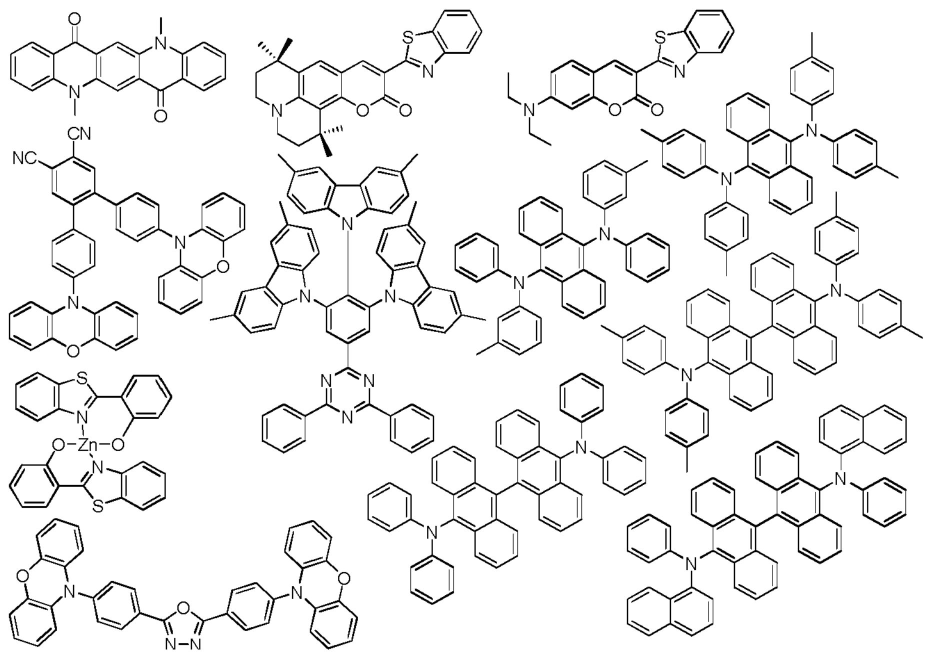

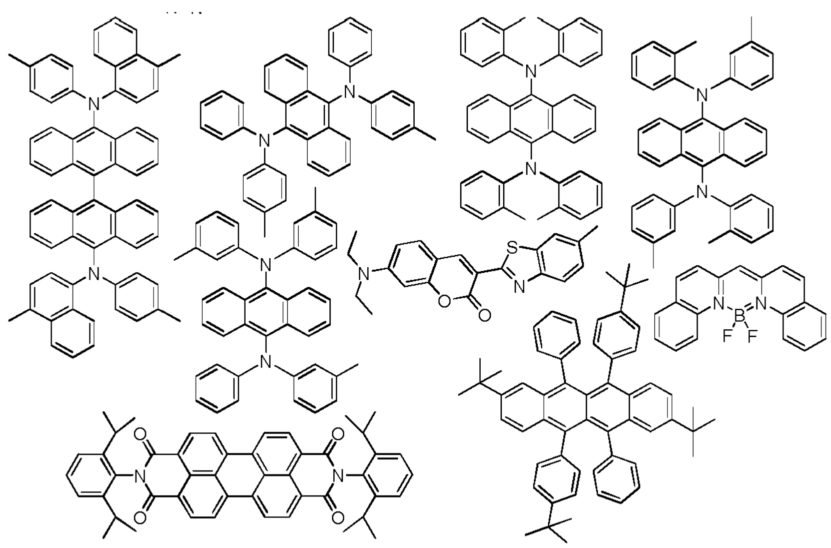

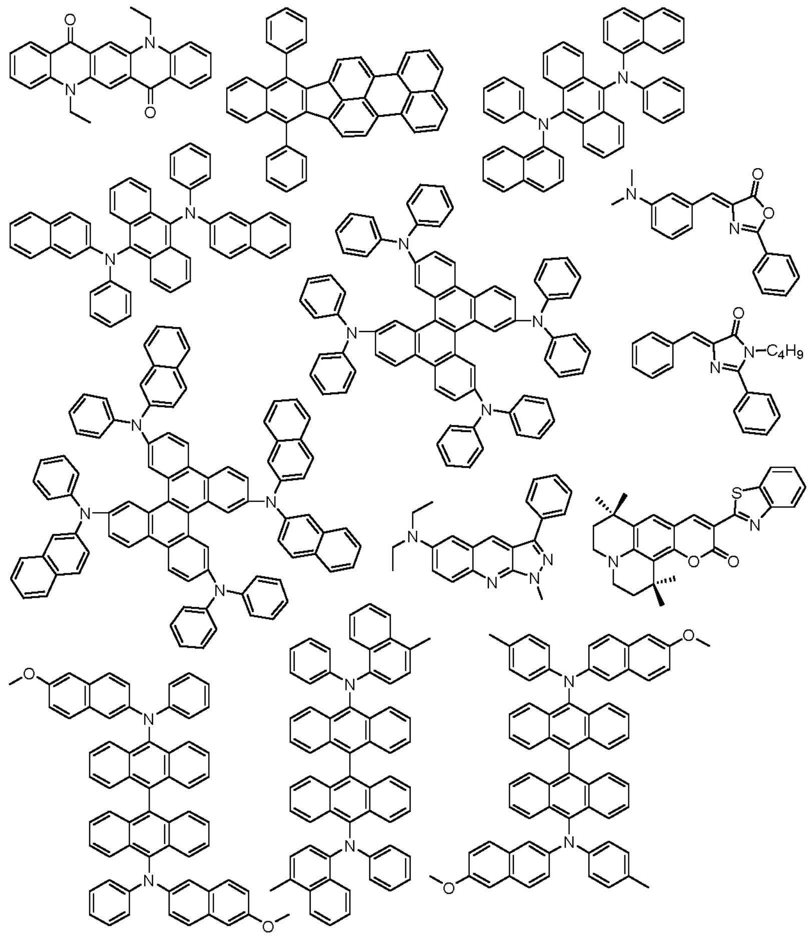

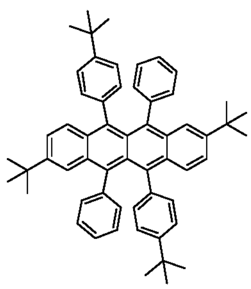

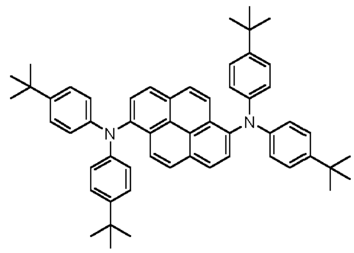

In a further embodiment of the invention, the composition has an emission peak in the visible or nearest ultraviolet range, i.e., in the range of a wavelength of from 380 to 800 nm, in particular between 485 nm and 590 nm, preferably between 505 nm and 565 nm, even more preferably between 515 nm and 545 nm.

*Composition wherein the at least one further emitter molecule F is a red fluorescence emitter*

In a further embodiment of the invention, the at least one further emitter molecule F is a fluorescence emitter, in particular a red fluorescence emitter.

In one embodiment, the at least one further emitter molecule F is a fluorescence emitter selected from the following group:

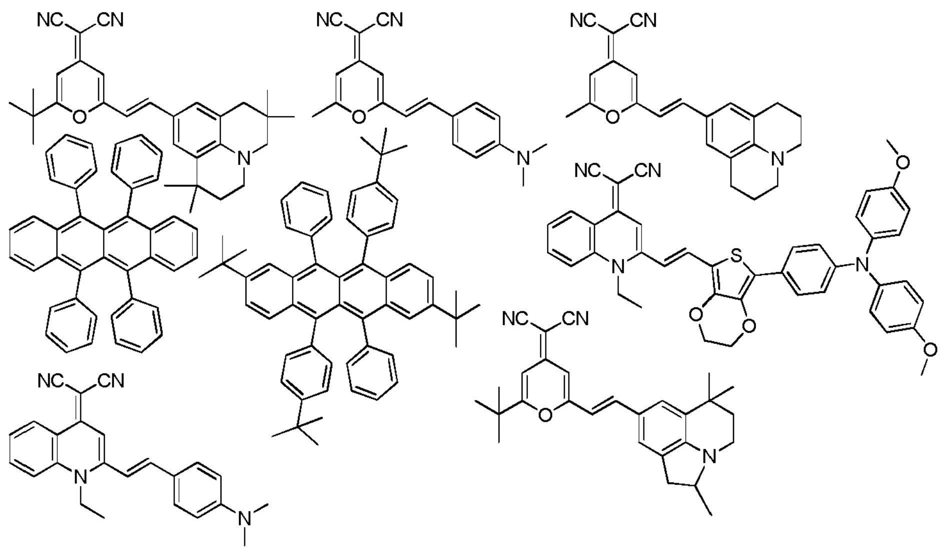

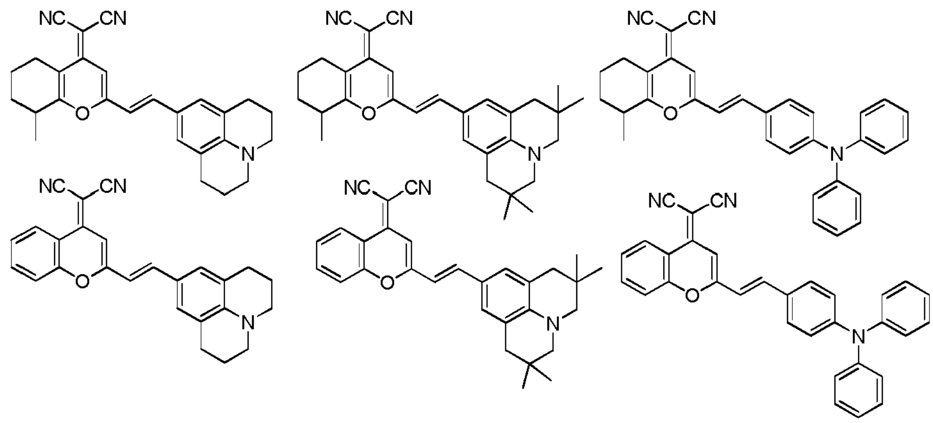

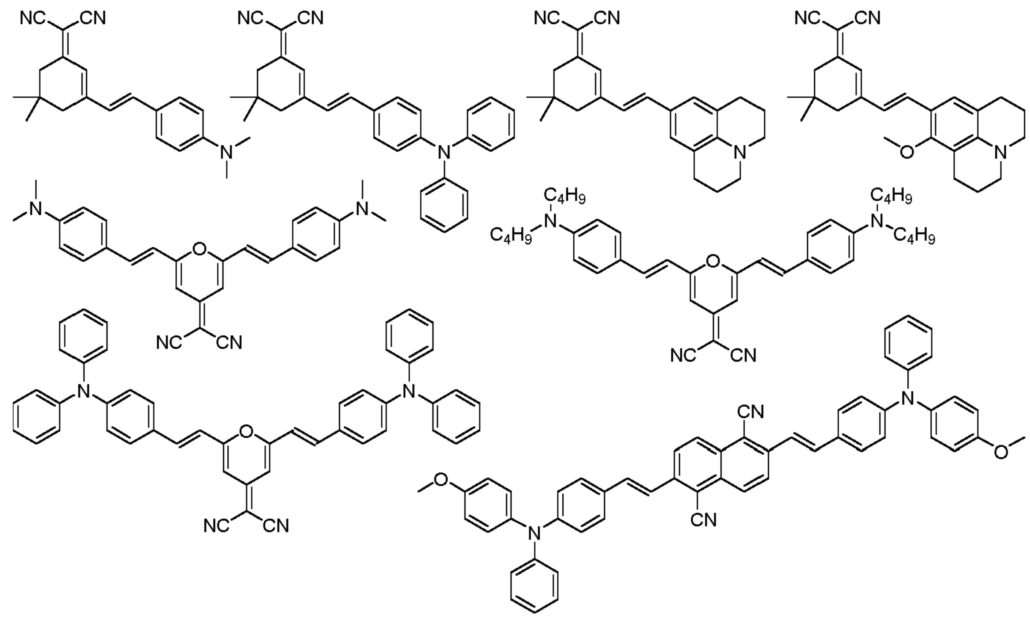

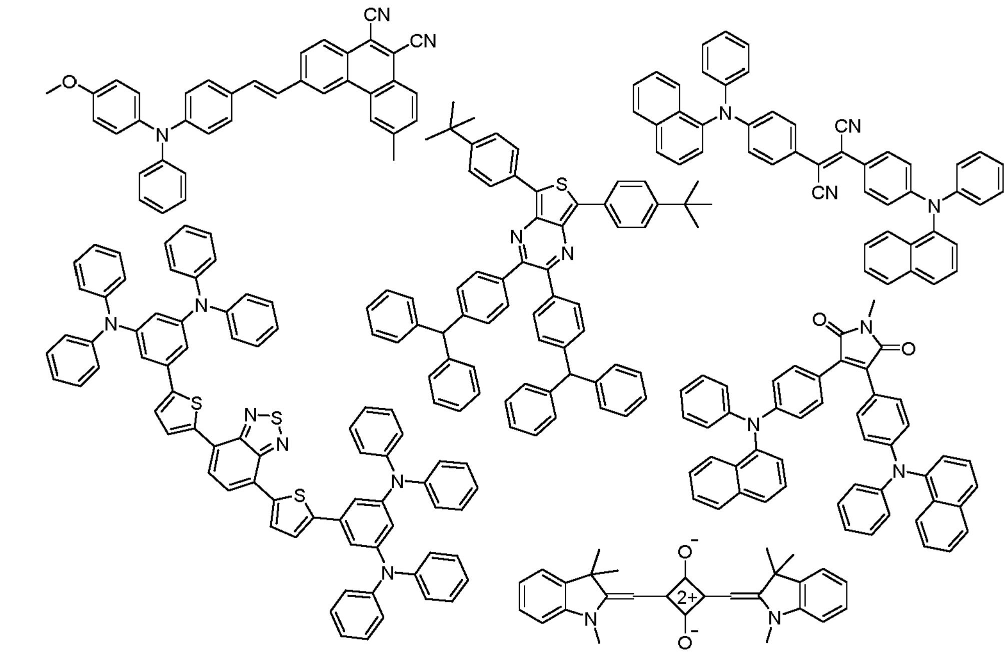

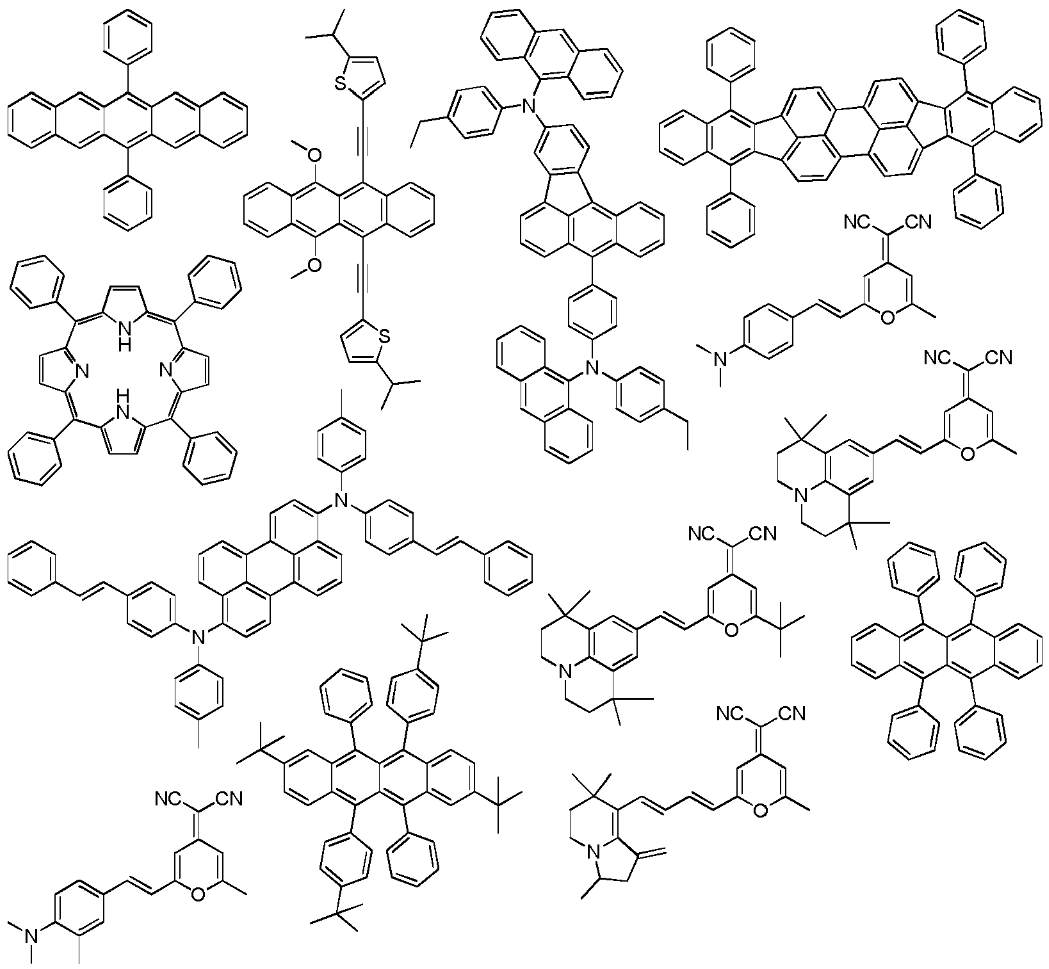

In a further embodiment of the invention, the composition has an emission peak in the visible or nearest ultraviolet range, i.e., in the range of a wavelength of from 380 to 800 nm, in particular between 590 nm and 690 nm, preferably between 610 nm and 665 nm, even more preferably between 620 nm and 640 nm.

*Light-emitting layer EML*

In one embodiment, the light-emitting layer EML of an organic light-emitting diode of the invention comprises (or essentially consists of) a composition comprising or consisting of:

(i) 1-50 % by weight, preferably 5-40 % by weight, in particular 10-30 % by weight, of one or more organic molecules according to the invention;
(ii) 5-99 % by weight, preferably 30-94.9 % by weight, in particular 40-89% by weight, of at least one host compound H; and
(iii) optionally 0-94 % by weight, preferably 0.1-65 % by weight, in particular 1-50 % by weight, of at least one further host compound D with a structure differing from the structure of the molecules according to the invention; and
(iv) optionally 0-94 % by weight, preferably 0-65 % by weight, in particular 0-50 % by weight, of a solvent; and
(v) optionally 0-30 % by weight, in particular 0-20 % by weight, preferably 0-5 % by weight, of at least one further emitter molecule F with a structure differing from the structure of the molecules according to the invention.

Preferably, energy can be transferred from the host compound H to the one or more organic molecules of the invention, in particular transferred from the first excited triplet state T1(H) of the host compound H to the first excited triplet state T1(E) of the one or more organic molecules according to the invention and/ or from the first excited singlet state S1(H) of the host compound H to the first excited singlet state S1(E) of the one or more organic molecules according to the invention.

In one embodiment, the host compound H has a highest occupied molecular orbital HOMO(H) having an energy $E^{HOMO}(H)$ in the range of from -5 eV to -6.5 eV and one organic molecule according to the invention E has a highest occupied molecular orbital HOMO(E) having an energy $E^{HOMO}(E)$, wherein $E^{HOMO}(H) > E^{HOMO}(E)$.

In a further embodiment, the host compound H has a lowest unoccupied molecular orbital LUMO(H) having an energy $E^{LUMO}(H)$ and the one organic molecule according to the invention E has a lowest unoccupied molecular orbital LUMO(E) having an energy $E^{LUMO}(E)$, wherein $E^{LUMO}(H) > E^{LUMO}(E)$.

*Light-emitting layer EML comprising at least one further host compound D*

In a further embodiment, the light-emitting layer EML of an organic light-emitting diode of the invention comprises (or essentially consists of) a composition comprising or consisting of:

(i) 1-50 % by weight, preferably 5-40 % by weight, in particular 10-30 % by weight, of one organic molecule according to the invention;
(ii) 5-99 % by weight, preferably 30-94.9 % by weight, in particular 40-89% by weight, of one host compound H; and
(iii) 0-94 % by weight, preferably 0.1-65 % by weight, in particular 1-50 % by weight, of at least one further host compound D with a structure differing from the structure of the molecules according to the invention; and
(iv) optionally 0-94 % by weight, preferably 0-65 % by weight, in particular 0-50 % by weight, of a solvent; and
(v) optionally 0-30 % by weight, in particular 0-20 % by weight, preferably 0-5 % by weight, of at least one further emitter molecule F with a structure differing from the structure of the molecules according to the invention.

In one embodiment of the organic light-emitting diode of the invention, the host compound H has a highest occupied molecular orbital HOMO(H) having an energy $E^{HOMO}(H)$ in the range of from -5 eV to -6.5 eV and the at least one further host compound D has a highest occupied molecular orbital HOMO(D) having an energy $E^{HOMO}(D)$, wherein $E^{HOMO}(H) > E^{HOMO}(D)$. The relation $E^{HOMO}(H) > E^{HOMO}(D)$ favors an efficient hole transport.

In a further embodiment, the host compound H has a lowest unoccupied molecular orbital LUMO(H) having an energy $E^{LUMO}(H)$ and the at least one further host compound D has a lowest unoccupied molecular orbital LUMO(D) having an energy $E^{LUMO}(D)$, wherein $E^{LUMO}(H) > E^{LUMO}(D)$. The relation $E^{LUMO}(H) > E^{LUMO}(D)$ favors an efficient electron transport.

In one embodiment of the organic light-emitting diode of the invention, the host compound H has a highest occupied molecular orbital HOMO(H) having an energy $E^{HOMO}(H)$ and a lowest unoccupied molecular orbital LUMO(H) having an energy $E^{LUMO}(H)$, and

the at least one further host compound D has a highest occupied molecular orbital HOMO(D) having an energy $E^{HOMO}(D)$ and a lowest unoccupied molecular orbital LUMO(D) having an energy $E^{LUMO}(D)$,
the organic molecule E of the invention has a highest occupied molecular orbital HOMO(E) having an energy $E^{HOMO}(E)$ and a lowest unoccupied molecular orbital LUMO(E) having an energy $E^{LUMO}(E)$,

wherein

$E^{HOMO}(H) > E^{HOMO}(D)$ and the difference between the energy level of the highest occupied molecular orbital HOMO(E) of organic molecule according to the invention ($E^{HOMO}(E)$) and the energy level of the highest occupied molecular orbital HOMO(H) of the host compound H ($E^{HOMO}(H)$) is between 0.5 eV and 0.5 eV, more preferably between -0.3 eV and 0.3 eV, even more preferably between -0.2 eV and 0.2 eV or even between -0.1 eV and 0.1 eV; and

$E^{LUMO}(H) > E^{LUMO}(D)$ and the difference between the energy level of the lowest unoccupied molecular orbital LUMO(E) of organic molecule according to the invention ($E^{LUMO}(E)$) and the lowest unoccupied molecular orbital LUMO(D) of the at least one further host compound D ($E^{LUMO}(D)$) is between -0.5 eV and 0.5 eV, more preferably between -0.3 eV and 0.3 eV, even more preferably between -0.2 eV and 0.2 eV or even between -0.1 eV and 0.1 eV.

*Light-emitting layer EML comprising at least one further emitter molecule F*

In a further embodiment, the light-emitting layer EML comprises (or (essentially) consists of) a composition comprising or consisting of:

(i) 1-50 % by weight, preferably 5-40 % by weight, in particular 10-30 % by weight, of one organic molecule according to the invention;
(ii) 5-98 % by weight, preferably 30-93.9 % by weight, in particular 40-88% by weight, of one host compound H;
(iii) 1-30 % by weight, in particular 1-20 % by weight, preferably 1-5 % by weight, of at least one further emitter molecule F with a structure differing from the structure of the molecules according to the invention; and
(iv) optionally 0-94 % by weight, preferably 0.1-65 % by weight, in particular 1-50 % by weight, of at least one further host compound D with a structure differing from the structure of the molecules according to the invention; and
(v) optionally 0-94 % by weight, preferably 0-65 % by weight, in particular 0-50 % by weight, of a solvent.

In a further embodiment, the light-emitting layer EML comprises (or (essentially) consists of) a composition as described in *Compositions with at least one further emitter,* with the at least one further emitter molecule F as defined in *Composition wherein the at least one further emitter molecule F is a green fluorescence emitter.*

In a further embodiment, the light-emitting layer EML comprises (or (essentially) consists of) a composition as described in *Compositions with at least one further emitter,* with the at least one further emitter molecule F as defined in *Composition wherein the at least one further emitter molecule F is a red fluorescence emitter.*

In one embodiment of the light-emitting layer EML comprising at least one further emitter molecule F, energy can be transferred from the one or more organic molecules of the invention E to the at least one further emitter molecule F, in particular transferred from the first excited singlet state S1(E) of one or more organic molecules of the invention E to the first excited singlet state S1(F) of the at least one further emitter molecule F.

In one embodiment, the first excited singlet state S1(H) of one host compound H of the light-emitting layer is higher in energy than the first excited singlet state S1(E) of the one or more organic molecules of the invention E: S1(H) > S1(E), and the first excited singlet state S1(H) of one host compound H is higher in energy than the first excited singlet state S1(F) of the at least one emitter molecule F: S1(H) > S1(F).

In one embodiment, the first excited triplet state T1(H) of one host compound H is higher in energy than the first excited triplet state T1(E) of the one or more organic molecules of the invention E: T1(H) > T1(E), and the first excited triplet state T1(H) of one host compound H is higher in energy than the first excited triplet state T1(F) of the at least one emitter molecule F: T1(H) > T1(F).

In one embodiment, the first excited singlet state S1(E) of the one or more organic molecules of the invention E is higher in energy than the first excited singlet state S1(F) of the at least one emitter molecule F: S1(E) > S1(F).

In one embodiment, the first excited triplet state T1(E) of the one or more organic molecules E of the invention is higher in energy than the first excited singlet state T1(F) of the at least one emitter molecule F: T1(E) > T1(F).

In one embodiment, the first excited triplet state T1(E) of the one or more organic molecules E of the invention is higher in energy than the first excited singlet state T1(F) of the at least one emitter molecule F: T1(E) > T1(F), wherein the absolute value of the energy difference between T1(E) and T1(F) is larger than 0.3 eV, preferably larger than 0.4 eV, or even larger than 0.5 eV.

In one embodiment, the host compound H has a highest occupied molecular orbital HOMO(H) having an energy $E^{HOMO}(H)$ in the range of from -5 to -6.5 eV and the at least one further host compound D has a highest occupied molecular orbital HOMO(D) having an energy $E^{HOMO}(D)$, wherein $E^{HOMO}(H) > E^{HOMO}(D)$.

In a further embodiment, the host compound H has a lowest unoccupied molecular orbital LUMO(H) having an energy $E^{LUMO}(H)$ and the at least one further host compound D has a lowest unoccupied molecular orbital LUMO(D) having an energy $E^{LUMO}(D)$, wherein $E^{LUMO}(H) > E^{LUMO}(D)$.

In one embodiment, the host compound H has a highest occupied molecular orbital HOMO(H) having an energy $E^{HOMO}(H)$ and a lowest unoccupied molecular orbital LUMO(H) having an energy $E^{LUMO}(H)$, and

the at least one further host compound D has a highest occupied molecular orbital HOMO(D) having an energy $E^{HOMO}(D)$ and a lowest unoccupied molecular orbital LUMO(D) having an energy $E^{LUMO}(D)$,
the organic molecule according to the invention E has a highest occupied molecular orbital HOMO(E) having an energy $E^{HOMO}(E)$ and a lowest unoccupied molecular orbital LUMO(E) having an energy $E^{LUMO}(E)$,

wherein

$E^{HOMO}(H) > E^{HOMO}(D)$ and the difference between the energy level of the highest occupied molecular orbital HOMO(E) of the organic molecule according to the invention E ($E^{HOMO}(E)$) and the energy level of the highest occupied molecular orbital HOMO(H) of the host compound H ($E^{HOMO}(H)$) is between -0.5 eV and 0.5 eV, more preferably between -0.3 eV and 0.3 eV, even more preferably between -0.2 eV and 0.2 eV or even between -0.1 eV and 0.1 eV; and
$E^{LUMO}(H) > E^{LUMO}(D)$ and the difference between the energy level of the lowest unoccupied molecular orbital LUMO(E) of the organic molecule according to the invention E ($E^{LUMO}(E)$) and the lowest unoccupied molecular orbital LUMO(D) of the at least one further host compound D ($E^{LUMO}(D)$) is between -0.5 eV and 0.5 eV, more preferably between -0.3 eV and 0.3 eV, even more preferably between -0.2 eV and 0.2 eV or even between -0.1 eV and 0.1 eV.

In one embodiment of the invention the host compound D and/ or the host compound H is a thermally-activated delayed fluorescence (TADF)-material. TADF materials exhibit a $\Delta E_{ST}$ value, which corresponds to the energy difference between the first excited singlet state (S1) and the first excited triplet state (T1), of less than 2500 $cm^{-1}$. Preferably the TADF material exhibits a $\Delta E_{ST}$ value of less than 3000 $cm^{-1}$, more preferably less than 1500 $cm^{-1}$, even more preferably less than 1000 $cm^{-1}$ or even less than 500 $cm^{-1}$.

In one embodiment, the host compound D is a TADF material and the host compound H exhibits a $\Delta E_{ST}$ value of more than 2500 $cm^{-1}$. In a particular embodiment, the host compound D is a TADF material and the host compound H is selected from group consisting of CBP, mCP, mCBP, 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole and 9-[3,5-bis(2-dibenzothiophenyl)phenyl]-9H-carbazole.

In one embodiment, the host compound H is a TADF material and the host compound D exhibits a $\Delta E_{ST}$ value of more than 2500 $cm^{-1}$. In a particular embodiment, the host compound H is a TADF material and the host compound D is selected from group consisting of T2T (2,4,6-tris(biphenyl-3-yl)-1,3,5-triazine), T3T (2,4,6-tris(triphenyl-3-yl)-1,3,5-triazine) and/or TST (2,4,6-tris(9,9'-spirobifluorene-2-yl)-1,3,5-triazine).

In a further aspect, the invention relates to an optoelectronic device comprising an organic molecule or a composition of the type described here, more particularly in the form of a device selected from the group consisting of organic light-emitting diode (OLED), light-emitting electrochemical cell, OLED sensor, more particularly gas and vapour sensors not hermetically externally shielded, organic diode, organic solar cell, organic transistor, organic field-effect transistor, organic laser and down-conversion element.

In a preferred embodiment, the optoelectronic device is a device selected from the group consisting of an organic light emitting diode (OLED), a light emitting electrochemical cell (LEC), and a light-emitting transistor.

In one embodiment of the optoelectronic device of the invention, the organic molecule according to the invention E is used as emission material in a light-emitting layer EML.

In one embodiment of the optoelectronic device of the invention, the light-emitting layer EML consists of the composition according to the invention described here.

When the optoelectronic device is an OLED, it may, for example, have the following layer structure:

1. substrate
2. anode layer A
3. hole injection layer, HIL
4. hole transport layer, HTL
5. electron blocking layer, EBL
6. emitting layer, EML
7. hole blocking layer, HBL
8. electron transport layer, ETL
9. electron injection layer, EIL
10. cathode layer,

wherein the OLED comprises each layer selected from the group of HIL, HTL, EBL, HBL, ETL, and EIL only optionally, different layers may be merged and the OLED may comprise more than one layer of each layer type defined above.

Furthermore, the optoelectronic device may, in one embodiment, comprise one or more protective layers protecting the device from damaging exposure to harmful species in the environment including, for example, moisture, vapor and/or gases.

In one embodiment of the invention, the optoelectronic device is an OLED, with the following inverted layer structure:

1. substrate
2. cathode layer
3. electron injection layer, EIL
4. electron transport layer, ETL
5. hole blocking layer, HBL
6. emitting layer, B
7. electron blocking layer, EBL
8. hole transport layer, HTL
9. hole injection layer, HIL
10. anode layer A

wherein the OLED comprises each layer selected from the group of HIL, HTL, EBL, HBL, ETL, and EIL only optionally, different layers may be merged and the OLED may comprise more than one layer of each layer types defined above.

In one embodiment of the invention, the optoelectronic device is an OLED, which may have a stacked architecture. In this architecture, contrary to the typical arrangement in which the OLEDs are placed side by side, the individual units are stacked on top of each other. Blended light may be generated with OLEDs exhibiting a stacked architecture, in particular white light may be generated by stacking blue, green and red OLEDs. Furthermore, the OLED exhibiting a stacked architecture may comprise a charge generation layer (CGL), which is typically located between two OLED subunits and typically consists of a n-doped and p-doped layer with the n-doped layer of one CGL being typically located closer to the anode layer.

In one embodiment of the invention, the optoelectronic device is an OLED, which comprises two or more emission layers between anode and cathode. In particular, this so-called tandem OLED comprises three emission layers, wherein one emission layer emits red light, one emission layer emits green light and one emission layer emits blue light, and optionally may comprise further layers such as charge generation layers, blocking or transporting layers between the individual emission layers. In a further embodiment, the emission layers are adjacently stacked. In a further embodiment, the tandem OLED comprises a charge generation layer between each two emission layers. In addition, adjacent emission layers or emission layers separated by a charge generation layer may be merged.

The substrate may be formed by any material or composition of materials. Most frequently, glass slides are used as substrates. Alternatively, thin metal layers (e.g., copper, gold, silver or aluminum films) or plastic films or slides may be used. This may allow for a higher degree of flexibility. The anode layer A is mostly composed of materials allowing to obtain an (essentially) transparent film. As at least one of both electrodes should be (essentially) transparent in order to allow light emission from the OLED, either the anode layer A or the cathode layer C is transparent. Preferably, the anode layer A comprises a large content or even consists of transparent conductive oxides (TCOs). Such anode layer A may, for example, comprise indium tin oxide, aluminum zinc oxide, fluorine doped tin oxide, indium zinc oxide, PbO, SnO, zirconium oxide, molybdenum oxide, vanadium oxide, tungsten oxide, graphite, doped Si, doped Ge, doped GaAs, doped polyaniline, doped polypyrrol and/or doped polythiophene.

The anode layer A (essentially) may consist of indium tin oxide (ITO) (e.g., $(InO_3)_{0.9}(SnO_2)_{0.1}$). The roughness of the anode layer A caused by the transparent conductive oxides (TCOs) may be compensated by using a hole injection layer (HIL). Further, the HIL may facilitate the injection of quasi charge carriers (i.e., holes) in that the transport of the quasi charge carriers from the TCO to the hole transport layer (HTL) is facilitated. The hole injection layer (HIL) may comprise poly-3,4-ethylendioxy thiophene (PEDOT), polystyrene sulfonate (PSS), $MoO_2$, $V_2O_5$, CuPC or CuI, in particular a mixture of PEDOT and PSS. The hole injection layer (HIL) may also prevent the diffusion of metals from the anode layer A into the hole transport layer (HTL). The HIL may, for example, comprise PEDOT:PSS (poly-3,4-ethylendioxy thiophene: polystyrene sulfonate), PEDOT (poly-3,4-ethylendioxy thiophene), mMTDATA (4,4',4"-tris[phenyl(m-tolyl)amino]triphenylamine), Spiro-TAD (2,2',7,7'-tetrakis(n,n-diphenylamino)-9,9'-spirobifluorene), DNTPD (N1,N1'-(biphenyl-4,4'-diyl)bis(N1-phenyl-N4,N4-di-m-tolylbenzene-1,4-diamine), NPB (N,N'-nis-(1-naphthalenyl)-N,N'-bis-phenyl-(1,1'-biphenyl)-4,4'-diamine), NPNPB (N,N'-diphenyl-N,N'-di-[4-(N,N-diphenyl-amino)phenyl]benzidine), MeO-TPD (N,N,N',N'-tetrakis(4-methoxyphenyl)benzidine), HAT-CN (1,4,5,8,9,11-hexaazatriphenylen-hexacarbonitrile) and/or Spiro-NPD (N,N'-diphenyl-N,N'-bis-(1-naphthyl)-9,9'-spirobifluorene-2,7-diamine).

Adjacent to the anode layer A or hole injection layer (HIL), a hole transport layer (HTL) is typically located.

Herein, any hole transport compound may be used. For example, electron-rich heteroaromatic compounds such as triarylamines and/or carbazoles may be used as hole transport compound. The HTL may decrease the energy barrier between the anode layer A and the light-emitting layer EML. The hole transport layer (HTL) may also be an electron blocking layer (EBL). Preferably, hole transport compounds bear comparably high energy levels of their triplet states T1. For example, the hole transport layer (HTL) may comprise a star-shaped heterocycle such as tris(4-carbazoyl-9-ylphenyl)amine (TCTA), poly-TPD (poly(4-butylphenyl-diphenyl-amine)), [alpha]-NPD (poly(4-butylphenyl-diphenyl-amine)), TAPC (4,4'-cyclohexyliden-bis[N,N-bis(4-methylphenyl)benzenamine]), 2-TNATA (4,4',4"-tris[2-naphthyl(phenyl)amino]triphenylamine), Spiro-TAD, DNTPD, NPB, NPNPB, MeO-TPD, HAT-CN and/or TrisPcz (9,9'-diphenyl-6-(9-phenyl-9H-carbazol-3-yl)-9H,9'H-3,3'-bicarbazole). In addition, the HTL may comprise a p-doped layer, which may be composed of an inorganic or organic dopant in an organic hole-transporting matrix. Transition metal oxides such as vanadium oxide, molybdenum oxide or tungsten oxide may, for example, be used as inorganic dopant. Tetrafluorotetracyanoquinodimethane ($F_4$-TCNQ), copper-pentafluorobenzoate (Cu(I)pFBz) or transition metal complexes may, for example, be used as organic dopant.

The EBL may, for example, comprise mCP (1,3-bis(carbazol-9-yl)benzene), TCTA, 2-TNATA, mCBP (3,3-di(9H-carbazol-9-yl)biphenyl), tris-Pcz, CzSi (9-(4-tert-Butylphenyl)-3,6-bis(triphenylsilyl)-9H-carbazole), and/or DCB (N,N'-dicarbazolyl-1,4-dimethylbenzene).

Adjacent to the hole transport layer (HTL), the light-emitting layer EML is typically located. The light-emitting layer EML comprises at least one light emitting molecule. Particularly, the EML comprises at least one light emitting molecule according to the invention E. In one embodiment, the light-emitting layer comprises only the organic molecules according to the invention. Typically, the EML additionally comprises one or more host materials H. For example, the host material H is selected from CBP (4,4'-Bis-(N-carbazolyl)-biphenyl), mCP, mCBP Sif87 (dibenzo[b,d]thiophen-2-yltriphenylsilane), CzSi, Sif88 (dibenzo[b,d]thiophen-2-yl)diphenylsilane), DPEPO (bis[2-(diphenylphosphino)phenyl] ether oxide), 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole, 9-[3,5-bis(2-dibenzothiophenyl)phenyl]-9H-carbazole, T2T (2,4,6-tris(biphenyl-3-yl)-1,3,5-triazine), T3T (2,4,6-tris(triphenyl-3-yl)-1,3,5-triazine) and/or TST (2,4,6-tris(9,9'-spirobifluorene-2-yl)-1,3,5-triazine). The host material H typically should be selected to exhibit first triplet (T1) and first singlet (S1) energy levels, which are energetically higher than the first triplet (T1) and first singlet (S1) energy levels of the organic molecule. Alternatively, the EML additionally comprises one or more host materials H, wherein the host is a triplet-triplet annihilation (TTA) material. A TTA material may convert energy from first excited triplet states T1 to first excited singlet state S1 by triplet-triplet annihilation. A TTA material should be selected that twice the energy of the lowermost excited triplet state energy level T1 of the TTA material is larger than the energy of the lowermost excited singlet state energy level of the light emitting molecule according to the invention, i.e., 2T1(TTA material) > S1 (light emitting molecule according to the invention).

In one embodiment of the invention, the EML comprises a so-called mixed-host system with at least one hole-dominant host and one electron-dominant host. In a particular embodiment, the EML comprises exactly one light emitting organic molecule according to the invention and a mixed-host system comprising T2T as electron-dominant host and a host selected from CBP, mCP, mCBP, 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole and 9-[3,5-bis(2-dibenzothiophenyl)phenyl]-9H-carbazole as hole-dominant host. In a further embodiment the EML comprises 50-80 % by weight, preferably 60-75 % by weight of a host selected from CBP, mCP, mCBP, 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole and 9-[3,5-bis(2-dibenzothiophenyl)phenyl]-9H-carbazole; 10-45 % by weight, preferably 15-30 % by weight of T2T and 5-40 % by weight, preferably 10-30 % by weight of light emitting molecule according to the invention.

Adjacent to the light-emitting layer EML, an electron transport layer (ETL) may be located. Herein, any electron transporter may be used. Exemplarily, electron-poor compounds such as, e.g., benzimidazoles, pyridines, triazoles, oxadiazoles (e.g., 1,3,4-oxadiazole), phosphinoxides and sulfone, may be used. An electron transporter may also be a star-shaped heterocycle such as 1,3,5-tri(1-phenyl-1H-benzo[d]imidazol-2-yl)phenyl (TPBi). The ETL may comprise NBphen (2,9-bis(naphthalen-2-yl)-4,7-diphenyl-1,10-phenanthroline), $Alq_3$ (Aluminum-tris(8-hydroxyquinoline)), TSPO1 (diphenyl-4-triphenylsilylphenyl-phosphinoxide), BPyTP2 (2,7-di(2,2'-bipyridin-5-yl)triphenyle), Sif87 (dibenzo[b,d]thiophen-2-yltriphenylsilane), Sif88 (dibenzo[b,d]thiophen-2-yl)diphenylsilane), BmPyPhB (1,3-bis[3,5-di(pyridin-3-yl)phenyl]benzene) and/or BTB (4,4'-bis-[2-(4,6-diphenyl-1,3,5-triazinyl)]-1,1'-biphenyl). Optionally, the ETL may be doped with materials such as Liq. The electron transport layer (ETL) may also block holes or a holeblocking layer (HBL) is introduced.

The HBL may, for example, comprise BCP (2,9-dimethyl-4,7-diphenyl-1,10-phenanthroline = Bathocuproine), BAlq (bis(8-hydroxy-2-methylquinoline)-(4-phenylphenoxy)aluminum), NBphen (2,9-bis(naphthalen-2-yl)-4,7-diphenyl-1,10-phenanthroline), $Alq_3$ (Aluminum-tris(8-hydroxyquinoline)), TSPO1 (diphenyl-4-triphenylsilylphenyl-phosphinoxide), T2T (2,4,6-tris(biphenyl-3-yl)-1,3,5-triazine), T3T (2,4,6-tris(triphenyl-3-yl)-1,3,5-triazine), TST (2,4,6-tris(9,9'-spirobifluorene-2-yl)-1,3,5-triazine), and/or TCB/TCP (1,3,5-tris(N-carbazolyl)benzol/ 1,3,5-tris(carbazol)-9-yl) benzene).

Adjacent to the electron transport layer (ETL), a cathode layer C may be located.The cathode layer C may, for example, comprise or may consist of a metal (e.g., Al, Au, Ag, Pt, Cu, Zn, Ni, Fe, Pb, LiF, Ca, Ba, Mg, In, W, or Pd) or a metal alloy. For practical reasons, the cathode layer may also consist of (essentially) intransparent metals such as Mg, Ca or Al. Alternatively or additionally, the cathode layer C may also comprise graphite and or carbon nanotubes (CNTs). Alternatively, the cathode layer C may also consist of nanoscalic silver wires.

An OLED may further, optionally, comprise a protection layer between the electron transport layer (ETL) and the cathode layer C (which may be designated as electron injection layer (EIL)). This layer may comprise lithium fluoride, cesium fluoride, silver, Liq (8-hydroxyquinolinolatolithium), $Li_2O$, $BaF_2$, MgO and/or NaF.

Optionally, the electron transport layer (ETL) and/or a hole blocking layer (HBL) may also comprise one or more host compounds H.

In order to modify the emission spectrum and/or the absorption spectrum of the light-emitting layer EML further, the light-emitting layer EML may further comprise one or more further emitter molecules F. Such an emitter molecule F may be any emitter molecule known in the art. Preferably such an emitter molecule F is a molecule with a structure differing from the structure of the molecules according to the invention E. The emitter molecule F may optionally be a TADF emitter. Alternatively, the emitter molecule F may optionally be a fluorescent and/or phosphorescent emitter molecule which is able to shift the emission spectrum and/or the absorption spectrum of the light-emitting layer EML. Exemplarily, the triplet and/or singlet excitons may be transferred from the organic emitter molecule according to the invention to the emitter molecule F before relaxing to the ground state S0 by emitting light typically red-shifted in comparison to the light emitted by an organic molecule. Optionally, the emitter molecule F may also provoke two-photon effects (i.e., the absorption of two photons of half the energy of the absorption maximum).

Optionally, an optoelectronic device (e.g., an OLED) may, for example, be an essentially white optoelectronic device. For example, such white optoelectronic device may comprise at least one (deep) blue emitter molecule and one or more emitter molecules emitting green and/or red light. Then, there may also optionally be energy transmittance between two or more molecules as described above.

As used herein, if not defined more specifically in the particular context, the designation of the colors of emitted and/or absorbed light is as follows:

| | |
|---|---|
| violet: | wavelength range of >380-420 nm; |
| deep blue: | wavelength range of >420-480 nm; |
| sky blue: | wavelength range of >480-500 nm; |
| green: | wavelength range of >500-560 nm; |
| yellow: | wavelength range of >560-580 nm; |
| orange: | wavelength range of >580-620 nm; |
| red: | wavelength range of >620-800 nm. |

With respect to emitter molecules, such colors refer to the emission maximum. Therefore, for example, a deep blue emitter has an emission maximum in the range of from >420 to 480 nm, a sky blue emitter has an emission maximum in the range of from >480 to 500 nm, a green emitter has an emission maximum in a range of from >500 to 560 nm, a red emitter has an emission maximum in a range of from >620 to 800 nm.

A deep blue emitter may preferably have an emission maximum of below 480 nm, more preferably below 470 nm, even more preferably below 465 nm or even below 460 nm. It will typically be above 420 nm, preferably above 430 nm, more preferably above 440 nm or even above 450 nm.

Accordingly, a further aspect of the present invention relates to an OLED, which exhibits an external quantum efficiency at 1000 cd/$m^2$ of more than 8 %, more preferably of more than 10 %, more preferably of more than 13 %, even more preferably of more than 15 % or even more than 20 % and/or exhibits an emission maximum between 420 nm and 500 nm, preferably between 430 nm and 490 nm, more preferably between 440 nm and 480 nm, even more preferably between 450 nm and 470 nm and/or exhibits a LT80 value at 500 cd/$m^2$ of more than 100 h, preferably more than 200 h, more preferably more than 400 h, even more preferably more than 750 h or even more than 1000 h. Accordingly, a further aspect of the present invention relates to an OLED, whose emission exhibits a CIEy color coordinate of less than 0.45, preferably less than 0.30, more preferably less than 0.20 or even more preferably less than 0.15 or even less than 0.10.

A further aspect of the present invention relates to an OLED, which emits light at a distinct color point. According to the present invention, the OLED emits light with a narrow emission band (small full width at half maximum (FWHM)). In one aspect, the OLED according to the invention emits light with a FWHM of the main emission peak of less than

0.30 eV, preferably less than 0.25 eV, more preferably less than 0.18 eV, even more preferably less than 0.15 eV or even less than 0.12 eV.

A further aspect of the present invention relates to an OLED, which emits light at a distinct color point. According to the present invention, the OLED emits light with a narrow emission band (small full width at half maximum (FWHM)). In one aspect, the OLED according to the invention emits light with a FWHM of the main emission peak of less than 0.30 eV, preferably less than 0.25 eV, more preferably less than 0.18 eV, even more preferably less than 0.15 eV or even less than 0.12 eV with an excited state lifetime of not more than 10 μs, of not more than 8 μs, in particular of not more than 6 μs, more preferably of not more than 5 μs or not more than 4 μs, even more preferably of not more than 3 μs or not more than 2 μs.

A further aspect of the present invention relates to an OLED, which emits light with CIEx and CIEy color coordinates close to the CIEx (= 0.131) and CIEy (= 0.046) color coordinates of the primary color blue (CIEx = 0.131 and CIEy = 0.046) as defined by ITU-R Recommendation BT.2020 (Rec. 2020) and thus is suited for the use in Ultra High Definition (UHD) displays, e.g. UHD-TVs. Accordingly, a further aspect of the present invention relates to an OLED, whose emission exhibits a CIEx color coordinate of between 0.02 and 0.30, preferably between 0.03 and 0.25, more preferably between 0.05 and 0.20 or even more preferably between 0.08 and 0.18 or even between 0.10 and 0.15 and/or a CIEy color coordinate of between 0.00 and 0.45, preferably between 0.01 and 0.30, more preferably between 0.02 and 0.20 or even more preferably between 0.03 and 0.15 or even between 0.04 and 0.10.

In a further aspect, the invention relates to a method for producing an optoelectronic component. In this case an organic molecule of the invention is used.

The optoelectronic device, in particular the OLED according to the present invention can be fabricated by any means of vapor deposition and/ or liquid processing. Accordingly, at least one layer is

- prepared by means of a sublimation process,
- prepared by means of an organic vapor phase deposition process,
- prepared by means of a carrier gas sublimation process,
- solution processed or printed.

The methods used to fabricate the optoelectronic device, in particular the OLED according to the present invention are known in the art. The different layers are individually and successively deposited on a suitable substrate by means of subsequent deposition processes. The individual layers may be deposited using the same or differing deposition methods.

Vapor deposition processes, for example, comprise thermal (co)evaporation, chemical vapor deposition and physical vapor deposition. For active matrix OLED display, an AMOLED backplane is used as substrate. The individual layer may be processed from solutions or dispersions employing adequate solvents. Solution deposition process, for example, comprise spin coating, dip coating and jet printing. Liquid processing may optionally be carried out in an inert atmosphere (e.g., in a nitrogen atmosphere) and the solvent may be completely or partially removed by means known in the state of the art.

**Examples**

General synthesis scheme I

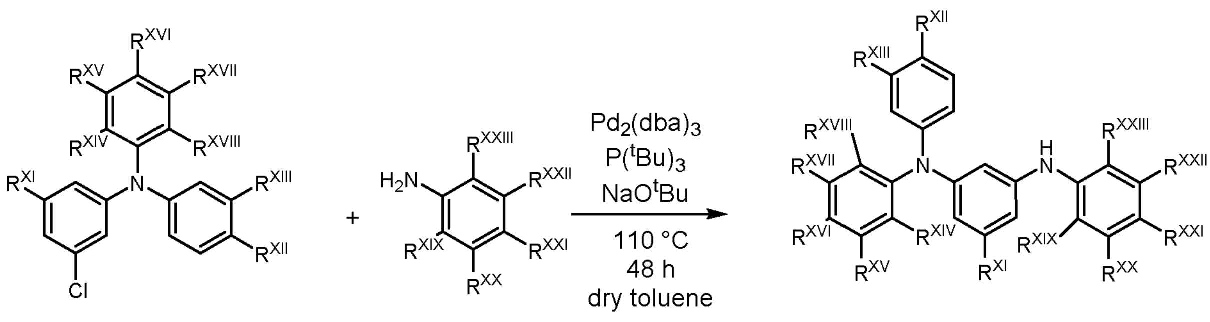


E1a E1b I1

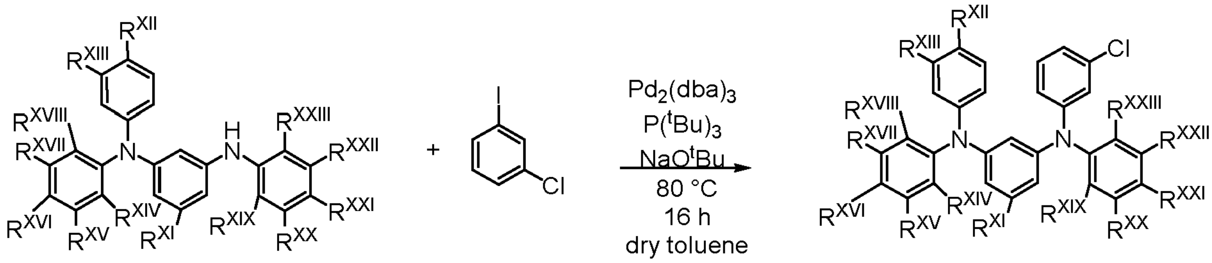


I1 I2

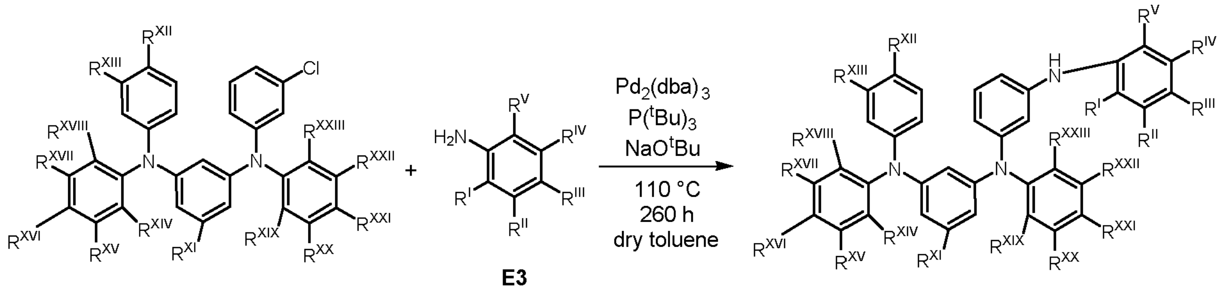


E3

I2 I3

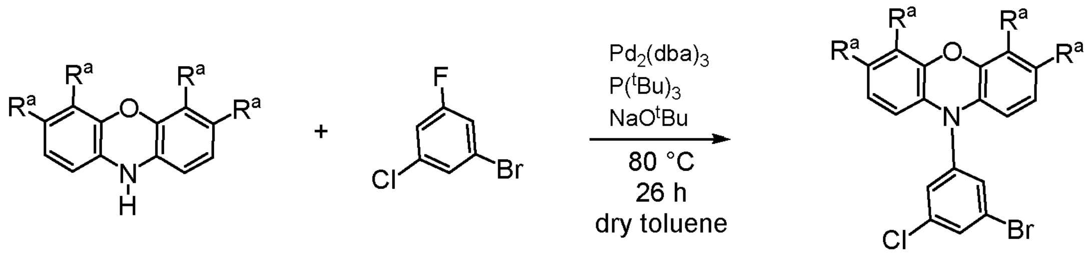


E1a-a E1a-b I2a

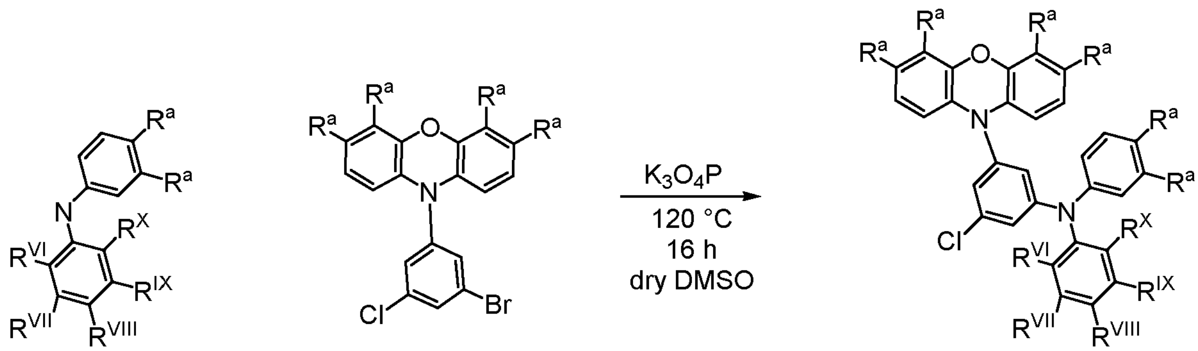


E3a I2a I3a

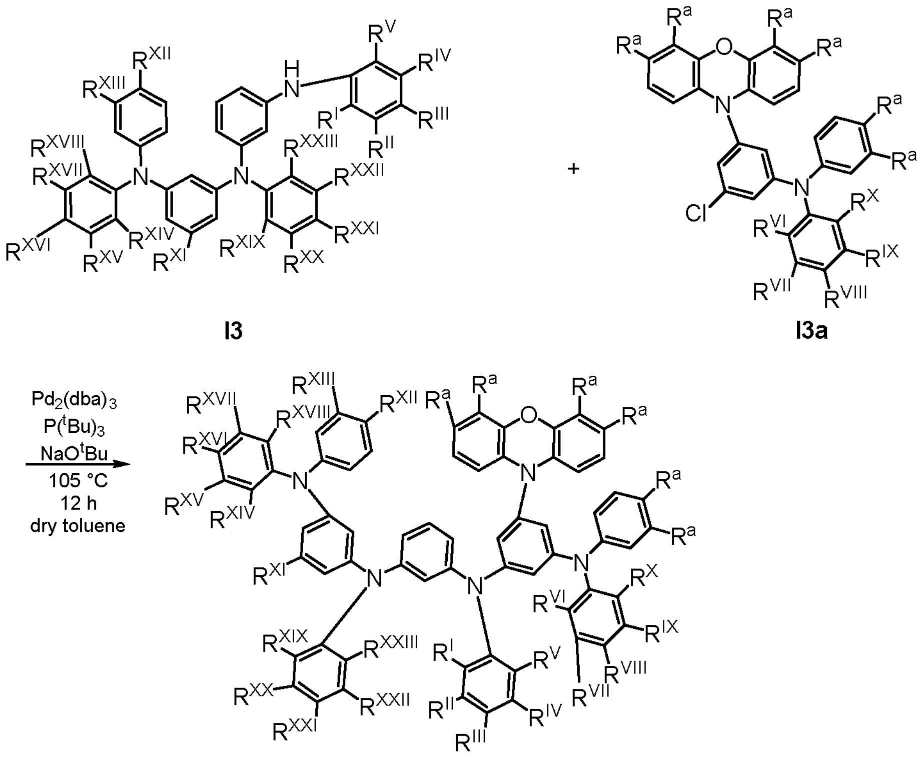


I3

I3a

I4

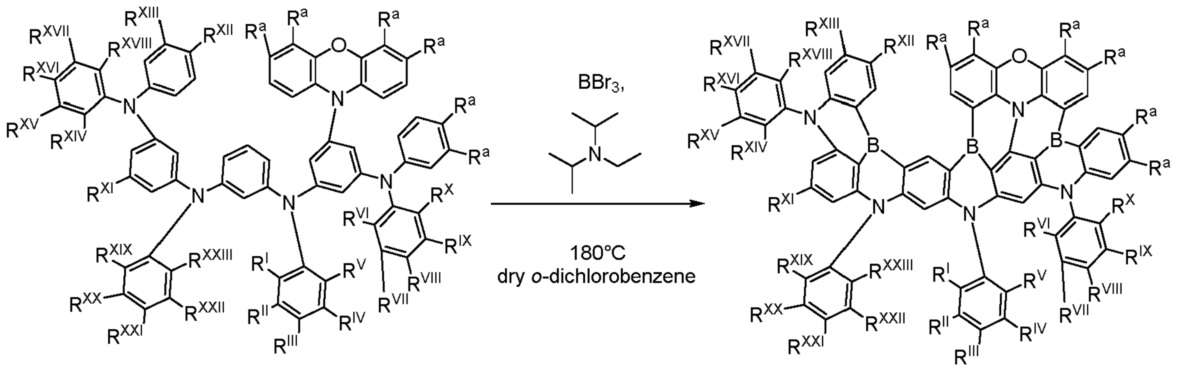


I4

P1

*General procedure for synthesis **AAV1:***

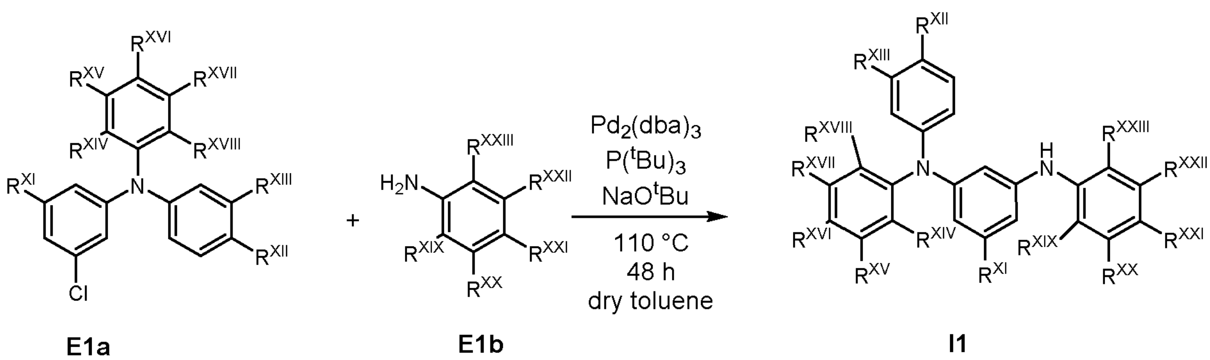


**E1a** **E1b** **I1**

**E1a** (1.00 equivalents), **E1b** (1.50 equivalents), tris(dibenzylideneacetone)dipalladium $Pd_2(dba)_3$ (0.02 equivalents; CAS: 51364-51-3), tri-tert-butyl-phosphine ($P(^tBu)_3$, CAS: 13716-12-6 , 0.08 equivalents) and sodium tert-butoxide ($NaO^tBu$; 3.00 equivalents) are stirred under nitrogen atmosphere in toluene at 110 °C for 48 h. After cooling down to room temperature (rt) the reaction mixture is extracted with ethyl acetate and brine and the phases are separated. The combined organic layers are dried over $MgSO_4$ and then the solvent is removed under reduced pressure. The crude product obtained is purified by recrystallization or column chromatography and **I1** is obtained as solid.

*General procedure for synthesis* ***AAV2:***

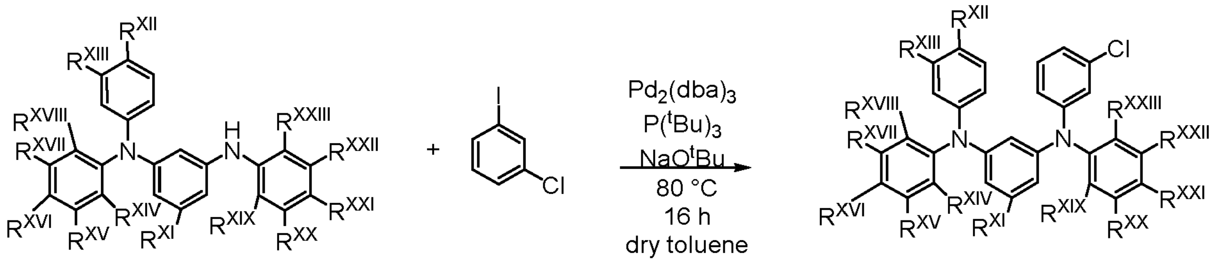


**I1** **I2**

**I1** (1.00 equivalents), 3-Chloroiodobenzene (1.20 equivalents; CAS: 625-99-0), tris(dibenzylideneacetone)dipalladium $Pd_2(dba)_3$ (0.02 equivalents; CAS: 51364-51-3), tri-tert-butyl-phosphine ($P(^tBu)_3$, CAS: 13716-12-6 , 0.08 equivalents) and sodium tert-butoxide ($NaO^tBu$; 2.00 equivalents) are stirred under nitrogen atmosphere in toluene at 110 °C for 260 h. After cooling down to room temperature (rt) the reaction mixture is extracted with ethyl acetate and brine and the phases are separated. The combined organic layers are dried over $MgSO_4$ and then the solvent is removed under reduced pressure. The crude product obtained is purified by recrystallization or column chromatography and **I2** is obtained as solid.

*General procedure for synthesis* ***AAV3:***

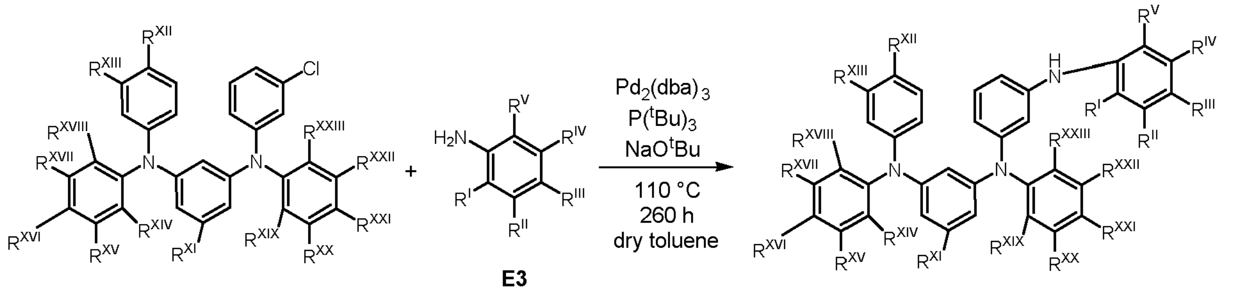


**E3**

**I2** **I3**

**I2** (1.00 equivalents), **E3** (2.00 equivalents), tris(dibenzylideneacetone)dipalladium $Pd_2(dba)_3$ (0.02 equivalents; CAS: 51364-51-3), tri-tert-butyl-phosphine ($P(^tBu)_3$, CAS: 13716-12-6 , 0.08 equivalents) and sodium tert-butoxide ($NaO^tBu$; 2.00 equivalents) are stirred under nitrogen atmosphere in toluene at 110 °C for 260 h. After cooling down to room temperature (rt) the reaction mixture is extracted with toluene and brine and the phases are separated. The combined organic layers are dried over $MgSO_4$ and then the solvent is removed under reduced pressure. The crude product obtained is purified by recrystallization or column chromatography and **I3** is obtained as solid.

*General procedure for synthesis* ***AAV2a:***

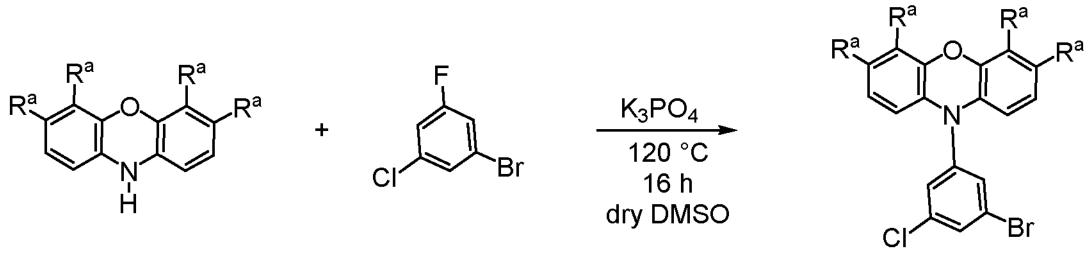


E1a-a I2a

**E1a-a** (1.00 equivalents), 1-Bromo-3-chloro-5-fluorobenzene (1.20 equivalents; CAS: 33863-76-2) and potassium phosphate tribasic (2.5 equivalents; CAS: 7778-53-2) are stirred under nitrogen atmosphere in dimethylsulfoxide DMSO at 120 °C for 16 h. After cooling down to room temperature (rt) the reaction mixture is poured into water. The precipitate is filtered. The crude product obtained is purified by recrystallization or column chromatography and **I2a** is obtained as solid.

*General procedure for synthesis **AAV3a:***

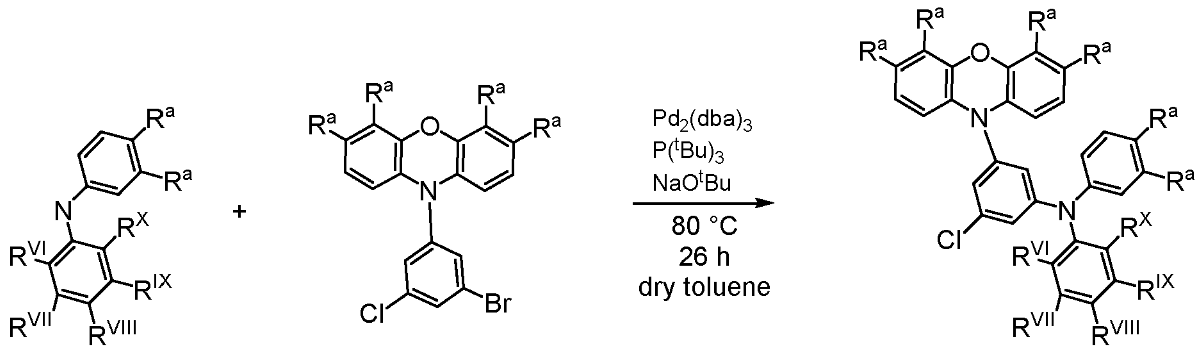


E3a I2a I3a

**E3a** (1.00 equivalents), **I2a** (1.00 equivalents), tris(dibenzylideneacetone)dipalladium $Pd_2(dba)_3$ (0.01 equivalents; CAS: 51364-51-3), tri-tert-butyl-phosphine ($P(^tBu)_3$, CAS: 13716-12-6 , 0.04 equivalents) and sodium tert-butoxide ($NaO^tBu$; 5.00 equivalents) are stirred under nitrogen atmosphere in toluene at 80 °C for 26 h. After cooling down to room temperature (rt) the reaction mixture is extracted with ethyl acetate and brine and the phases are separated. The combined organic layers are dried over $MgSO_4$ and then the solvent is removed under reduced pressure. The crude product obtained is purified by recrystallization or column chromatography and **I3a** is obtained as solid.

*General procedure for synthesis **AAV4:***

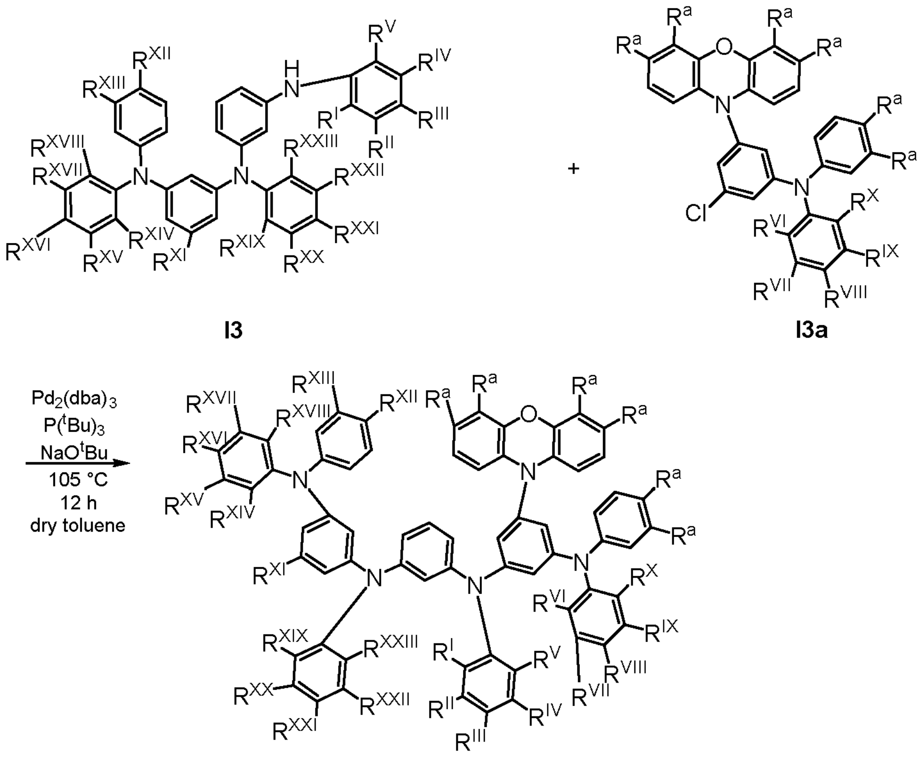


I3 I3a

I4

**I3** (1.00 equivalents), **I3a** (1.00 equivalents), tris(dibenzylideneacetone)dipalladium $Pd_2(dba)_3$ (0.01 equivalents; CAS: 51364-51-3), tri-tert-butyl-phosphine ($P(^tBu)_3$, CAS: 13716-12-6 , 0.04 equivalents) and sodium tert-butoxide ($NaO^tBu$; 2.00 equivalents) are stirred under nitrogen atmosphere in toluene at 105 °C for 12 h. After cooling down to room temperature (rt) the reaction mixture is extracted with toluene and brine and the phases are separated. The combined organic layers are dried over $MgSO_4$ and then the solvent is removed under reduced pressure. The crude product obtained is purified by recrystallization or column chromatography and **I4** is obtained as solid.

*General procedure for synthesis* ***AAV5:***

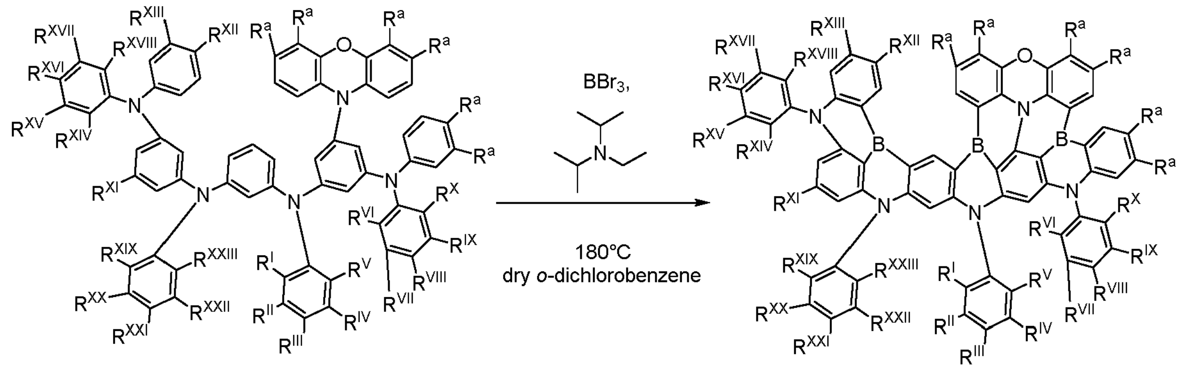


I4 P1

Under nitrogen atmosphere, boron tribromide (CAS 10294-33-4, 6.00 equiv.) is slowly added to a solution of **I4** (1.00 equiv.) in o-dichlorobenzene. The reaction mixture is stirred at 180 °C overnight and, upon cooling to room temperature, quenched by the addition of N,N-Diisopropylethylamine (CAS 7087-68-5; 16.0 equivalents). The reaction mixture is extracted with dichloromethane and water and the phases are separated. The combined organic layers are dried over $MgSO_4$ and then the solvent is removed under reduced pressure. The crude product obtained is purified by recrystallization or column chromatography and **P1** is optained as a solid.

General synthesis scheme II

RI= RX,...RV =RVI

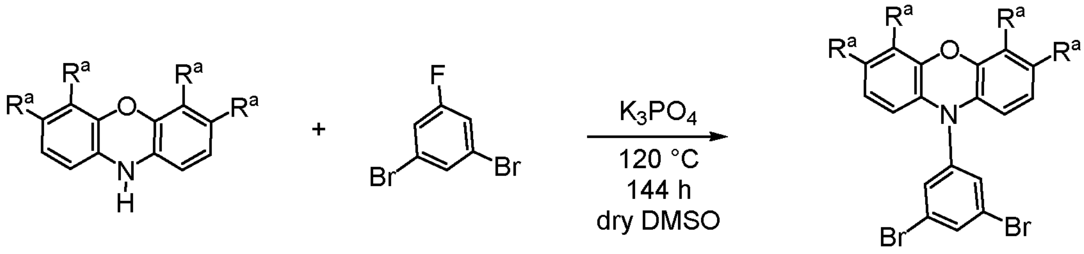


E4

I5

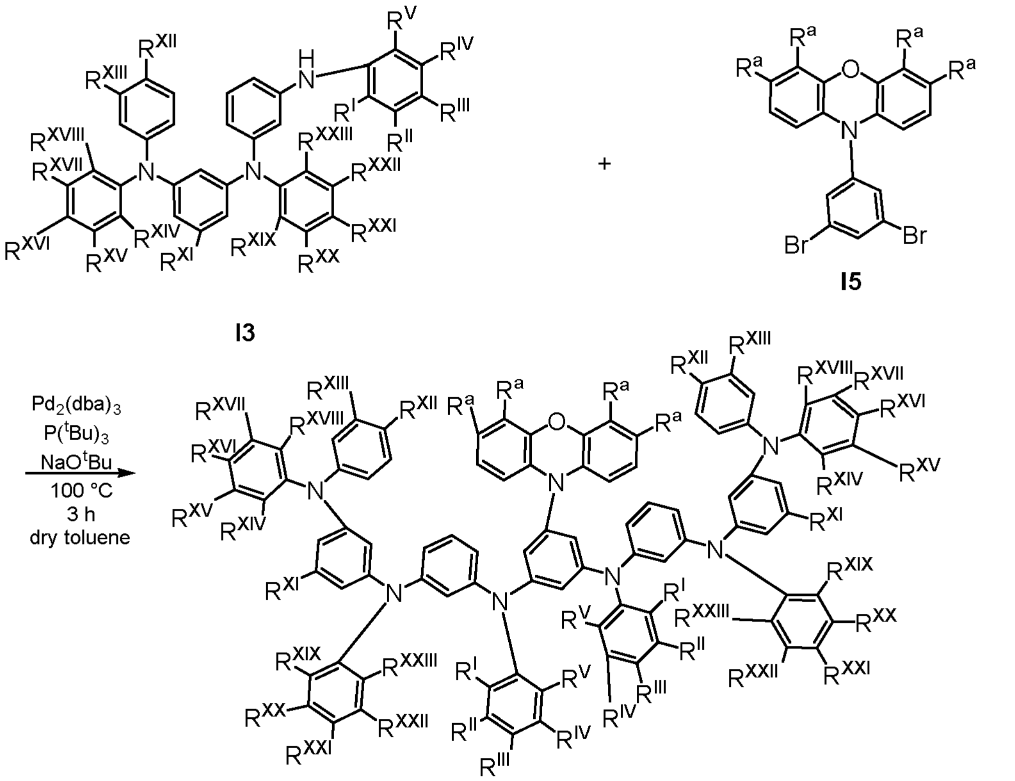


I5

I3

I6

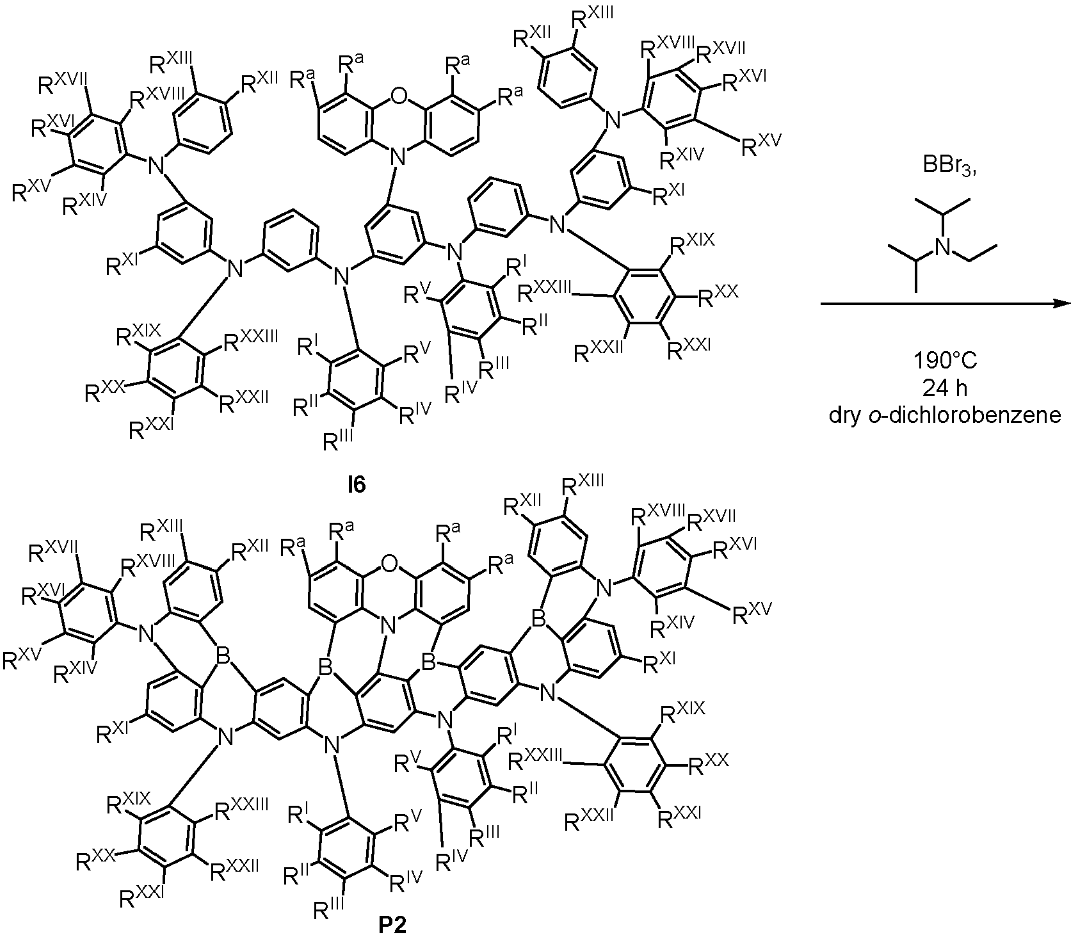


I6

P2

*General procedure for synthesis* ***AAV6:***

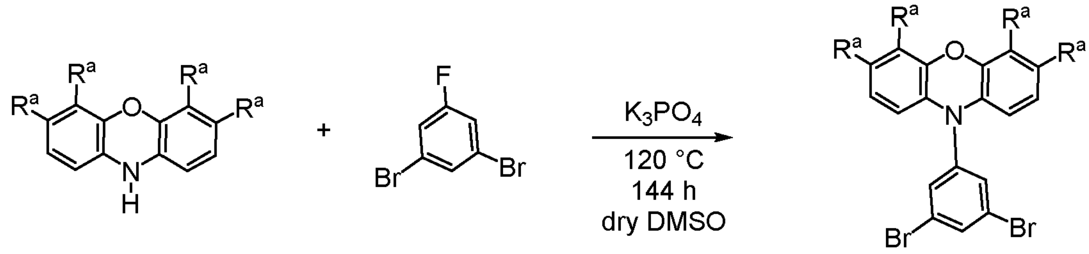


E4 I5

**E4** (1.00 equivalents), 1,3-Dibromo-5-fluorobenzene (1.20 equivalents; CAS: 135-67-1) and potassium phosphate tribasic (2.5 equivalents; CAS: 7778-53-2) are stirred under nitrogen atmosphere in dimethylsulfoxide DMSO at 120 °C for 144 h. After cooling down to room temperature (rt) the reaction mixture is poured into water. The precipitate is filtered. The crude product obtained is purified by recrystallization or column chromatography and **I5** is obtained as solid.

*General procedure for synthesis* ***AAV7:***

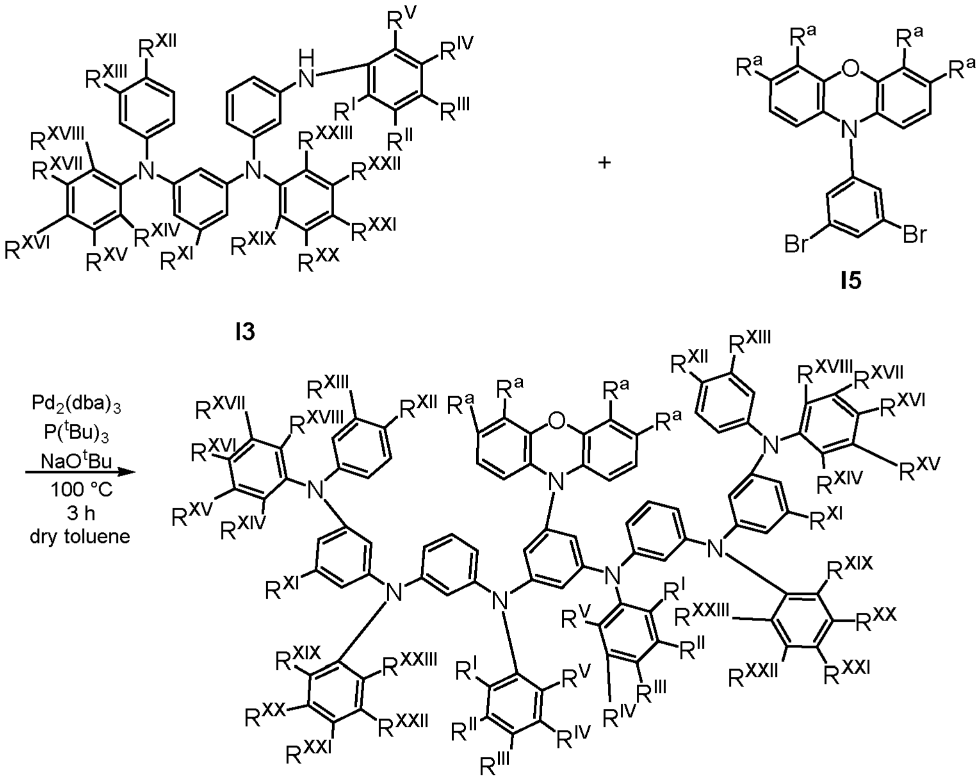


I3 I5

I6

**I3** (2.00 equivalents), **I5** (1.00 equivalents), tris(dibenzylideneacetone)dipalladium $Pd_2(dba)_3$ (0.01 equivalents; CAS: 51364-51-3), tri-tert-butyl-phosphine ($P(^tBu)_3$, CAS: 13716-12-6 , 0.04 equivalents) and sodium tert-butoxide (Na-$O^tBu$; 5.00 equivalents) are stirred under nitrogen atmosphere in toluene at 100 °C for 3 h. After cooling down to room temperature (rt) the reaction mixture is extracted with ethyl acetate and brine and the phases are separated. The combined organic layers are dried over $MgSO_4$ and then the solvent is removed under reduced pressure. The crude product obtained is purified by recrystallization or column chromatography and **I6** is obtained as solid.

*General procedure for synthesis* ***AAV8:***

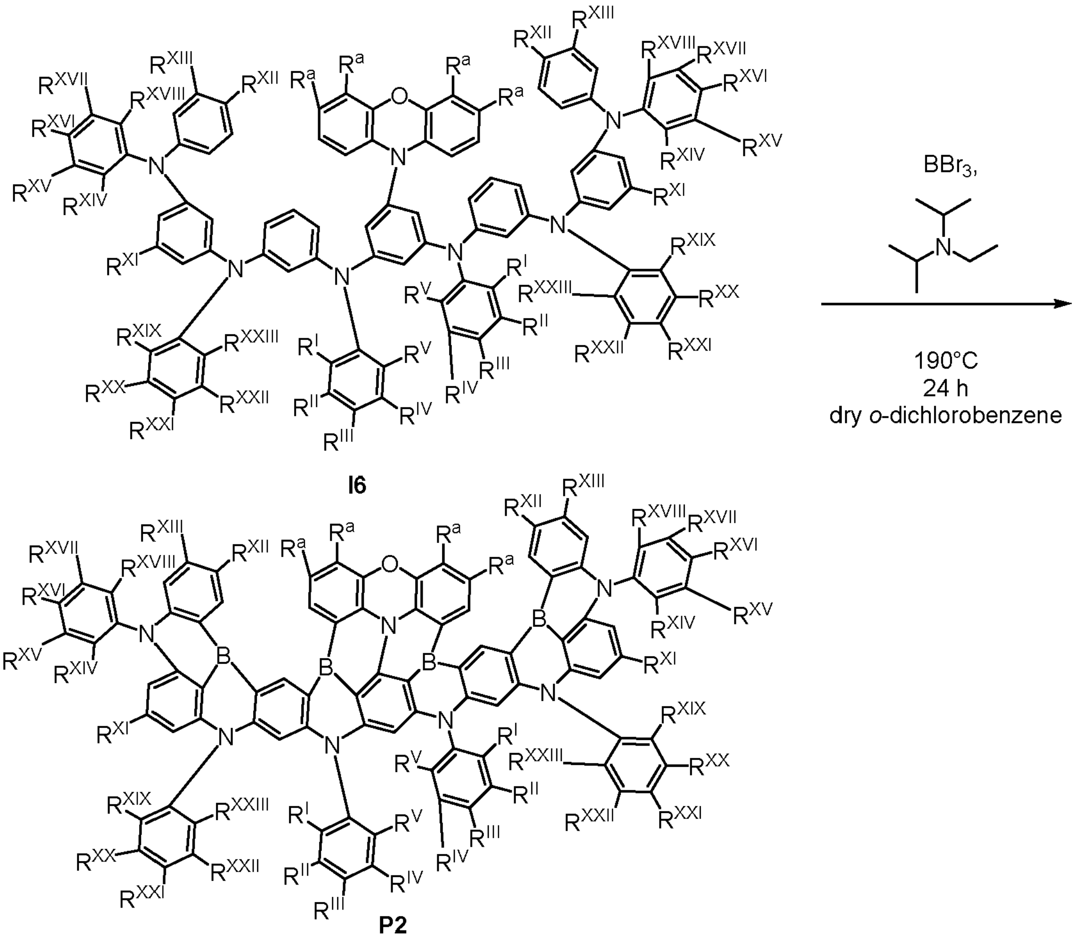


**I6**

**P2**

Under nitrogen atmosphere, boron tribromide (CAS 10294-33-4, 8.00 equiv.) is slowly added to a solution of **I6** (1.00 equiv.) in o-dichlorobenzene. The reaction mixture is stirred at 190 °C for 24 h and, upon cooling to room temperature, quenched by the addition of N,N-Diisopropylethylamine (CAS 7087-68-5; 16.0 equivalents). The reaction mixture is extracted with dichloromethane and water and the phases are separated. The combined organic layers are dried over $MgSO_4$ and then the solvent is removed under reduced pressure. The crude product obtained is purified by recrystallization or column chromatography and **P2** is obtained as a solid.

*Cyclic voltammetry*

Cyclic voltammograms are measured from solutions having concentration of $10^{-3}$ mol/L of the organic molecules in dichloromethane or a suitable solvent and a suitable supporting electrolyte (e.g. 0.1 mol/L of tetrabutylammonium hexafluorophosphate). The measurements are conducted at room temperature under nitrogen atmosphere with a three-electrode assembly (Working and counter electrodes: Pt wire, reference electrode: Pt wire) and calibrated using $FeCp_2/FeCp_2^+$ as internal standard. The HOMO data was corrected using ferrocene as internal standard against a saturated calomel electrode (SCE).

*Density functional theory calculation*

Molecular structures are optimized employing the BP86 functional and the resolution of identity approach (RI). Excitation energies are calculated using the (BP86) optimized structures employing Time-Dependent DFT (TD-DFT) methods. Orbital and excited state energies are calculated with the B3LYP functional. Def2-SVP basis sets (and a m4-grid for numerical integration are used. The Turbomole program package is used for all calculations.

*Photophysical measurements*

*Sample pretreatment: Spin-coating*

Apparatus: Spin150, SPS euro.

The sample concentration is 0,2 mg/ml, dissolved in Toluene/DCM a suitable solvent. Program: 7; 30sec.at 2000 U/min. After coating, the films are tried at 70 °C for 1 min.

Photoluminescence spectroscopy and TCSPC (*Time-correlated single-photon counting*) Steady-state emission spectroscopy is recorded using a Horiba Scientific, Modell FluoroMax-4 equipped with a 150 W Xenon-Arc lamp, excitation- and emissions monochromators and a Hamamatsu R928 photomultiplier and a time-correlated single-photon counting option. Emissions and excitation spectra are corrected using standard correction fits.

Excited state lifetimes are determined employing the same system using the TCSPC method with FM-2013 equipment and a Horiba Yvon TCSPC hub.

Excitation sources:

NanoLED 370 (wavelength: 371 nm, puls duration: 1.1 ns)
NanoLED 290 (wavelength: 294 nm, puls duration: <1 ns)
SpectraLED 310 (wavelength: 314 nm)
SpectraLED 355 (wavelength: 355 nm).

Data analysis (exponential fit) was done using the software suite DataStation and DAS6 analysis software. The fit is specified using the chi-squared-test.

*Time-resolved PL spectroscopy in the $\mu$s-range and ns-range (FS5)*

Time-resolved PL measurements were performed on a FS5 fluorescence spectrometer from Edinburgh Instruments. Compared to measurements on the HORIBA setup, better light gathering allows for an optimized signal to noise ratio, which favors the FS5 system especially for transient PL measurements of delayed fluorescence characteristics. The continuous light source is a 150W xenon arc lamp, selected wavelengths are chosen by a Czerny-Turner monochromator, which is also used to set specific emission wavelengths. The sample emission is directed towards a sensitive R928P photomultiplier tube (PMT), allowing the detection of single photons with a peak quantum efficiency of up to 25 % in the spectral range between 200 nm to 870 nm. The detector is a temperature stabilized PMT, providing dark counts below 300 cps (counts per second). Finally, to determine the transient decay lifetime of the delayed fluorescence, a tail fit using three exponential functions is applied. By weighting the specific lifetimes $\tau_i$ with their corresponding amplitudes $A_i$,

$$\tau_{\mathrm{DF}} = \sum_{i=1}^{3} \frac{A_i \tau_i}{A_i}$$

the delayed fluorescence lifetime $\tau_{\mathrm{DF}}$ is determined.

*Photoluminescence quantum yield measurements*

For photoluminescence quantum yield (PLQY) measurements an *Absolute PL Quantum Yield Measurement C9920-03G* system (*Hamamatsu Photonics*) is used. Quantum yields and CIE coordinates are determined using the software U6039-05 version 3.6.0.

Emission maxima are given in nm, quantum yields $\Phi$ in % and CIE coordinates as x,y values. PLQY is determined using the following protocol:

1) Quality assurance: Anthracene in ethanol (known concentration) is used as reference
2) Excitation wavelength: the absorption maximum of the organic molecule is determined and the molecule is excited using this wavelength
3) Measurement

Quantum yields are measured for sample of films (2 % by weight of the emitter in PMMA) under nitrogen atmosphere. The yield is calculated using the equation:

$$\Phi_{PL} = \frac{n_{photon}, emitted}{n_{photon}, absorbed} = \frac{\int \frac{\lambda}{hc}\left[Int_{emitted}^{sample}(\lambda) - Int_{absorbed}^{sample}(\lambda)\right]d\lambda}{\int \frac{\lambda}{hc}\left[Int_{emitted}^{reference}(\lambda) - Int_{absorbed}^{reference}(\lambda)\right]d\lambda}$$

, wherein $n_{photon}$ denotes the photon count and Int. the intensity.

*Production and characterization of optoelectronic devices*

Optoelectronic devices, such as OLED devices, comprising organic molecules according to the invention can be produced via vacuum-deposition methods. If a layer contains more than one compound, the weight-percentage of one or more compounds is given in %. The total weight-percentage values amount to 100 %, thus if a value is not given, the fraction of this compound equals to the difference between the given values and 100 %.

The (not fully optimized) OLEDs are characterized using standard methods and measuring electroluminescence spectra, the external quantum efficiency (in %) in dependency on the intensity, calculated using the light detected by the photodiode, and the current. The OLED device lifetime is extracted from the change of the luminance during operation at constant current density. The LT50 value corresponds to the time, where the measured luminance decreased to 50 % of the initial luminance, analogously LT80 corresponds to the time point, at which the measured luminance decreased to 80 % of the initial luminance, LT 95 to the time point, at which the measured luminance decreased to 95 % of the initial luminance etc.

Accelerated lifetime measurements are performed (e.g. applying increased current densities). Exemplarily LT80 values at 500 cd/m$^2$ are determined using the following equation:

$$\mathrm{LT80}\left(500\frac{cd}{m^2}\right) = \mathrm{LT80}(L_0)\left(\frac{L_0}{500\frac{cd}{m^2}}\right)^{1.6}$$

wherein $L_0$ denotes the initial luminance at the applied current density.

The values correspond to the average of several pixels (typically two to eight), the standard deviation between these pixels is given.

**HPLC-MS**

HPLC-MS analysis is performed on an HPLC by Agilent (1260 series) with MS-detector (Thermo LTQ XL).

For example, a typical HPLC method is as follows: a reverse phase column 3.0 mm x 100 mm, particle size 2.7 μm from Agilent *(Poroshell 120EC-C18, 3.0 x 100 mm, 2.7 μm HPLC column)* is used in the HPLC. The HPLC-MS measurements are performed at room temperature (rt) following gradients

| Flow rate [ml/min] | Time [min] | A[%] | B[%] | C[%] |
|---|---|---|---|---|
| 1.5 | 30 | 40 | 40 | 30 |
| 1.5 | 45 | 10 | 10 | 80 |
| 1.5 | 50 | 40 | 10 | 80 |
| 1.5 | 51 | 30 | 40 | 30 |
| 1.5 | 55 | 30 | 10 | 30 |

using the following solvent mixtures containing 0.1% formic acid:

| | | |
|---|---|---|
| Solvent A: | $H_2O$ (10%) | MeCN (90%) |
| Solvent B: | $H_2O$ (90%) | MeCN (10%) |
| Solvent C: | THF (50%) | MeCN (50%) |

An injection volume of 2 μL from a solution with a concentration of 0.5 mg/mL of the analyte is taken for the

measurements.
Ionization of the probe is performed using an atmospheric pressure chemical ionization (APCI) source either in positive (APCI +) or negative (APCI -) ionization mode or an atmospheric pressure photoionization (APPI) source.

**Example 1**

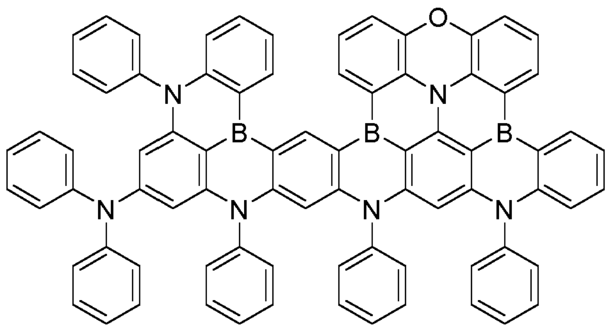

Example 1 was synthesized according to

***AAV1*** (77% yield), wherein 5-Chloro-N1,N1,N3,N3-tetraphenyl-1,3-benzenediamine [1630850-28-0] was used as compound **E1a** and Aniline [62-53-3] was used as compound **E1b; MS (HPLC-MS):** m/z (retention time) = 504.4 (4.04 min).
***AAV2*** (80% yield); **MS (HPLC-MS):** m/z (retention time) = 614 (5.1 min).
***AAV3*** (46% yield), wherein Aniline [62-53-3] was used as compound **E3; MS (HPLC-MS):** m/z (retention time) = 671.6 (4.68 min).
***AAV2a*** (54% yield), wherein Phenoxazine [135-67-1] was used as compound **E1a-a; MS (GC-MS):** m/z (retention time) = 373 (8.6 min).
***AAV3a*** (49% yield), wherein Diphenylamine [122-39-4] was used as compound **E3a; MS (GC-MS):** m/z (retention time) = 460 (11.95 min).
***AAV4*** (50% yield); **MS (HPLC-MS):** m/z (retention time) = 1096 (7.20 min).
***AAV5*** (8% yield). **MS (HPLC-MS):** m/z (retention time) = 1120 (8.47 min).
The emission maximum of example 1 (1% by weight in PMMA) is at 475 nm, the full width at half maximum (FWHM) is 0.15 eV (28 nm), the CIEx and $CIE_Y$ coordinates are 0 .12, and 0.23, respectively, the excited state lifetime is 4.7 $\mu$s.

**Example 2**

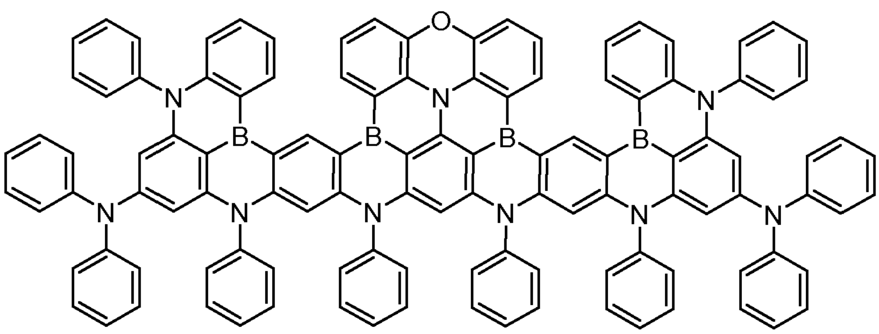

Example 2 was synthesized according to

***AAV1*** (77% yield), wherein 5-Chloro-N1,N1,N3,N3-tetraphenyl-1,3-benzenediamine [1630850-28-0] was used as compound **E1a** and Aniline [62-53-3] was used as compound **E1b; MS (HPLC-MS):** m/z (retention time) = 504.4

(4.05 min).

***AAV2*** (80% yield); **MS (HPLC-MS):** m/z (retention time) = 615 (5.12 min).

***AAV3*** (46% yield), wherein Aniline [62-53-3] was used as compound **E3; MS (HPLC-MS):** m/z (retention time) = 671.9 (4.76 min).

***AAV6*** (25% yield), wherein Phenoxazine [135-67-1] was used as compound **E4; MS (GC-MS):** m/z (retention time) = 417 (9.04 min).

***AAV7*** (80% yield); **MS (HPLC-MS):** m/z (retention time) = 1598.5 (8.27 min).

***AAV8***(1% yield). **MS (HPLC-MS):** m/z (retention time) = 1629 (9.32 min).

The emission maximum of example 2 (1% by weight in PMMA) is at 480 nm, the full width at half maximum (FWHM) is 0.13 eV (24 nm), the CIEx and $CIE_Y$ coordinates are 0 .16, and 0.36, respectively, the excited state lifetime is 1.25 μs.

**Comparative Example C1**

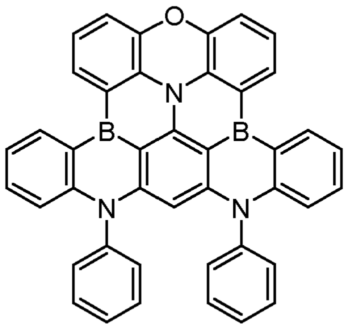

The emission maximum of example C1 (1% by weight in PMMA) is at 452 nm, the full width at half maximum (FWHM) is 0.23 eV (40 nm), the CIEx and $CIE_Y$ coordinates are 0.15, and 0.11, respectively, the excited state lifetime is 0.45 ms.

**Additional Examples of Organic Molecules of the Invention**

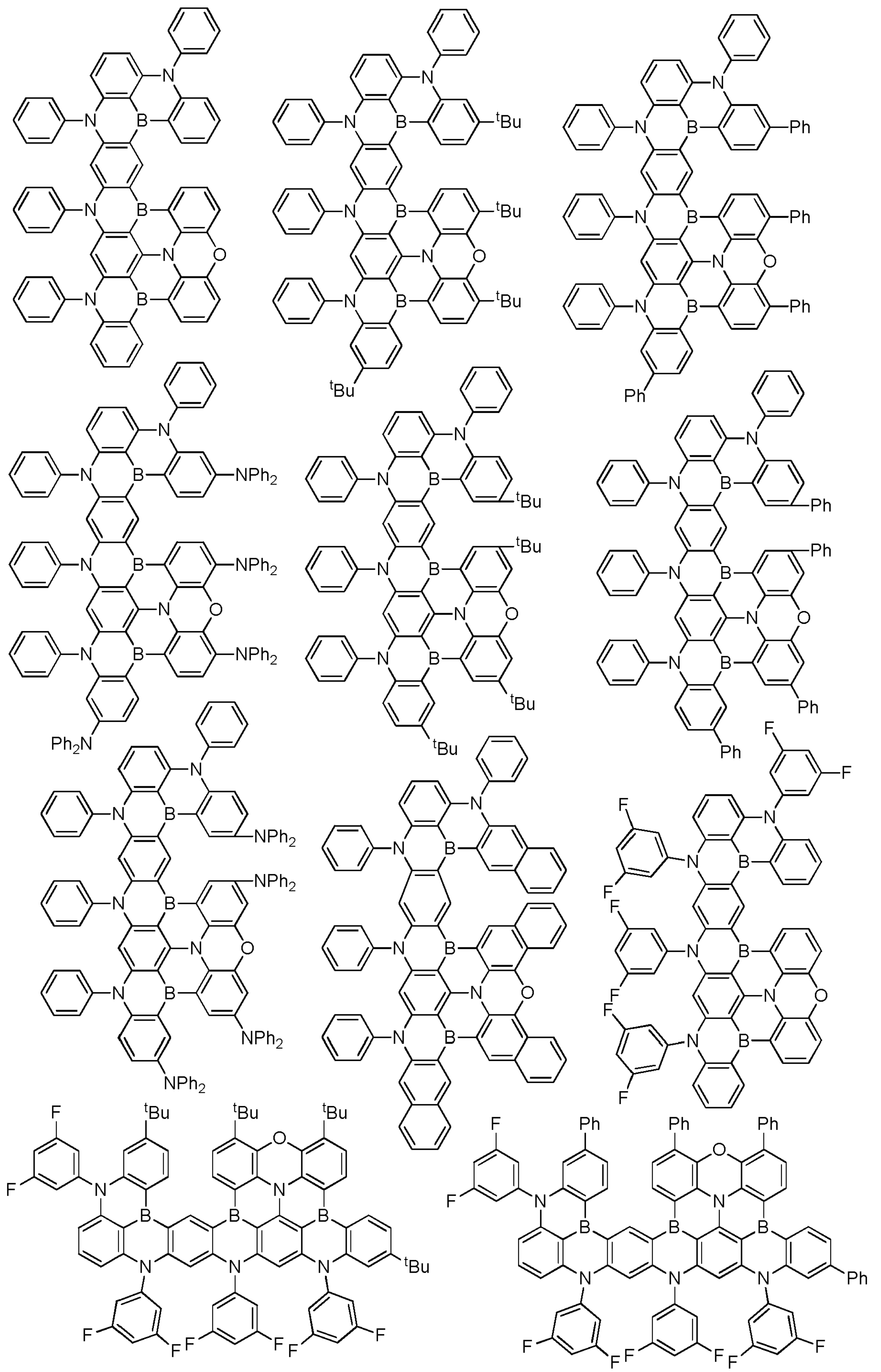

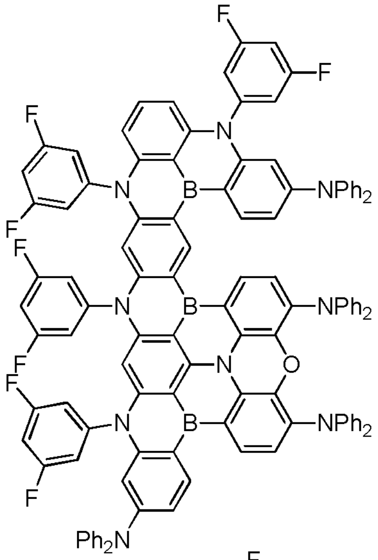

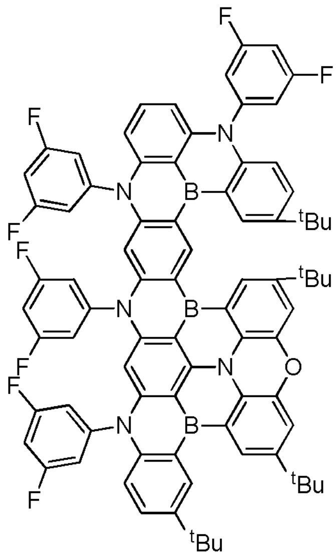

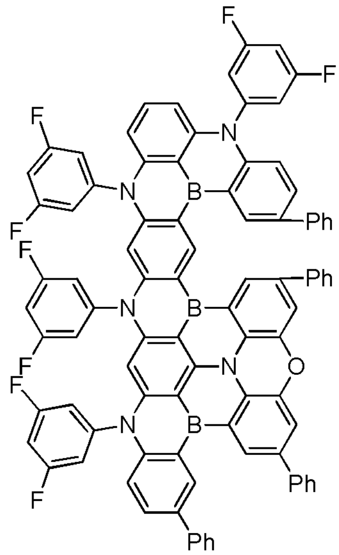

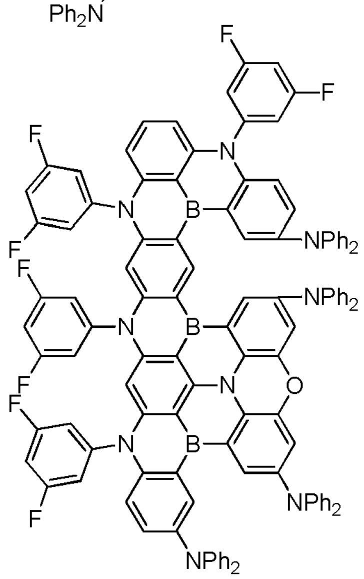

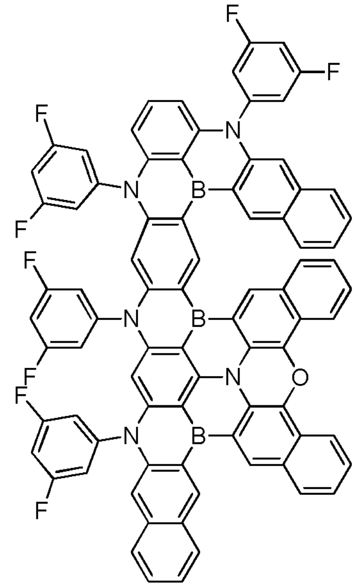

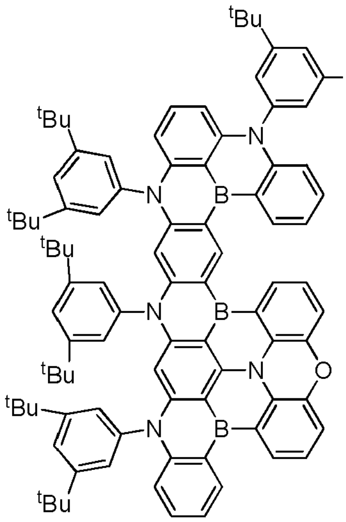

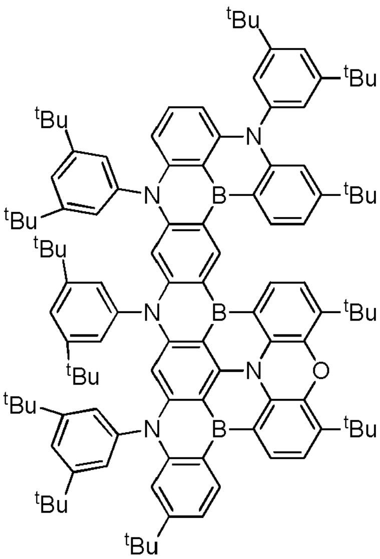

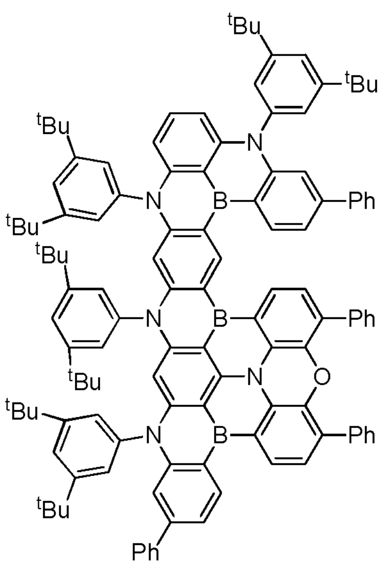

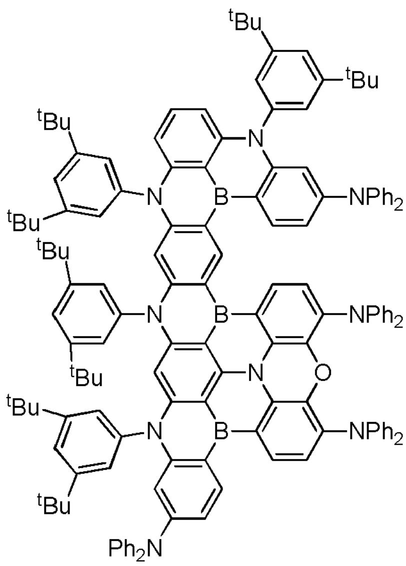

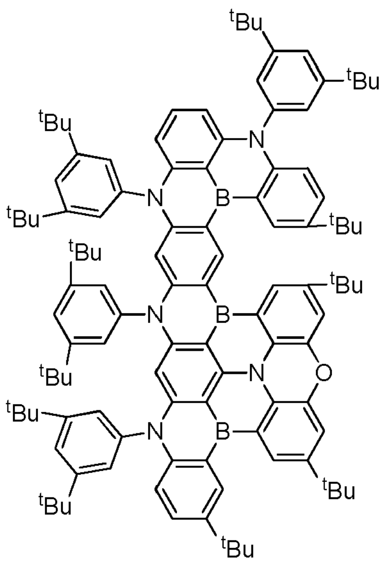

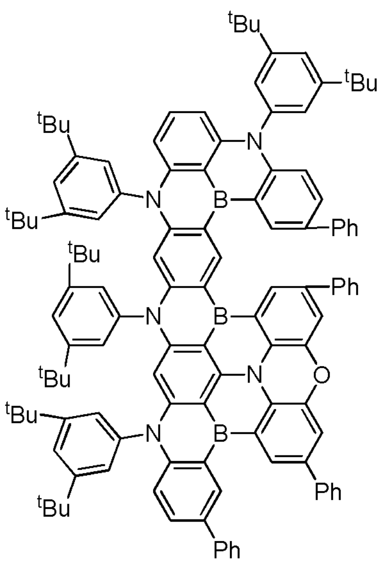

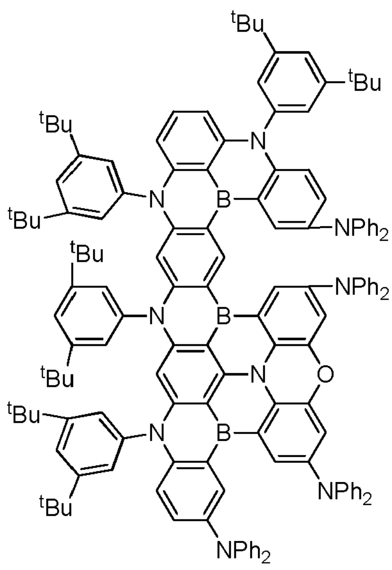

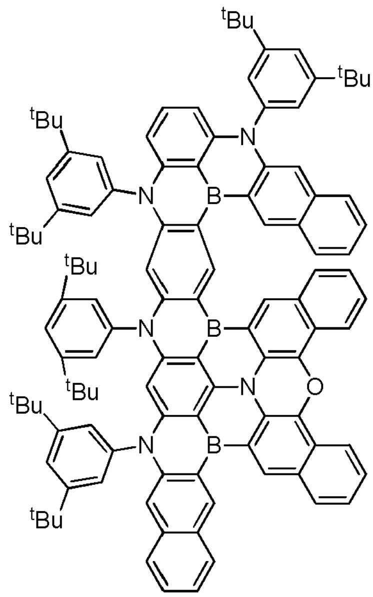

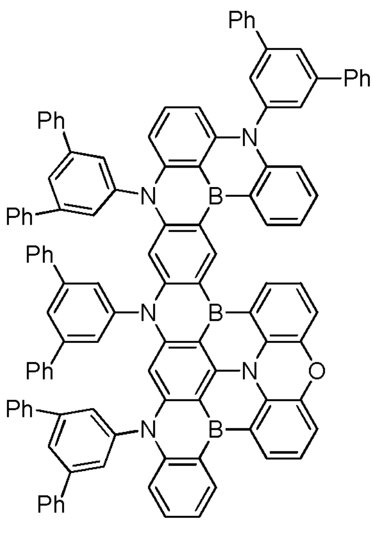

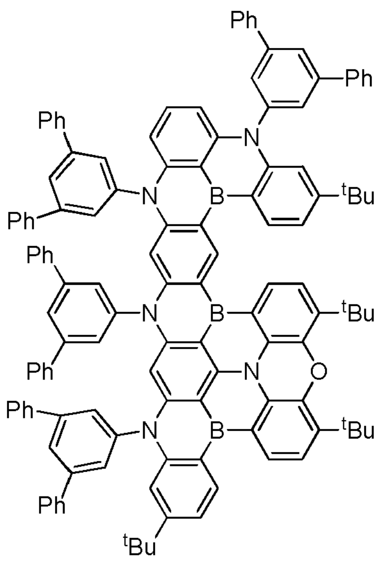

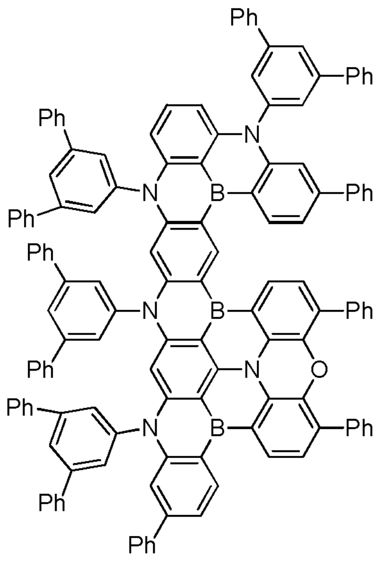
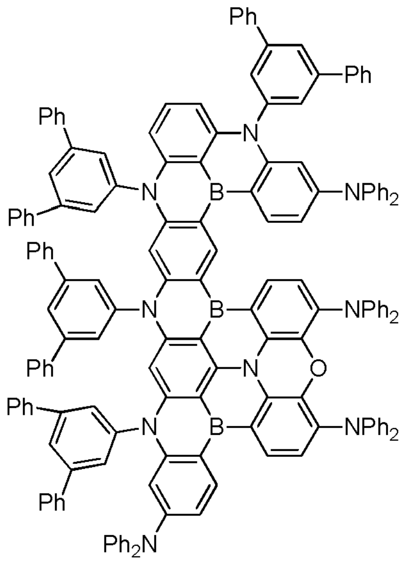
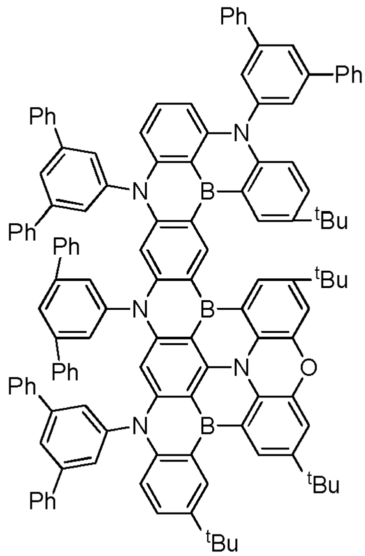

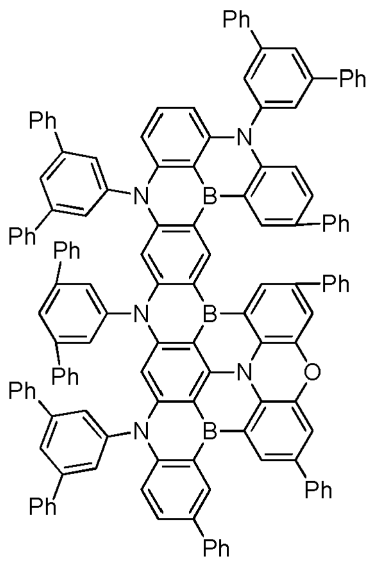
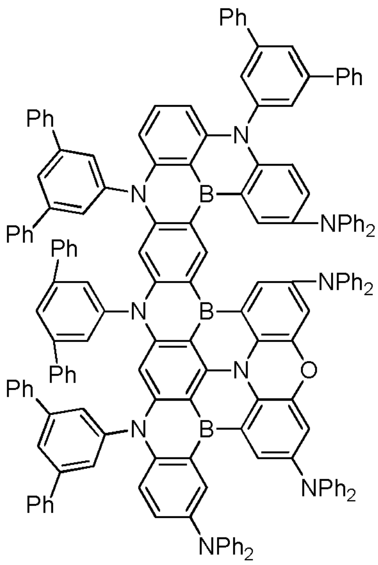
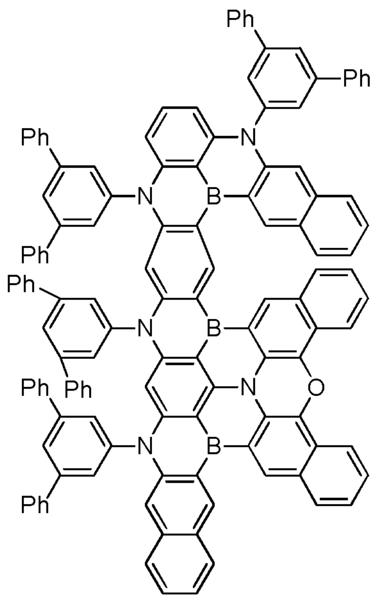

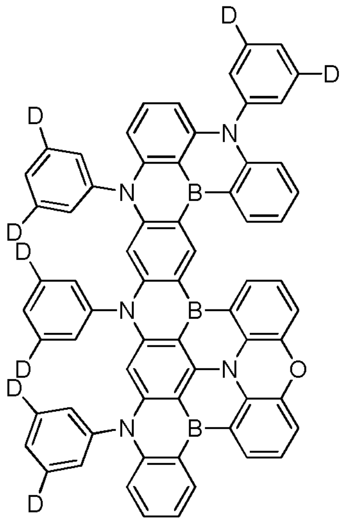

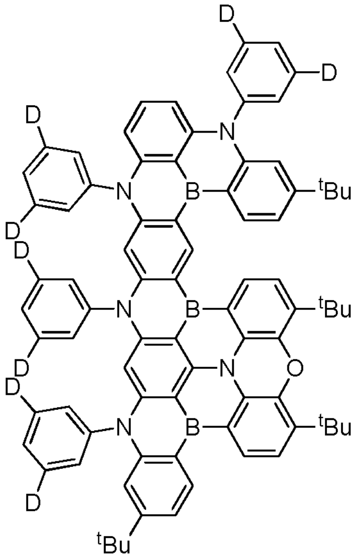

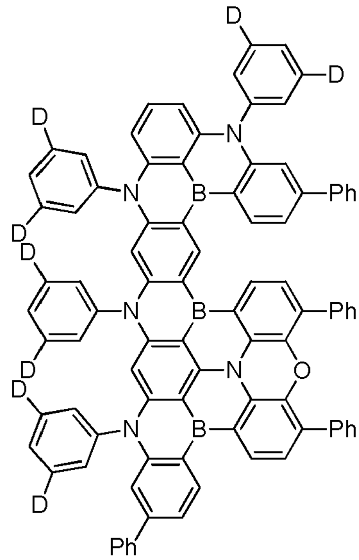

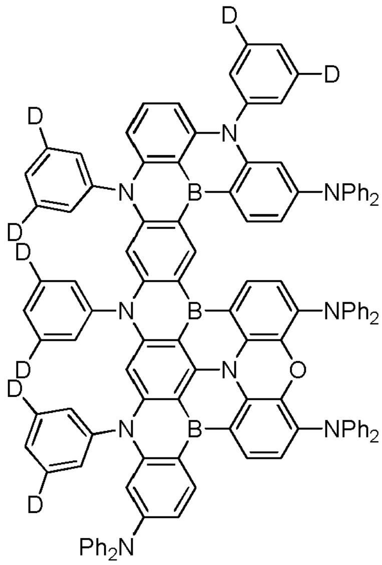

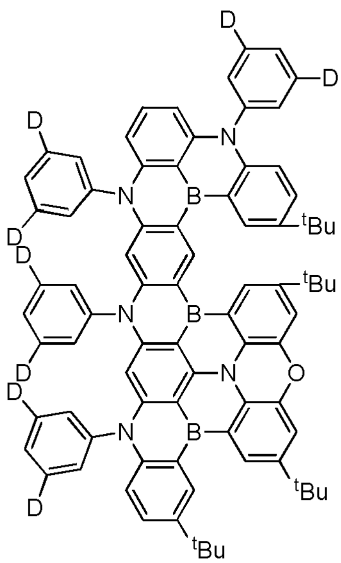

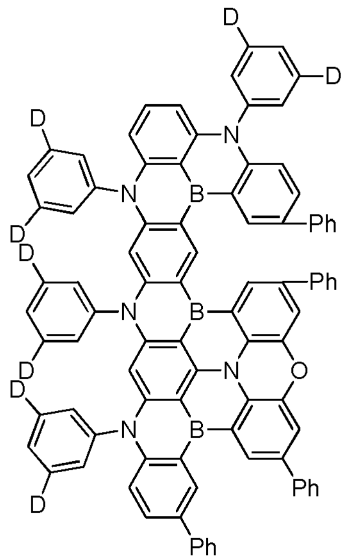

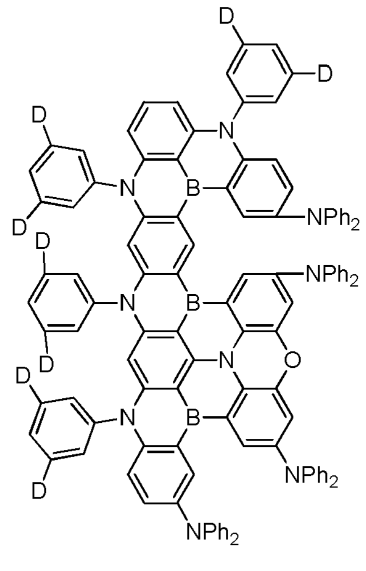

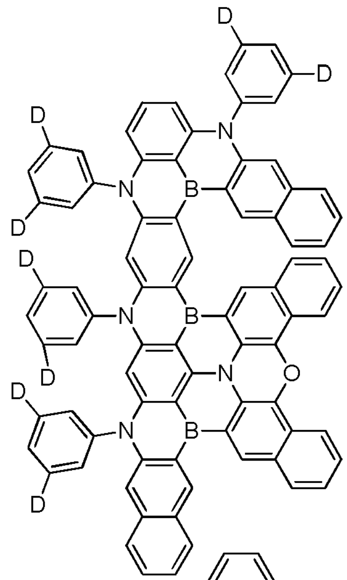

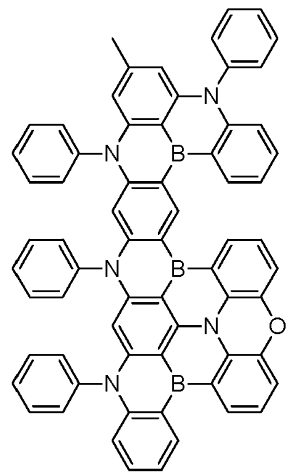

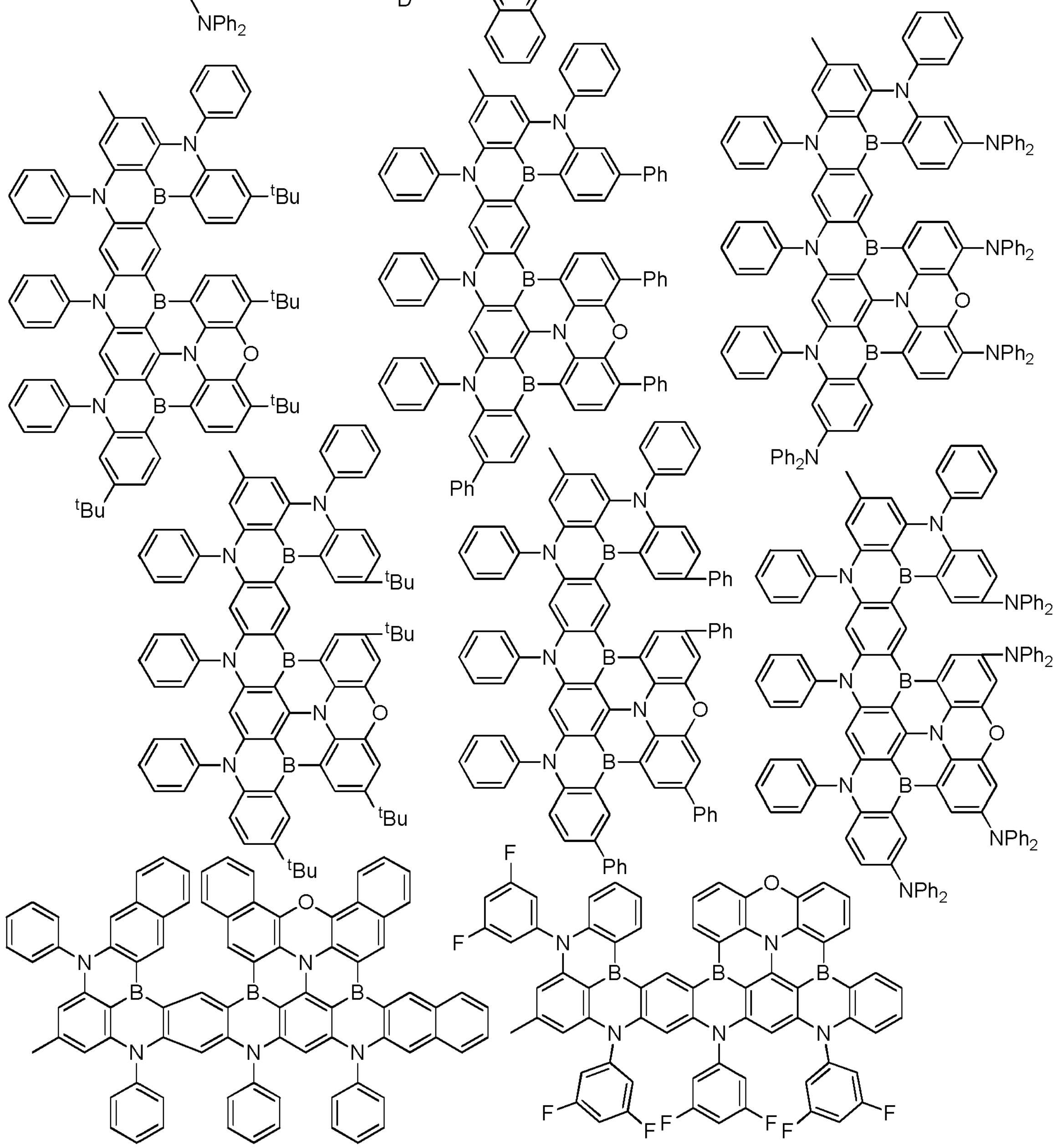

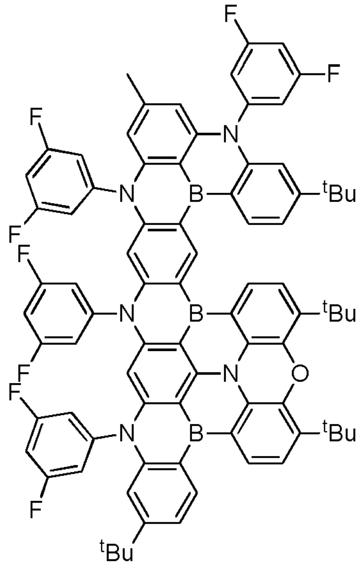

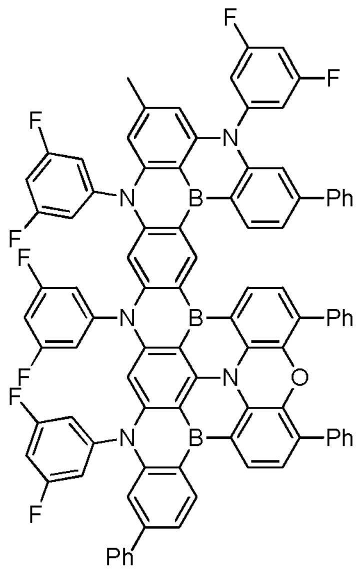

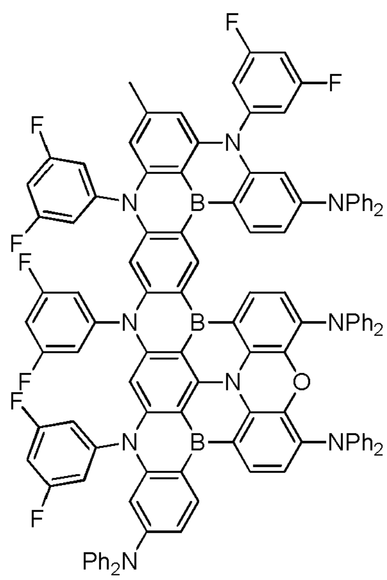

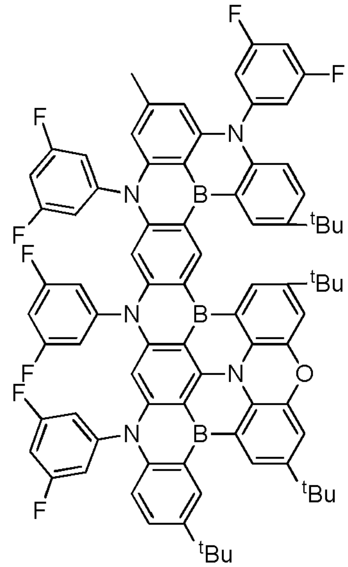

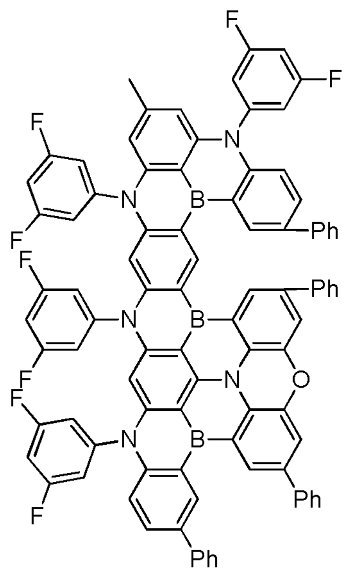

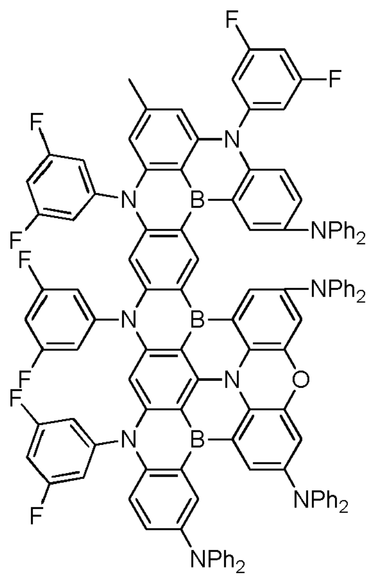

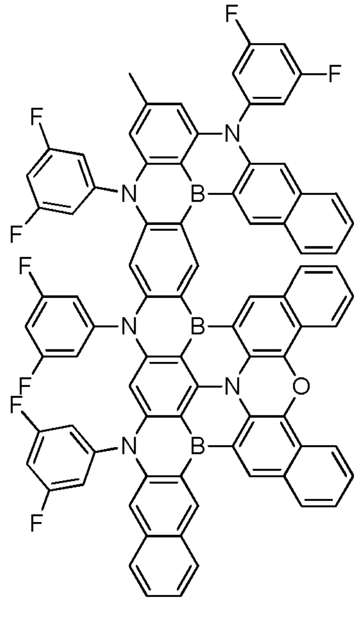

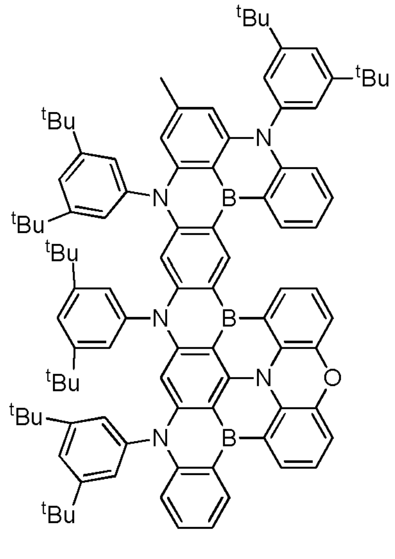

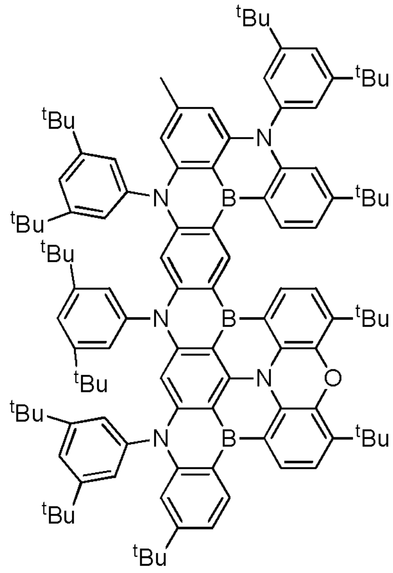

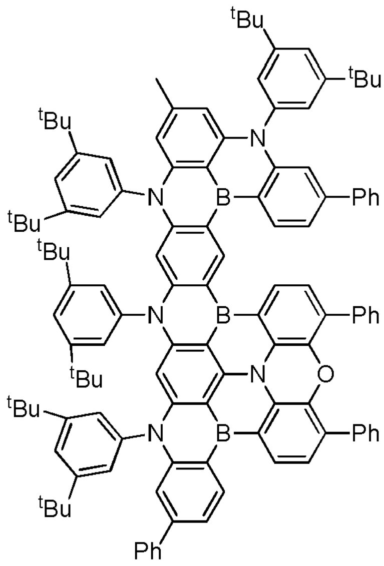

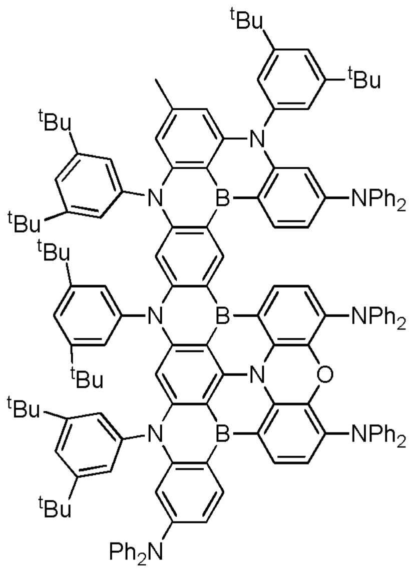

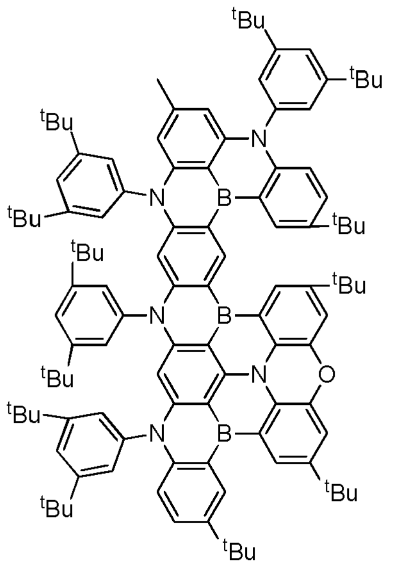

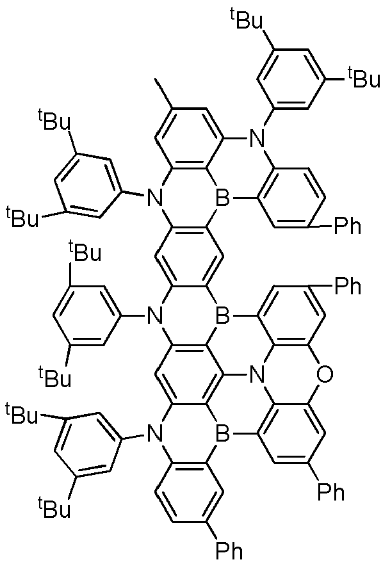

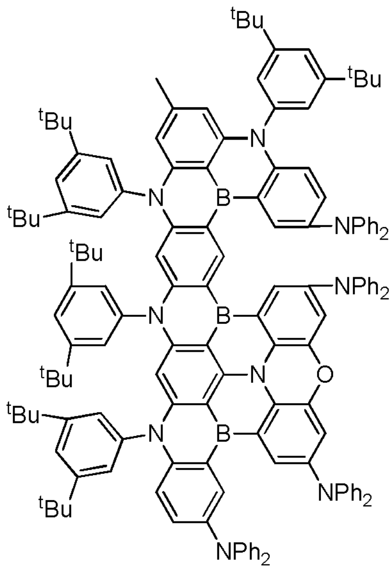

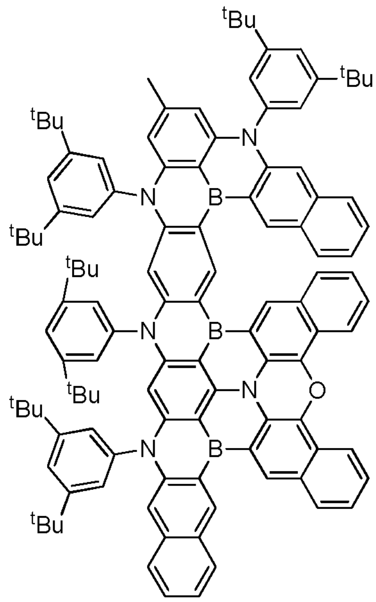

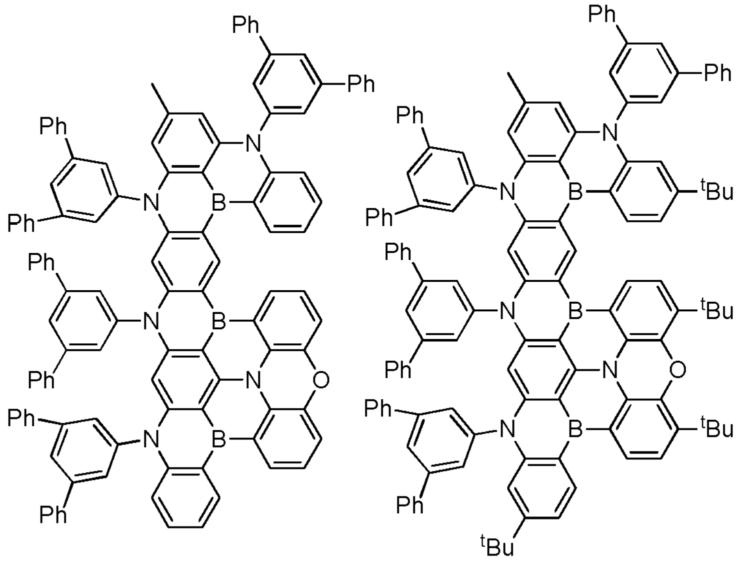

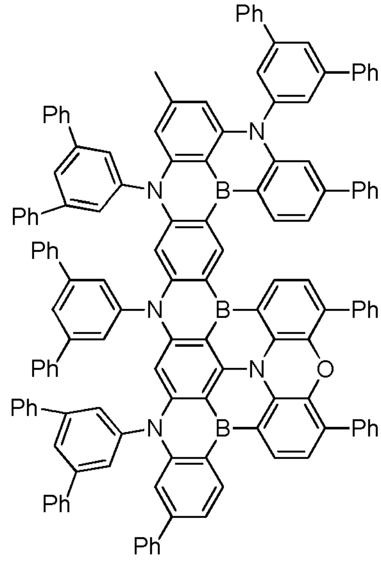

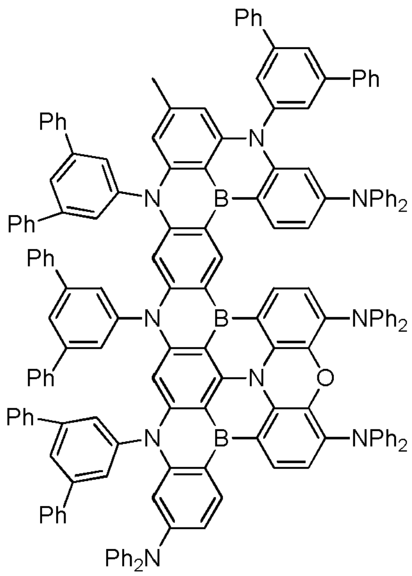

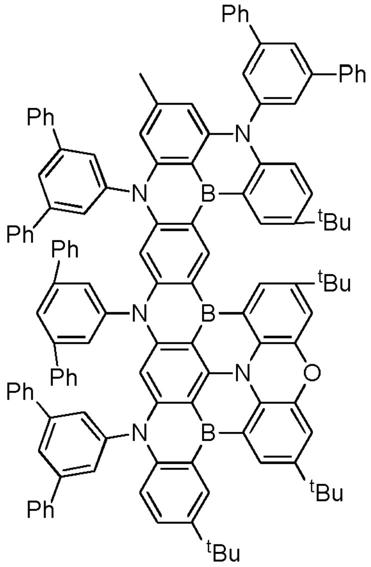

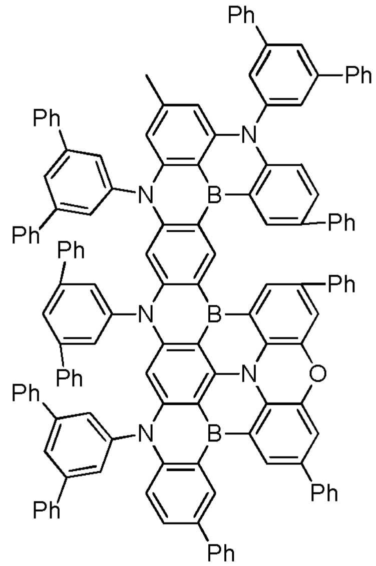

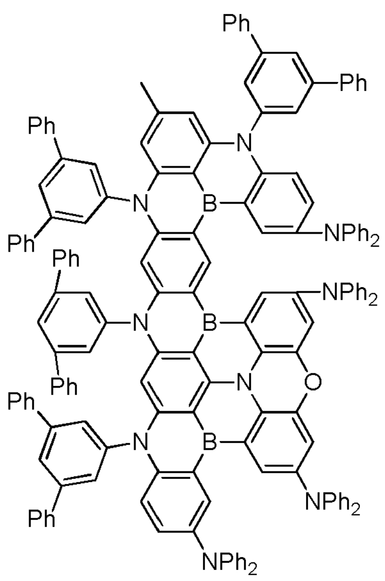

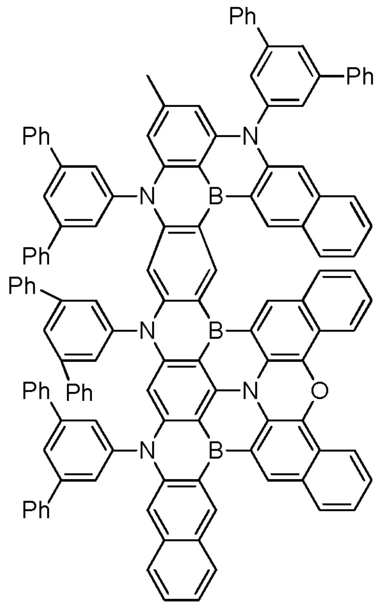

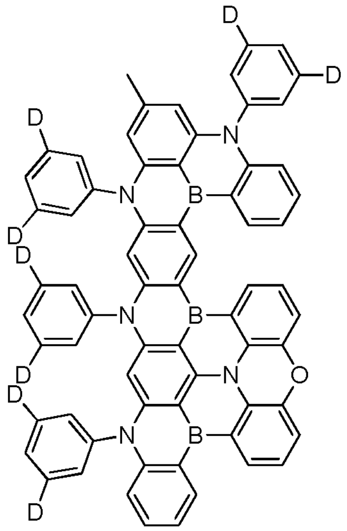

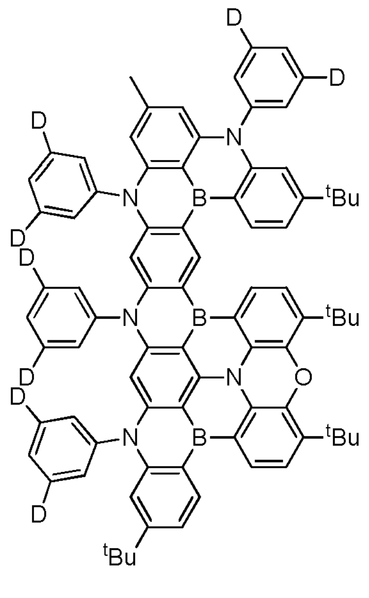

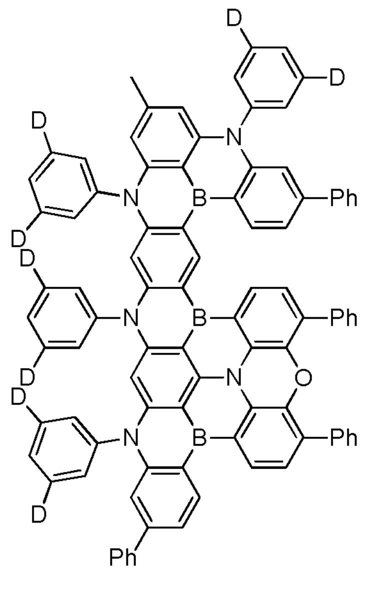

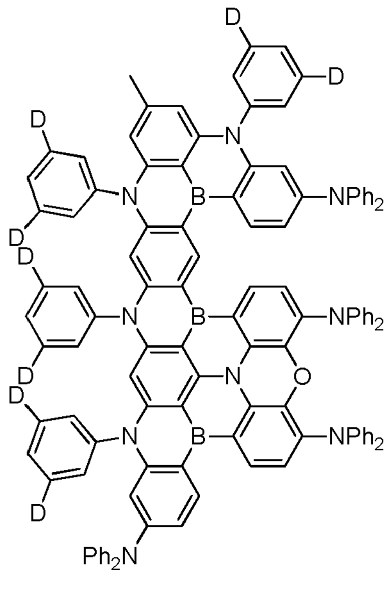

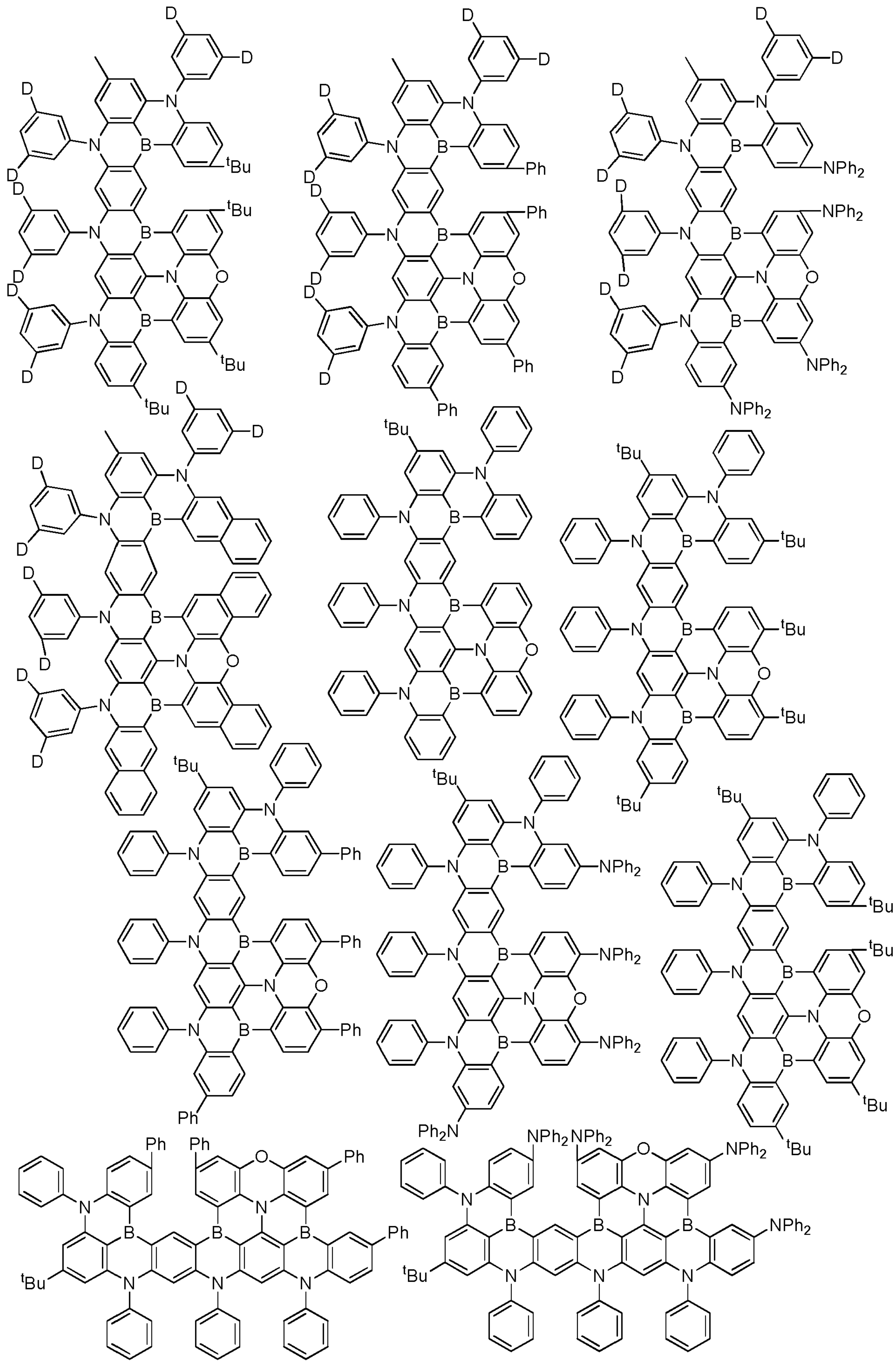

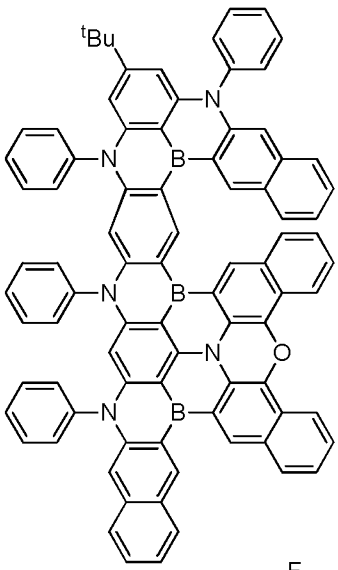

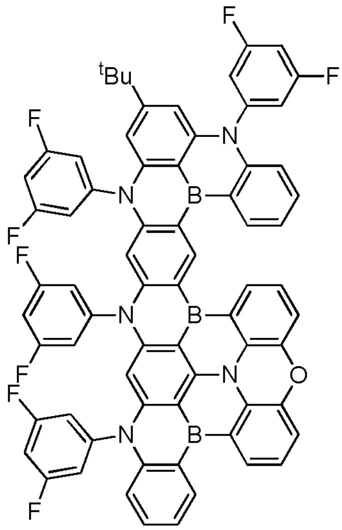

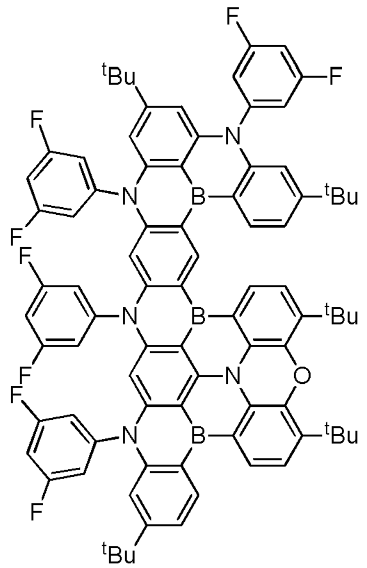

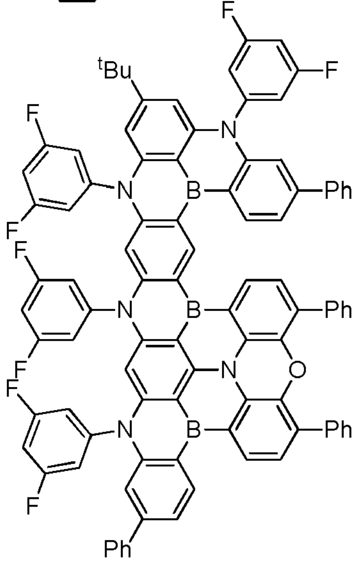

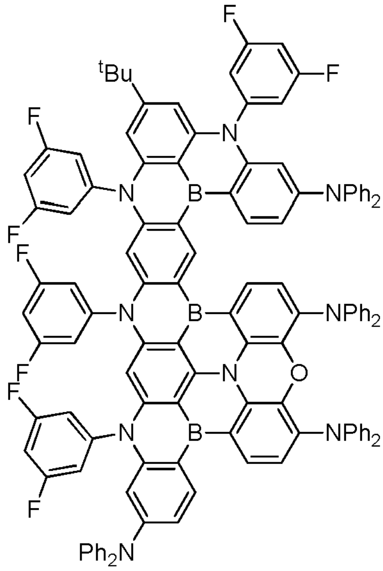

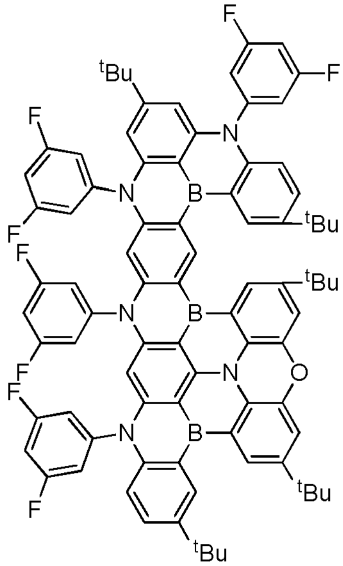

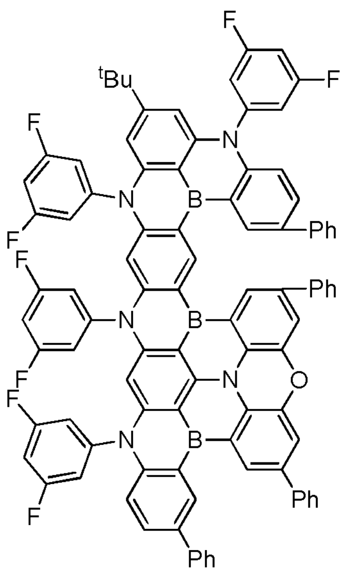

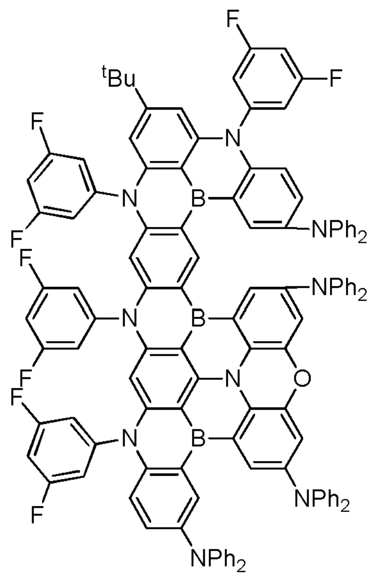

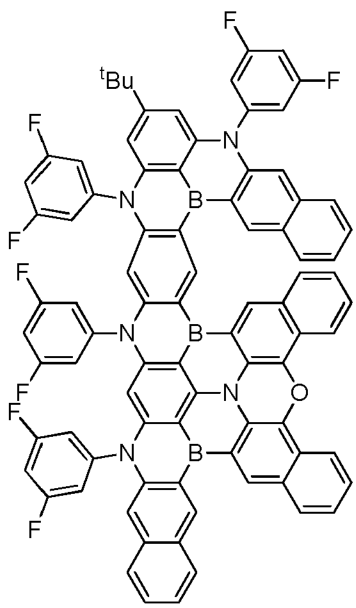

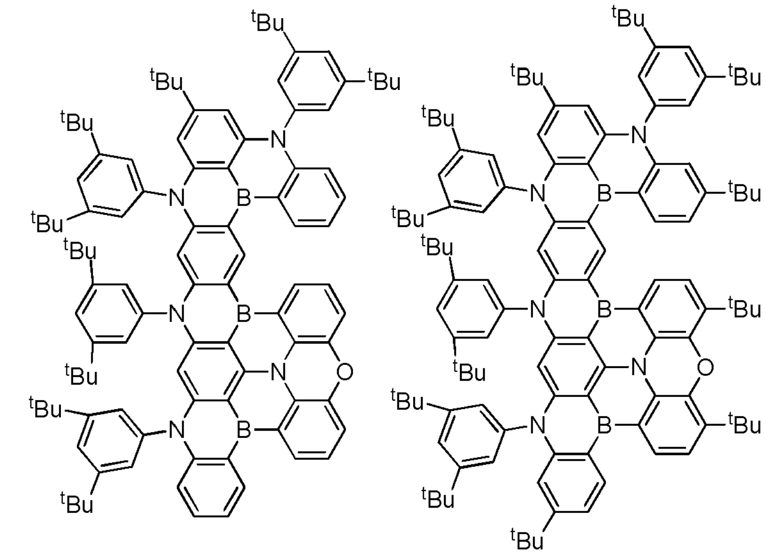

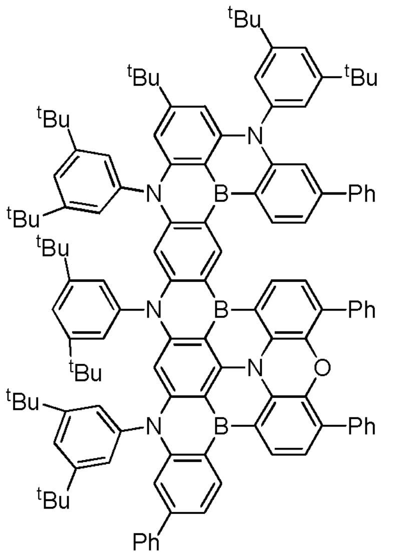

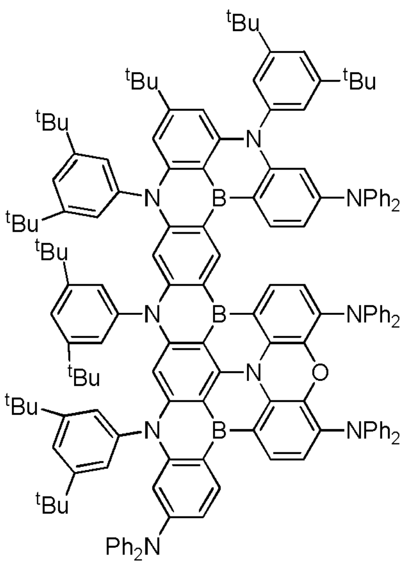

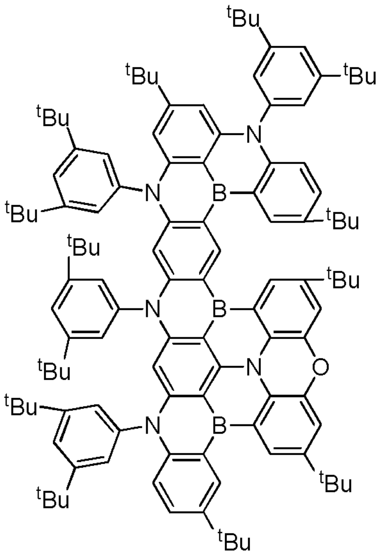

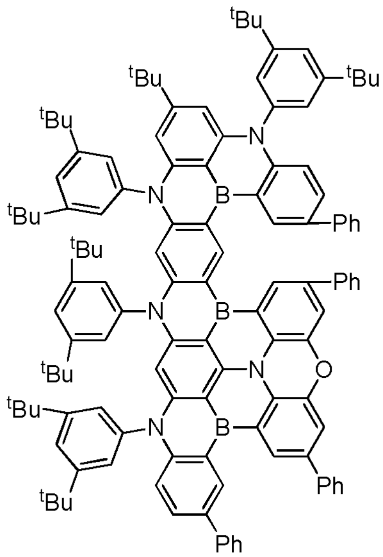

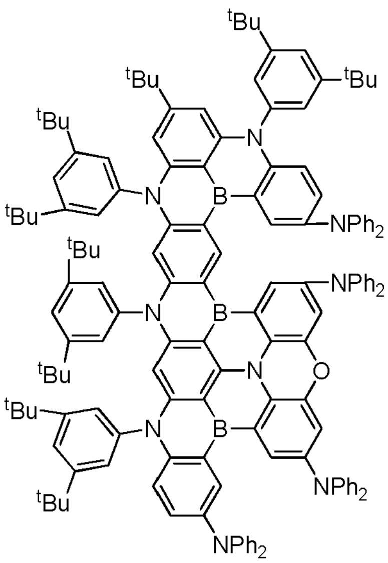

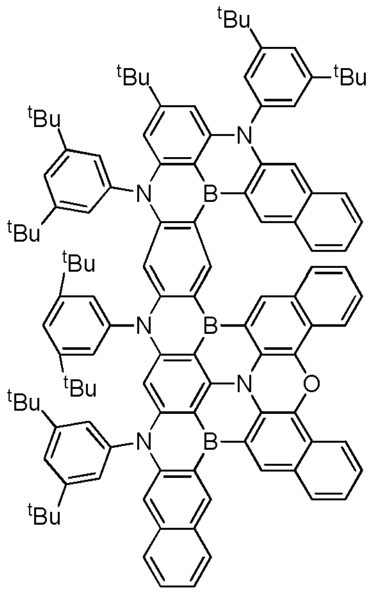

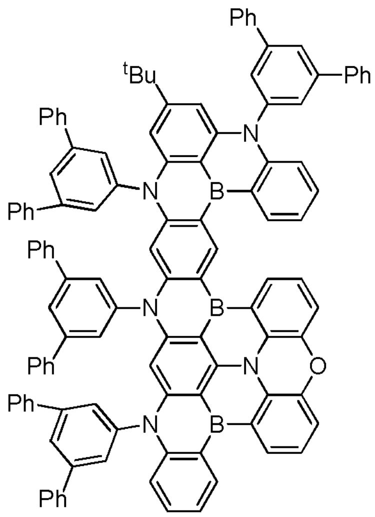

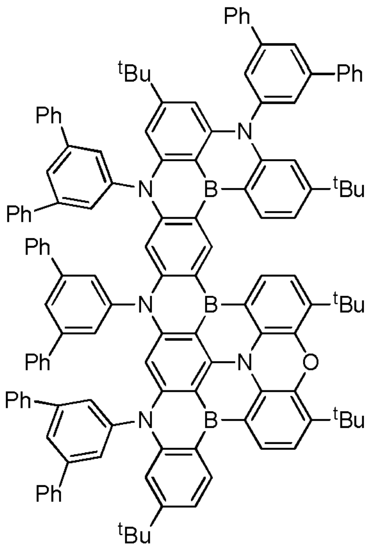

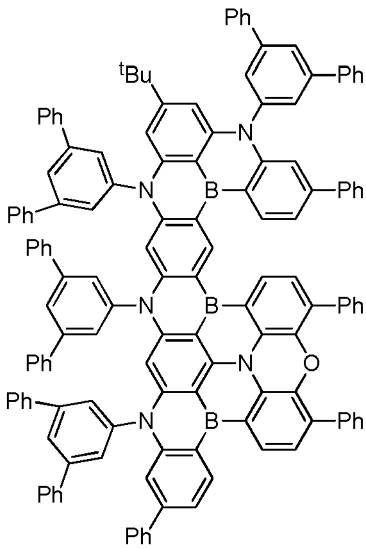

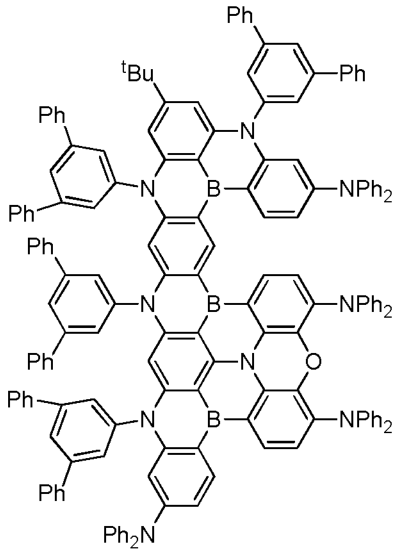

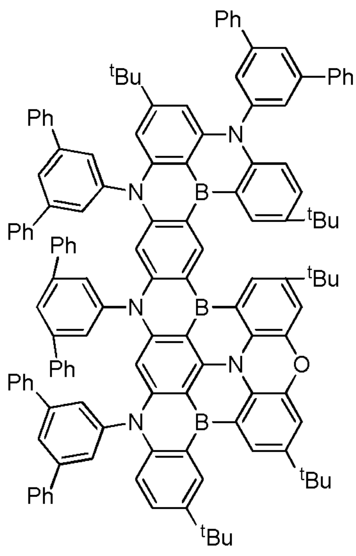
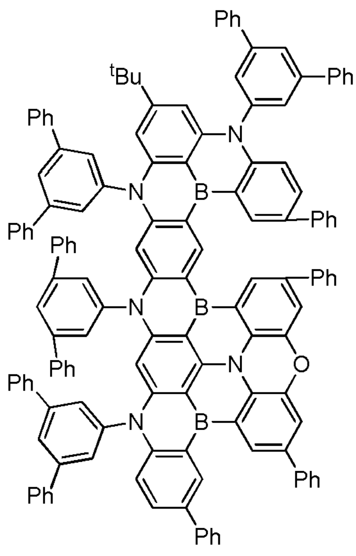
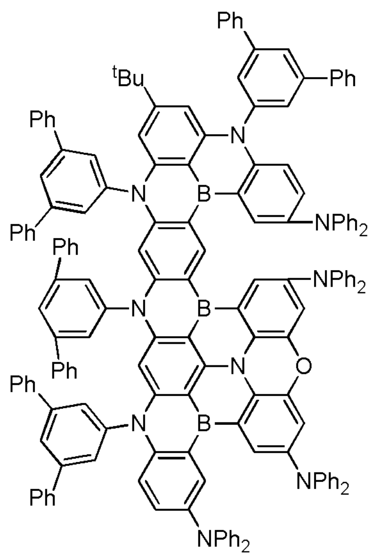

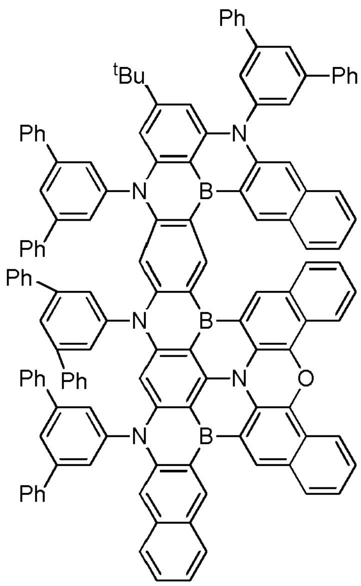
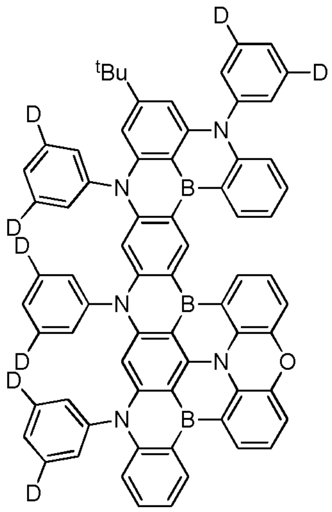
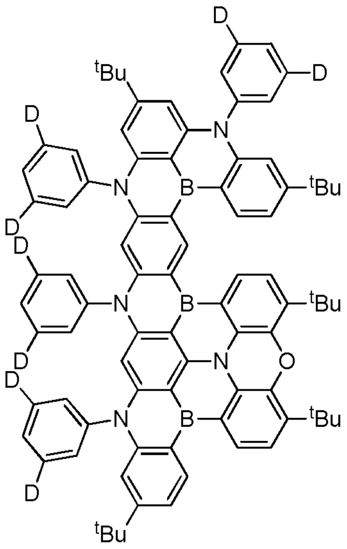

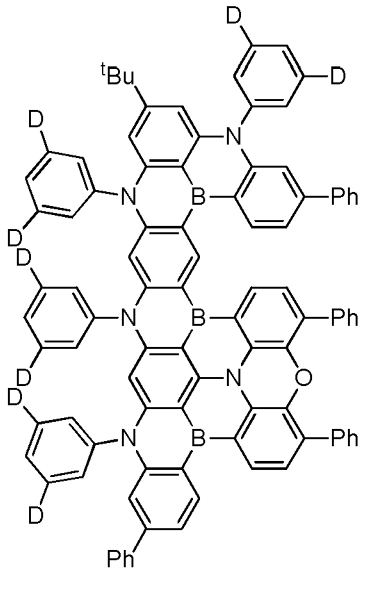

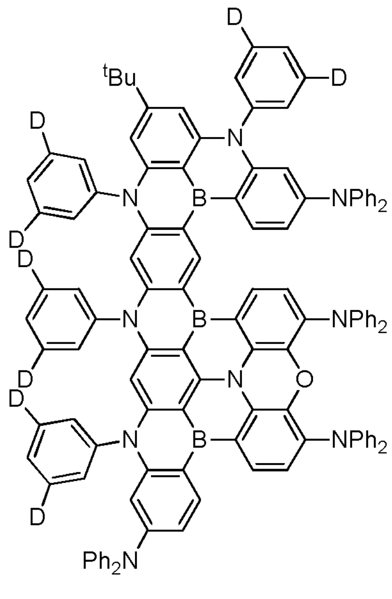

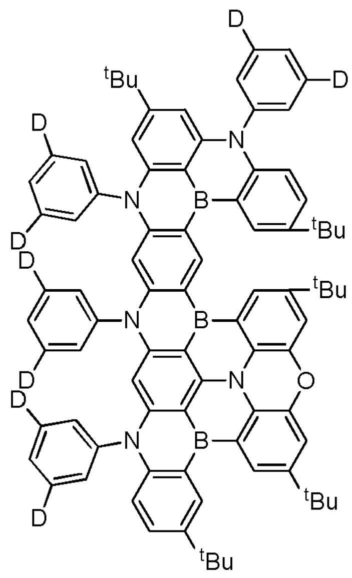

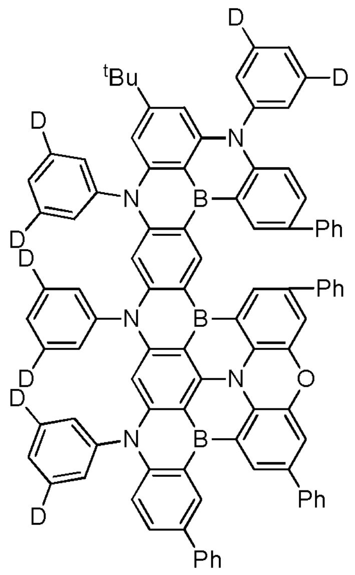

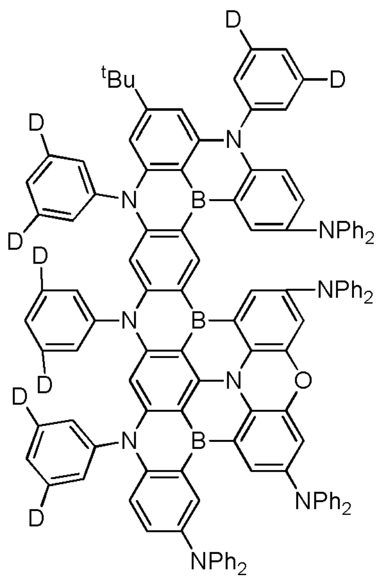

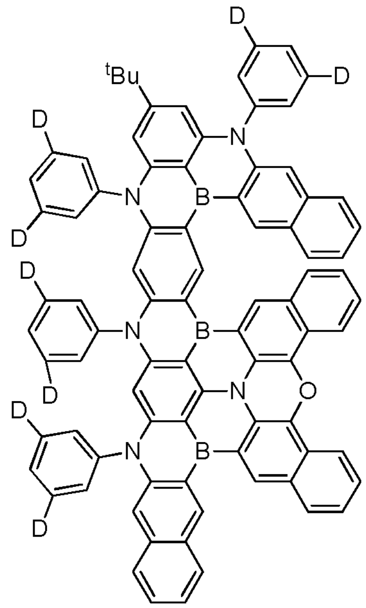

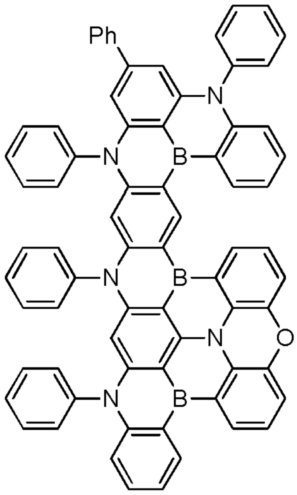

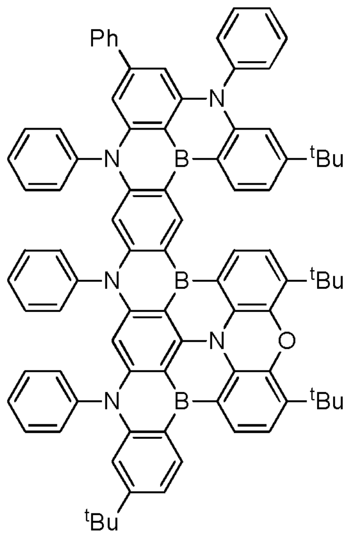

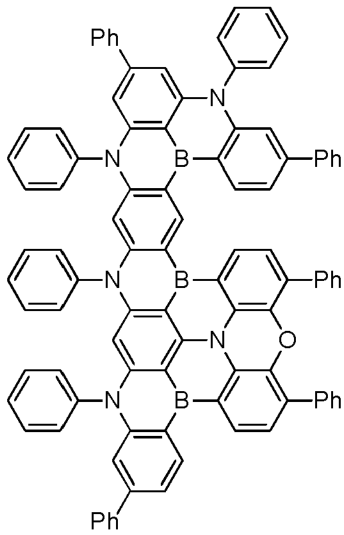

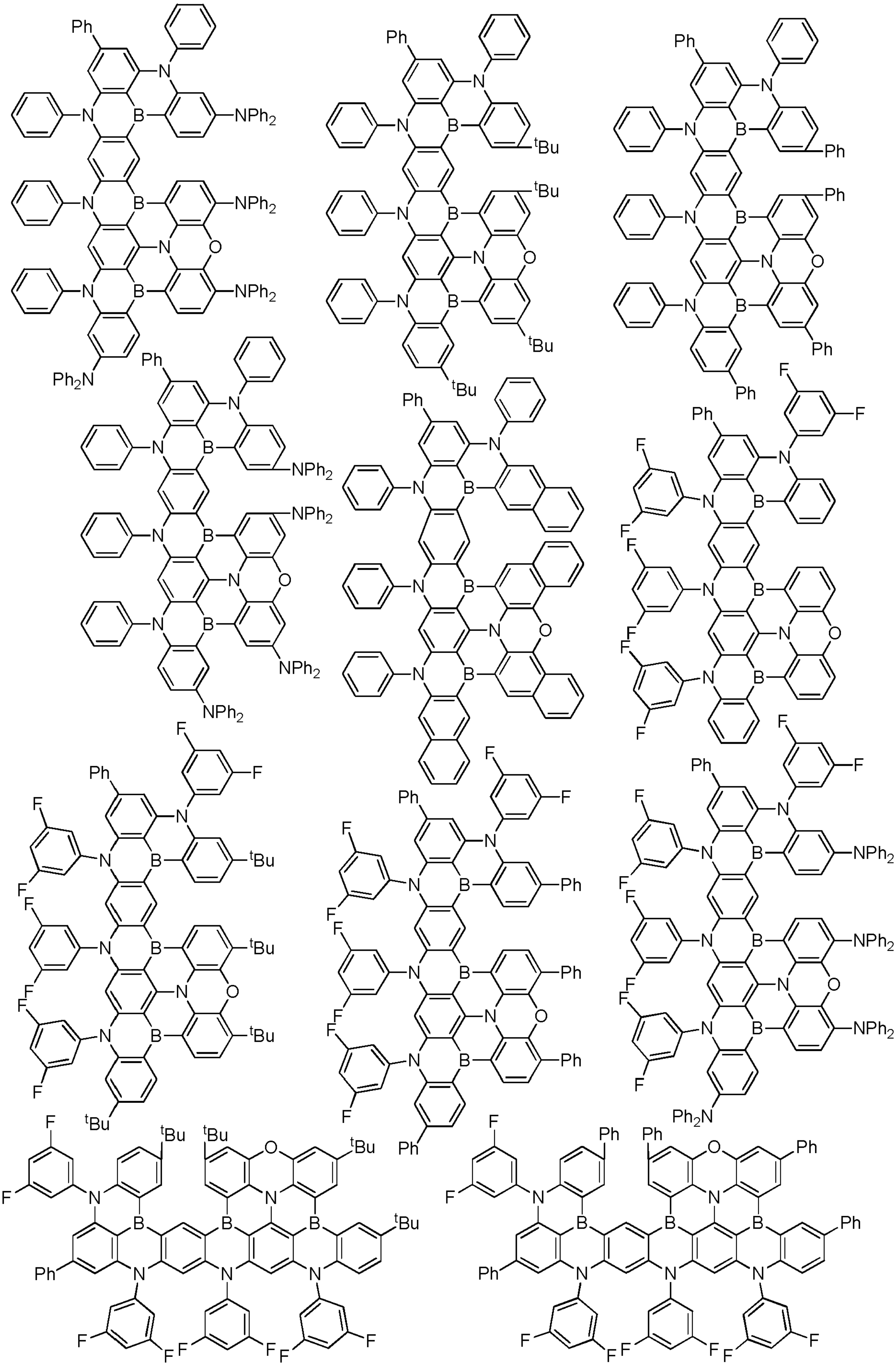

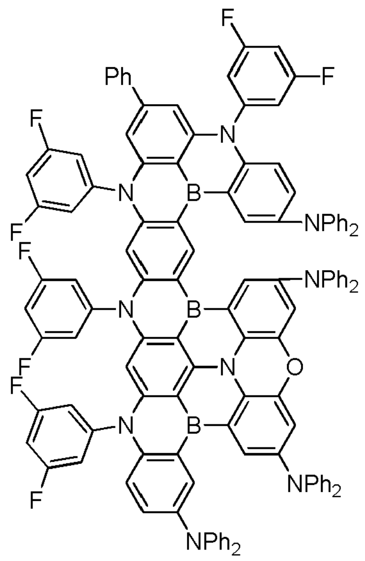

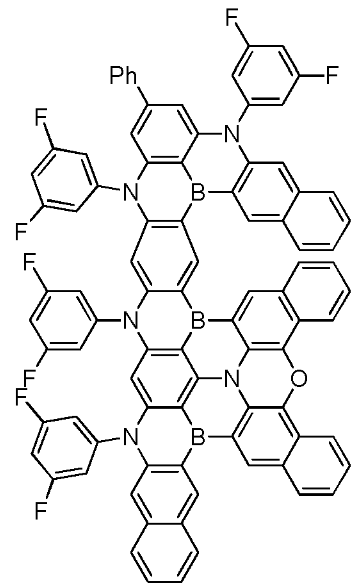

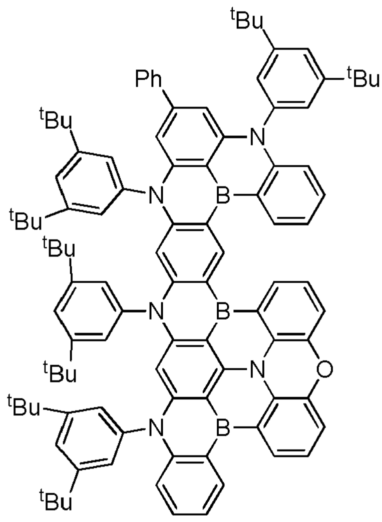

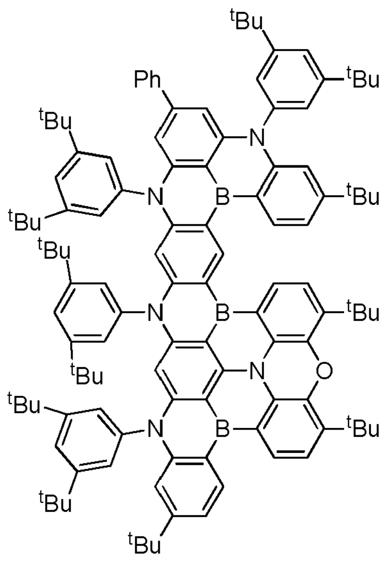

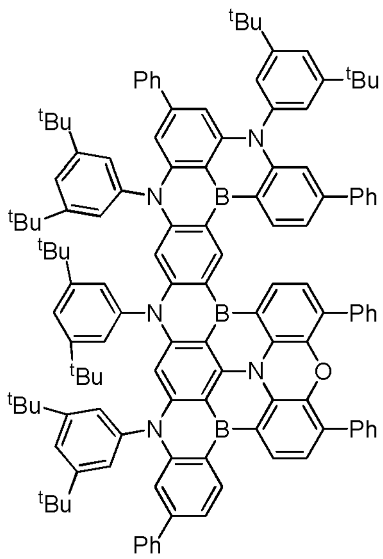

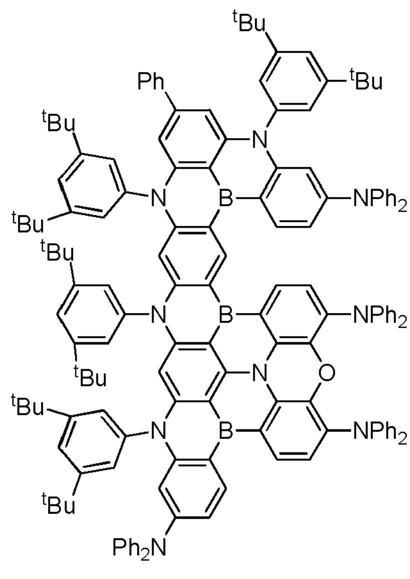

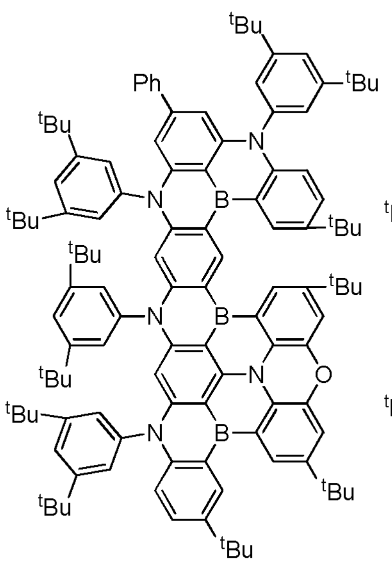

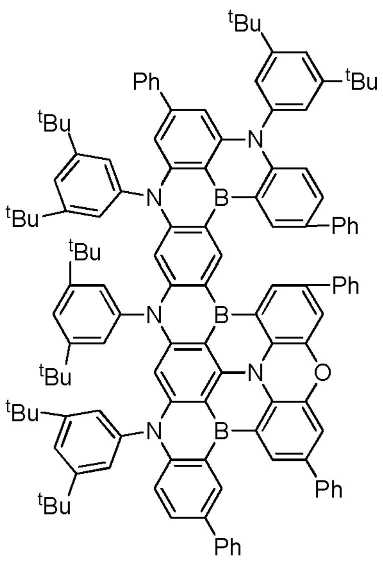

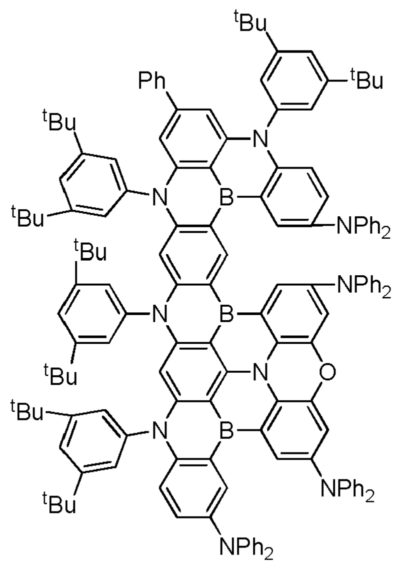

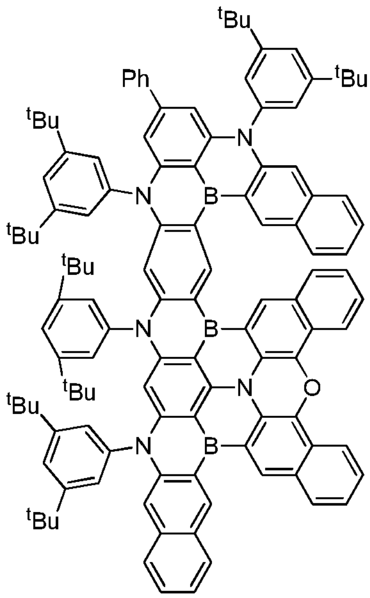

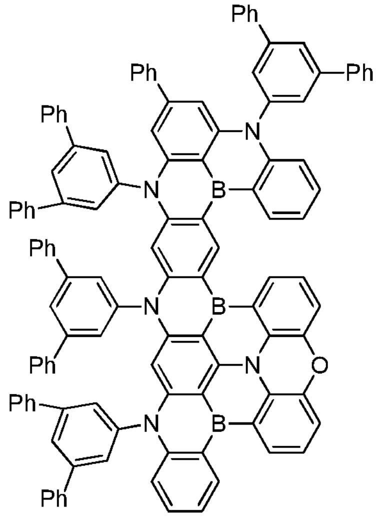

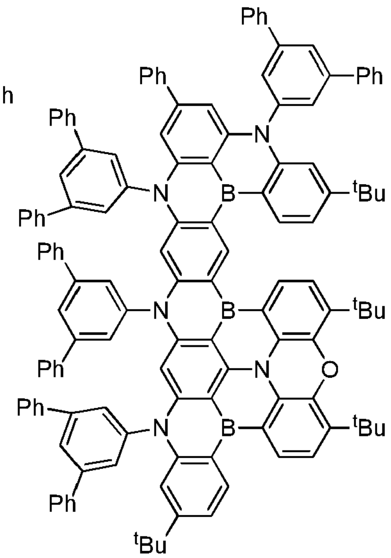

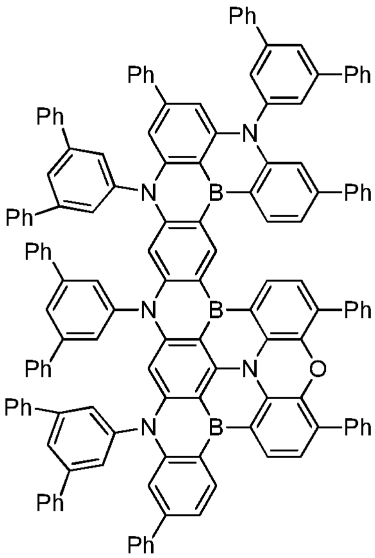

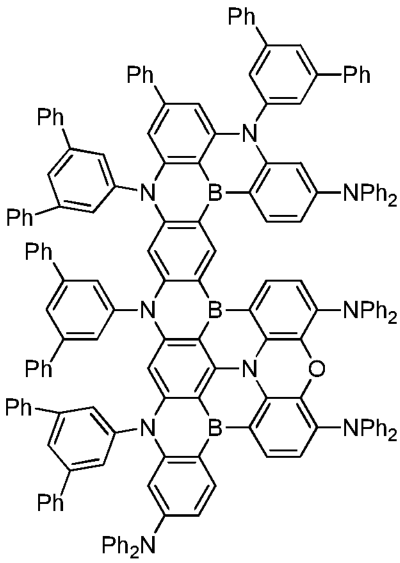

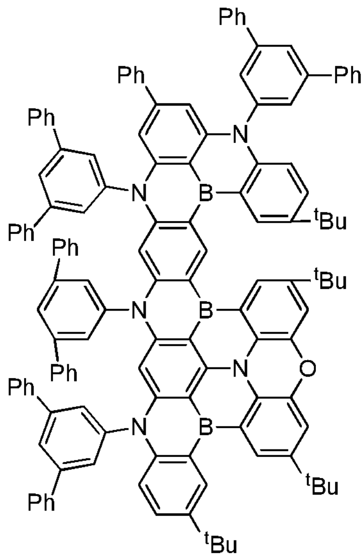

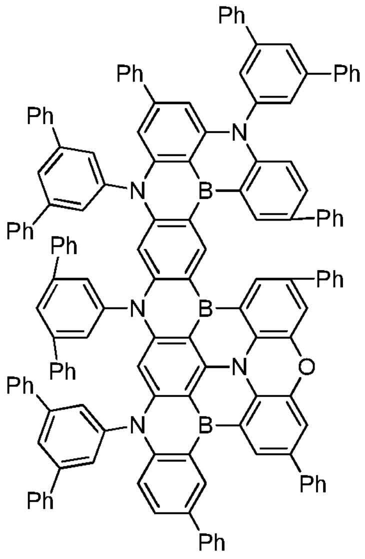

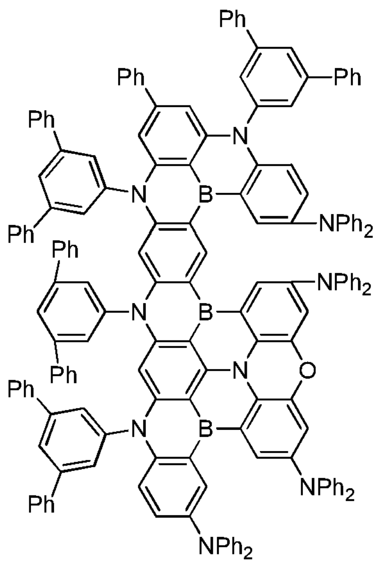

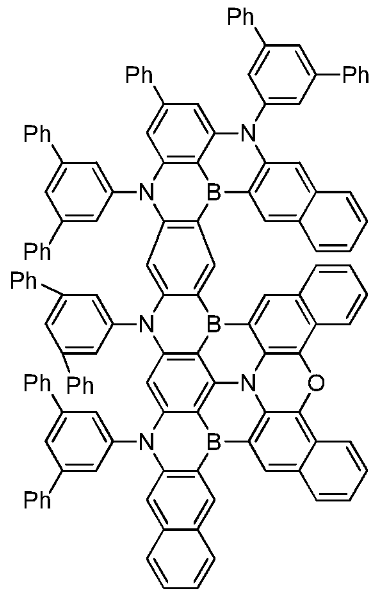

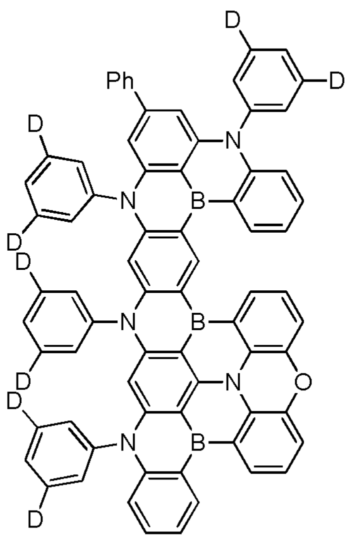

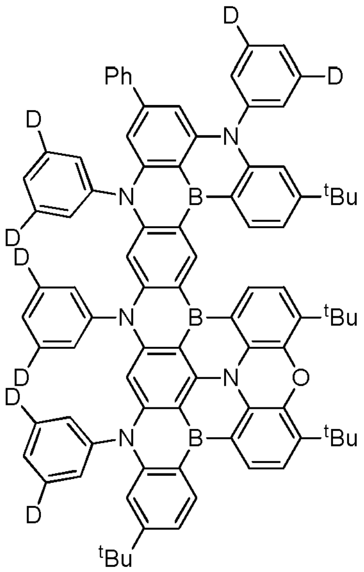

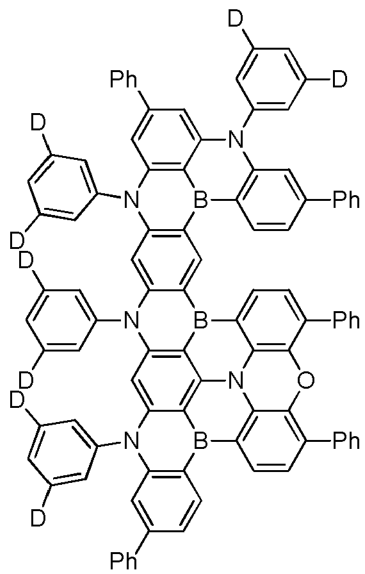

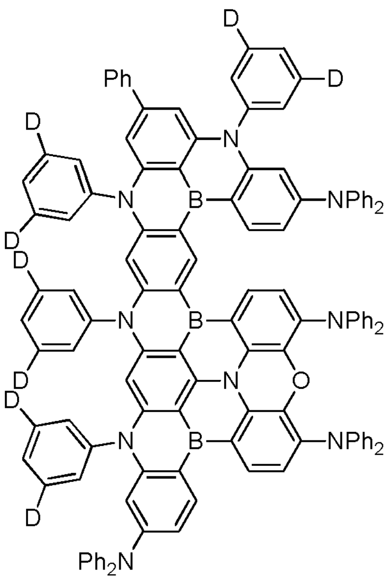

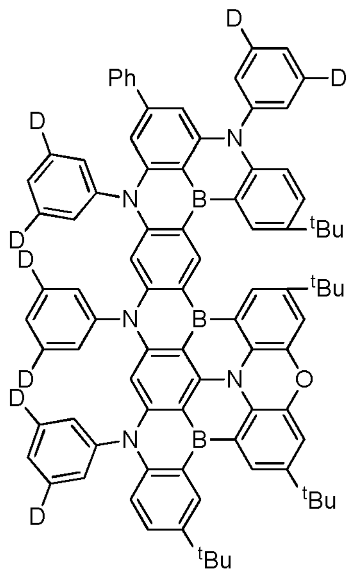

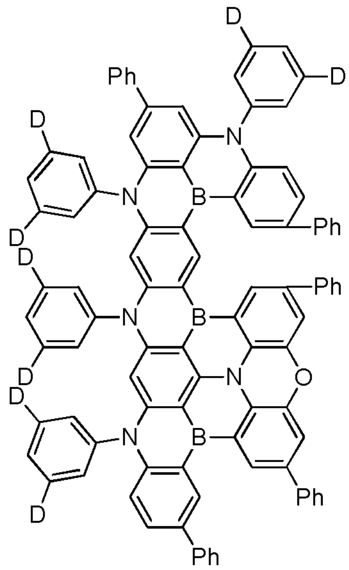

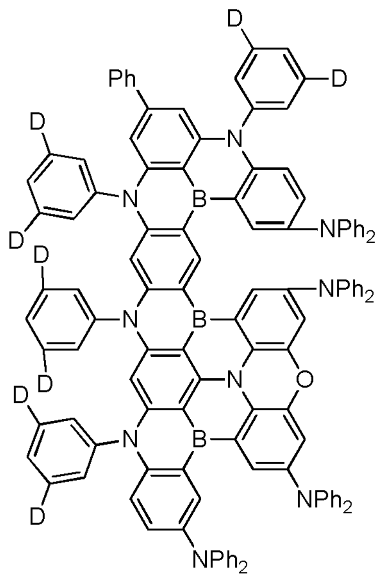

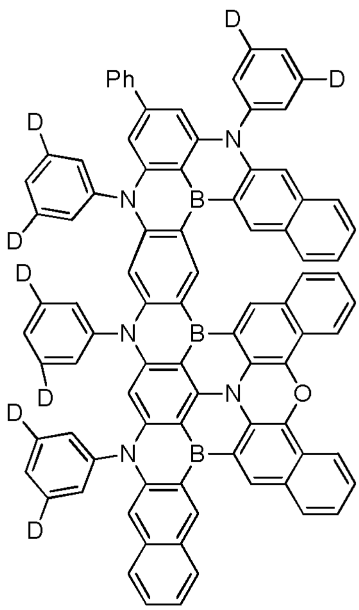

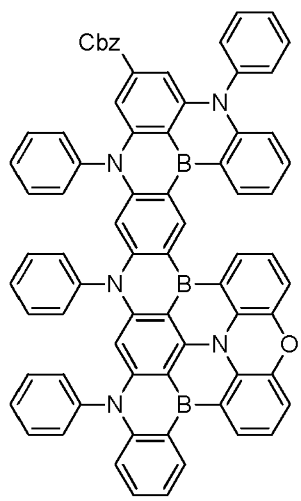

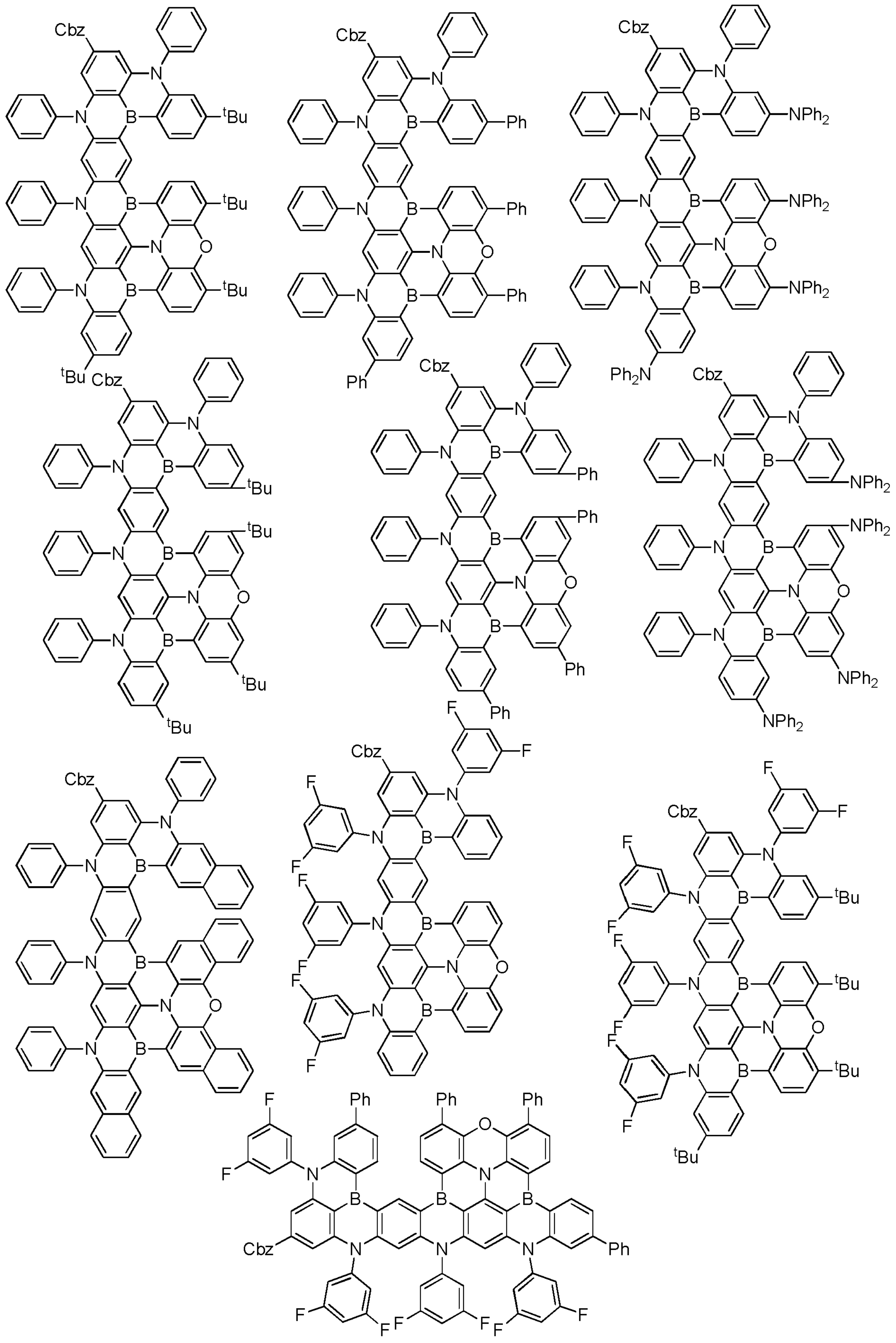

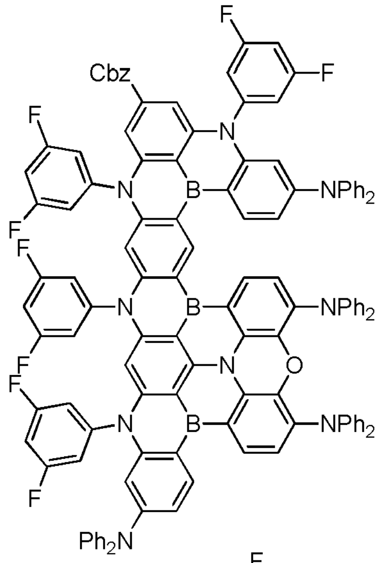
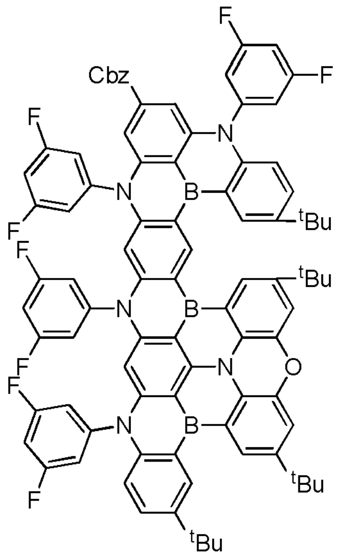
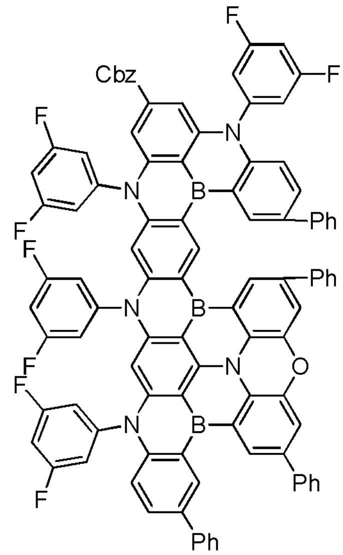
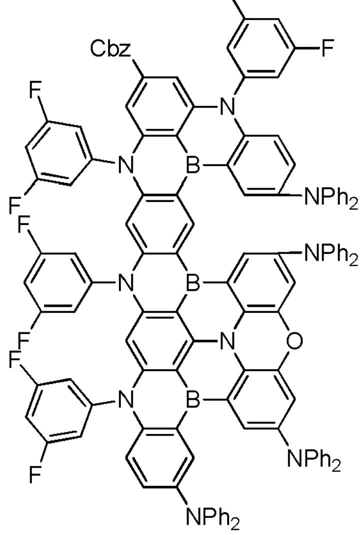
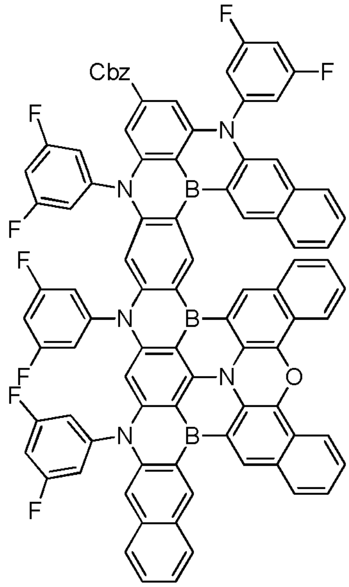
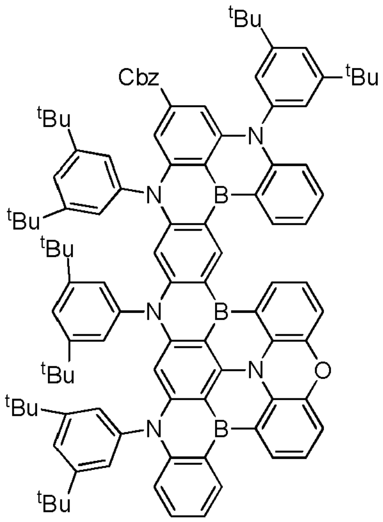
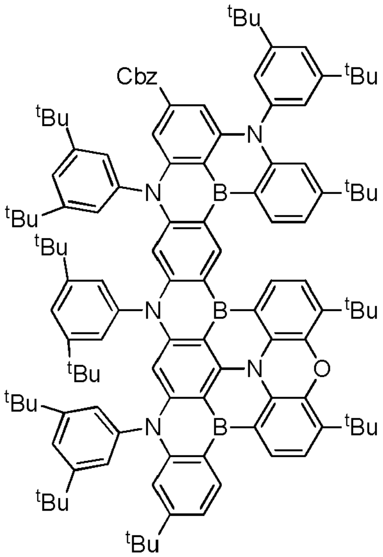
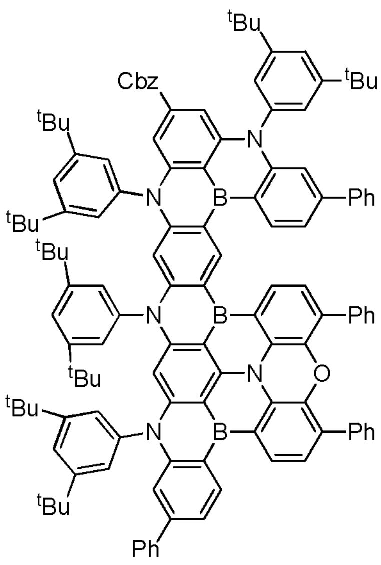
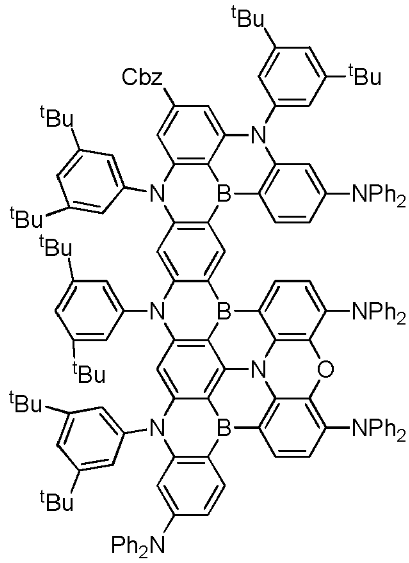

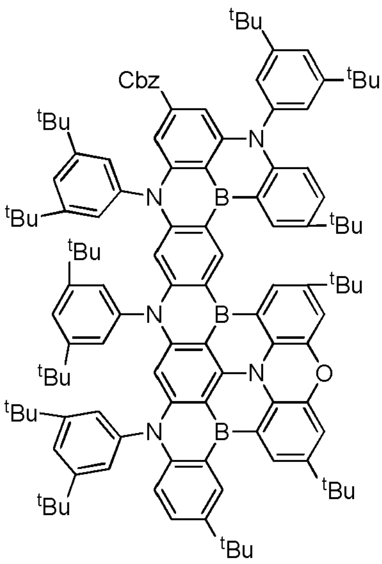

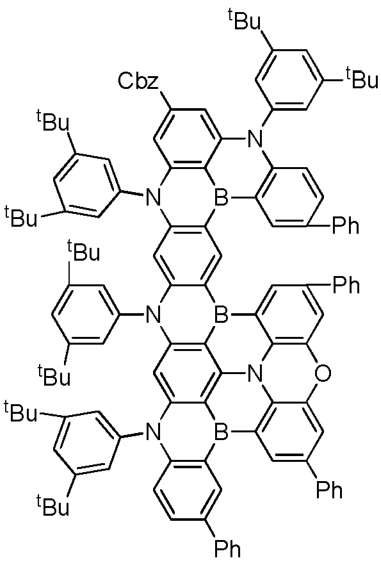

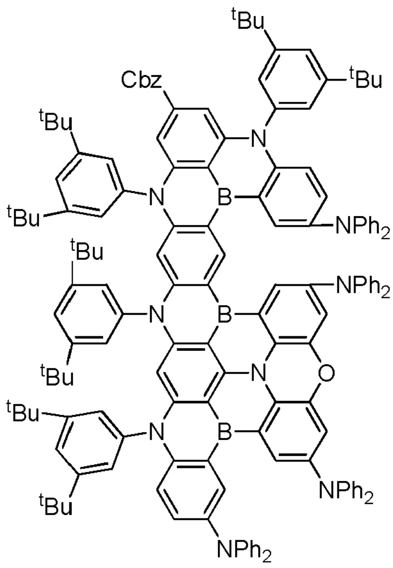

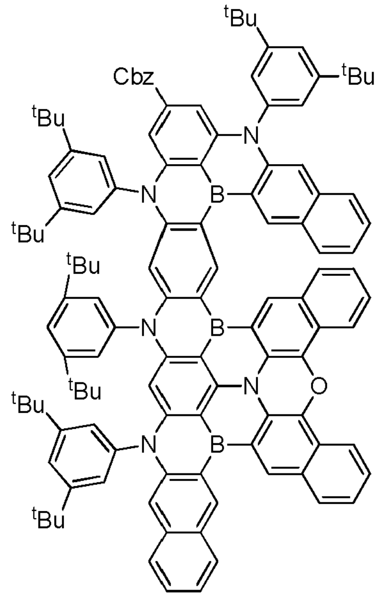

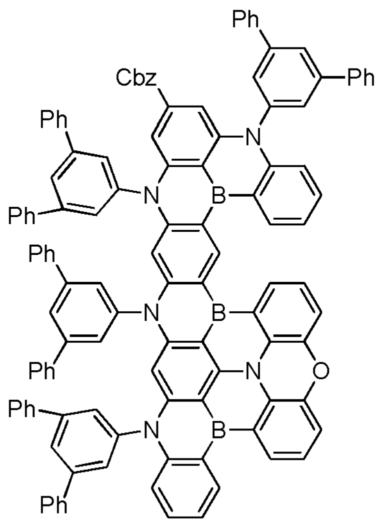

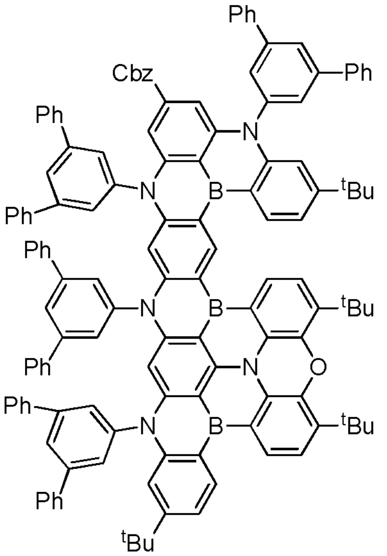

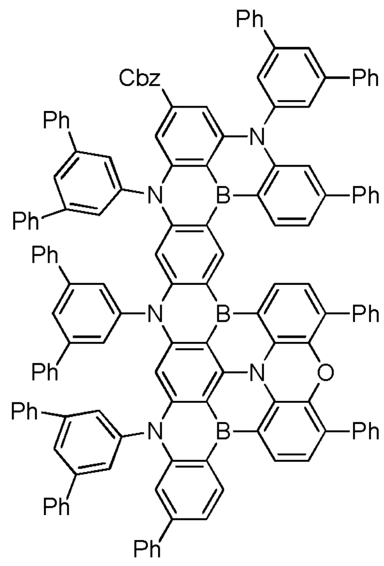

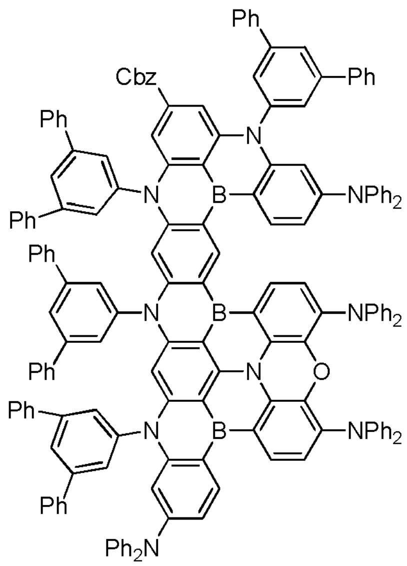

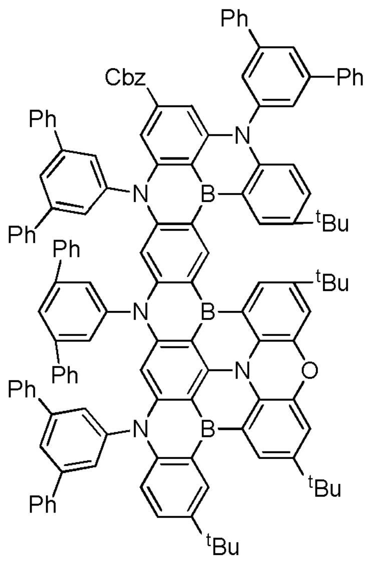

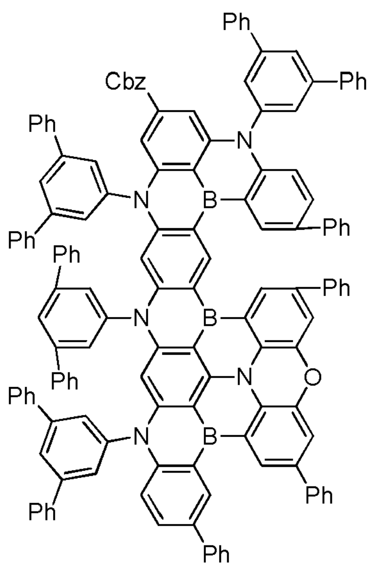

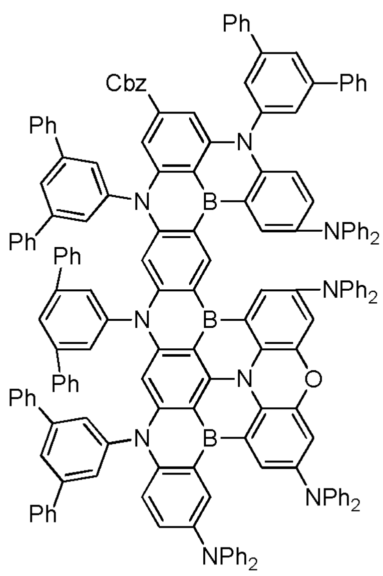

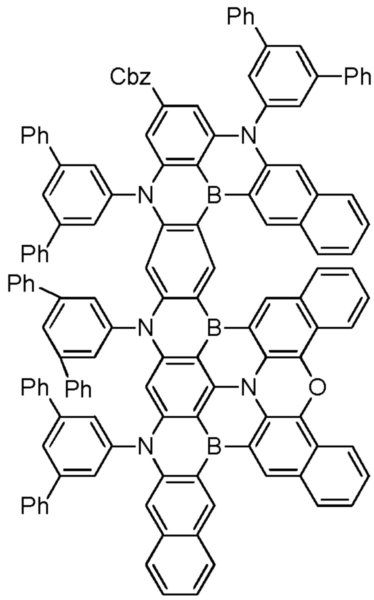

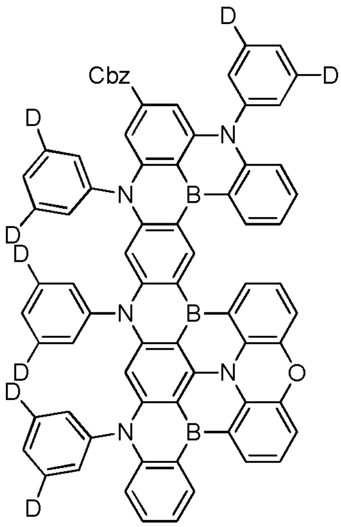

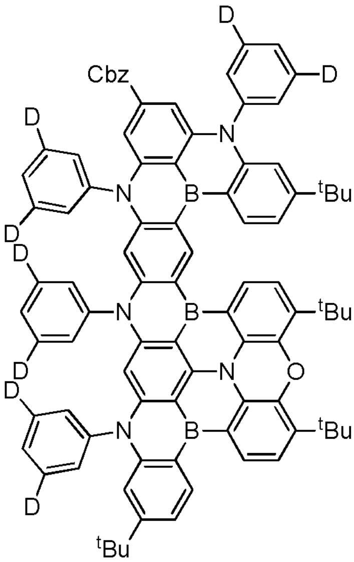

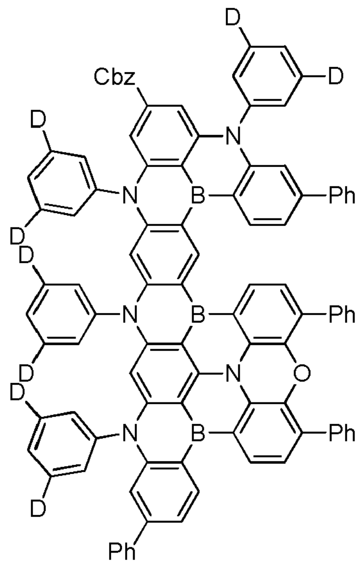

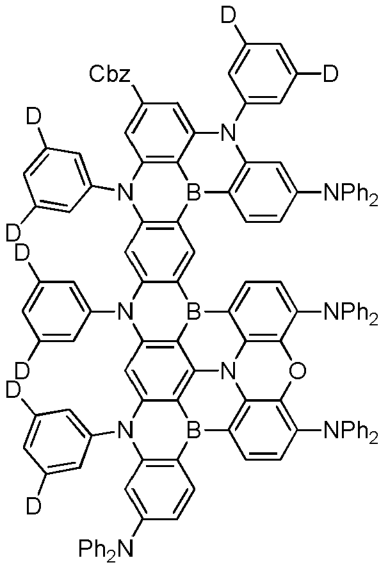

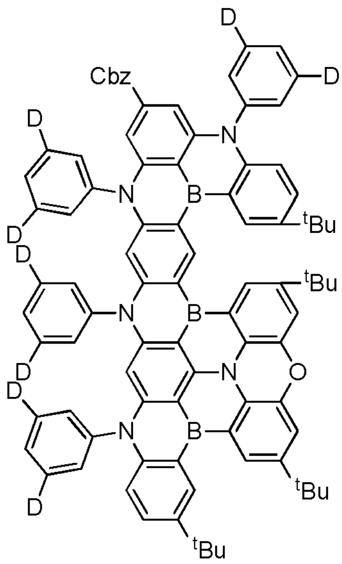

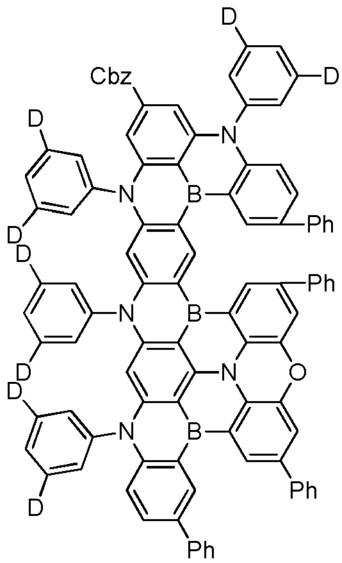

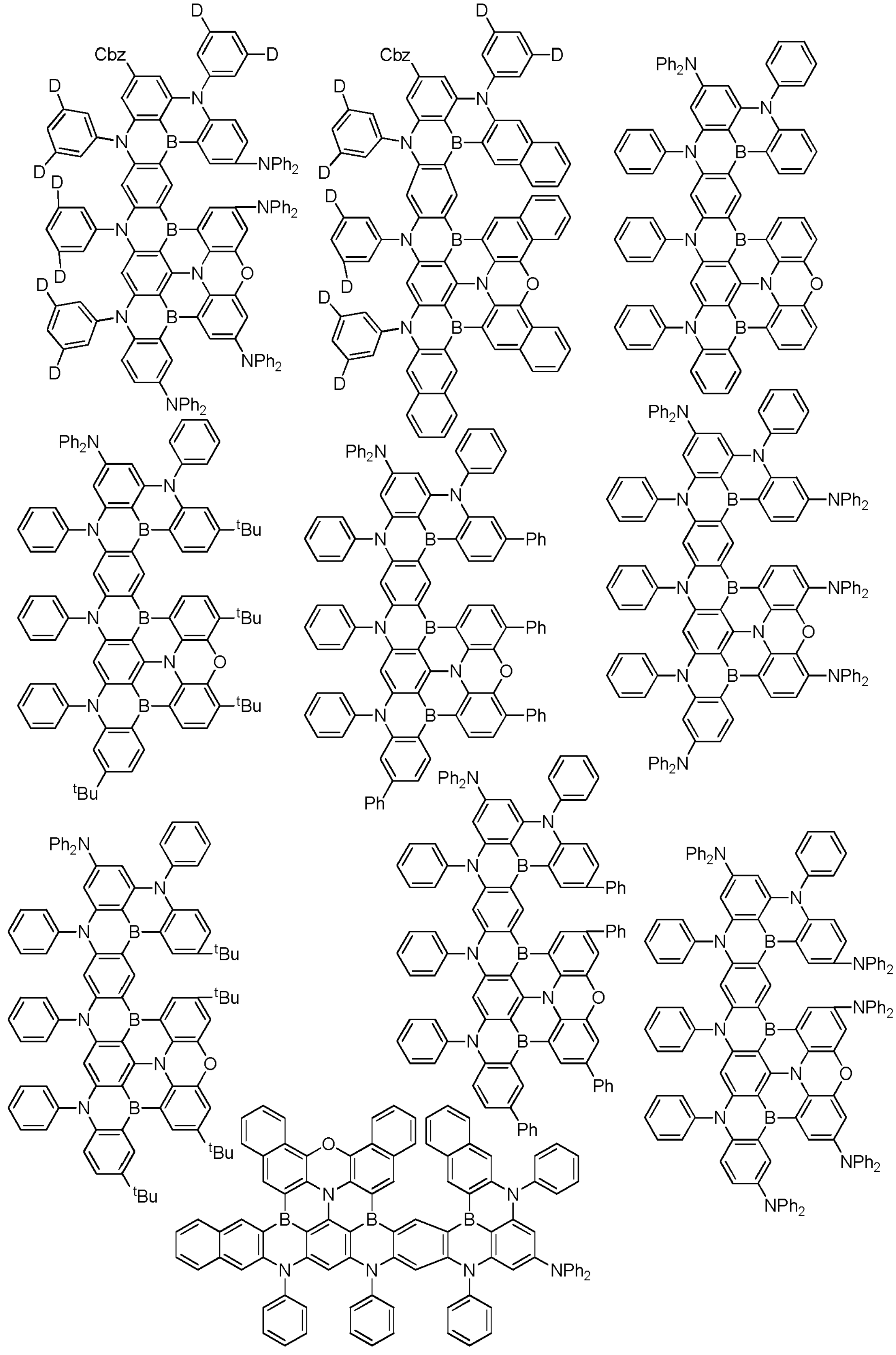

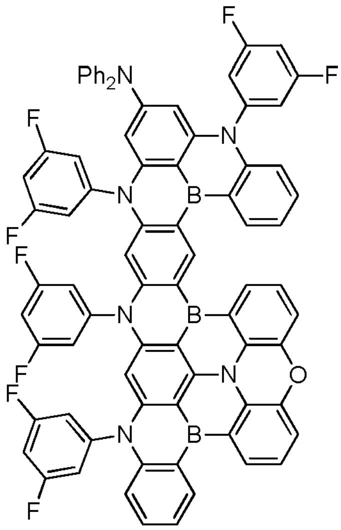
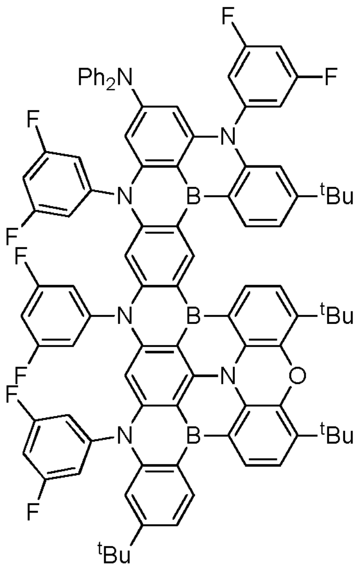
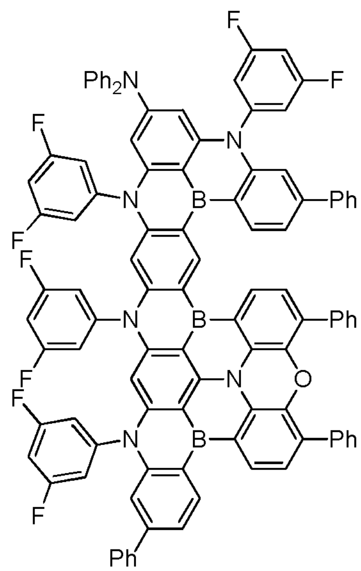
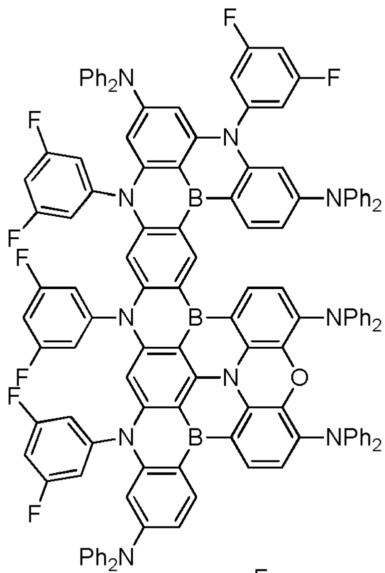
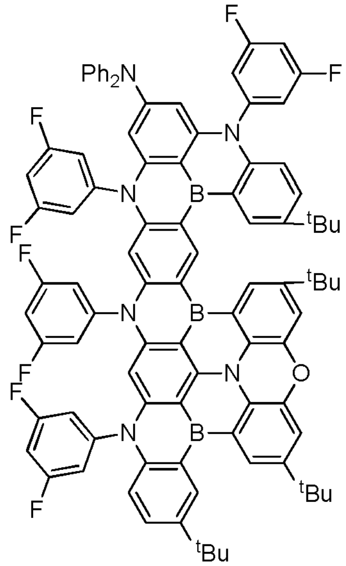
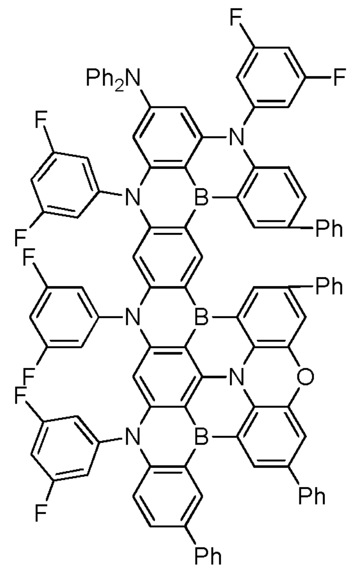
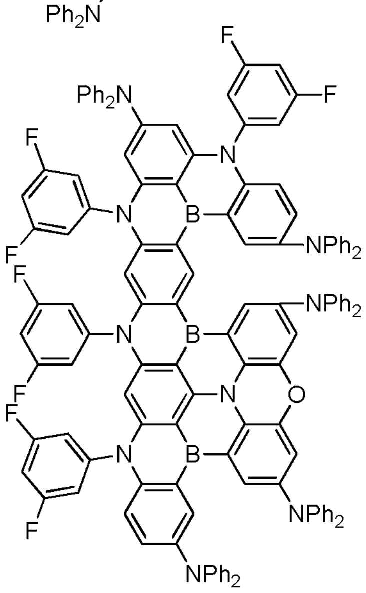
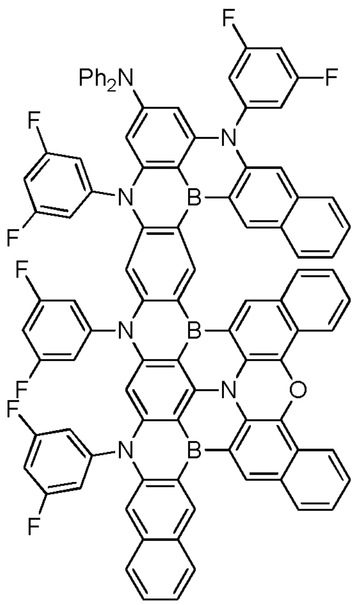
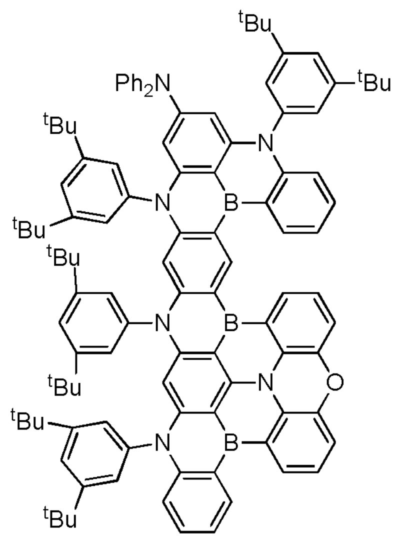

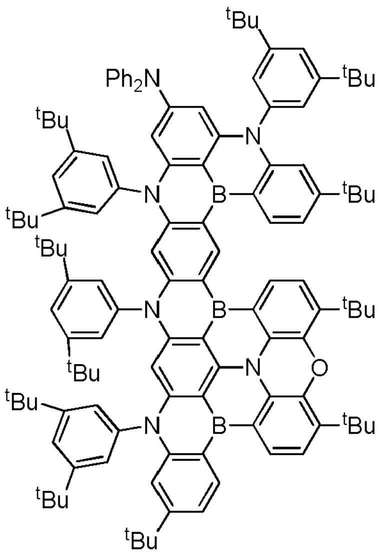

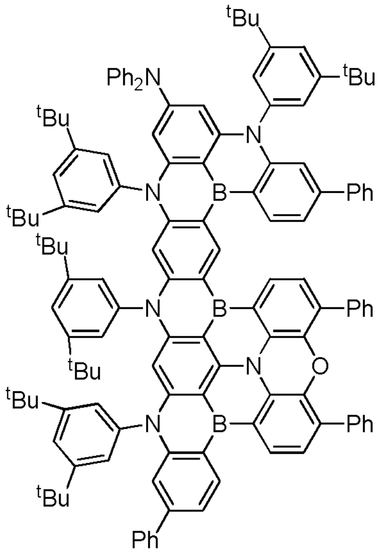

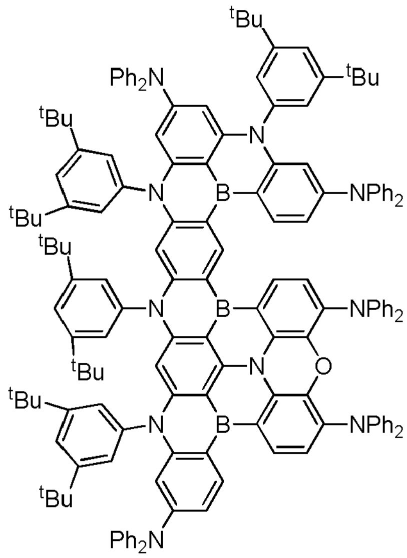

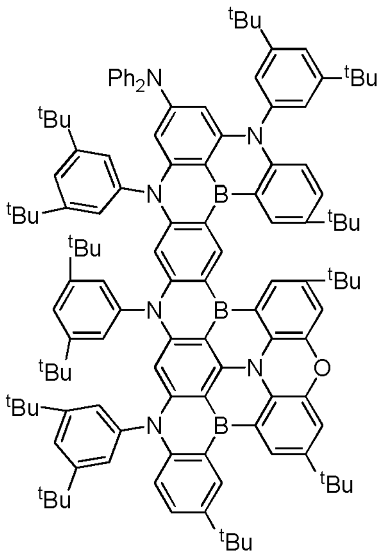

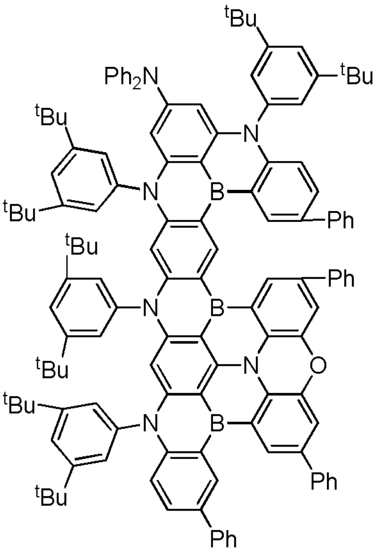

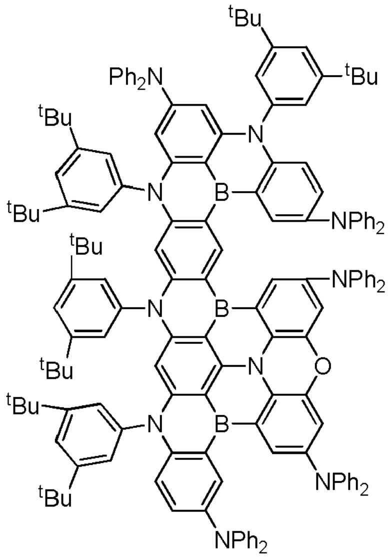

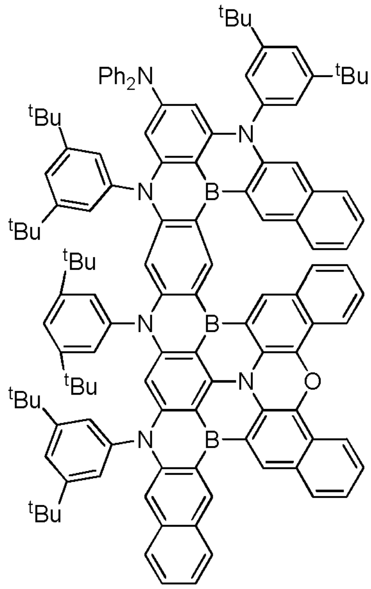

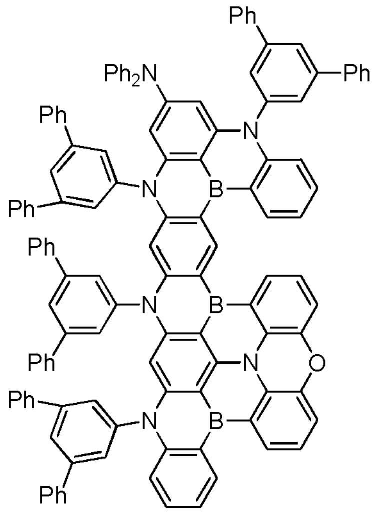

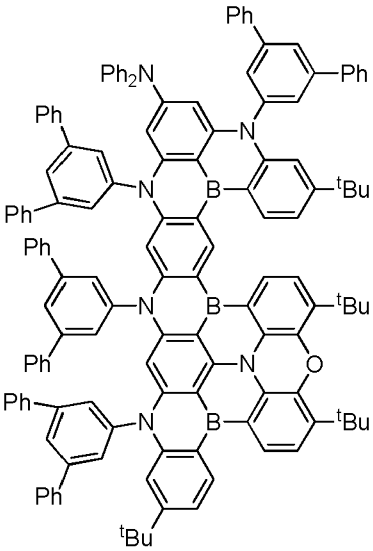

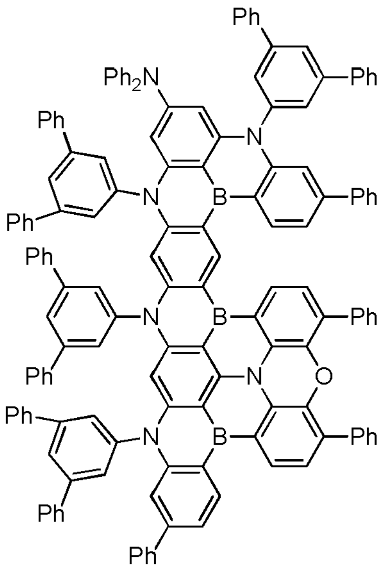

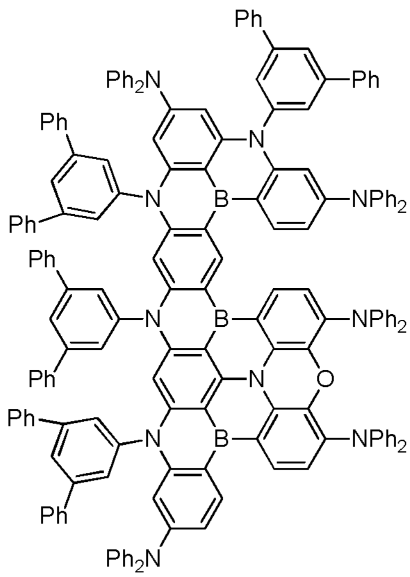

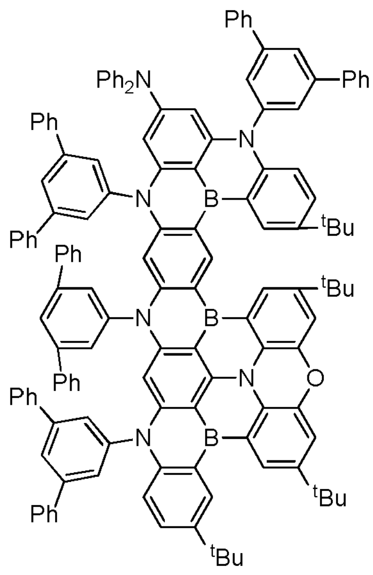

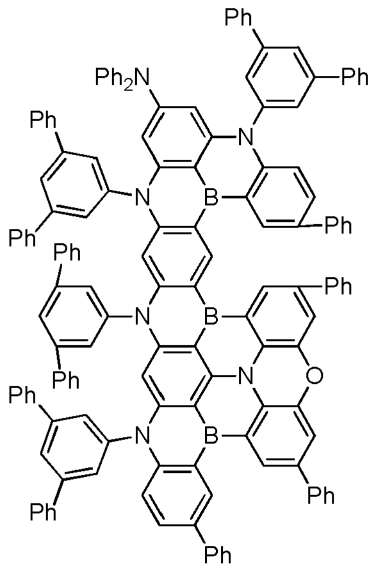

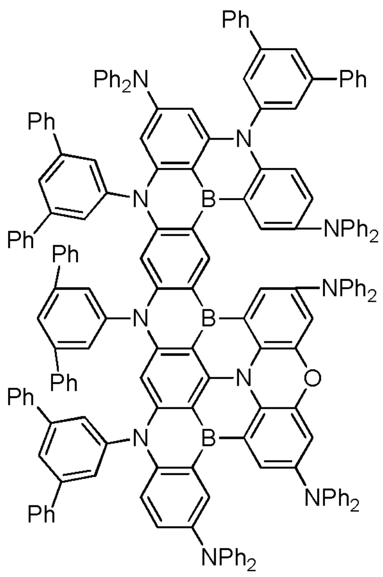

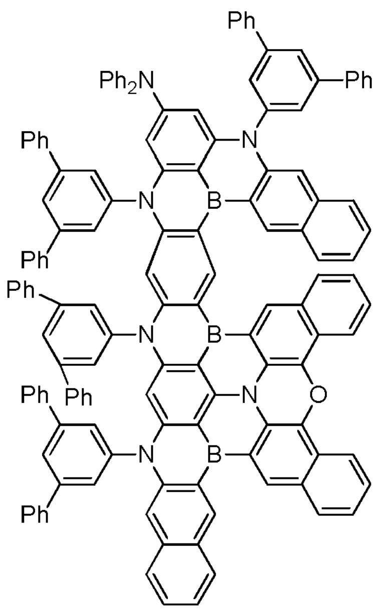

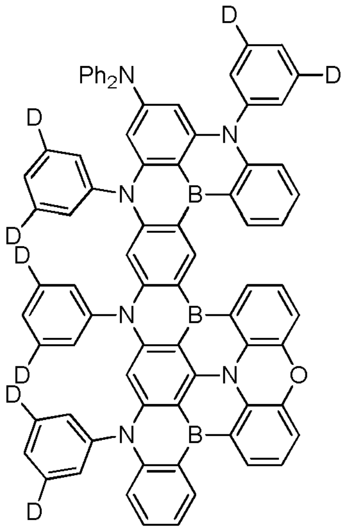

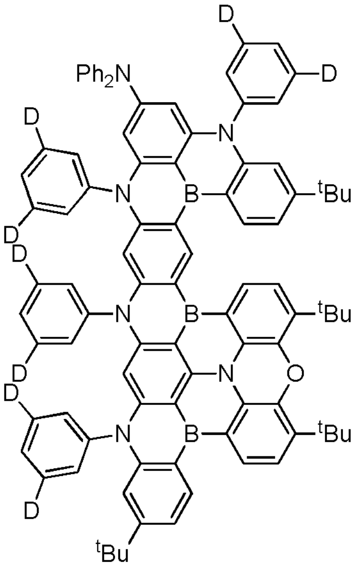

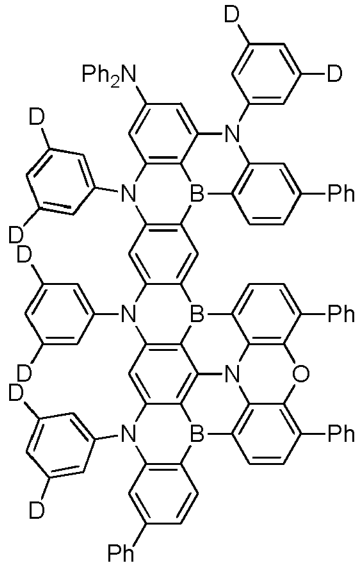

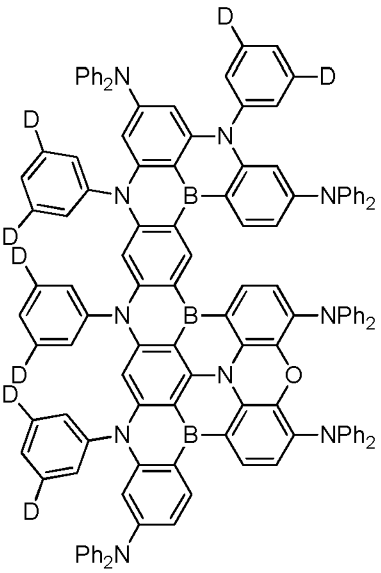

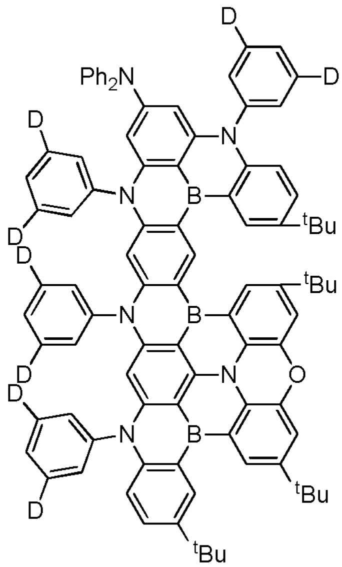

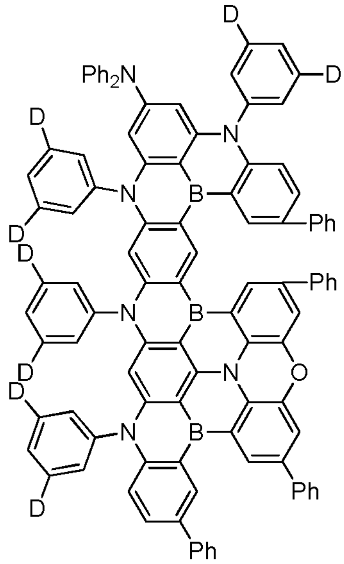

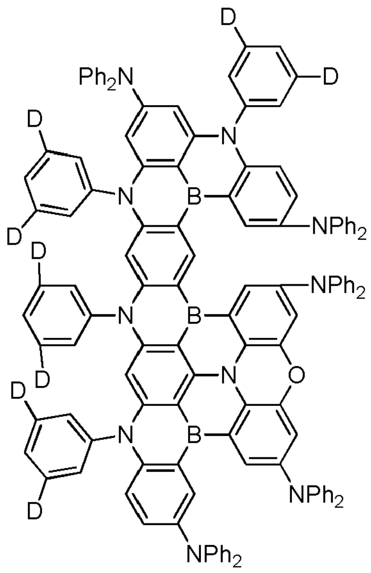 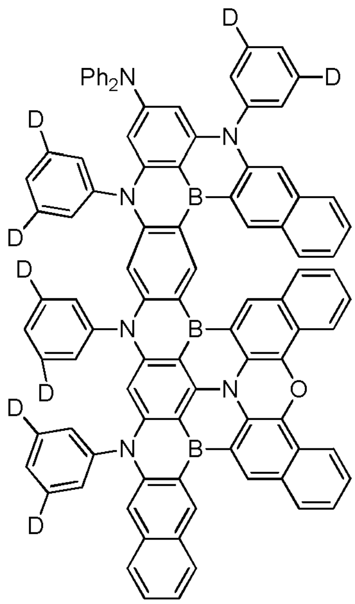

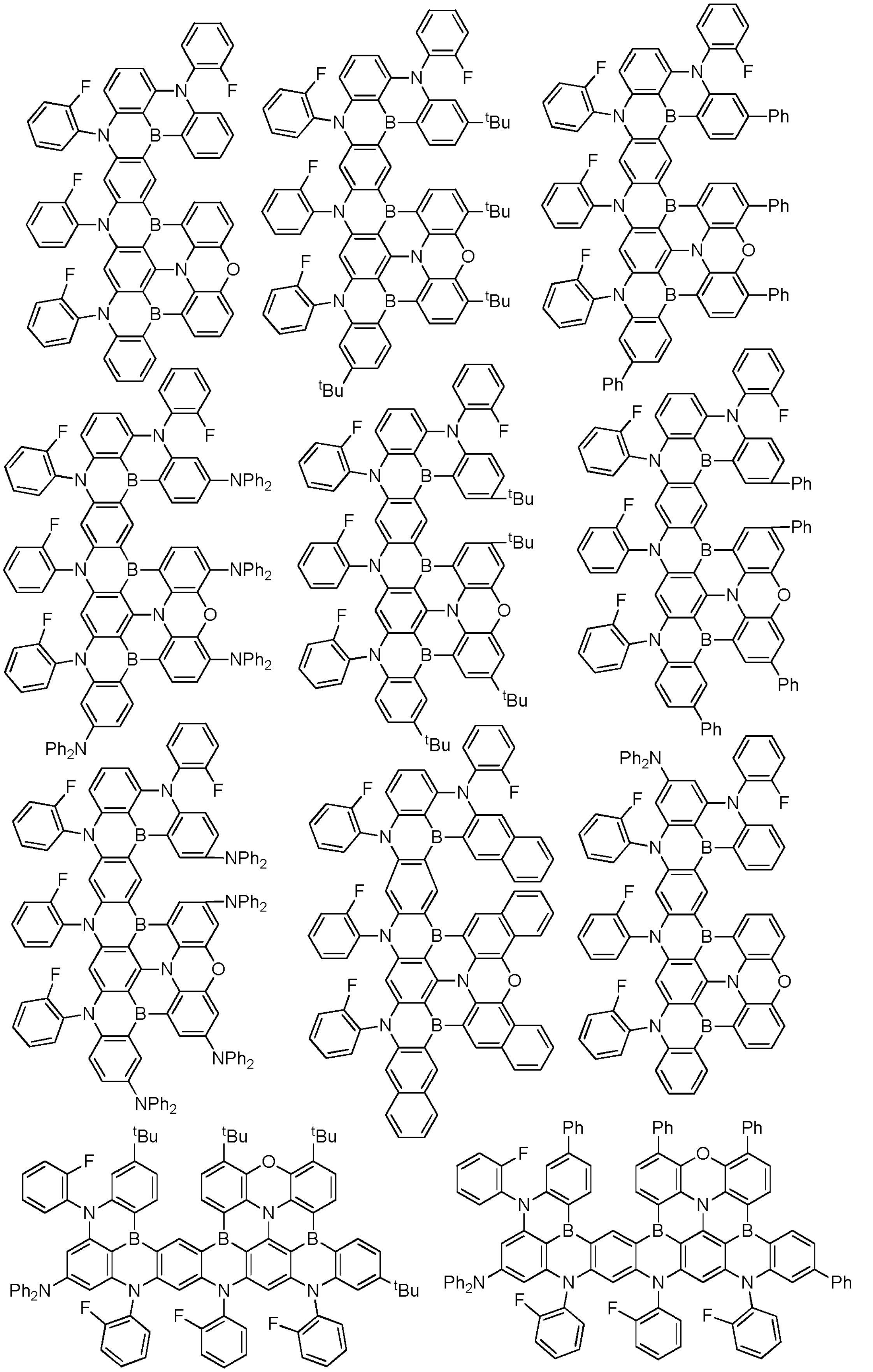

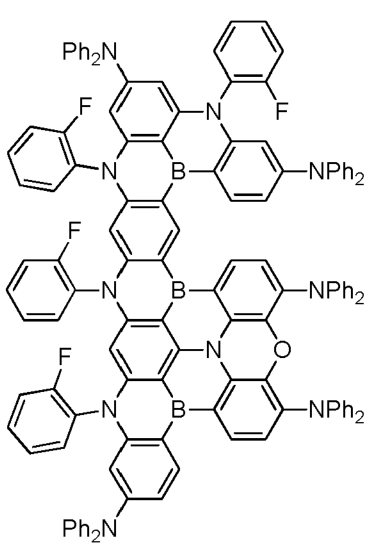

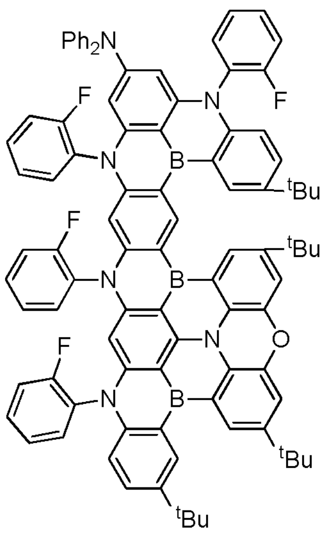

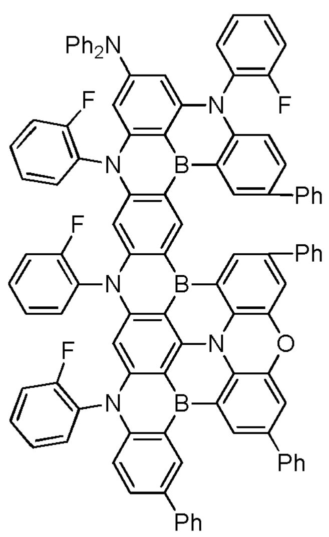

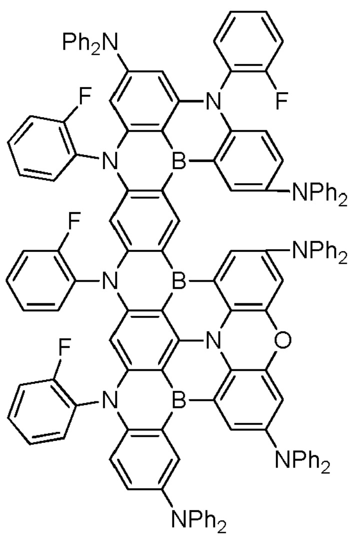

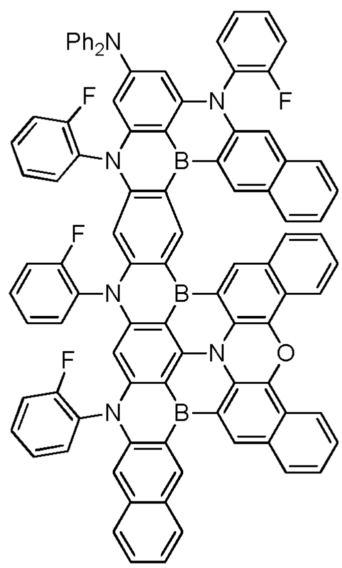

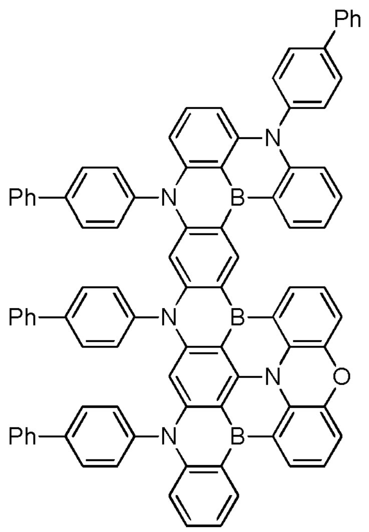

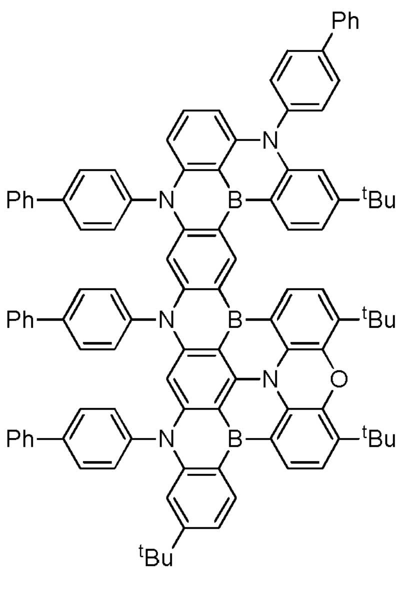

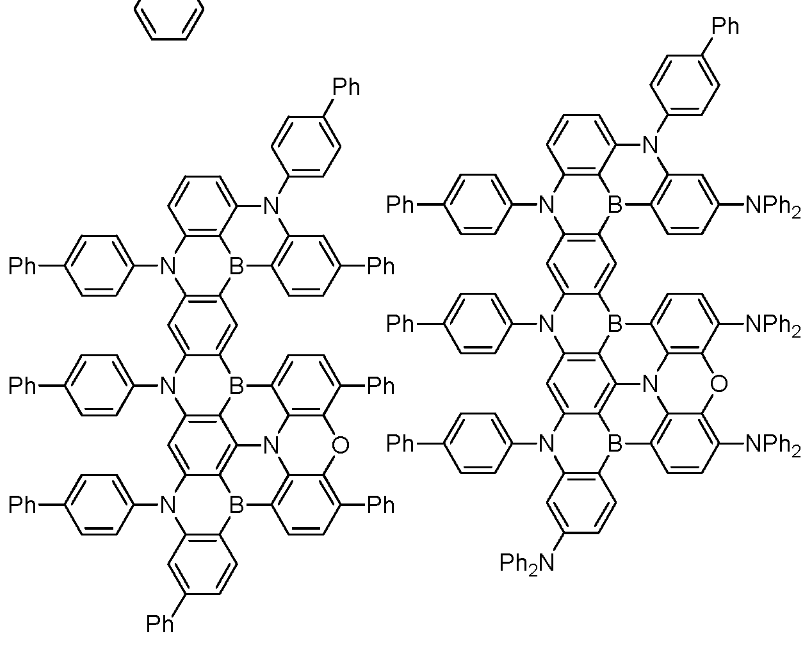

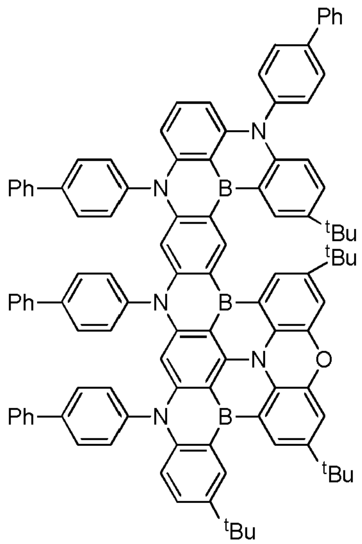

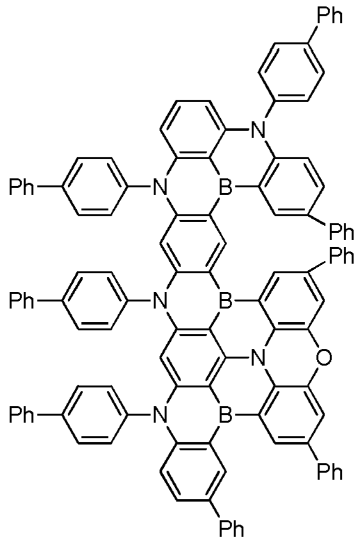

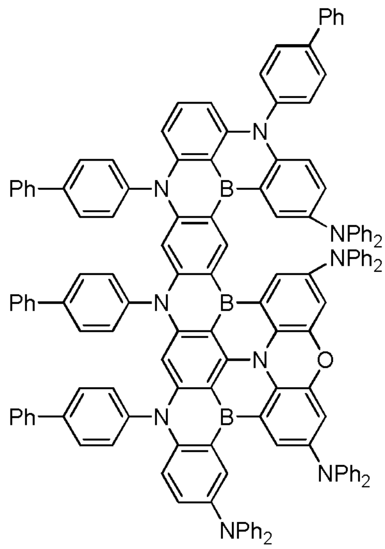

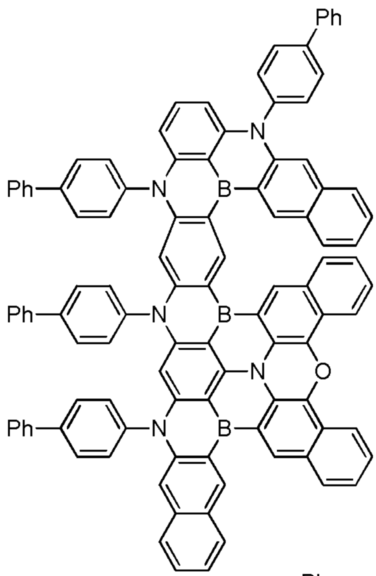

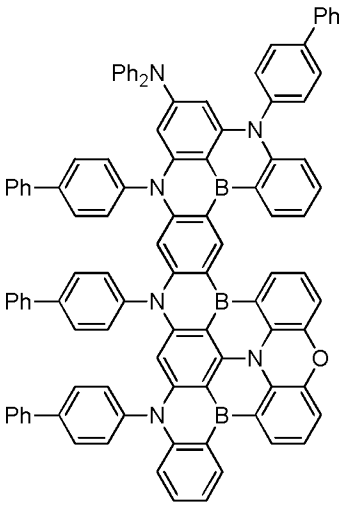

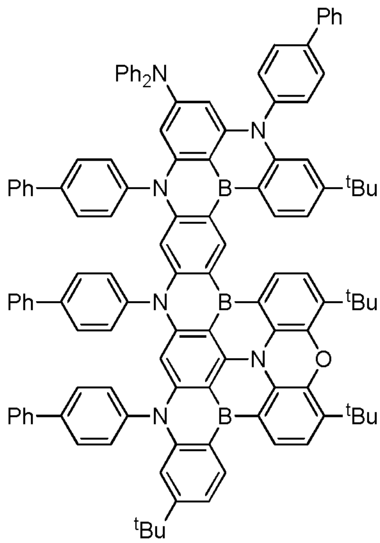

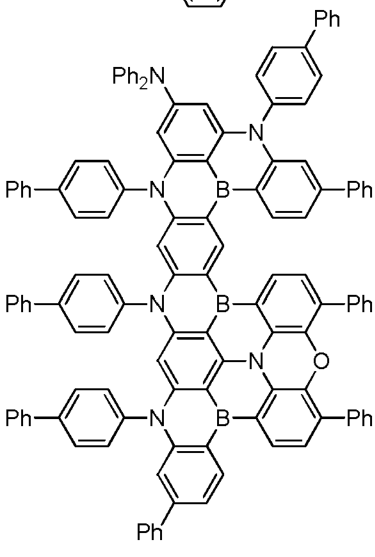

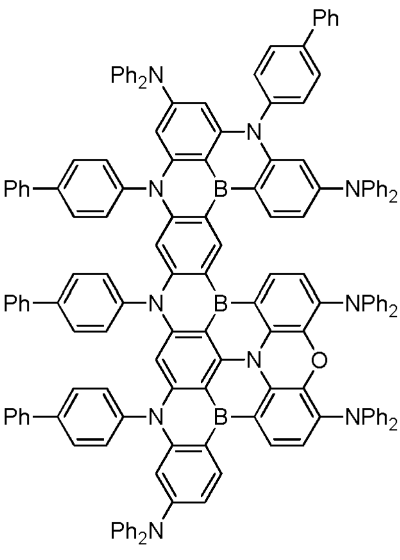

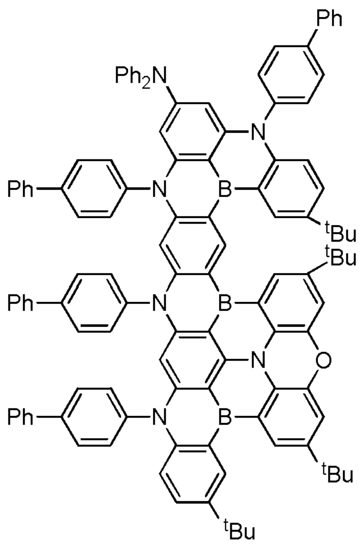

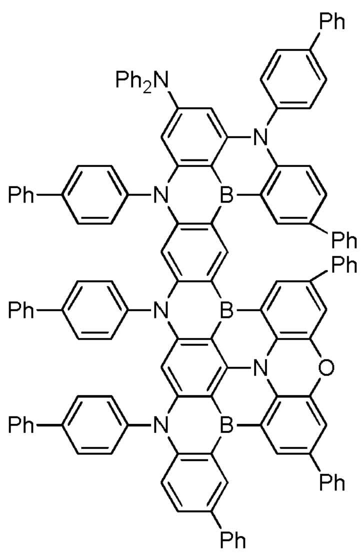

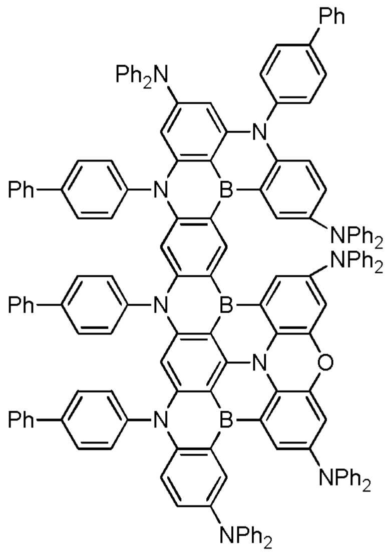

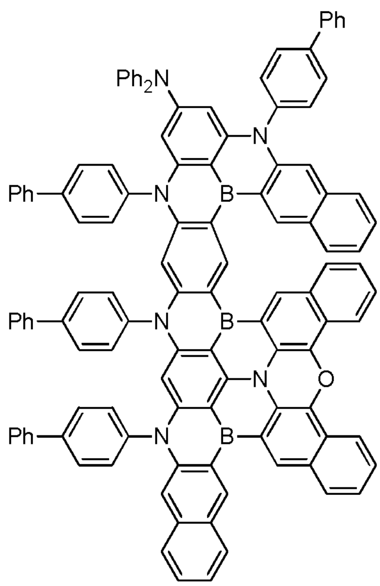

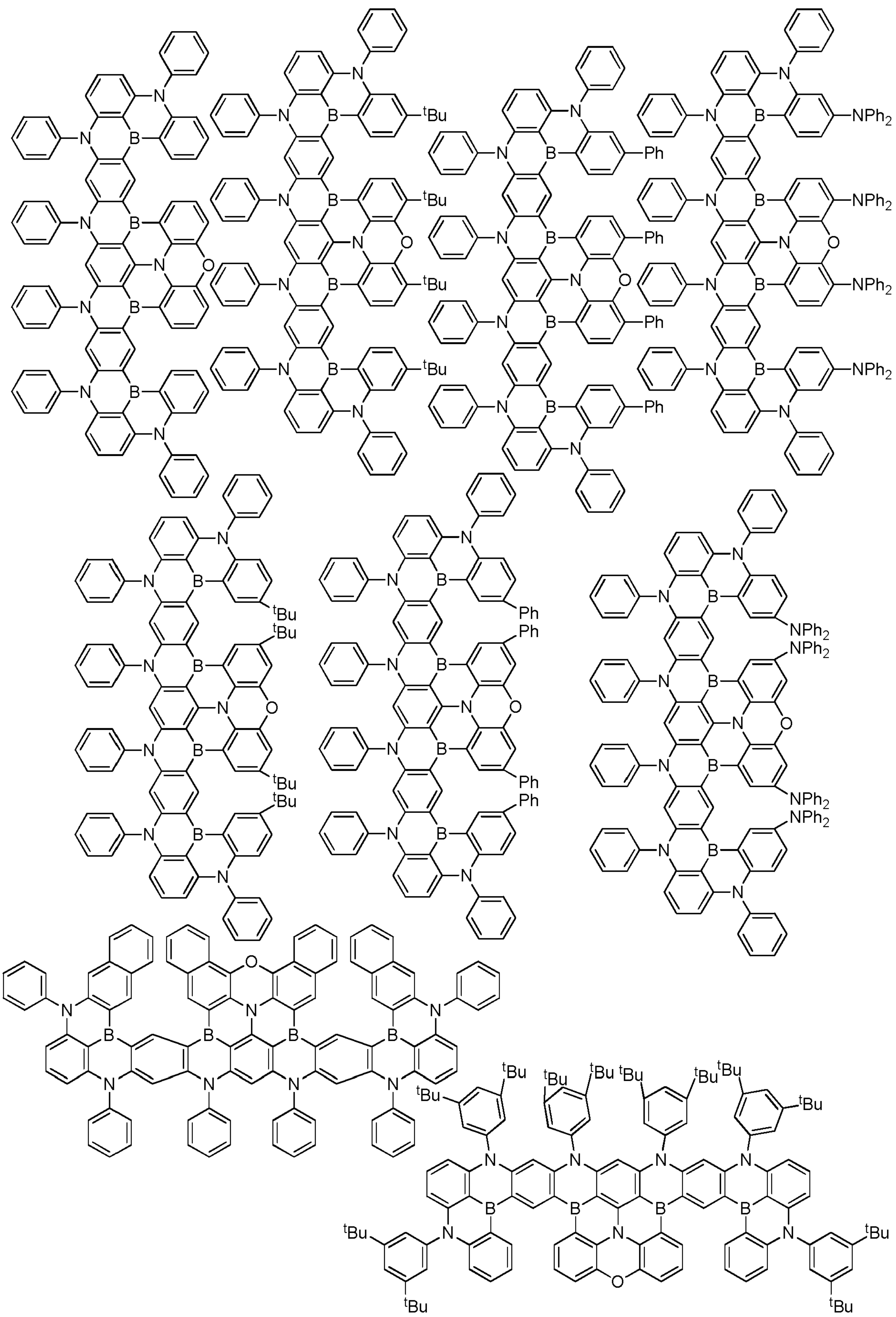

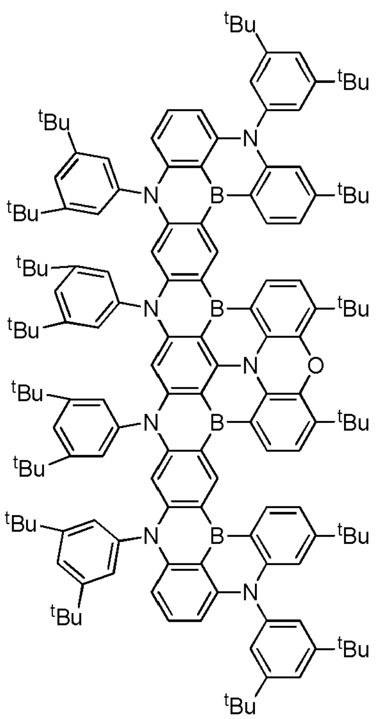

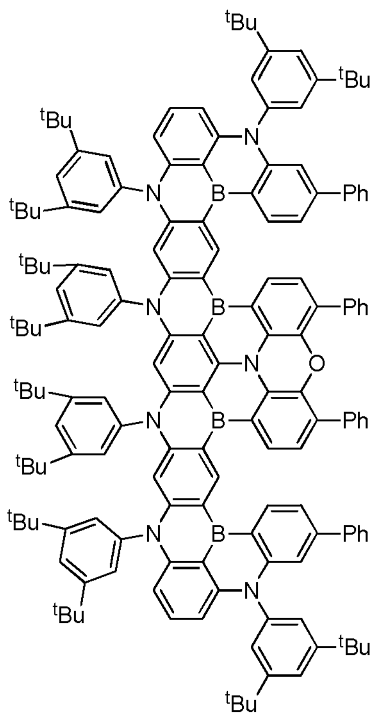

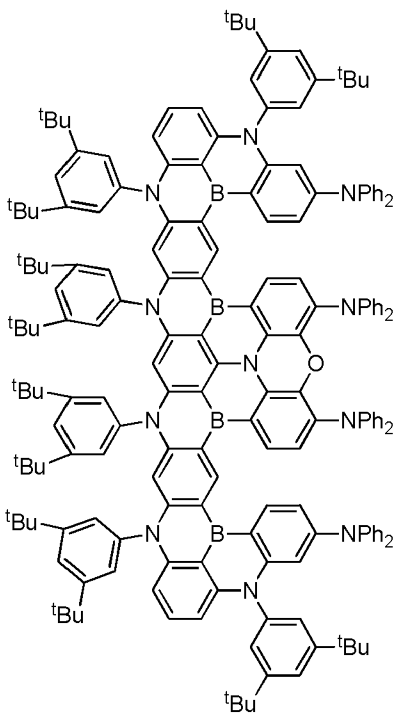

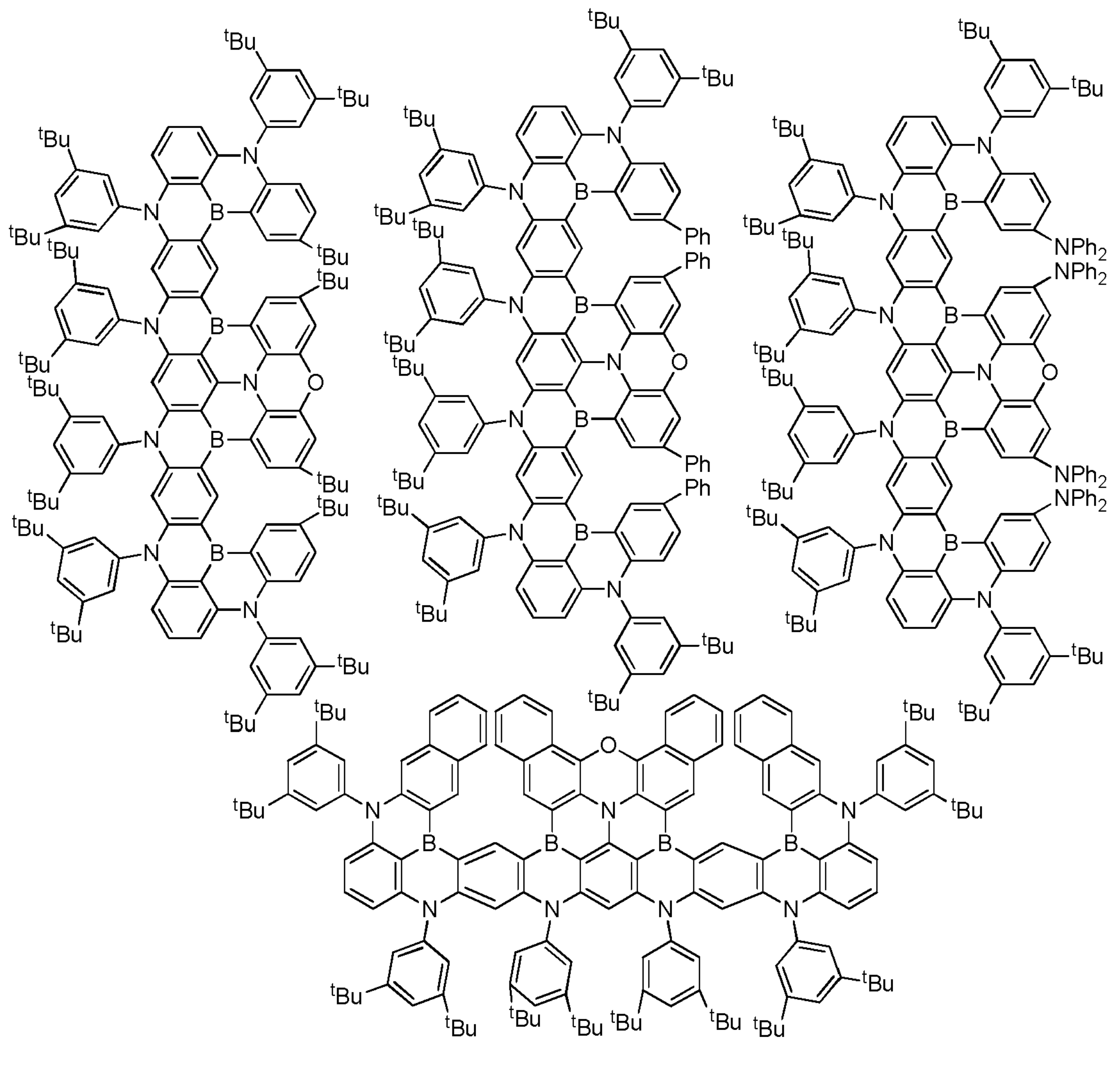

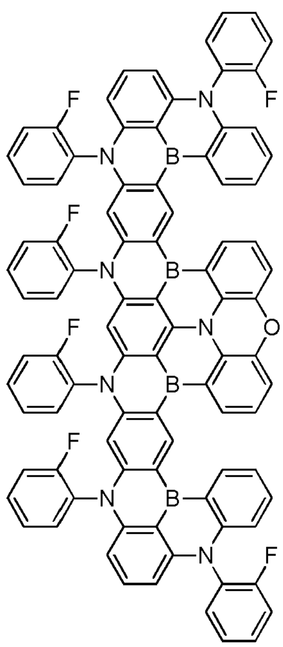

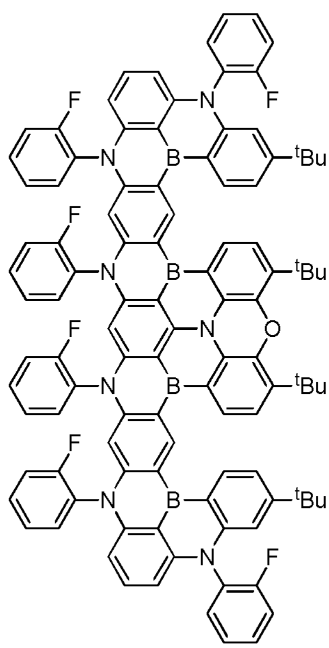

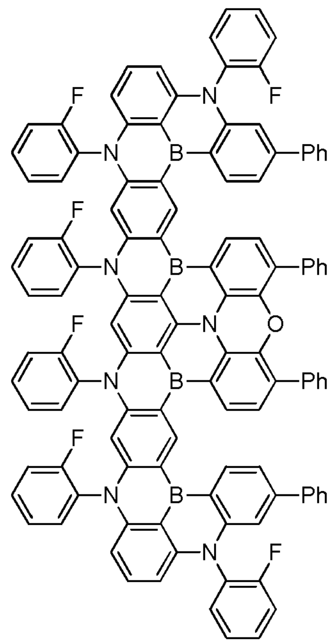

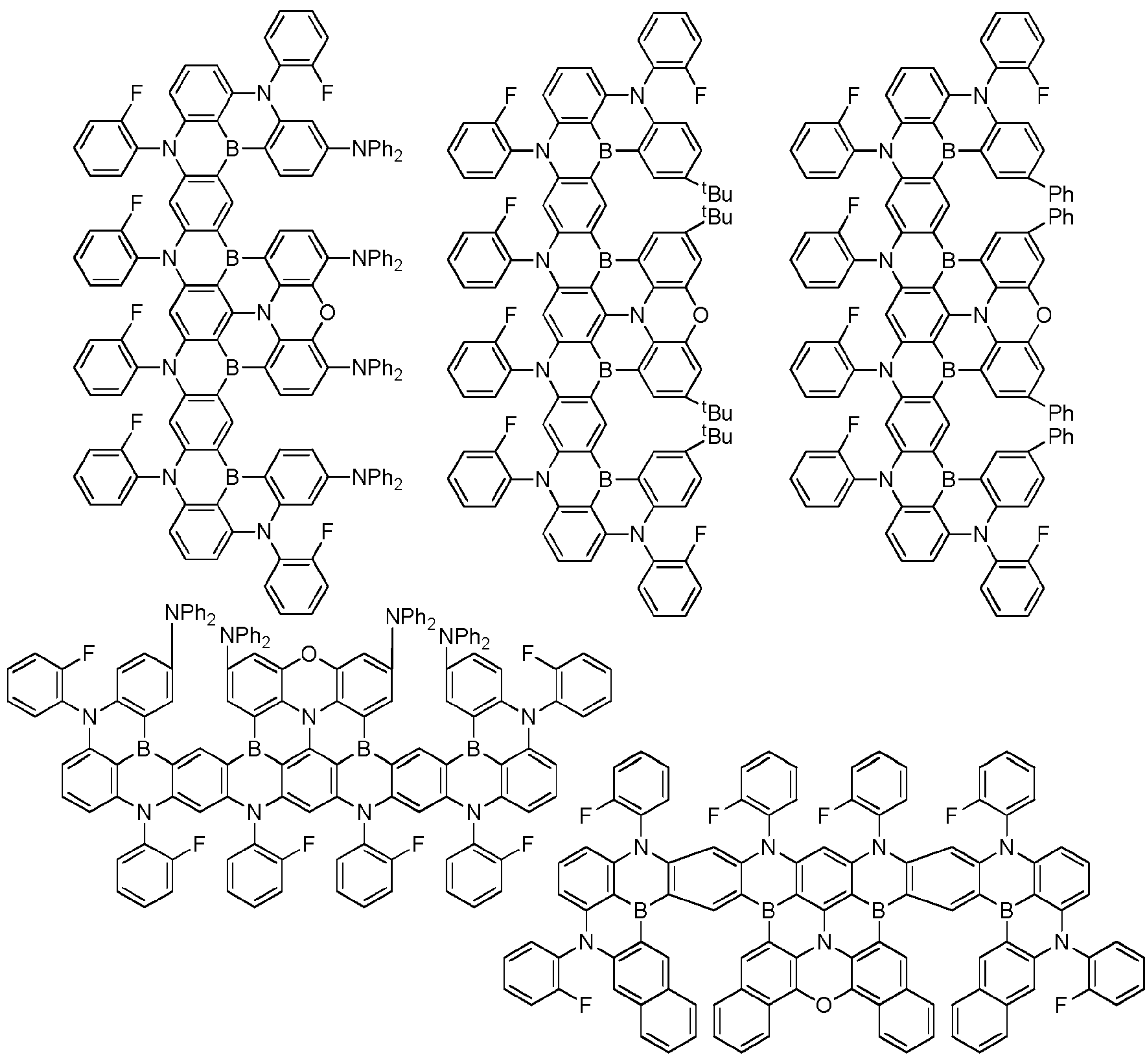

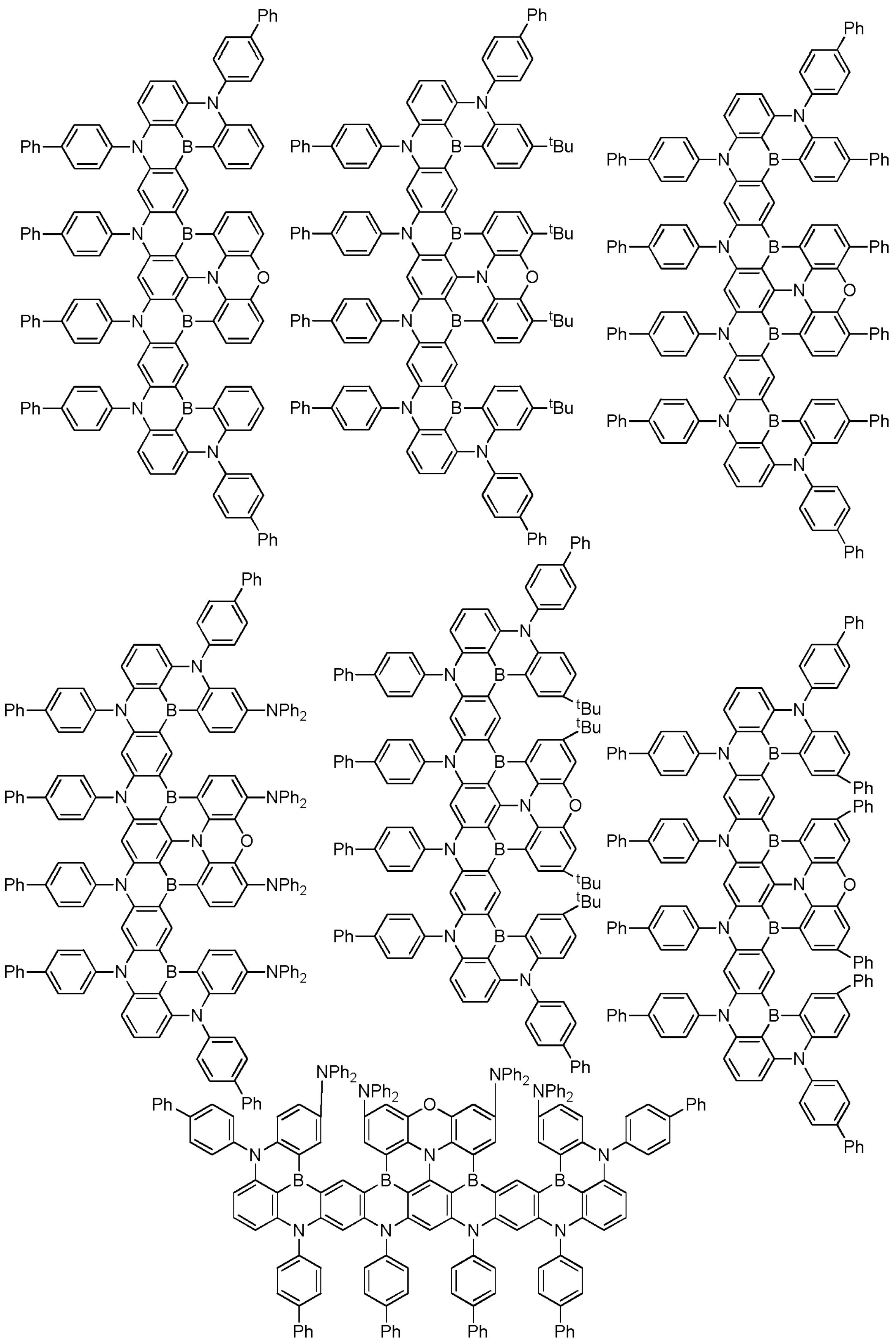

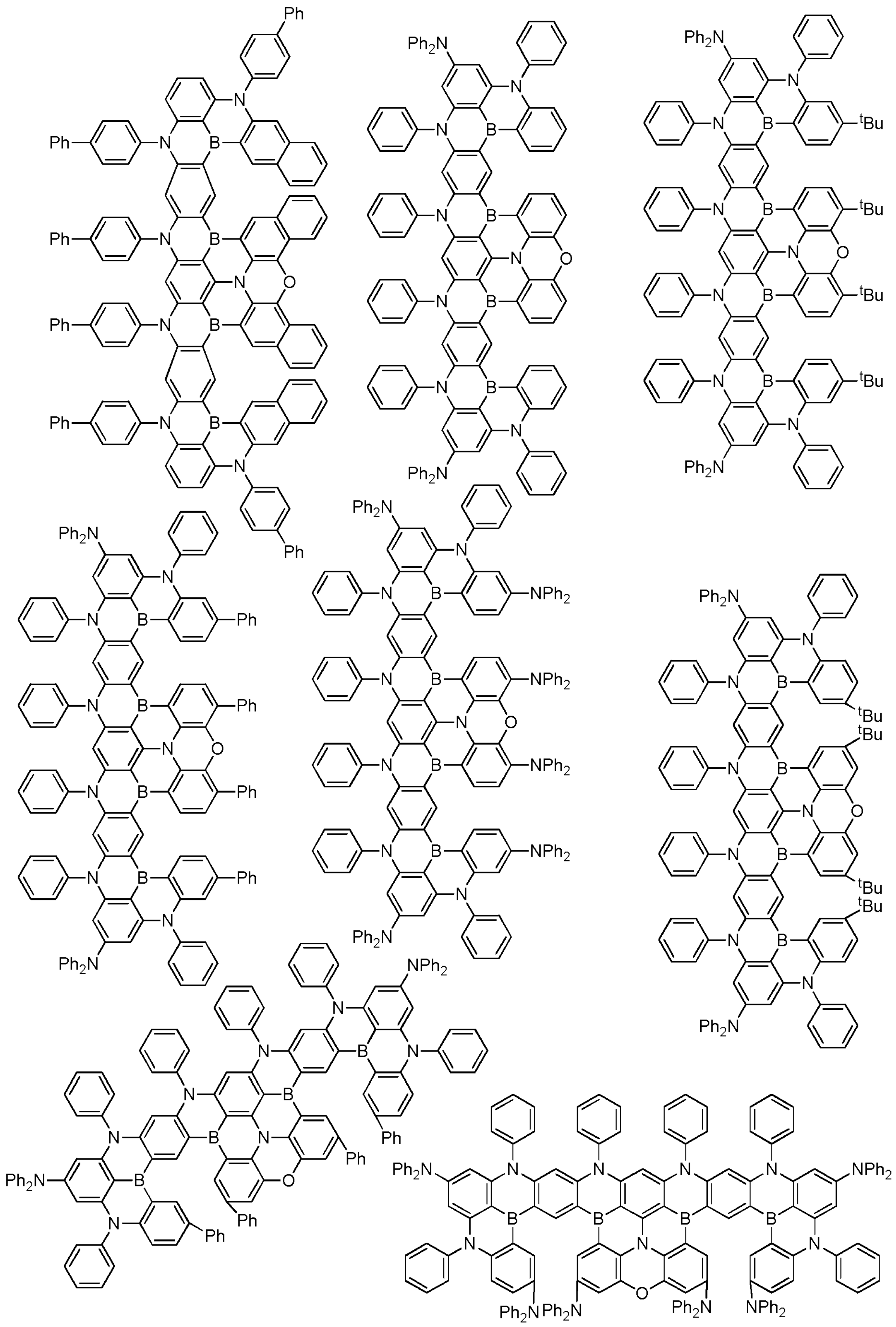

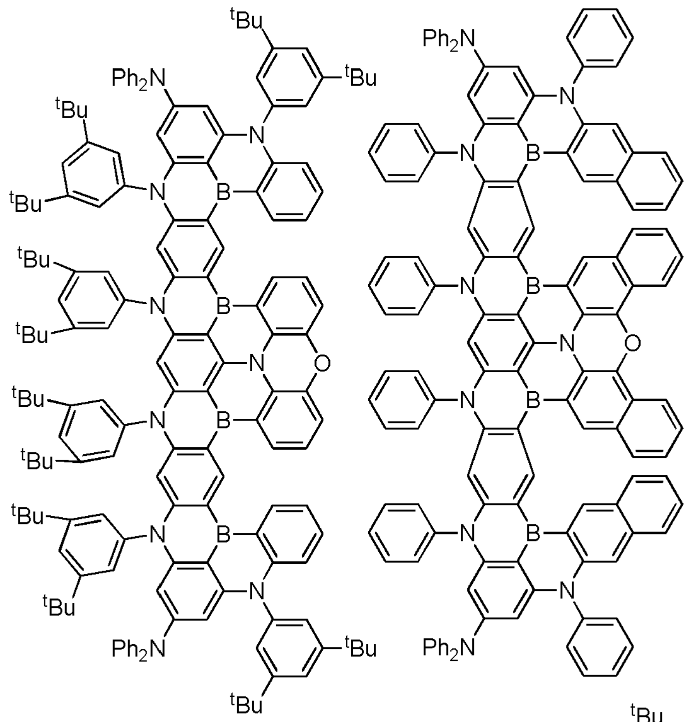

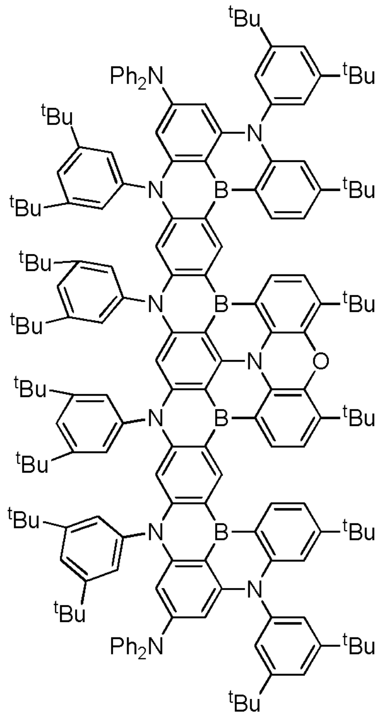

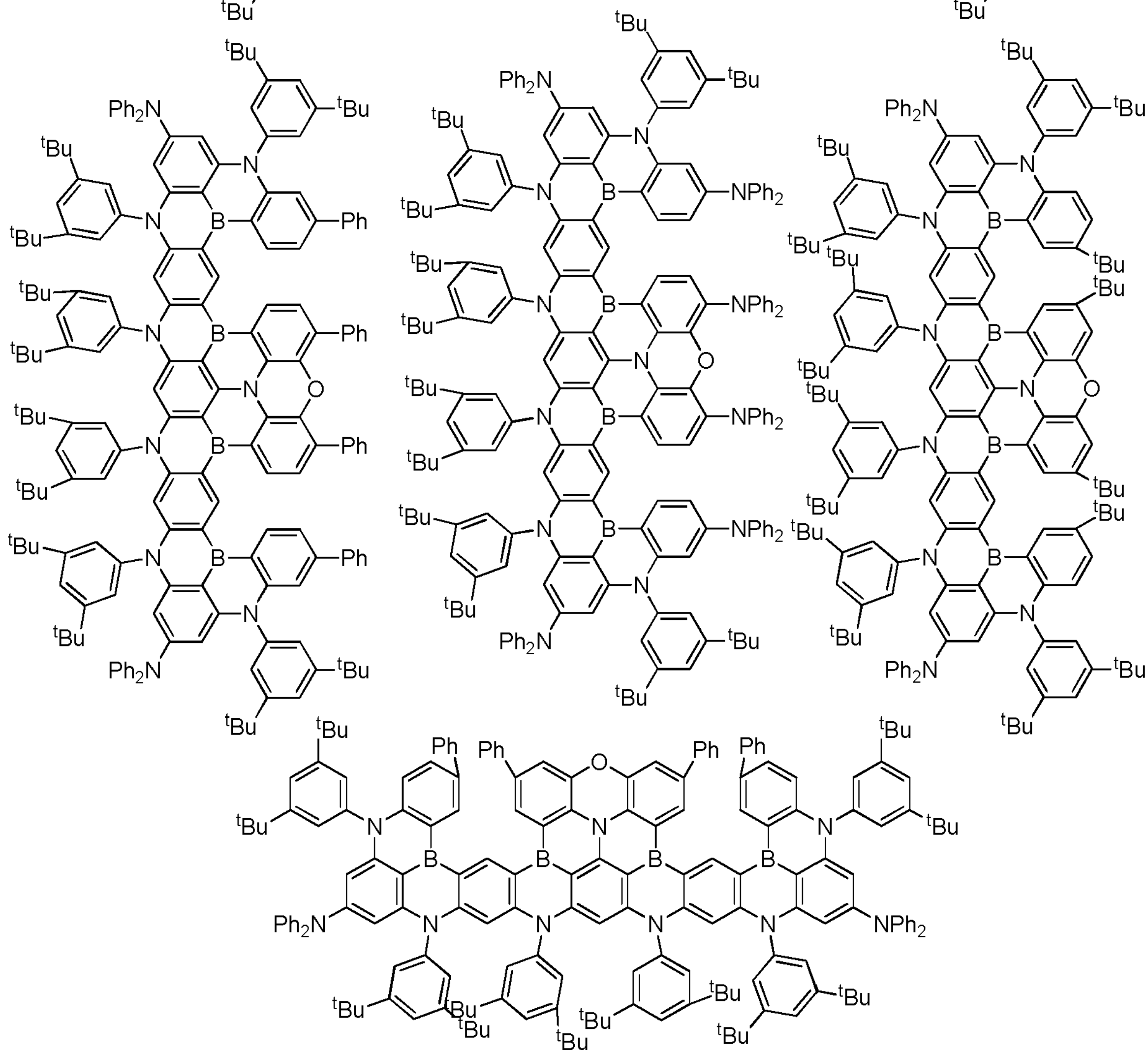

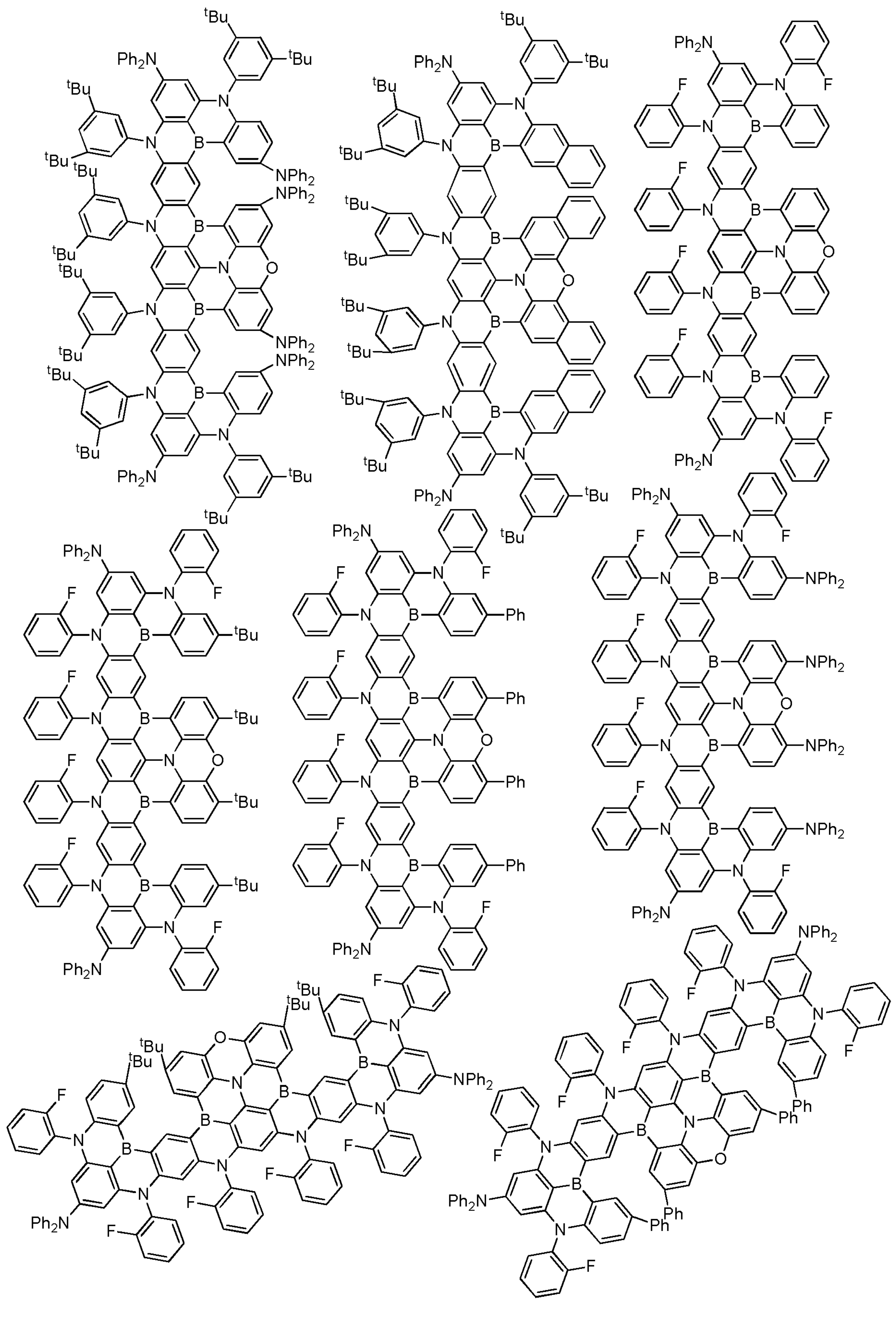

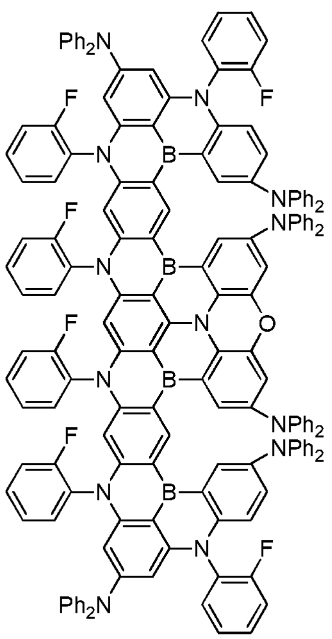
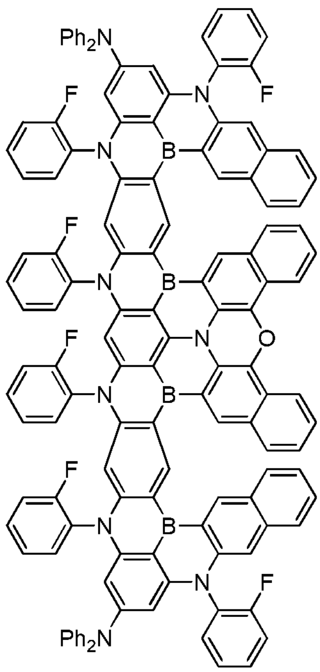
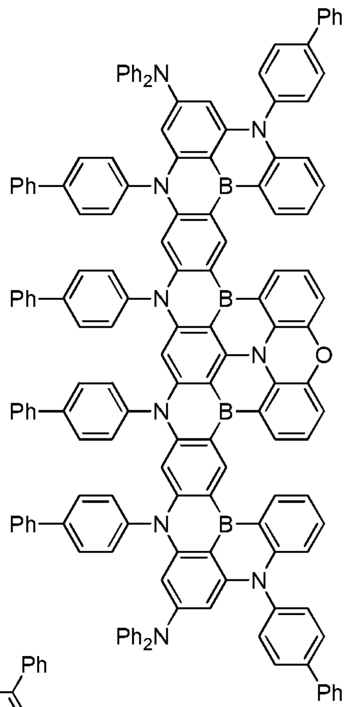
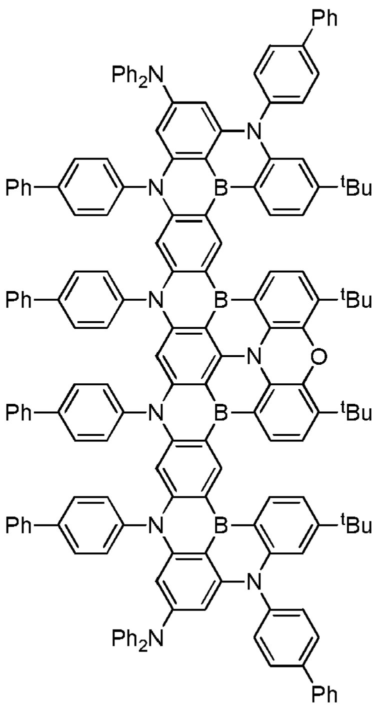
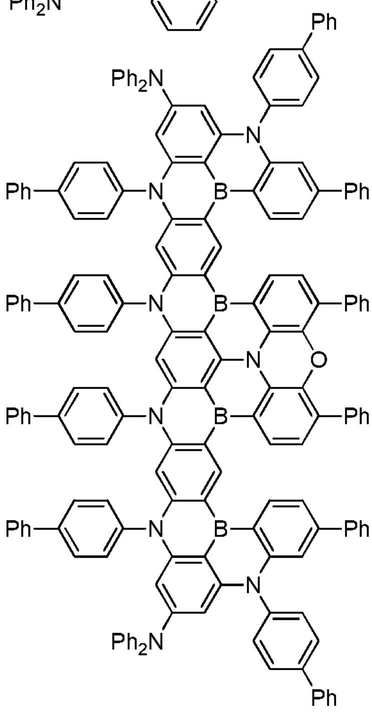
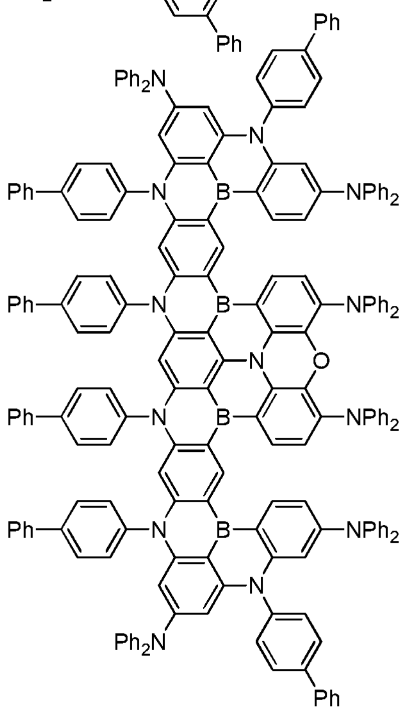
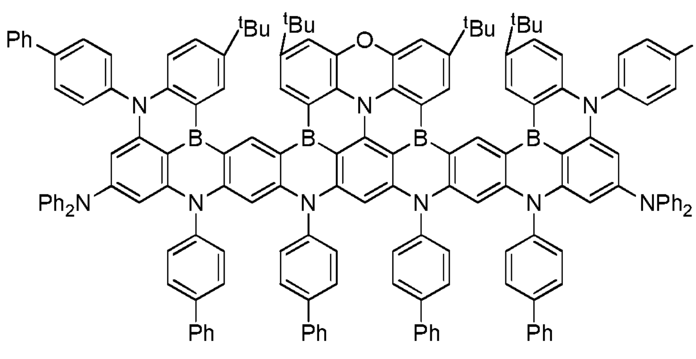

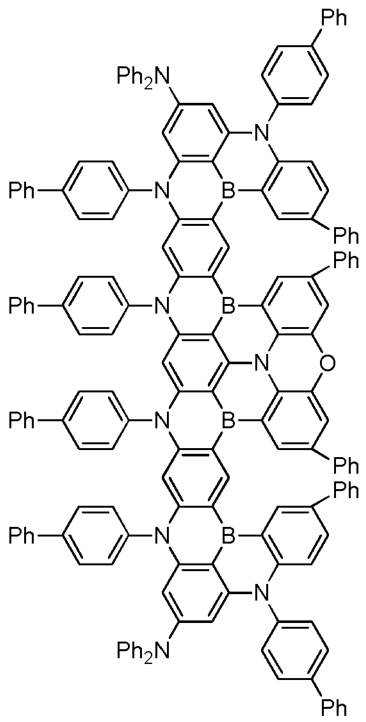

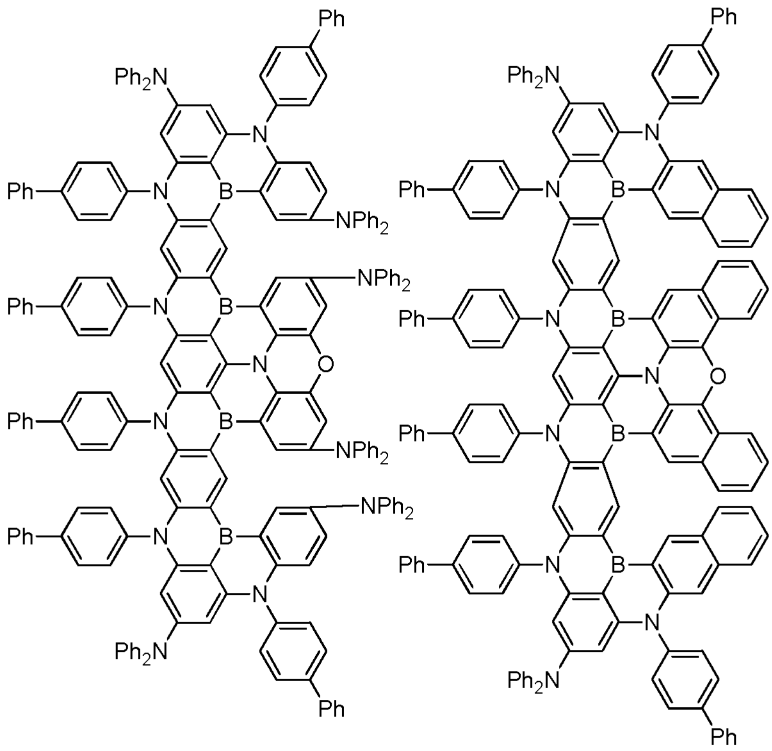

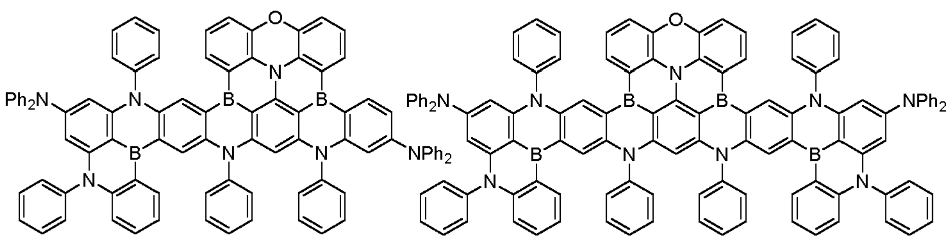

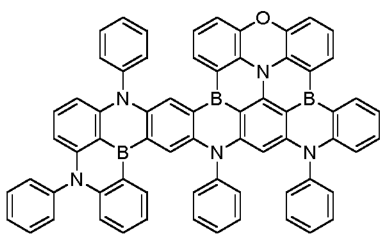

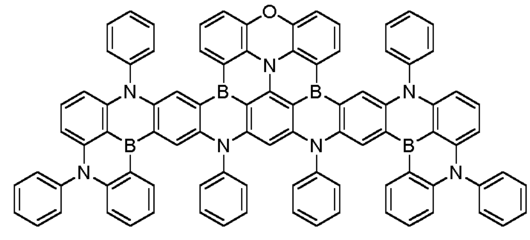

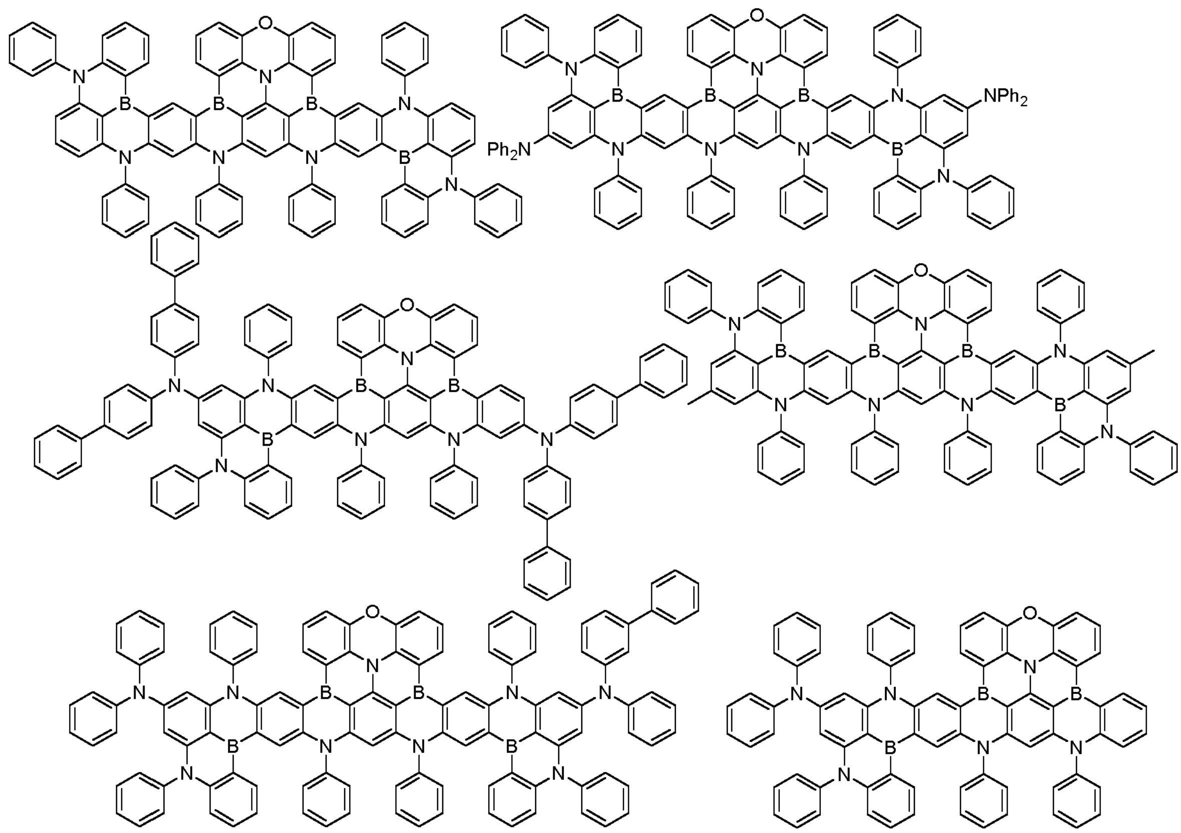

## Figures

Figure 1 Emission spectrum of example **1** (1% by weight) in PMMA.
Figure 2 Emission spectrum of example **2** (1% by weight) in PMMA.

## Claims

**1.** Organic molecule, comprising

- a first chemical moiety comprising a structure of formula I:

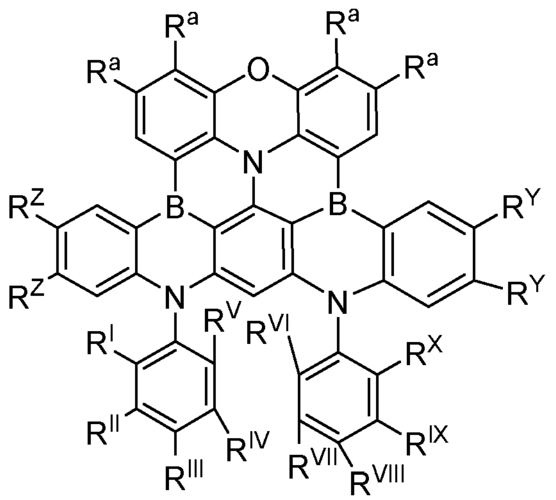

Formula I

and

- one or two second chemical moieties comprising a structure of formula II:

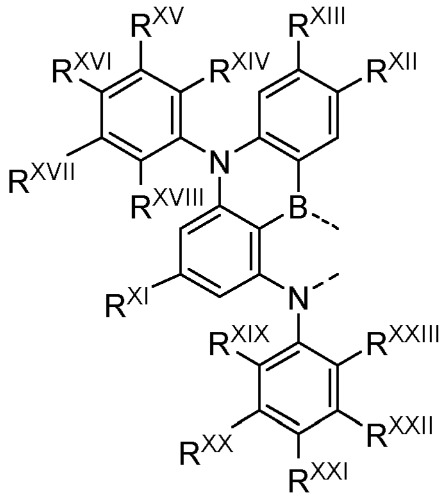

Formula II

wherein

$R^Z$ indicates the binding site of a single bond linking the first chemical moiety to the second moiety;
$R^Y$ indicates the binding site of a single bond linking the first chemical moiety to the second moiety or is $R^a$;
the dashed lines

“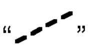”

represent the binding sites of the first chemical moiety to the second chemical moiety;
$R^a$ is at each occurrence independently selected from the group consisting of:

hydrogen, deuterium, $N(R^5)_2$, $OR^5$, $SR^5$, $CF_3$, CN, F, Cl, Br, I,
$C_1$-$C_{40}$-alkyl,

which is optionally substituted with one or more substituents $R^5$ and

wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-alkoxy,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^S)_2$, C=O, C=S, C=Se, $C=NR^5$, $P(=O)(R^5)$, SO, $SO_2$, $NR^5$, O, S or $CONR^5$;

$C_1$-$C_{40}$-thioalkoxy,

which is optionally substituted with one or more substituents $R^4$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_6$-$C_{60}$-aryl,

which is optionally substituted with one or more substituents $R^5$; and $C_3$-$C_{57}$-heteroaryl,
which is optionally substituted with one or more substituents $R^5$;

$R^5$ is at each occurrence independently selected from the group consisting of:

hydrogen, deuterium, F, Cl, Br, I,
$C_1$-$C_{12}$-alkyl,
wherein optionally one or more hydrogen atoms are independently substituted by $R^6$;
$C_6$-$C_{18}$-aryl,

wherein optionally one or more hydrogen atoms are independently substituted by $R^6$;
and
$C_3$-$C_{15}$-heteroaryl,
wherein optionally one or more hydrogen atoms are independently substituted by $R^6$;

$R^6$ is at each occurrence independently selected from the group consisting of:

hydrogen, deuterium, F, Cl, Br, I, $C_1$-$C_{12}$-alkyl,
$C_6$-$C_{18}$-aryl,
wherein optionally one or more hydrogen atoms are independently substituted by $C_1$-Cs-alkyl substituents; and
$C_3$-$C_{15}$-heteroaryl,
wherein optionally one or more hydrogen atoms are independently substituted by $C_1$-Cs-alkyl substituents;
$R^I$, $R^{II}$, $R^{III}$, $R^{IV}$, $R^V$, $R^{VI}$, $R^{VII}$, $R^{VIII}$, $R^{IX}$, $R^X$, $R^{XI}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are at each occurrence independently selected from the group consisting of:

hydrogen, deuterium, $N(R^4)_2$, $OR^4$, $SR^4$, $Si(R^4)_3$, $B(OR^4)_2$, $OSO_2R^4$, $CF_3$, CN, F, Cl, Br, I,
$C_1$-$C_{40}$-alkyl,

which is optionally substituted with one or more substituents $R^4$ and
wherein one or more non-adjacent $CH_2$-groups are optionally substituted by $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;

$C_1$-$C_{40}$-alkoxy,

which is optionally substituted with one or more substituents $R^4$ and
wherein one or more non-adjacent $CH_2$-groups are optionally substituted by $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O,

S or $CONR^4$;

$C_1$-$C_{40}$-thioalkoxy,

which is optionally substituted with one or more substituents $R^4$ and wherein one or more non-adjacent $CH_2$-groups are optionally substituted by $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;

$C_2$-$C_{40}$-alkenyl,

which is optionally substituted with one or more substituents $R^4$ and wherein one or more non-adjacent $CH_2$-groups are optionally substituted by $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;

$C_2$-$C_{40}$-alkynyl,

which is optionally substituted with one or more substituents $R^4$ and wherein one or more non-adjacent $CH_2$-groups are optionally substituted by $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S or $CONR^4$;

$C_6$-$C_{60}$-aryl,

which is optionally substituted with one or more substituents $R^4$; and $C_3$-$C_{57}$-heteroaryl, which is optionally substituted with one or more substituents $R^4$;

$R^4$ is at each occurrence independently from another selected from the group consisting of:

hydrogen, deuterium, F, Cl, Br, I, OPh, SPh, $CF_3$, CN, $Si(C_1$-$C_5$-alkyl$)_3$, $Si(Ph)_3$,
$C_1$-$C_5$-alkyl,
wherein optionally one or more hydrogen atoms are independently substituted by deuterium, halogen, CN, or $CF_3$;
$C_1$-$C_5$-alkoxy,
wherein optionally one or more hydrogen atoms are independently substituted by deuterium, halogen, CN, or $CF_3$;
$C_1$-$C_5$-thioalkoxy,
wherein optionally one or more hydrogen atoms are independently substituted by deuterium, halogen, CN, or $CF_3$;
$C_2$-$C_5$-alkenyl,
wherein optionally one or more hydrogen atoms are independently substituted by deuterium, halogen, CN, or $CF_3$;
$C_2$-$C_5$-alkynyl,
wherein optionally one or more hydrogen atoms are independently substituted by deuterium, halogen, CN, or $CF_3$;
$C_6$-$C_{18}$-aryl,
which is optionally substituted with one or more substituents $R^5$;
$C_3$-$C_{17}$-heteroaryl,
which is optionally substituted with one or more substituents $R^5$;
$N(C_6$-$C_{18}$-aryl$)_2$,
$N(C_3$-$C_{17}$-heteroaryl$)_2$; and
$N(C_3$-$C_{17}$-heteroaryl$)(C_6$-$C_{18}$-aryl$)$,
wherein substituents $R^a$ positioned adjacent to each other are optionally bonded to each other and form an aryl ring, which is optionally substituted with one or more substituents selected from the group consisting of $C_1$-$C_5$-alkyl, deuterium, F, Cl, Br, I, CN and $CF_3$.

2. Organic molecule according to claim 1, comprising a structure of formula II-a:

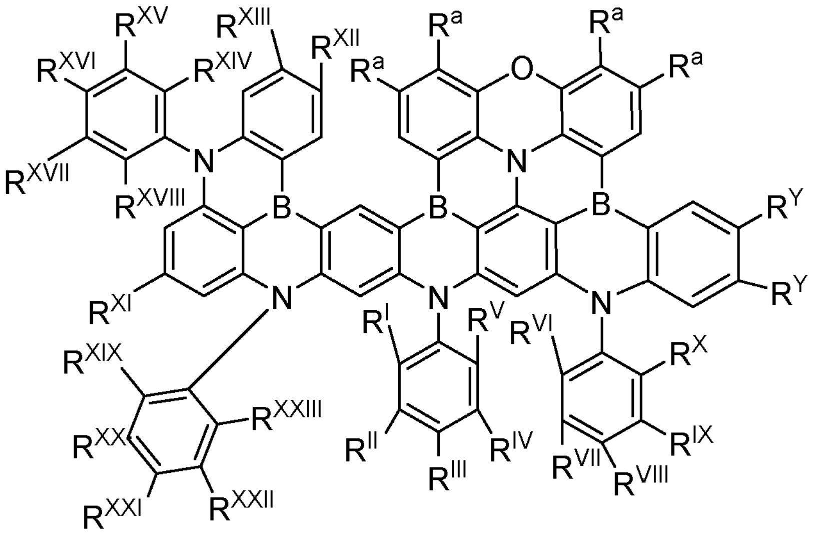

Formula II-a

3. Organic molecule according to claim 1 or 2, wherein the second chemical moiety consists of a structure of formula II-0a, formula II-0b or formula II-0c:

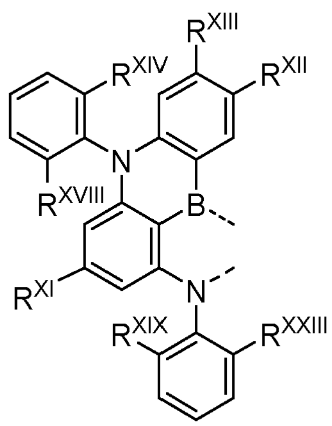

Formula II-0a

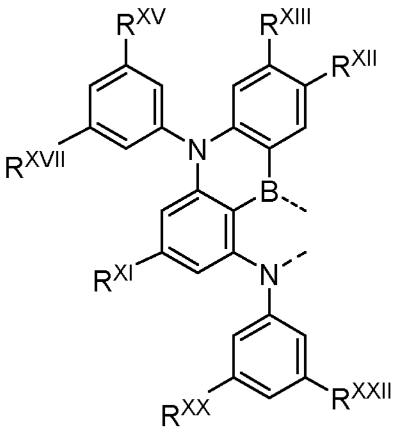

Formula II-0b

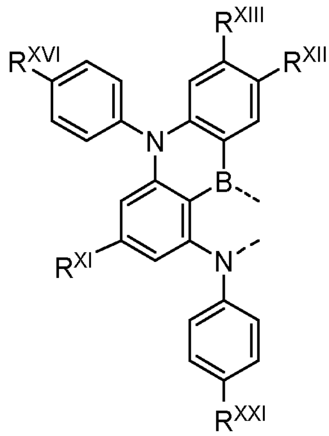

Formula II-0c

4. Organic molecule according to any of claims 1 to 3, wherein the second chemical moiety consists of a structure of formula II-I:

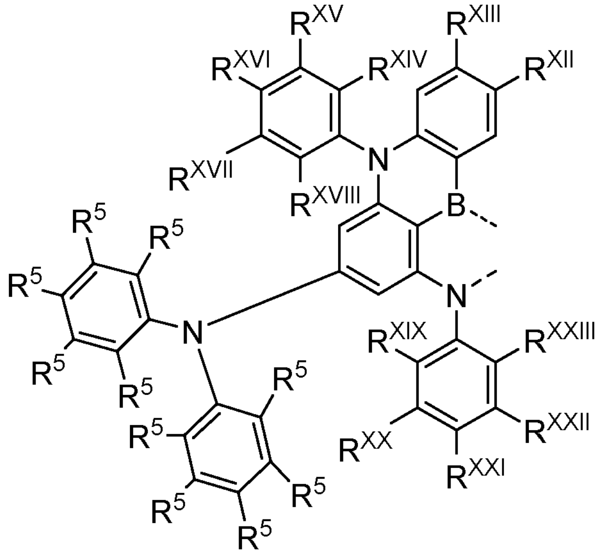

Formula II-I

5. Organic molecule according to any of claims 1 to 4, wherein $R^Y$ indicates the binding site of a single bond linking the first chemical moiety to the second moiety.

6. Organic molecule according to any of claims 1 to 5, wherein $R^a$ is independently selected from the group consisting of:

hydrogen, Me, $^i$Pr, $^t$Bu, CN, $CF_3$, F,
Ph, which is optionally substituted with one or more substituents independently from each other selected from the group consisting of Me, $^i$Pr, $^t$Bu, CN, $CF_3$, F and Ph,
pyridinyl, which is optionally substituted with one or more substituents independently from each other selected from the group consisting of Me, $^i$Pr, $^t$Bu, CN, $CF_3$, F and Ph,
carbazolyl, which is optionally substituted with one or more substituents independently from each other selected from the group consisting of Me, $^i$Pr, $^t$Bu, CN, $CF_3$, F and Ph,
triazinyl, which is optionally substituted with one or more substituents independently from each other selected from the group consisting of Me, $^i$Pr, $^t$Bu, CN, $CF_3$, F and Ph,
and $N(Ph)_2$, which is optionally substituted with one or more substituents independently from each other selected from the group consisting of Me, $^i$Pr, $^t$Bu, F and Ph.

7. Organic molecule according to any of claims 1 to 6, wherein $R^I$, $R^{II}$, $R^{III}$, $R^{IV}$, $R^V$, $R^{VI}$, $R^{VII}$, $R^{VIII}$, $R^{IX}$, $R^X$, $R^{XI}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are independently selected from the group consisting of:

hydrogen, Me, $^i$Pr, $^t$Bu, CN, $CF_3$, F,
Ph, which is optionally substituted with one or more substituents independently from each other selected from the group consisting of Me, $^i$Pr, $^t$Bu, CN, $CF_3$, F and Ph,
pyridinyl, which is optionally substituted with one or more substituents independently from each other selected from the group consisting of Me, $^i$Pr, $^t$Bu, CN, $CF_3$, F and Ph,
carbazolyl, which is optionally substituted with one or more substituents independently from each other selected from the group consisting of Me, $^i$Pr, $^t$Bu, CN, $CF_3$, F and Ph,
triazinyl, which is optionally substituted with one or more substituents independently from each other selected from the group consisting of Me, $^i$Pr, $^t$Bu, CN, $CF_3$, F and Ph, and
$N(Ph)_2$, which is optionally substituted with one or more substituents independently from each other selected from the group consisting of Me, $^i$Pr, $^t$Bu, F and Ph.

8. Organic molecule according to any of claims 1 to 7, wherein $R^I$, $R^{II}$, $R^{III}$, $R^{IV}$, $R^V$, $R^{VI}$, $R^{VII}$, $R^{VIII}$, $R^{IX}$, $R^X$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, and $R^{XXIII}$ are independently selected from the group consisting of:

hydrogen, Me, $^{i}$Pr, $^{t}$Bu, CN, $CF_3$, F,
Ph, which is optionally substituted with one or more substituents independently from each other selected from the group consisting of Me, $^{i}$Pr, $^{t}$Bu, CN, $CF_3$, F and Ph,
pyridinyl, which is optionally substituted with one or more substituents independently from each other selected from the group consisting of Me, $^{i}$Pr, $^{t}$Bu, CN, $CF_3$, F and Ph,
carbazolyl, which is optionally substituted with one or more substituents independently from each other selected from the group consisting of Me, $^{i}$Pr, $^{t}$Bu, CN, $CF_3$, F and Ph,
triazinyl, which is optionally substituted with one or more substituents independently from each other selected from the group consisting of Me, $^{i}$Pr, $^{t}$Bu, CN, $CF_3$, F and Ph.

**9.** Use of an organic molecule according to any of claims 1 to 8 as a luminescent emitter in an optoelectronic device.

**10.** Use according to claim 9, wherein the optoelectronic device is selected from the group consisting of: organic light-emitting diodes (OLEDs), light-emitting electrochemical cells, OLED-sensors, organic diodes, organic solar cells, organic transistors, organic field-effect transistors, organic lasers, and down-conversion elements.

**11.** Composition, comprising:

(a) an organic molecule according to any of claims 1 to 8, in particular in the form of an emitter and/or a host, and
(b) an emitter and/or host material, which differs from the organic molecule, and
(c) optionally, a dye and/or a solvent.

**12.** Optoelectronic device, comprising an organic molecule according to any of claims 1 to 8 or a composition according to claim 11.

**13.** Optoelectronic device according to claim 12 in the form of a device selected from the group consisting of organic light-emitting diode (OLED), light-emitting electrochemical cell, OLED-sensor, organic diode, organic solar cell, organic transistor, organic field-effect transistor, organic laser, and down-conversion element.

**14.** Optoelectronic device according to claim 12 or 13, comprising:

- a substrate,
- an anode, and
- a cathode, wherein the anode or the cathode is disposed on the substrate, and
- a light-emitting layer, which is arranged between the anode and the cathode and which comprises the organic molecule or the composition.

**15.** Method for producing an optoelectronic device, wherein an organic molecule according to any one of claims 1 to 8 or a composition according to claim 11 is used, in particular comprising the processing of the organic molecule by a vacuum evaporation method or from a solution.

**Patentansprüche**

**1.** Organisches Molekül, umfassend

- eine erste chemische Einheit, umfassend eine Struktur der Formel I:

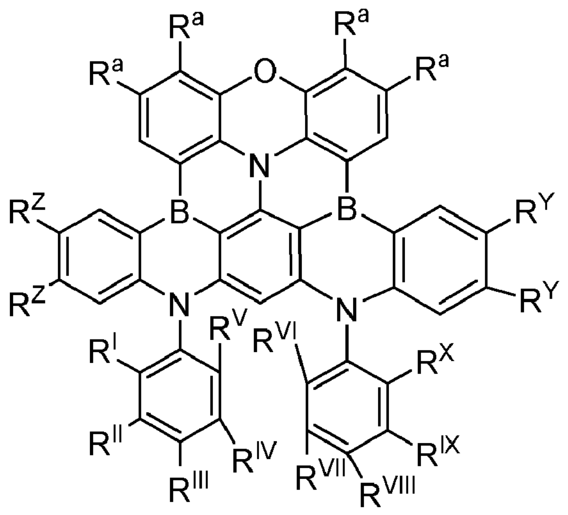

Formel I

und

- eine oder zwei zweite chemische Einheiten, umfassend eine Struktur der Formel II:

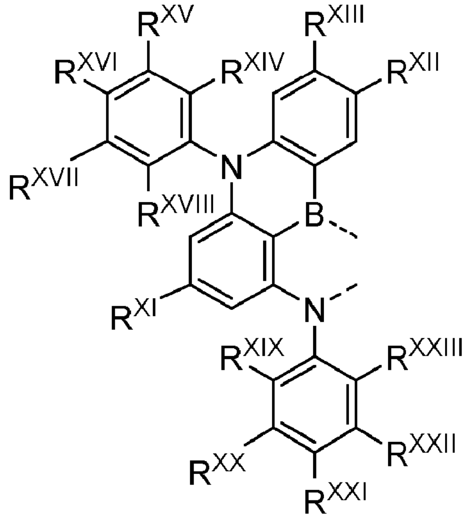

Formel II

wobei

$R^z$ die Bindungsstelle einer Einfachbindung angibt, die die erste chemische Einheit mit der zweiten Einheit verbindet;

$R^Y$ die Bindungsstelle einer Einfachbindung angibt, die die erste chemische Einheit mit der zweiten Einheit verbindet, oder $R^a$ ist;

die gestrichelten Linien

“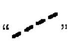”

die Bindungsstellen der ersten chemische Einheit an die zweite chemische Einheit darstellen;

$R^a$ bei jedem Vorkommen unabhängig aus der Gruppe bestehend aus Folgenden ausgewählt ist:

Wasserstoff, Deuterium, $N(R^5)_2$, $OR^5$, $SR^5$, $CF_3$, CN, F, Cl, Br, I,

$C_1$-$C_{40}$-Alkyl,

das gegebenenfalls durch einen oder mehrere Substituenten $R^5$ substituiert ist und wobei eine oder mehrere nicht angrenzende $CH_2$-Gruppen gegebenenfalls durch $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S oder $CONR^5$ substituiert sind;

$C_1$-$C_{40}$-Alkoxy,

das gegebenenfalls durch einen oder mehrere Substituenten $R^5$ substituiert ist und wobei eine oder mehrere nicht angrenzende $CH_2$-Gruppen gegebenenfalls durch $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S oder $CONR^5$ substituiert sind;

$C_1$-$C_{40}$- Thioalkoxy,

das gegebenenfalls durch einen oder mehrere Substituenten $R^4$ substituiert ist und wobei eine oder mehrere nicht angrenzende $CH_2$-Gruppen gegebenenfalls durch $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S oder $CONR^5$ substituiert sind;

$C_6$-$C_{60}$-Aryl,
das gegebenenfalls durch einen oder mehrere Substituenten $R^5$ substituiert ist; und
$C_3$-$C_{57}$-Heteroaryl,
das gegebenenfalls durch einen oder mehrere Substituenten $R^5$ substituiert ist;
$R^5$ bei jedem Vorkommen unabhängig aus der Gruppe bestehend aus Folgenden ausgewählt ist:

Wasserstoff, Deuterium, F, Cl, Br, I,
$C_1$-$C_{12}$-Alkyl,
wobei gegebenenfalls ein oder mehrere Wasserstoffatome unabhängig durch $R^6$ substituiert sind;
$C_6$-$C_{18}$-Aryl,
wobei gegebenenfalls ein oder mehrere Wasserstoffatome unabhängig durch $R^6$ substituiert sind; und
$C_3$-$C_{15}$-Heteroaryl,
wobei gegebenenfalls ein oder mehrere Wasserstoffatome unabhängig durch $R^6$ substituiert sind;
$R^6$ bei jedem Vorkommen unabhängig aus der Gruppe bestehend aus Folgenden ausgewählt ist:

Wasserstoff, Deuterium, F, Cl, Br, I, $C_1$-$C_{12}$-Alkyl,
$C_6$-$C_{18}$-Aryl,
wobei gegebenenfalls ein oder mehrere Wasserstoffatome unabhängig durch $C_1C_5$-Alkyl-Substituenten substituiert sind; und
$C_3$-$C_{15}$-Heteroaryl,
wobei gegebenenfalls ein oder mehrere Wasserstoffatome unabhängig durch $C_1C_5$-Alkyl-Substituenten substituiert sind;
$R^I$, $R^{II}$, $R^{III}$, $R^{IV}$, $R^V$, $R^{VI}$, $R^{VII}$, $R^{VIII}$, $R^{IX}$, $R^X$, $R^{XI}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, und $R^{XXIII}$ bei jedem Vorkommen unabhängig aus der Gruppe bestehend aus Folgenden ausgewählt sind:

Wasserstoff, Deuterium, $N(R^4)_2$, $OR^4$, $SR^4$, $Si(R^4)_3$, $B(OR^4)_2$, $OSO_2R^4$, $CF_3$, CN, F, Cl, Br, I,
$C_1$-$C_{40}$-Alkyl,

das gegebenenfalls durch einen oder mehrere Substituenten $R^4$ substituiert ist und wobei eine oder mehrere nicht angrenzende $CH_2$-Gruppen gegebenenfalls durch $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S oder $CONR^4$ substituiert sind;

$C_1$-$C_{40}$-Alkoxy,

das gegebenenfalls durch einen oder mehrere Substituenten $R^4$ substituiert ist und wobei eine oder mehrere nicht angrenzende $CH_2$-Gruppen gegebenenfalls durch $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S oder $CONR^4$ substituiert sind;

$C_1$-$C_{40}$- Thioalkoxy,

das gegebenenfalls durch einen oder mehrere Substituenten $R^4$ substituiert ist und wobei eine oder mehrere nicht angrenzende $CH_2$-Gruppen gegebenenfalls durch $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S oder $CONR^4$ substituiert sind;

$C_2$-$C_{40}$-Alkenyl,

das gegebenenfalls durch einen oder mehrere Substituenten $R^4$ substituiert ist und wobei eine oder mehrere nicht angrenzende $CH_2$-Gruppen gegebenenfalls durch $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S oder $CONR^4$ substituiert sind;

$C_2$-$C_{40}$-Alkinyl,

das gegebenenfalls durch einen oder mehrere Substituenten $R^4$ substituiert ist und wobei eine oder mehrere nicht angrenzende $CH_2$-Gruppen gegebenenfalls durch $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S oder $CONR^4$ substituiert sind;

$C_6$-$C_{60}$-Aryl,

das gegebenenfalls durch einen oder mehrere Substituenten $R^4$ substituiert ist; und $C_3$-$C_{57}$-Heteroaryl,
das gegebenenfalls durch einen oder mehrere Substituenten $R^4$ substituiert ist;

$R^4$ bei jedem Vorkommen unabhängig voneinander aus der Gruppe bestehend aus Folgenden ausgewählt ist: Wasserstoff, Deuterium, F, Cl, Br, I, OPh, SPh, $CF_3$, CN, $Si(C_1\text{-}C_5\text{-Alkyl})_3$, $Si(Ph)_3$,
wobei gegebenenfalls ein oder mehrere Wasserstoffatome unabhängig durch Deuterium, Halogen, CN oder $CF_3$ substituiert sind;
$C_1$-$C_5$-Alkoxy,
wobei gegebenenfalls ein oder mehrere Wasserstoffatome unabhängig durch Deuterium, Halogen, CN oder $CF_3$ substituiert sind;
$C_1$-$C_5$- Thioalkoxy,
wobei gegebenenfalls ein oder mehrere Wasserstoffatome unabhängig durch Deuterium, Halogen, CN oder $CF_3$ substituiert sind;
$C_2$-$C_5$-Alkenyl,
wobei gegebenenfalls ein oder mehrere Wasserstoffatome unabhängig durch Deuterium, Halogen, CN oder $CF_3$ substituiert sind;
$C_2$-$C_5$-Alkinyl,
wobei gegebenenfalls ein oder mehrere Wasserstoffatome unabhängig durch Deuterium, Halogen, CN oder $CF_3$ substituiert sind;
$C_6$-$C_{18}$-Aryl,
das gegebenenfalls durch einen oder mehrere Substituenten $R^5$ substituiert ist;
$C_3$-$C_{17}$-Heteroaryl,
das gegebenenfalls durch einen oder mehrere Substituenten $R^5$ substituiert ist;
$N(C_6\text{-}C_{18}\text{-AryL})_2$,
$N(C_3\text{-}C_{17}\text{-Heteroaryl})_2$; und
$N(C_3\text{-}C_{17}\text{-Heteroaryl})(C_6\text{-}C_{18}\text{-Aryl})$,
wobei Substituenten $R^a$, die angrenzend aneinander angeordnet sind, gegebenenfalls aneinander gebunden sind und einen Arylring bilden, der gegebenenfalls durch einen oder mehrere

Substituenten substituiert ist, die aus der Gruppe bestehend aus $C_1$-$C_5$-Alkyl, Deuterium, F, Cl, Br, I, CN und $CF_3$ ausgewählt sind.

2. Organisches Molekül nach Anspruch 1, umfassend eine Struktur der Formel II-a:

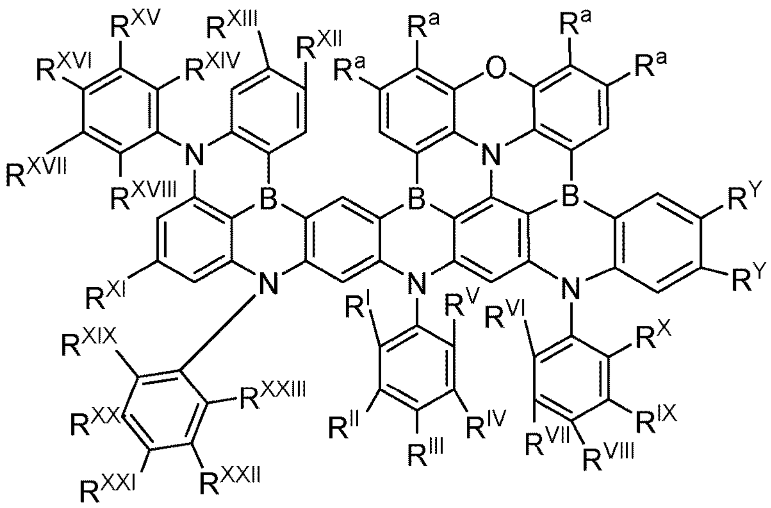

Formel II-a

3. Organisches Molekül nach Anspruch 1 oder 2, wobei die zweite chemische Einheit aus einer Struktur der Formel II-0a, Formel II-0b oder Formel II-0c besteht:

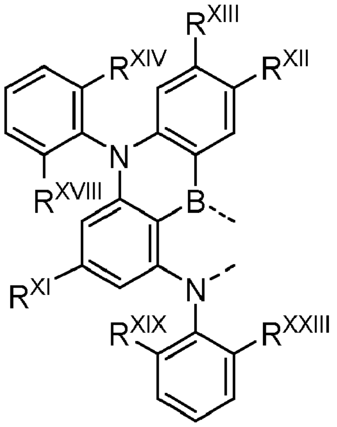

Formel II-0a

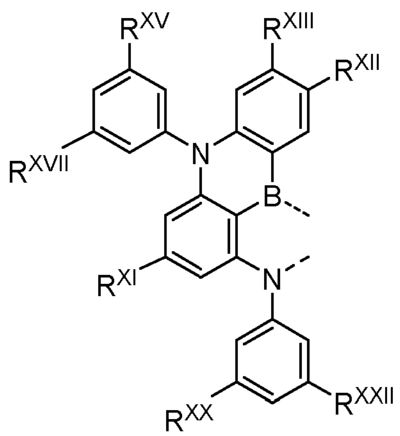

Formel II-0b

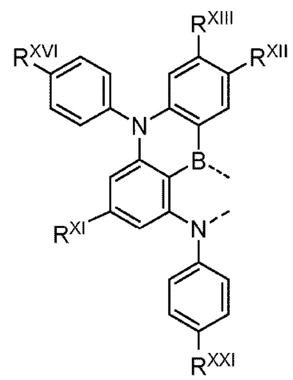

Formel II-0c

4. Organisches Molekül nach einem der Ansprüche 1 bis 3, wobei die zweite chemische Einheit aus einer Struktur der Formel II-1 besteht:

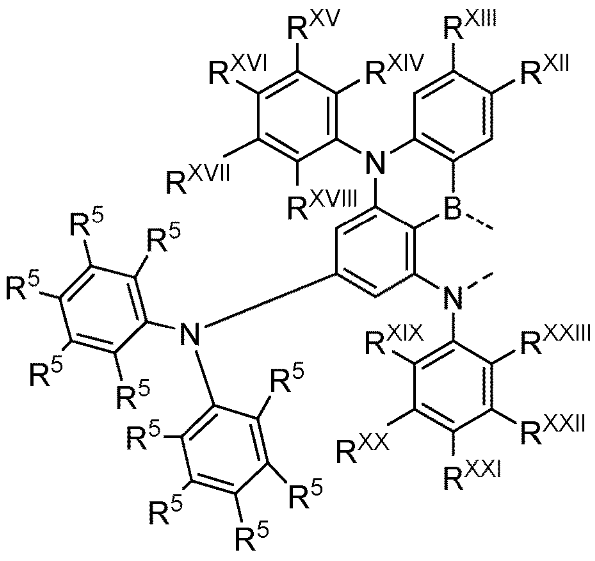

Formel II-I

5. Organisches Molekül nach einem der Ansprüche 1 bis 4, wobei $R^Y$ die Bindungsstelle einer Einfachbindung angibt, die die erste chemische Einheit mit der zweiten Einheit verbindet.

6. Organisches Molekül nach einem der Ansprüche 1 bis 5, wobei $R^a$ unabhängig aus der Gruppe bestehend aus Folgenden ausgewählt ist:

Wasserstoff, Me, $^i$Pr, $^t$Bu, CN, $CF_3$, F,
Ph, das gegebenenfalls durch einen oder mehrere Substituenten substituiert ist, die unabhängig voneinander aus der Gruppe bestehend aus Me, $^i$Pr, $^t$Bu, CN, $CF_3$, F und Ph ausgewählt sind,
Pyridinyl, das gegebenenfalls durch einen oder mehrere Substituenten substituiert ist, die unabhängig voneinander aus der Gruppe bestehend aus Me, $^i$Pr, $^t$Bu, CN, $CF_3$, F und Ph ausgewählt sind,
Carbazolyl, das gegebenenfalls durch einen oder mehrere Substituenten substituiert ist, die unabhängig voneinander aus der Gruppe bestehend aus Me, $^i$Pr, $^t$Bu, CN, $CF_3$, F und Ph ausgewählt sind,
Triazinyl, das gegebenenfalls durch einen oder mehrere Substituenten substituiert ist, die unabhängig voneinander aus der Gruppe bestehend aus Me, $^i$Pr, $^t$Bu, CN, $CF_3$, F und Ph ausgewählt sind,
und $N(Ph)_2$, das gegebenenfalls durch einen oder mehrere Substituenten substituiert ist, die unabhängig voneinander aus der Gruppe bestehend aus Me, $^i$Pr, $^t$Bu, F und Ph ausgewählt sind.

7. Organisches Molekül nach einem der Ansprüche 1 bis 6, wobei $R^I$, $R^{II}$, $R^{III}$, $R^{IV}$, $R^V$, $R^{VI}$, $R^{VII}$, $R^{VIII}$, $R^{IX}$, $R^X$, $R^{XI}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$ und $R^{XXIII}$ unabhängig aus der Gruppe bestehend aus Folgenden ausgewählt sind:

Wasserstoff, Me, $^i$Pr, $^t$Bu, CN, $CF_3$, F,
Ph, das gegebenenfalls durch einen oder mehrere Substituenten substituiert ist, die unabhängig voneinander aus der Gruppe bestehend aus Me, $^i$Pr, $^t$Bu, CN, $CF_3$, F und Ph ausgewählt sind,
Pyridinyl, das gegebenenfalls durch einen oder mehrere Substituenten substituiert ist, die unabhängig voneinander aus der Gruppe bestehend aus Me, $^i$Pr, $^t$Bu, CN, $CF_3$, F und Ph ausgewählt sind,
Carbazolyl, das gegebenenfalls durch einen oder mehrere Substituenten substituiert ist, die unabhängig voneinander aus der Gruppe bestehend aus Me, $^i$Pr, $^t$Bu, CN, $CF_3$, F und Ph ausgewählt sind,
Triazinyl, das gegebenenfalls durch einen oder mehrere Substituenten substituiert ist, die unabhängig voneinander aus der Gruppe bestehend aus Me, $^i$Pr, $^t$Bu, CN, $CF_3$, F und Ph ausgewählt sind, und
$N(Ph)_2$, das gegebenenfalls durch einen oder mehrere Substituenten substituiert ist, die unabhängig voneinander aus der Gruppe bestehend aus Me, $^i$Pr, $^t$Bu, F und Ph ausgewählt sind.

8. Organisches Molekül nach einem der Ansprüche 1 bis 7, wobei $R^I$, $R^{II}$, $R^{III}$, $R^{IV}$, $R^V$, $R^{VI}$, $R^{VII}$, $R^{VIII}$, $R^{IX}$, $R^X$, $R^{XI}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$ und $R^{XXIII}$ unabhängig aus der Gruppe bestehend aus Folgenden ausgewählt sind:

Wasserstoff, Me, $^{i}Pr$, $^{t}Bu$, CN, $CF_3$, F,
Ph, das gegebenenfalls durch einen oder mehrere Substituenten substituiert ist, die unabhängig voneinander aus der Gruppe bestehend aus Me, $^{i}Pr$, $^{t}Bu$, CN, $CF_3$, F und Ph ausgewählt sind,
Pyridinyl, das gegebenenfalls durch einen oder mehrere Substituenten substituiert ist, die unabhängig voneinander aus der Gruppe bestehend aus Me, $^{i}Pr$, $^{t}Bu$, CN, $CF_3$, F und Ph ausgewählt sind,
Carbazolyl, das gegebenenfalls durch einen oder mehrere Substituenten substituiert ist, die unabhängig voneinander aus der Gruppe bestehend aus Me, $^{i}Pr$, $^{t}Bu$, CN, $CF_3$, F und Ph ausgewählt sind,
Triazinyl, das gegebenenfalls durch einen oder mehrere Substituenten substituiert ist, die unabhängig voneinander aus der Gruppe bestehend aus Me, $^{i}Pr$, $^{t}Bu$, CN, $CF_3$, F und Ph ausgewählt sind.

**9.** Verwendung eines organischen Moleküls nach einem der Ansprüche 1 bis 8 als lumineszierender Emitter in einer optoelektronischen Vorrichtung.

**10.** Verwendung nach Anspruch 9, wobei die optoelektronische Vorrichtung ausgewählt ist aus der Gruppe bestehend aus: organischen Leuchtdioden (OLEDs), lichtemittierenden elektrochemischen Zellen, OLED-Sensoren, organischen Dioden, organischen Solarzellen, organischen Transistoren, organischen Feldeffekttransistoren, organischen Lasern und Abwärtskonvertierungselementen.

**11.** Zusammensetzung, umfassend:

(a) ein organisches Molekül nach einem der Ansprüche 1 bis 8, insbesondere in Form eines Emitters und/oder eines Hosts, und
(b) ein Emitter- und/oder Hostmaterial, das sich von dem organischen Molekül unterscheidet, und
(c) gegebenenfalls einen Farbstoff und/oder ein Lösungsmittel.

**12.** Optoelektronische Vorrichtung, umfassend ein organisches Molekül nach einem der Ansprüche 1 bis 8 oder eine Zusammensetzung nach Anspruch 11.

**13.** Optoelektronische Vorrichtung nach Anspruch 12 in Form einer Vorrichtung, die aus der Gruppe bestehend aus organischer Leuchtdiode (OLED), lichtemittierender elektrochemischer Zelle, OLED-Sensor, organischer Diode, organischer Solarzelle, organischem Transistor, organischem Feldeffekttransistor, organischem Laser und Abwärtskonvertierungselement ausgewählt ist.

**14.** Optoelektronische Vorrichtung nach Anspruch 12 oder 13, umfassend:

- ein Substrat,
- eine Anode und
- eine Kathode, wobei die Anode oder die Kathode auf dem Substrat angeordnet ist, und
- eine lichtemittierende Schicht, die zwischen der Anode und der Kathode angeordnet ist und die das organische Molekül oder die Zusammensetzung umfasst.

**15.** Verfahren zum Herstellen einer optoelektronischen Vorrichtung, in der ein organisches Molekül nach einem der Ansprüche 1 bis 8 oder eine Zusammensetzung nach Anspruch 11 verwendet wird, insbesondere umfassend die Verarbeitung des organischen Moleküls durch ein Vakuumverdampfungsverfahren oder aus einer Lösung.

**Revendications**

**1.** Molécule organique, comprenant

- un premier fragment chimique comprenant une structure de formule I :

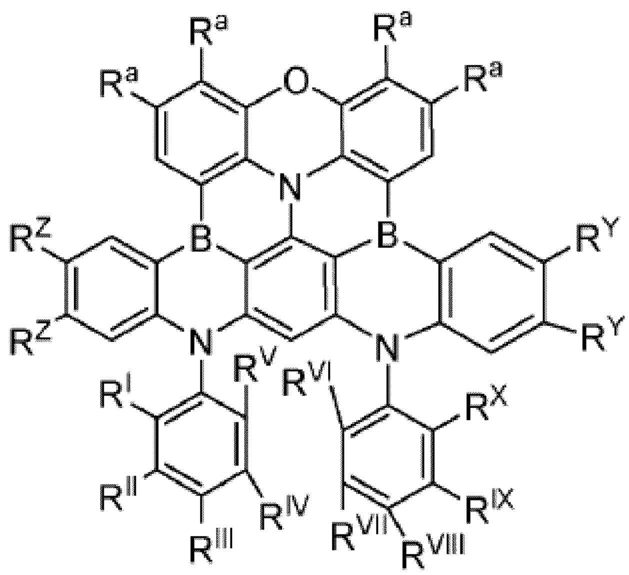

Formule I

et

- un ou deux deuxièmes fragments chimiques comprenant une structure de formule II :

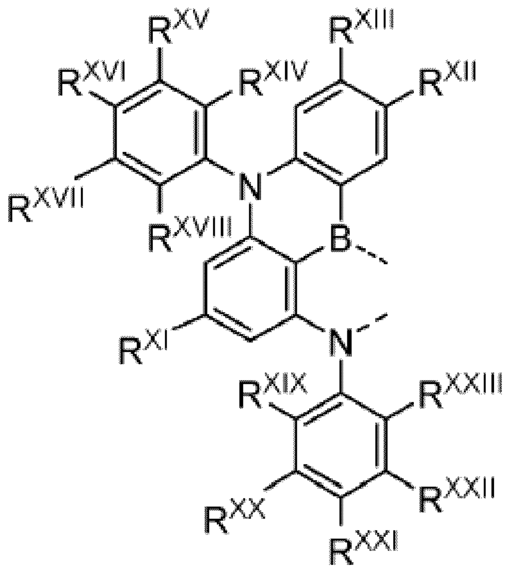

Formule II

dans laquelle

$R^Z$ indique le site de liaison d'une liaison simple reliant le premier fragment chimique au deuxième fragment ;

$R^Y$ indique le site de liaison d'une liaison simple reliant le premier fragment chimique au deuxième fragment ou est $R^a$ ;

les lignes pointillées

« 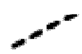 »

représentent les sites de liaison du premier fragment chimique au deuxième fragment chimique ;

$R^a$ est à chaque occurrence sélectionné indépendamment parmi le groupe consistant en :

un hydrogène, un deutérium, $N(R^5)_2$, $OR^5$, $SR^5$, $CF_3$, CN, F, Cl, Br, I,
un alkyle en $C_1$-$C_{40}$,
qui est facultativement substitué avec un ou plusieurs substituants $R^5$ et
dans lequel un ou plusieurs groupes $CH_2$ non adjacents sont facultativement remplacés par $R^5C=CR^5$, C≡C, $Si(R^5)_2$, Ge $(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
un alcoxy en $C_1$-$C_{40}$,
qui est facultativement substitué avec un ou plusieurs substituants $R^5$ et
dans lequel un ou plusieurs groupes $CH_2$ non adjacents sont facultativement remplacés par $R^5C=CR^5$, C≡C, $Si(R^5)_2$, $Ge(R^5)_2$, $Sn(R^5)_2$, C=O, C=S, C=Se, $C=NR^5$, P $(=O)(R^5)$, SO, $SO_2$, $NR^5$, O, S ou $CONR^5$ ;
un thioalcoxy en $C_1$-$C_{40}$,
qui est facultativement substitué avec un ou plusieurs substituants $R^4$ et
dans lequel un ou plusieurs groupes $CH_2$ non adjacents sont facultativement remplacés par $R^5C=CR^5$, C≡C, $Si(R^5)_2$, $Ge(R^5)_2$, $Sn(R^5)_2$, C=O, C=S, C=Se, $C=NR^5$, P $(=O)(R^5)$, SO, $SO_2$, $NR^5$, O, S ou $CONR^5$ ;
un aryle en $C_6$-$C_{60}$,
qui est facultativement substitué avec un ou plusieurs substituants $R^5$ ; et
un hétéroaryle en $C_3$-$C_{57}$,
qui est facultativement substitué avec un ou plusieurs substituants $R^5$ ;
$R^5$ est à chaque occurrence sélectionné indépendamment parmi le groupe consistant en :

un hydrogène, un deutérium, F, Cl, Br, I,
un alkyle en $C_1$-$C_{12}$,
dans lequel facultativement un ou plusieurs atomes d'hydrogène sont indépendamment remplacés par $R^6$ ;
un aryle en $C_6$-$C_{18}$,
dans lequel facultativement un ou plusieurs atomes d'hydrogène sont indépendamment remplacés par $R^6$ ; et
un hétéroaryle en $C_3$-$C_{15}$,
dans lequel facultativement un ou plusieurs atomes d'hydrogène sont indépendamment remplacés par $R^6$ ;
$R^6$ est à chaque occurrence sélectionné indépendamment parmi le groupe consistant en :

un hydrogène, un deutérium, F, Cl, Br, I, un alkyle en $C_1$-$C_{12}$,
un aryle en $C_6$-$C_{18}$,
dans lequel facultativement un ou plusieurs atomes d'hydrogène sont indépendamment remplacés par des substituants alkyle en $C_1$-$C_5$ ; et
un hétéroaryle en $C_3$-$C_{15}$,
dans lequel facultativement un ou plusieurs atomes d'hydrogène sont indépendamment remplacés par des substituants alkyle en $C_1$-$C_5$ ;
$R^I$, $R^{II}$, $R^{III}$, $R^{IV}$, $R^V$, $R^{VI}$, $R^{VII}$, $R^{VIII}$, $R^{IX}$, $R^X$, $R^{XI}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$, et $R^{XXIII}$ sont à chaque occurrence sélectionnés indépendamment parmi le groupe consistant en :
un hydrogène, un deutérium, $N(R^4)_2$, $OR^4$, $SR^4$, $Si(R^4)_3$, $B(OR^4)_2$, $OSO_2R^4$, $CF_3$, CN, F, Cl, Br, I,
un alkyle en $C_1$-$C_{40}$,
qui est facultativement substitué avec un ou plusieurs substituants $R^4$ et
dans lequel un ou plusieurs groupes $CH_2$ non adjacents sont facultativement remplacés par $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S ou $CONR^4$ ;
un alcoxy en $C_1$-$C_{40}$,
qui est facultativement substitué avec un ou plusieurs substituants $R^4$ et
dans lequel un ou plusieurs groupes $CH_2$ non adjacents sont facultativement remplacés par $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S ou $CONR^4$ ;
un thioalcoxy en $C_1$-$C_{40}$,
qui est facultativement substitué avec un ou plusieurs substituants $R^4$ et
dans lequel un ou plusieurs groupes $CH_2$ non adjacents sont facultativement remplacés par $R^4C=CR^4$, C≡C, $Si(R^4)_2$, $Ge(R^4)_2$, $Sn(R^4)_2$, C=O, C=S, C=Se, $C=NR^4$, $P(=O)(R^4)$, SO, $SO_2$, $NR^4$, O, S ou $CONR^4$ ;
un alcényle en $C_2$-$C_{40}$,

qui est facultativement substitué avec un ou plusieurs substituants $R^4$ et
dans lequel un ou plusieurs groupes $CH_2$ non adjacents sont facultativement remplacés par $R^4C=CR^4$, C≡C, $Si(R^4)_2$, $Ge(R^4)_2$, $Sn(R^4)_2$, C=O, C=S, C=Se, $C=NR^4$, P (=O) ($R^4$), SO, $SO_2$, $NR^4$, O, S ou $CONR^4$ ;
un alcynyle en $C_2$-$C_{40}$,
qui est facultativement substitué avec un ou plusieurs substituants $R^4$ et
dans lequel un ou plusieurs groupes $CH_2$ non adjacents sont facultativement remplacés par $R^4C=CR^4$, C≡C, $Si(R^4)_2$, $Ge(R^4)_2$, $Sn(R^4)_2$, C=O, C=S, C=Se, $C=NR^4$, P(=O)($R^4$), SO, $SO_2$, $NR^4$, O, S ou $CONR^4$ ;
un aryle en $C_6$-$C_{60}$,
qui est facultativement substitué avec un ou plusieurs substituants $R^4$ ; et
un hétéroaryle en $C_3$-$C_{57}$,
qui est facultativement substitué avec un ou plusieurs substituants $R^4$ ;
$R^4$ est à chaque occurrence indépendamment d'un autre sélectionné parmi le groupe consistant en :

un hydrogène, un deutérium, F, Cl, Br, I, OPh, SPh, $CF_3$, CN, un Si (alkyle en $C_1$-$C_5$)$_3$, $Si(Ph)_3$,
un alkyle en $C_1$-$C_5$,
dans lequel facultativement un ou plusieurs atomes d'hydrogène sont indépendamment remplacés par un deutérium, un halogène, CN ou $CF_3$ ;
un alcoxy en $C_1$-$C_5$,
dans lequel facultativement un ou plusieurs atomes d'hydrogène sont indépendamment remplacés par un deutérium, un halogène, CN ou $CF_3$ ;
un thioalcoxy en $C_1$-$C_5$,
dans lequel facultativement un ou plusieurs atomes d'hydrogène sont indépendamment remplacés par un deutérium, un halogène, CN ou $CF_3$ ;
un alcényle en $C_2$-$C_5$,
dans lequel facultativement un ou plusieurs atomes d'hydrogène sont indépendamment remplacés par un deutérium, un halogène, CN ou $CF_3$ ;
un alcynyle en $C_2$-$C_5$,
dans lequel facultativement un ou plusieurs atomes d'hydrogène sont indépendamment remplacés par un deutérium, un halogène, CN ou $CF_3$ ;
un aryle en $C_6$-$C_{18}$,
qui est facultativement substitué avec un ou plusieurs substituants $R^5$ ;
un hétéroaryle en $C_3$-$C_{17}$,
qui est facultativement substitué avec un ou plusieurs substituants $R^5$ ;
un N (aryle en $C_6$-$C_{18}$)$_2$,
un N (hétéroaryle en $C_3$-$C_{17}$)$_2$ ; et
un N (hétéroaryle en $C_3$-$C_{17}$) (aryle en $C_6$-$C_{18}$),
dans lequel les substituants $R^a$ positionnés adjacents l'un à l'autre sont facultativement liés l'un à l'autre et forment un cycle aryle, qui est facultativement substitué avec un ou plusieurs substituants sélectionnés parmi le groupe consistant en un alkyle en $C_1$-$C_5$, un deutérium, F, Cl, Br, I, CN et $CF_3$.

**2.** Molécule organique selon la revendication 1, comprenant une structure de formule II-a :

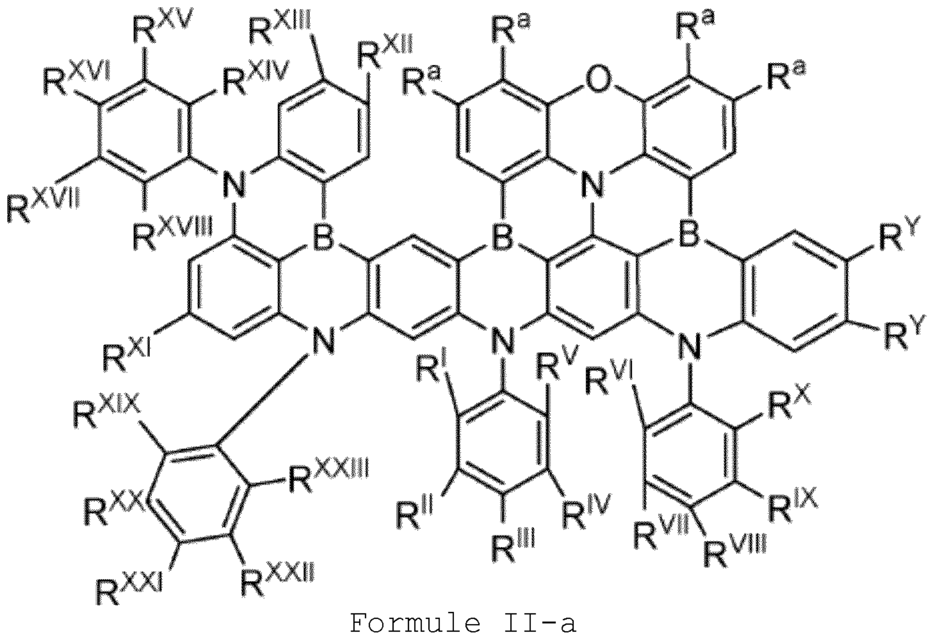

Formule II-a

3. Molécule organique selon la revendication 1 ou 2, dans laquelle le deuxième fragment chimique consiste en une structure de formule II-0a, de formule II-0b ou de formule II-0c :

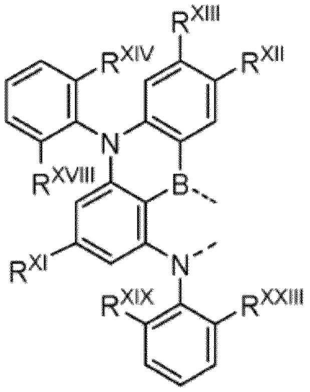

Formule II-0a

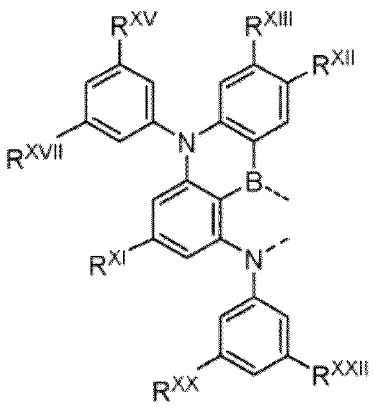

Formule II-0b

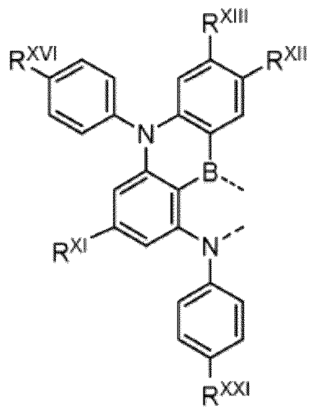

Formule II-0c

4. Molécule organique selon l'une quelconque des revendications 1 à 3, dans laquelle le deuxième fragment chimique consiste en une structure de formule II-I :

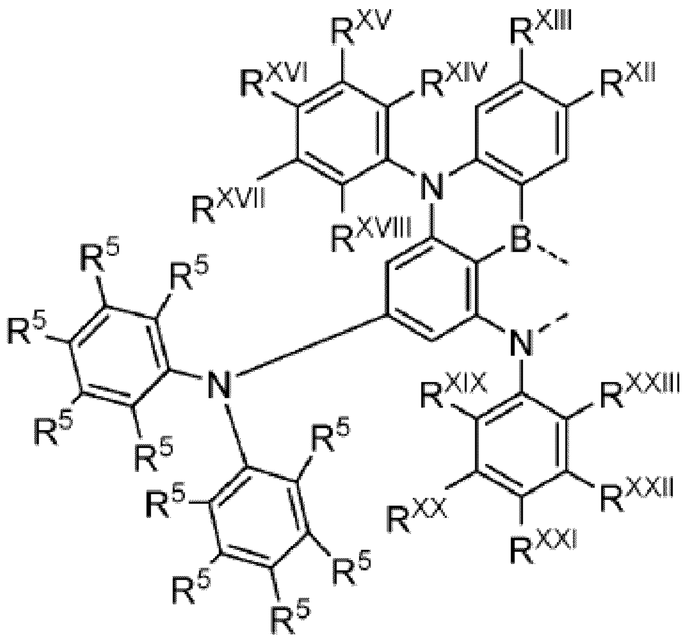

Formule II-I

5. Molécule organique selon l'une quelconque des revendications 1 à 4, dans laquelle $R^Y$ indique le site de liaison d'une liaison simple reliant le premier fragment chimique au deuxième fragment.

6. Molécule organique selon l'une quelconque des revendications 1 à 5, dans laquelle $R^a$ est sélectionné indépendamment parmi le groupe consistant en :

un hydrogène, Me, $^i$Pr, $^t$Bu, CN, $CF_3$, F,
Ph, qui est facultativement substitué avec un ou plusieurs substituants sélectionnés indépendamment les uns des autres parmi le groupe consistant en Me, $^i$Pr, $^t$Bu, CN, $CF_3$, F et Ph,
un pyridinyle, qui est facultativement substitué avec un ou plusieurs substituants sélectionnés indépendamment les uns des autres parmi le groupe consistant en Me, $^i$Pr, $^t$Bu, CN, $CF_3$, F et Ph,
un carbazolyle, qui est facultativement substitué avec un ou plusieurs substituants sélectionnés indépendamment les uns des autres parmi le groupe consistant en Me, $^i$Pr, $^t$Bu, CN, $CF_3$, F et Ph,
un triazinyle, qui est facultativement substitué avec un ou plusieurs substituants sélectionnés indépendamment les uns des autres parmi le groupe consistant en Me, $^i$Pr, $^t$Bu, CN, $CF_3$, F et Ph,
et $N(Ph)_2$, qui est facultativement substitué avec un ou plusieurs substituants sélectionnés indépendamment les uns des autres parmi le groupe consistant en Me, $^i$Pr, $^t$Bu, F et Ph.

7. Molécule organique selon l'une quelconque des revendications 1 à 6, dans laquelle $R^I$, $R^{II}$, $R^{III}$, $R^{IV}$, $R^V$, $R^{VI}$, $R^{VII}$, $R^{VIII}$, $R^{IX}$, $R^X$, $R^{XI}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$ et $R^{XXIII}$ sont sélectionnés indépendamment parmi le groupe consistant en :

un hydrogène, Me, $^i$Pr, $^t$Bu, CN, $CF_3$, F,
Ph, qui est facultativement substitué avec un ou plusieurs substituants sélectionnés indépendamment les uns des autres parmi le groupe consistant en Me, $^i$Pr, $^t$Bu, CN, $CF_3$, F et Ph,
un pyridinyle, qui est facultativement substitué avec un ou plusieurs substituants sélectionnés indépendamment les uns des autres parmi le groupe consistant en Me, $^i$Pr, $^t$Bu, CN, $CF_3$, F et Ph,
un carbazolyle, qui est facultativement substitué avec un ou plusieurs substituants sélectionnés indépendamment les uns des autres parmi le groupe consistant en Me, $^i$Pr, $^t$Bu, CN, $CF_3$, F et Ph,
un triazinyle, qui est facultativement substitué avec un ou plusieurs substituants sélectionnés indépendamment les uns des autres parmi le groupe consistant en Me, $^i$Pr, $^t$Bu, CN, $CF_3$, F et Ph, et
$N(Ph)_2$, qui est facultativement substitué avec un ou plusieurs substituants sélectionnés indépendamment les uns des autres parmi le groupe consistant en Me, $^i$Pr, $^t$Bu, F et Ph.

8. Molécule organique selon l'une quelconque des revendications 1 à 7, dans laquelle $R^I$, $R^{II}$, $R^{III}$, $R^{IV}$, $R^V$, $R^{VI}$, $R^{VII}$,

$R^{VIII}$, $R^{IX}$, $R^{X}$, $R^{XII}$, $R^{XIII}$, $R^{XIV}$, $R^{XV}$, $R^{XVI}$, $R^{XVII}$, $R^{XVIII}$, $R^{XIX}$, $R^{XX}$, $R^{XXI}$, $R^{XXII}$ et $R^{XXIII}$ sont sélectionnés indépendamment parmi le groupe consistant en :

un hydrogène, Me, $^{i}$Pr, $^{t}$Bu, CN, $CF_3$, F,
Ph, qui est facultativement substitué avec un ou plusieurs substituants sélectionnés indépendamment les uns des autres parmi le groupe consistant en Me, $^{i}$Pr, $^{t}$Bu, CN, $CF_3$, F et Ph,
un pyridinyle, qui est facultativement substitué avec un ou plusieurs substituants sélectionnés indépendamment les uns des autres parmi le groupe consistant en Me, $^{i}$Pr, $^{t}$Bu, CN, $CF_3$, F et Ph,
un carbazolyle, qui est facultativement substitué avec un ou plusieurs substituants sélectionnés indépendamment les uns des autres parmi le groupe consistant en Me, $^{i}$Pr, $^{t}$Bu, CN, $CF_3$, F et Ph,
un triazinyle, qui est facultativement substitué avec un ou plusieurs substituants sélectionnés indépendamment les uns des autres parmi le groupe consistant en Me, $^{i}$Pr, $^{t}$Bu, CN, $CF_3$, F et Ph.

**9.** Utilisation d'une molécule organique selon l'une quelconque des revendications 1 à 8 comme émetteur luminescent dans un dispositif optoélectronique.

**10.** Utilisation selon la revendication 9, dans laquelle le dispositif optoélectronique est sélectionné parmi le groupe consistant en : les diodes électroluminescentes organiques (DELO), les cellules électrochimiques électroluminescentes, les capteurs DELO, les diodes organiques, les cellules solaires organiques, les transistors organiques, les transistors organiques à effet de champ, les lasers organiques, et les éléments de conversion descendante.

**11.** Composition, comprenant :

(a) une molécule organique selon l'une des revendications 1 à 8, en particulier sous forme d'un émetteur et/ou d'un hôte, et
(b) un matériau émetteur et/ou hôte, qui est différent de la molécule organique, et
(c) facultativement, un colorant et/ou un solvant.

**12.** Dispositif optoélectronique, comprenant une molécule organique selon l'une des revendications 1 à 8 ou une composition selon la revendication 11.

**13.** Dispositif optoélectronique selon la revendication 12, sous la forme d'un dispositif sélectionné parmi le groupe consistant en une diode électroluminescente organique (DELO), une cellule électrochimique électroluminescente, un capteur DELO, une diode organique, une cellule solaire organique, un transistor organique, un transistor organique à effet de champ, un laser organique, et un élément de conversion descendante.

**14.** Dispositif optoélectronique selon la revendication 12 ou 13, comprenant :

- un substrat,
- une anode, et
- une cathode, dans lequel l'anode ou la cathode est disposée sur le substrat, et
- une couche électroluminescente, qui est agencée entre l'anode et la cathode et qui comprend la molécule organique ou la composition.

**15.** Procédé de fabrication d'un dispositif optoélectronique, dans lequel une molécule organique selon l'une quelconque des revendications 1 à 8 ou une composition selon la revendication 11 est utilisée, en particulier comprenant le traitement de la molécule organique par un procédé d'évaporation sous vide ou à partir d'une solution.

Figure 1

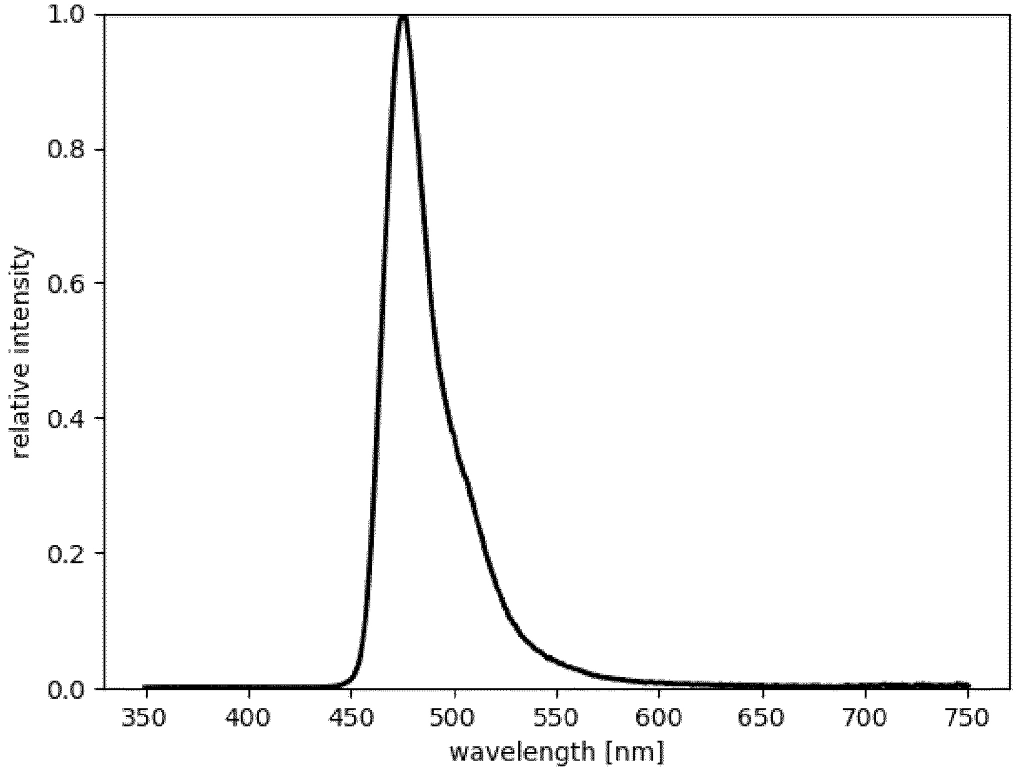


Figure 2

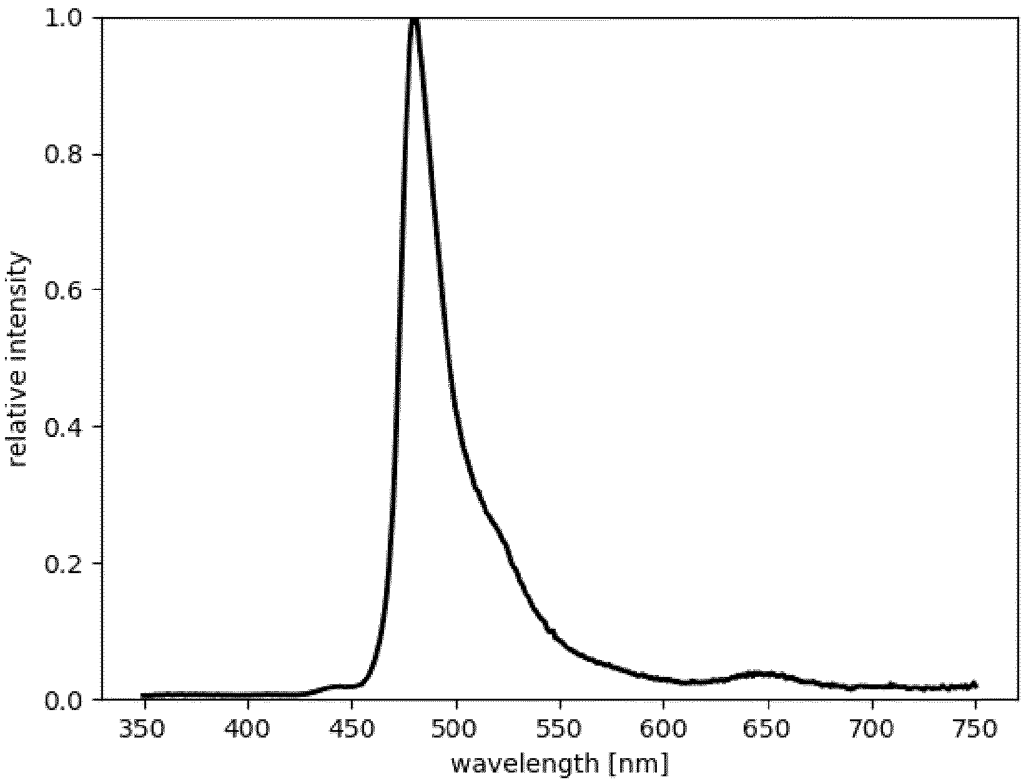

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CA 3017010
- US 2020203651 A


### Non-patent literature cited in the description


- **A. MICHELOTTI ; M. ROCHE.** *Synthesis,* 2019, vol. 51 (06), 1319-1328
- **J. ATZRODT ; V. DERDAU ; T. FEY ; J. ZIMMERMANN.** *Angew. Chem. Int. Ed.,* 2007, vol. 46 (15), 7744-7765
- **Y. SAWAMA ; Y. MONGUCHI ; H. SAJIKI.** *Synlett,* 2012, vol. 23 (7), 959-972
- **WONG ; ZYSMAN-COLMAN.** Purely Organic Thermally Activated Delayed Fluorescence Materials for Organic Light-Emitting Diodes. *Adv. Mater.,* 2017, vol. 29 (22), 1605444-1605498
- *CHEMICAL ABSTRACTS,* 51364-51-3
- *CHEMICAL ABSTRACTS,* 13716-12-6
- *CHEMICAL ABSTRACTS,* 625-99-0
- *CHEMICAL ABSTRACTS,* 33863-76-2
- *CHEMICAL ABSTRACTS,* 7778-53-2
- *CHEMICAL ABSTRACTS,* 10294-33-4
- *CHEMICAL ABSTRACTS,* 7087-68-5
- *CHEMICAL ABSTRACTS,* 135-67-1